(19) Europäisches Patentamt
European Patent Office
Office européen des brevets

(11) **EP 4 326 733 B1**

(12) # EUROPEAN PATENT SPECIFICATION

(45) Date of publication and mention of the grant of the patent:
**30.07.2025 Bulletin 2025/31**

(21) Application number: **22725733.4**

(22) Date of filing: **25.04.2022**

(51) International Patent Classification (IPC):
***C07F 5/02*** *(2006.01)* ***H10K 85/60*** *(2023.01)*
***H10K 101/20*** *(2023.01)* ***C09K 11/06*** *(2006.01)*

(52) Cooperative Patent Classification (CPC):
**C07F 5/02; C09K 11/06; H10K 85/657; H10K 85/658;** C09K 2211/1055; H10K 50/11; H10K 2101/20; Y02E 10/549

(86) International application number:
**PCT/EP2022/060927**

(87) International publication number:
**WO 2022/223842 (27.10.2022 Gazette 2022/43)**

(54) **ORGANIC MOLECULES FOR OPTOELECTRONIC DEVICES**
ORGANISCHE MOLEKÜLE FÜR OPTOELEKTRONISCHE VORRICHTUNGEN
MOLÉCULES ORGANIQUES POUR DISPOSITIFS OPTOÉLECTRONIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.04.2021 PCT/EP2021/060703**
**22.12.2021 EP 21217105**

(43) Date of publication of application:
**28.02.2024 Bulletin 2024/09**

(73) Proprietor: **Samsung Display Co., Ltd.**
**Yongin-si, Gyeonggi-do 17113 (KR)**

(72) Inventors:
- **SEIFERMANN, Stefan**
  **77815 Bühl (DE)**
- **DÜCK, Sebastian**
  **69115 Heidelberg (DE)**

(74) Representative: **Dr. Weitzel & Partner**
**Patent- und Rechtsanwälte mbB**
**Friedenstrasse 10**
**89522 Heidenheim (DE)**

(56) References cited:
**WO-A1-2020/135953 US-A1- 2019 067 577**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 326 733 B1

## Description

The invention relates to light-emitting organic molecules and their use in organic light-emitting diodes (OLEDs) and in other optoelectronic devices.

## Prior art

WO 2020/135953 A1 relates to an organic compound, in particular for the application in optoelectronic devices, wherein the organic compound has a structure of formula (I):

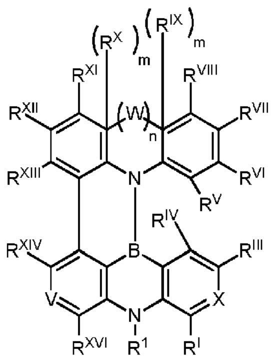

Formula I

,

wherein n is 0 or 1, m = 1 - n, X is N or $CR^{II}$, V is N or $CR^{XV}$, and W is selected from the group consisting of a single bond, $Si(R^3)_2$, $C(R^3)_2$ and $BR^3$ and $R^1$, $R^I$ and $R^{III}$ to $R^{XVI}$ are defined as disclosed in WO 2020/135953 A1.

US 2019/067577 A1 discloses a boron containing heterocyclic compound for OLEDs the compound having the formula I:

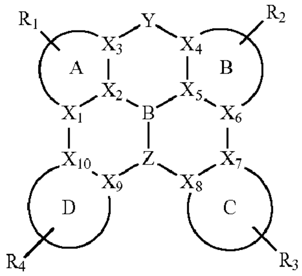

wherein rings A, B, C, D, and $R_1$ to $R_4$, $X_4$ to $X_{10}$, Y, and Z are defined as disclosed in US 2019/067577 A1.

## Description

The object of the present invention is to provide molecules which are suitable for use in optoelectronic devices.

This object is achieved by the invention which provides a new class of organic molecules.

According to the invention the organic molecules are purely organic molecules, i.e. they do not contain any metal ions in contrast to metal complexes known for use in optoelectronic devices.

According to the present invention, the organic molecules exhibit emission maxima in the blue or sky-blue and green spectral range. The organic molecules exhibit in particular emission maxima between 420 nm and 560 nm, in particular between 420 nm and 520 nm, preferably between 440 nm and 495 nm, more preferably between 450 nm and 470 nm. The photoluminescence quantum yields of the organic molecules according to the invention are, in particular, 50 % or more. The use of the molecules according to the invention in an optoelectronic device, for example an organic light-emitting diode (OLED), leads to higher efficiencies or higher color purity, expressed by the full width at half maximum (FWHM) of emission, of the device. Corresponding OLEDs have a higher stability than OLEDs with known emitter materials and comparable color. OLEDs with a light-emission layer which comprises the organic molecules of the invention together with a host material, in particular with a triplet-triplet-annihilation host material, have high stabilities.

The organic light-emitting molecule of the invention comprises or consists of a structure of formula I

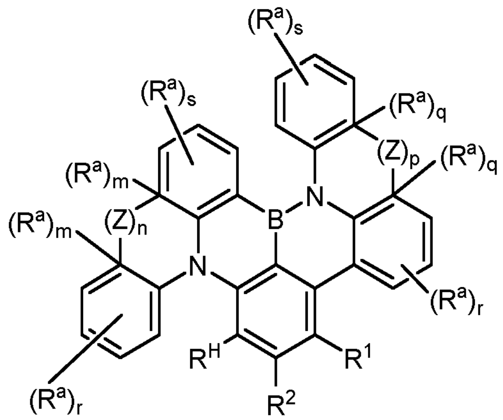

Formula I

wherein

$R^1$ and $R^2$ are independently from each other selected from the group consisting of: $C_1$-$C_{40}$-alkyl, which is optionally substituted with one or more substituents $R^5$, and $C_6$-$C_{60}$-aryl, which is optionally substituted with one or more substituents $R^5$;
$R^H$ is selected from the group consisting of hydrogen, deuterium, F, Br, I, and $C_1$-$C_4$-alkyl;
n, m, p, q are integer selected from 0 and 1,
wherein n + m = 1 and p + q = 1;
r is at each occurrence an integer selected from 0, 1, 2, 3 or 4;
s is at each occurrence an integer selected from 0, 1, 2 or 3;
Z is at each occurrence independently selected from the group consisting of a direct bond, $CR^3R^4$, $C{=}CR^3R^4$, C=O, $C{=}NR^3$, $NR^3$, O, $SiR^3R^4$, S, S(O) and $S(O)_2$;
$R^a$, $R^3$ and $R^4$ is at each occurrence independently selected from the group consisting of: hydrogen, deuterium, $N(R^5)_2$, $OR^5$, $Si(R^5)_3$, $B(OR^5)_2$, $B(R^5)_2$, $OSO_2R^5$, $CF_3$, CN, F, Br, I, $C_1$-$C_{40}$-alkyl,

which is optionally substituted with one or more substituents $R^5$ and
wherein one or more non-adjacent $CH_2$-groups are optionally substituted by $R^5C{=}CR^5$, C≡C, $Si(R^5)_2$, $Ge(R^5)_2$, $Sn(R^5)_2$, C=O, C=S, C=Se, $C{=}NR^5$, $P(=O)(R^5)$, SO, $SO_2$, $NR^5$, O, S or $CONR^5$;

$C_1$-$C_{40}$-alkoxy,

which is optionally substituted with one or more substituents $R^5$ and
wherein one or more non-adjacent $CH_2$-groups are optionally substituted by $R^5C{=}CR^5$, C≡C, $Si(R^5)_2$, $Ge(R^5)_2$, $Sn(R^5)_2$, C=O, C=S, C=Se, $C{=}NR^5$, $P(=O)(R^5)$, SO, $SO_2$, $NR^5$, O, S or $CONR^5$;

$C_1$-$C_{40}$-thioalkoxy,

which is optionally substituted with one or more substituents $R^5$ and
wherein one or more non-adjacent $CH_2$-groups are optionally substituted by $R^5C{=}CR^5$, C≡C, $Si(R^5)_2$, $Ge(R^5)_2$, $Sn(R^5)_2$, C=O, C=S, C=Se, $C{=}NR^5$, $P(=O)(R^5)$, SO, $SO_2$, $NR^5$, O, S or $CONR^5$;

$C_2$-$C_{40}$-alkenyl,

which is optionally substituted with one or more substituents $R^5$ and
wherein one or more non-adjacent $CH_2$-groups are optionally substituted by $R^5C{=}CR^5$, C≡C, $Si(R^5)_2$, $Ge(R^5)_2$, $Sn(R^5)_2$, C=O, C=S, C=Se, $C{=}NR^5$, $P(=O)(R^5)$, SO, $SO_2$, $NR^5$, O, S or $CONR^5$;

$C_2$-$C_{40}$-alkynyl,

which is optionally substituted with one or more substituents $R^5$ and
wherein one or more non-adjacent $CH_2$-groups are optionally substituted by $R^5C{=}CR^5$, C≡C, $Si(R^5)_2$, $Ge(R^5)_2$, $Sn(R^5)_2$, C=O, C=S, C=Se, $C{=}NR^5$, $P(=O)(R^5)$, SO, $SO_2$, $NR^5$, O, S or $CONR^5$;

$C_6$-$C_{60}$-aryl,

which is optionally substituted with one or more substituents $R^5$; and $C_2$-$C_{57}$-heteroaryl, which is optionally substituted with one or more substituents $R^5$;

$R^5$ is at each occurrence independently from another selected from the group consisting of: hydrogen, deuterium, $N(R^6)_2$, $OR^6$, $Si(R^6)_3$, $B(OR^6)_2$, $B(R^6)_2$, $OSO_2R^6$, $CF_3$, CN, F, Br, I, $C_1$-$C_{40}$-alkyl,

which is optionally substituted with one or more substituents $R^6$ and wherein one or more non-adjacent $CH_2$-groups are optionally substituted by $R^6C{=}CR^6$, C≡C, $Si(R^6)_2$, $Ge(R^6)_2$, $Sn(R^6)_2$, C=O, C=S, C=Se, $C{=}NR^6$, $P(=O)(R^6)$, SO, $SO_2$, $NR^6$, O, S or $CONR^6$;

$C_1$-$C_{40}$-alkoxy,

which is optionally substituted with one or more substituents $R^6$ and wherein one or more non-adjacent $CH_2$-groups are optionally substituted by $R^6C{=}CR^6$, C≡C, $Si(R^6)_2$, $Ge(R^6)_2$, $Sn(R^6)_2$, C=O, C=S, C=Se, $C{=}NR^6$, $P(=O)(R^6)$, SO, $SO_2$, $NR^6$, O, S or $CONR^6$;

$C_1$-$C_{40}$-thioalkoxy,

which is optionally substituted with one or more substituents $R^6$ and wherein one or more non-adjacent $CH_2$-groups are optionally substituted by $R^6C{=}CR^6$, C≡C, $Si(R^6)_2$, $Ge(R^6)_2$, $Sn(R^6)_2$, C=O, C=S, C=Se, $C{=}NR^6$, $P(=O)(R^6)$, SO, $SO_2$, $NR^6$, O, S or $CONR^6$;

$C_2$-$C_{40}$-alkenyl,

which is optionally substituted with one or more substituents $R^6$ and wherein one or more non-adjacent $CH_2$-groups are optionally substituted by $R^6C{=}CR^6$, C≡C, $Si(R^6)_2$, $Ge(R^6)_2$, $Sn(R^6)_2$, C=O, C=S, C=Se, $C{=}NR^6$, $P(=O)(R^6)$, SO, $SO_2$, $NR^6$, O, S or $CONR^6$;

$C_2$-$C_{40}$-alkynyl,

which is optionally substituted with one or more substituents $R^6$ and wherein one or more non-adjacent $CH_2$-groups are optionally substituted by $R^6C{=}CR^6$, C≡C, $Si(R^6)_2$, $Ge(R^6)_2$, $Sn(R^6)_2$, C=O, C=S, C=Se, $C{=}NR^6$, $P(=O)(R^6)$, SO, $SO_2$, $NR^6$, O, S or $CONR^6$;

$C_6$-$C_{60}$-aryl,

which is optionally substituted with one or more substituents $R^6$; and $C_2$-$C_{57}$-heteroaryl, which is optionally substituted with one or more substituents $R^6$;

$R^6$ is at each occurrence independently from another selected from the group consisting of: hydrogen, deuterium, OPh, $CF_3$, CN, F,
$C_1$-$C_5$-alkyl,
wherein one or more hydrogen atoms are optionally, independently substituted by deuterium, CN, $CF_3$, or F;
$C_1$-$C_5$-alkoxy,
wherein one or more hydrogen atoms are optionally, independently substituted by deuterium, CN, $CF_3$, or F;
$C_1$-$C_5$-thioalkoxy,
wherein one or more hydrogen atoms are optionally, independently substituted by deuterium, CN, $CF_3$, or F;
$C_2$-$C_5$-alkenyl,
wherein one or more hydrogen atoms are optionally, independently substituted by deuterium, CN, $CF_3$, or F;
$C_2$-$C_5$-alkynyl,
wherein one or more hydrogen atoms are optionally, independently substituted by deuterium, CN, $CF_3$, or F;
$C_6$-$C_{18}$-aryl,

which is optionally substituted with one or more $C_1$-$C_5$-alkyl substituents; $C_2$-$C_{17}$-heteroaryl, which is optionally substituted with one or more $C_1$-$C_5$-alkyl substituents; $N(C_6$-$C_{18}$-aryl$)_2$;

$N(C_2\text{-}C_{17}\text{-heteroaryl})_2$, and
$N(C_2\text{-}C_{17}\text{-heteroaryl})(C_6\text{-}C_{18}\text{-aryl})$;
wherein any of the substituents $R^a$, $R^1$, $R^2$, $R^3$, $R^4$, $R^5$, and $R^6$ may independently form a mono- or polycyclic, aliphatic, aromatic, heteroaromatic and/or benzo-fused ring system with one or more substituents $R^a$, $R^1$, $R^2$, $R^3$, $R^4$, $R^5$ and/or $R^6$.

In one embodiment, the organic molecules comprise or consist of a structure formula Ia:

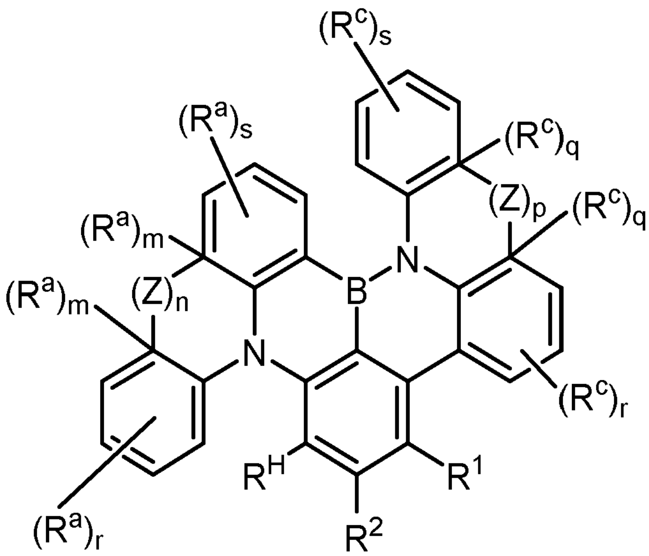

Formula Ia

wherein $R^c$ is at each occurrence independently selected from the group consisting of: hydrogen, deuterium, $N(R^5)_2$, $OR^5$, $Si(R^5)_3$, $B(OR^5)_2$, $B(R^5)_2$, $OSO_2R^5$, $CF_3$, CN, F, Br, I,
$C_1$-$C_{40}$-alkyl,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-alkoxy,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-thioalkoxy,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkenyl,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkynyl,

which is optionally substituted with one or more substituents $R^5$ and

wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_6$-$C_{60}$-aryl,

which is optionally substituted with one or more substituents $R^5$; and $C_2$-$C_{57}$-heteroaryl, which is optionally substituted with one or more substituents $R^5$,

and wherein the aforementioned definitions apply.

In a further embodiment of the invention, $R^c$ is at each occurrence independently from another selected from the group consisting of:

hydrogen,
Me,
$^i$Pr,
$^t$Bu,
Ph, which is optionally substituted with one or more substituents independently from each other selected from the group consisting of Me, $^i$Pr, $^t$Bu, CN, $CF_3$, and Ph,
and wherein the aforementioned definitions apply.

In one embodiment, the organic molecules comprise or consist of a structure formula IIa, formula IIb, formula IIc or formula IId:

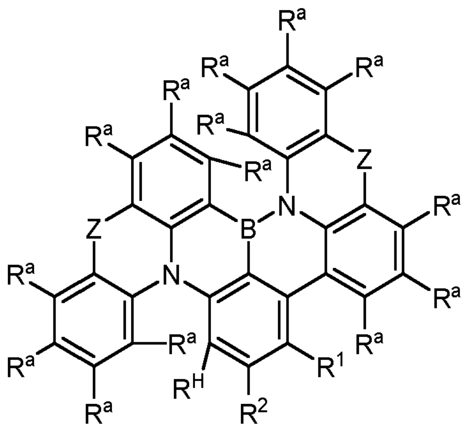

Formula IIa

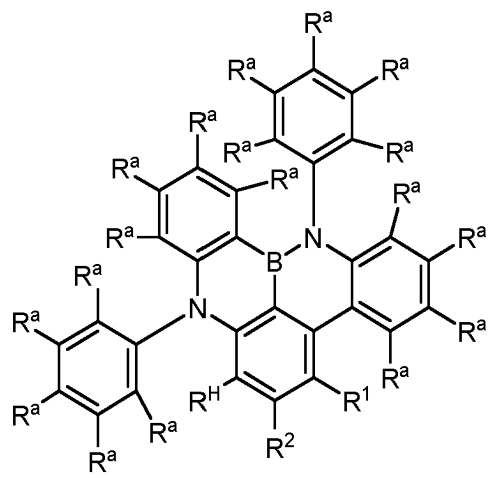

Formula IIb

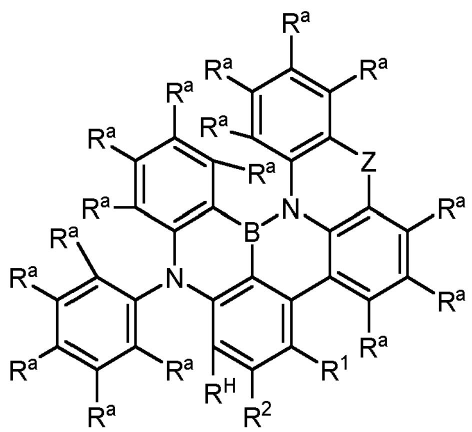

Formula IIc

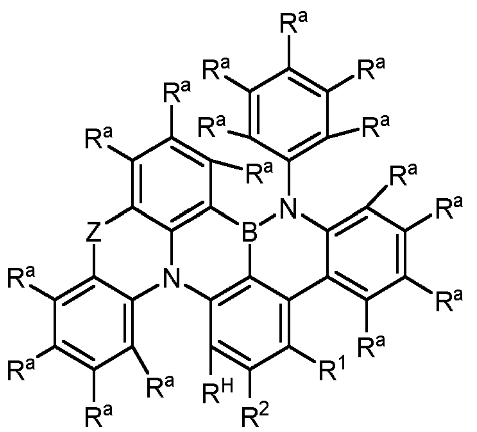

Formula IId.

In one embodiment, Z is at each occurrence selected from the group consisting of a direct bond, $NR^3$, O and S.

In a preferred embodiment, Z is at each occurrence a direct bond.

In one embodiment the organic molecules comprise or consist of a structure formula IIa-2, formula IIb-2, formula IIc-2 or formula IId-2:

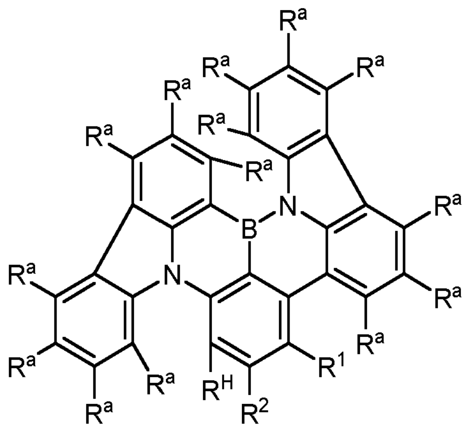

Formula IIa-2

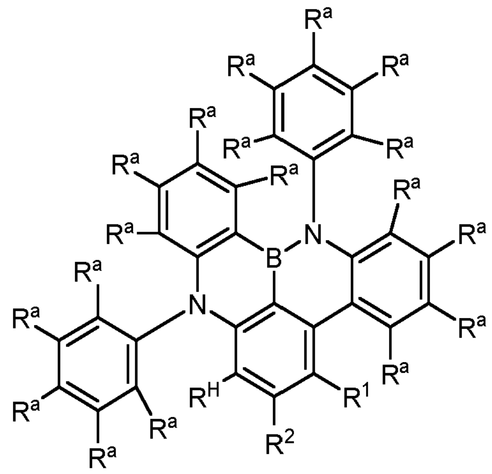

Formula IIb-2

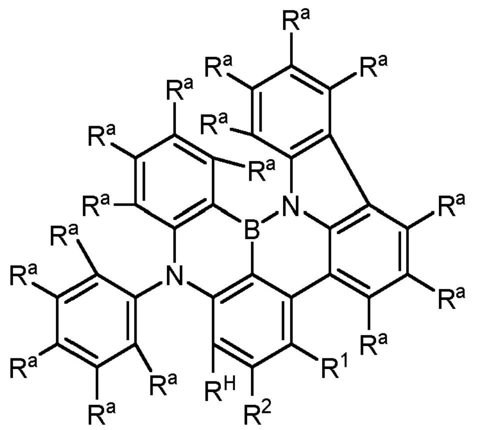

Formula IIc-2

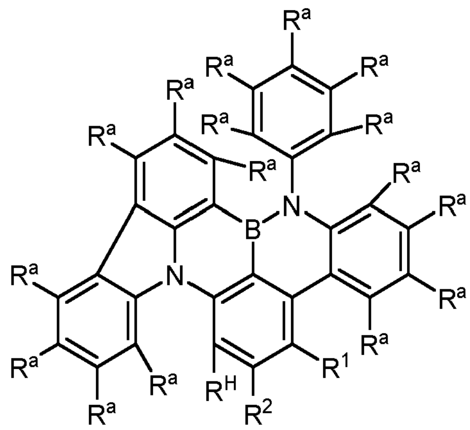

Formula IId-2.

In a preferred embodiment, the organic molecules comprise or consist of a structure formula IIa-2.

In a preferred embodiment, at least one mono- or polycyclic, aliphatic, aromatic, heteroaromatic and/or benzo-fused ring system is formed by $R^a$, $R^3$, $R^4$, $R^5$, and $R^6$ substituents together with one or more further substituents $R^a$, $R^3$, $R_4$, $R^5$ and/or $R^6$.

In one embodiment, $R^a$ is at each occurrence independently from another selected from the group consisting of:

hydrogen,
deuterium,
Me,
$^i$Pr,
$^t$Bu,
CN,
$CF_3$,
Ph, which is optionally substituted with one or more substituents independently from each other selected from the group consisting of Me, $^i$Pr, $^t$Bu, CN, $CF_3$, and Ph,
pyridinyl, which is optionally substituted with one or more substituents independently from each other selected from the group consisting of Me, $^i$Pr, $^t$Bu, CN, $CF_3$, and Ph,
pyrimidinyl, which is optionally substituted with one or more substituents independently from each other selected from the group consisting of Me, $^i$Pr, $^t$Bu, CN, $CF_3$, and Ph,

carbazolyl, which is optionally substituted with one or more substituents independently from each other selected from the group consisting of Me, $^{i}Pr$, $^{t}Bu$, CN, $CF_3$, and Ph,

triazinyl, which is optionally substituted with one or more substituents independently from each other selected from the group consisting of Me, $^{i}Pr$, $^{t}Bu$, CN, $CF_3$, and Ph,

and $N(Ph)_2$, which is optionally substituted with one or more substituents independently from each other selected from the group consisting of Me, $^{i}Pr$, $^{t}Bu$, CN, $CF_3$, and Ph;

wherein two or more adjacent substituents $R^a$ may form attachment points for a ring system selected from the group consisting of:

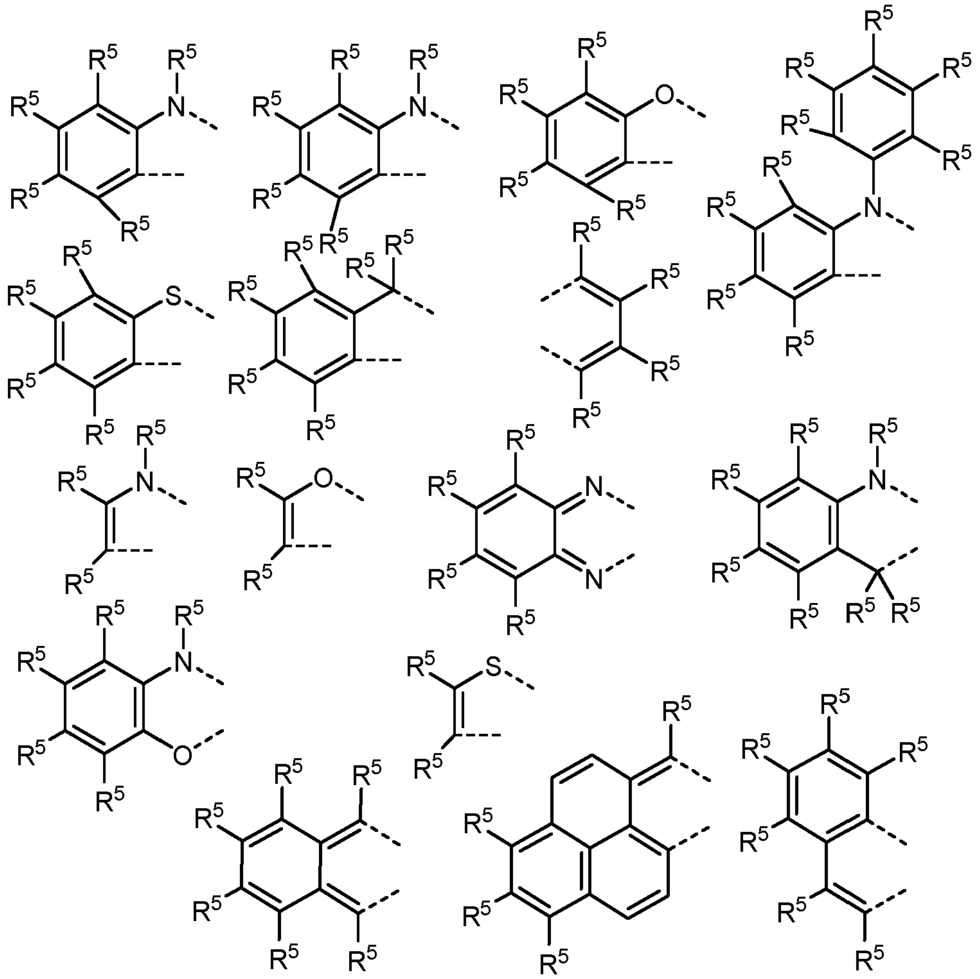

wherein each dashed line indicates a direct bond connecting one of the above shown ring systems to the positions of two adjacent substituents $R^a$.

In one embodiment, $R^a$ is at each occurrence independently from another selected from the group consisting of:

deuterium,
Me,
$^{i}Pr$,
$^{t}Bu$,
CN,
$CF_3$,
Ph, which is optionally substituted with one or more substituents independently from each other selected from the group consisting of Me, $^{i}Pr$, $^{t}Bu$, CN, $CF_3$, and Ph,
pyridinyl, which is optionally substituted with one or more substituents independently from each other selected from the group consisting of Me, $^{i}Pr$, $^{t}Bu$, CN, $CF_3$, and Ph,
pyrimidinyl, which is optionally substituted with one or more substituents independently from each other selected from the group consisting of Me, $^{i}Pr$, $^{t}Bu$, CN, $CF_3$, and Ph,

carbazolyl, which is optionally substituted with one or more substituents independently from each other selected from the group consisting of Me, $^iPr$, $^tBu$, CN, $CF_3$, and Ph,

and triazinyl, which is optionally substituted with one or more substituents independently from each other selected from the group consisting of Me, $^iPr$, $^tBu$, CN, $CF_3$, and Ph;

wherein two or more adjacent substituents $R^a$ may form attachment points for a ring system selected from the group consisting of:

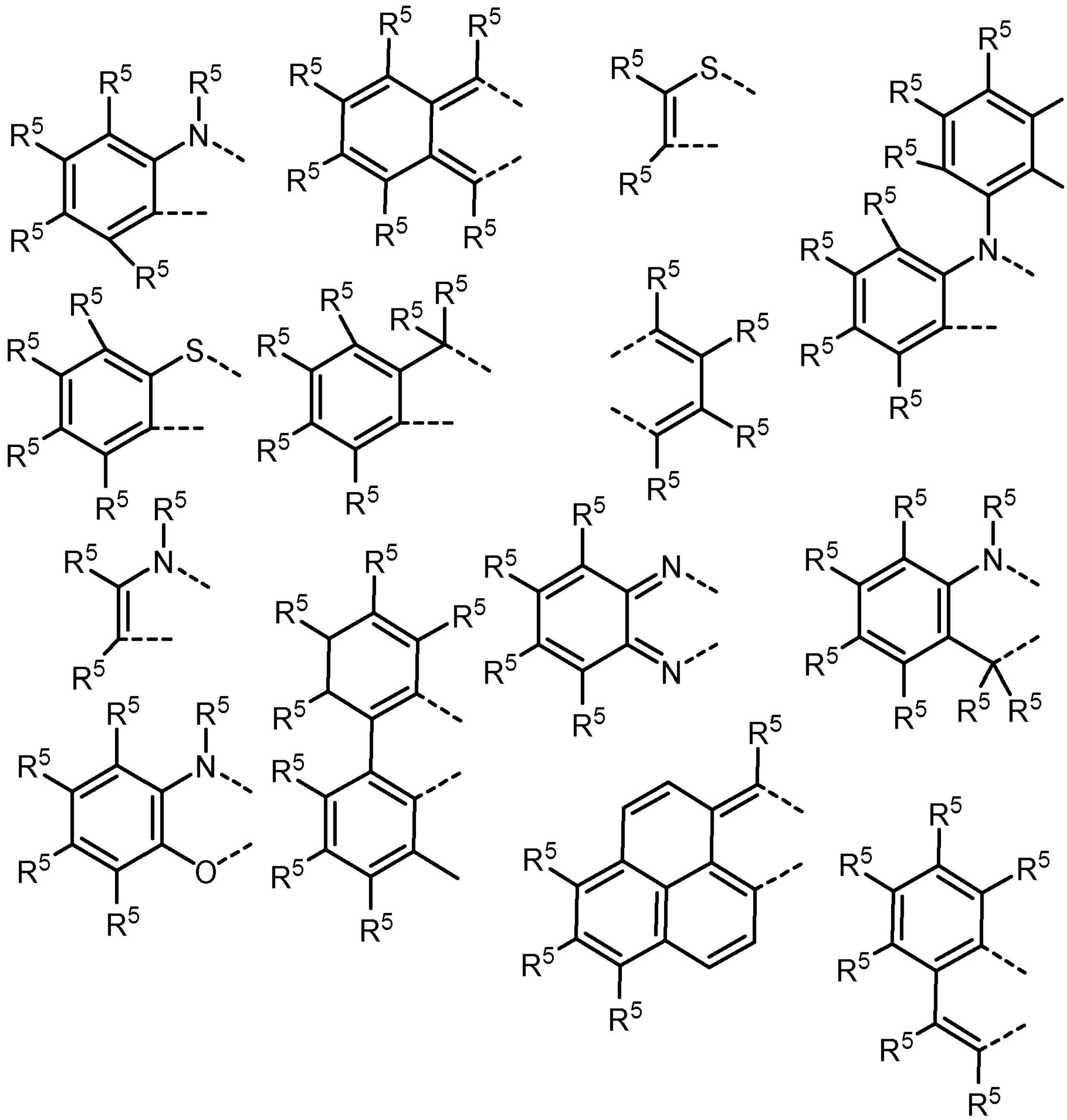

wherein each dashed line indicates a direct bond connecting one of the above shown ring systems to the positions of two adjacent substituents $R^a$.

In certain embodiments, if $R^2$ is a $^tBu$ group then $R^a$ does not form a benzo-fused ring system including a $C_4$ benzo fused ring as shown, and

if $R^2$ is a substituted benzofuran group then $R^a$ does not form benzo-fused ring system including a $C_4$ benzo fused ring as shown:

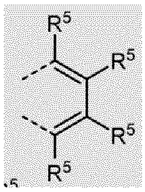

In a further embodiment of the invention, $R^a$ is at each occurrence independently from another selected from the group consisting of:

hydrogen,
Me,
$^iPr$,
$^tBu$,
CN,
$CF_3$,
Ph, which is optionally substituted with one or more substituents $R^5$, pyridinyl, which is optionally substituted with one or more substituents $R^5$, pyrimidinyl, which is optionally substituted with one or more substituents $R^5$, carbazolyl, which is optionally substituted with one or more substituents $R^5$, triazinyl, which is optionally substituted with one or more substituents $R^5$, and $N(Ph)_2$, which is optionally substituted with one or more substituents $R^5$; wherein any two of the groups $R^a$ positioned adjacent to each other are optionally bonded to each other and form a ring system selected from a group consisting of:

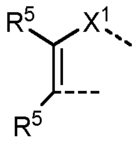

wherein $X^1$ is S, O or $NR^5$.

In a further embodiment of the invention, $R^a$ is at each occurrence independently from another selected from the group consisting of:

hydrogen,
Me,
$^iPr$,
$^tBu$,
CN,
$CF_3$,
Ph, which is optionally substituted with one or more substituents independently from each other selected from the group consisting of Me, $^iPr$, $^tBu$, CN, $CF_3$, and Ph,
pyridinyl, which is optionally substituted with one or more substituents independently from each other selected from the group consisting of Me, $^iPr$, $^tBu$, CN, $CF_3$, and Ph,
pyrimidinyl, which is optionally substituted with one or more substituents independently from each other selected from the group consisting of Me, $^iPr$, $^tBu$, CN, $CF_3$, and Ph, and
triazinyl, which is optionally substituted with one or more substituents independently from each other selected from the group consisting of Me, $^iPr$, $^tBu$, CN, $CF_3$, and Ph.

In a further embodiment of the invention, $R^a$ is at each occurrence independently from another selected from the group consisting of:

hydrogen,
Me,
$^iPr$,
$^tBu$,
Ph, which is optionally substituted with one or more substituents independently from each other selected from the group consisting of Me, $^iPr$, $^tBu$, CN, $CF_3$, and Ph.

In a preferred embodiment, the organic molecules comprise or consist of a structure formula IIa-21:

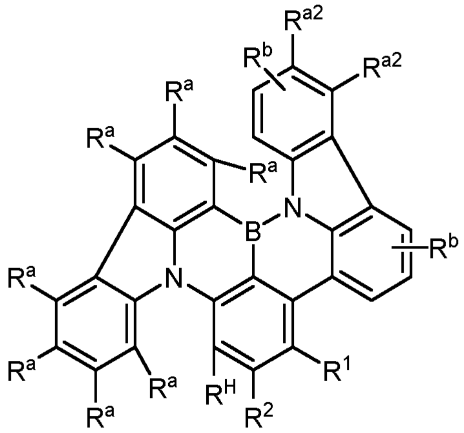

Formula IIa-21

wherein both $R^{a2}$ are selected from $R^a$ and together form a mono- or polycyclic, aliphatic, aromatic, heteroaromatic and/or benzo-fused ring system with each other; and

$R^b$ is at each occurrence independently from another selected from the group consisting of hydrogen, deuterium, $N(R^5)_2$, $OR^5$, $Si(R^5)_3$, $B(OR^5)_2$, $OSO_2R^5$, $CF_3$, CN, F, Br, I,

$C_1$-$C_{40}$-alkyl,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-alkoxy,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-thioalkoxy,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkenyl,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkynyl,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_6$-$C_{60}$-aryl,

which is optionally substituted with one or more substituents $R^5$; and $C_2$-$C_{57}$-heteroaryl,
which is optionally substituted with one or more substituents $R^5$.

In a further embodiment of the invention, $R^b$ is at each occurrence independently from another selected from the group consisting of:

hydrogen, deuterium,
Me, $^iPr$, $^tBu$, CN, $CF_3$,
Ph, which is optionally substituted with one or more substituents independently from each other selected from the group consisting of Me, $^iPr$, $^tBu$, CN, $CF_3$, and Ph,
pyridinyl, which is optionally substituted with one or more substituents independently from each other selected from the group consisting of Me, $^iPr$, $^tBu$, CN, $CF_3$, and Ph,
carbazolyl, which is optionally substituted with one or more substituents independently from each other selected from the group consisting of Me, $^iPr$, $^tBu$, CN, $CF_3$, and Ph,
triazinyl, which is optionally substituted with one or more substituents independently from each other selected from the group consisting of Me, $^iPr$, $^tBu$, CN, $CF_3$, and Ph,
and $N(Ph)_2$.

In a preferred embodiment, the organic molecules comprise or consist of a structure formula IIa-22:

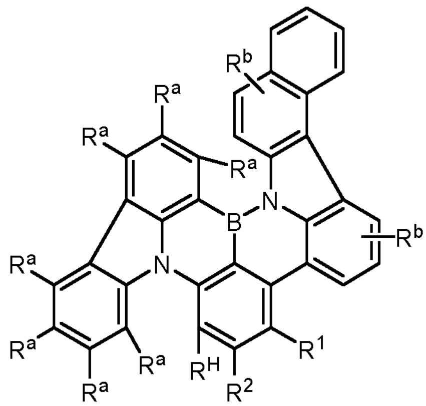

Formula IIa-22

In one embodiment, the organic molecules comprise or consist of a structure formula IIa-23:

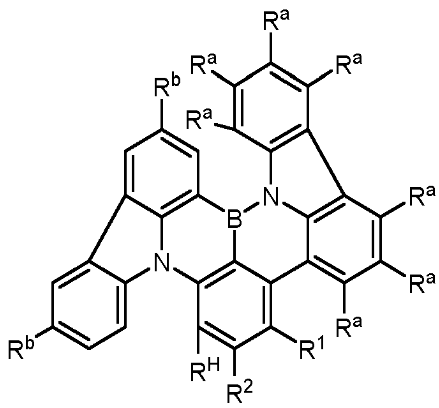

Formula IIa-23.

In one embodiment, $R^H$ is selected from hydrogen, deuterium and methyl.
In a preferred embodiment, $R^H$ is hydrogen.
In one embodiment, the organic molecules comprise or consist of a structure of formula III:

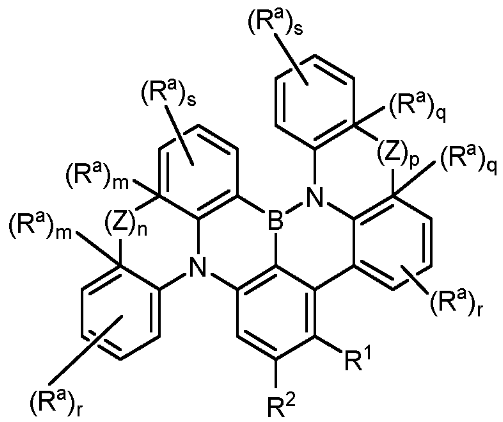

Formula III.

In a preferred embodiment, $R^1$ and $R^2$ is independently from each other selected from a $C_1$-$C_6$ alkyl and

Ph, which is optionally substituted with one or more substituents independently from each other selected from the group consisting of Me, $^i$Pr, $^t$Bu, CN, $CF_3$, and Ph,
wherein $R^1$ and $R^2$ may together form a mono- or polycyclic, aliphatic and/or aromatic ring system.

In a preferred embodiment, $R^1$ and $R^2$ is independently from each other selected from a $C_1$-$C_6$ alkyl and Ph, which is optionally substituted with one or more substituents independently from each other selected from the group consisting of Me, $^i$Pr, $^t$Bu, CN, $CF_3$, and Ph.

In a preferred embodiment, $R^1$ is selected from a $C_1$-$C_6$ alkyl and Ph, which is optionally substituted with one or more substituents independently from each other selected from the group consisting of Me, $^i$Pr, $^t$Bu, CN, $CF_3$, and Ph.

In one embodiment, $R^1$ a $C_1$-$C_6$ alkyl.

In one embodiment, $R^1$ is methyl.

In one embodiment, $R^2$ is selected from a $C_1$-$C_6$ alkyl and Ph, which is optionally substituted with one or more substituents independently from each other selected from the group consisting of Me, $^i$Pr, $^t$Bu, CN, $CF_3$, and Ph.

In one embodiment, the organic molecules comprise or consist of one of the following structures, formula III-1 to formula III-15:

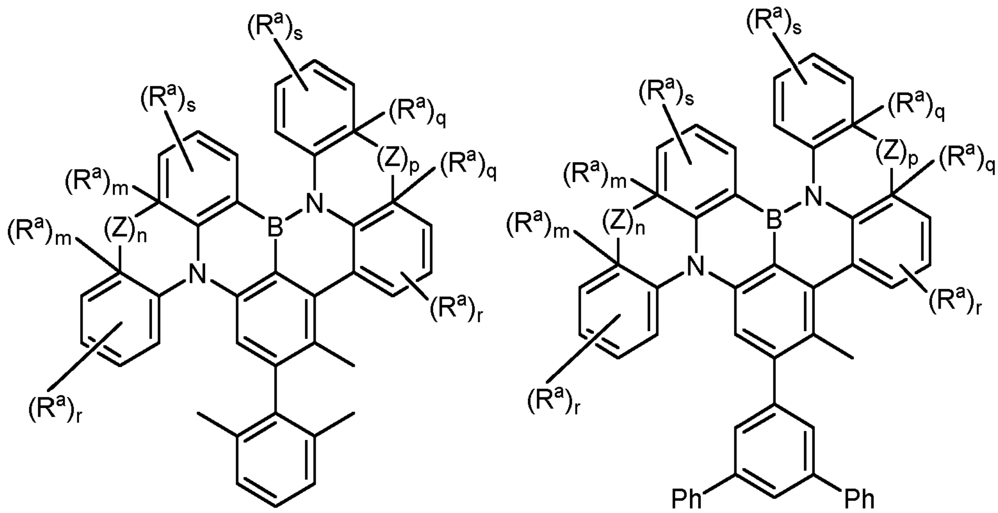

Formula III-1

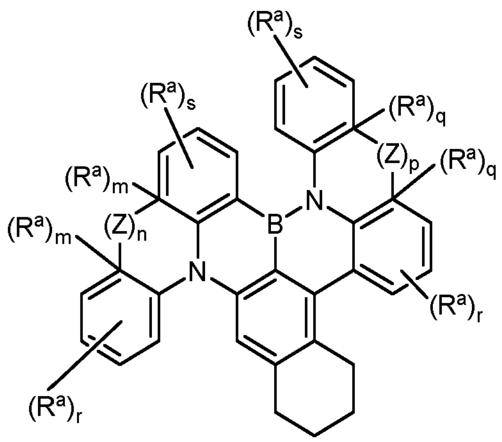

Formula III-2

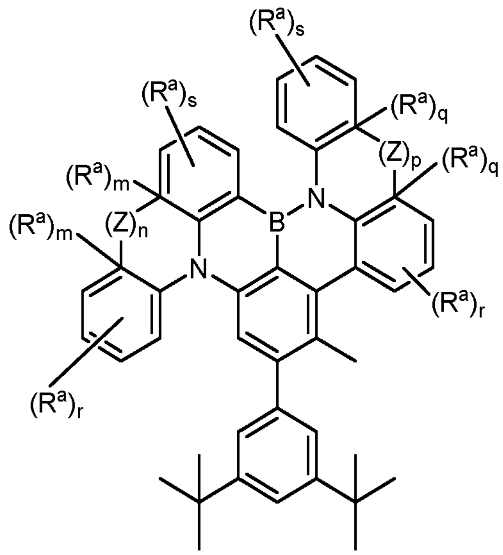

Formula III-3

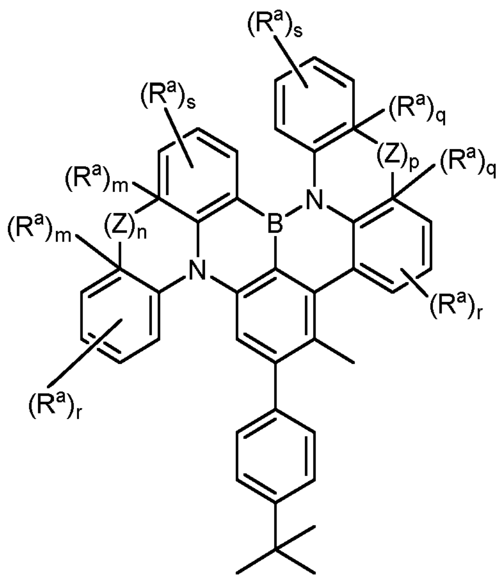

Formula III-4

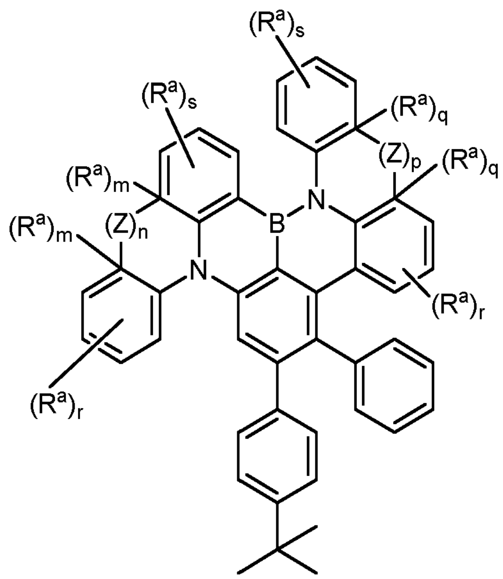

Formula III-5

Formula III-6

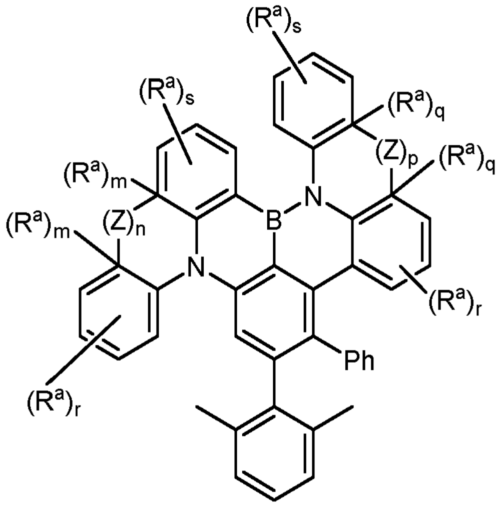

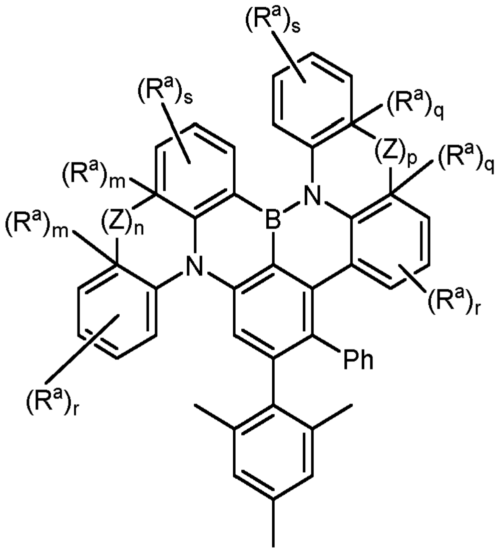

Formula III-7

Formula III-8

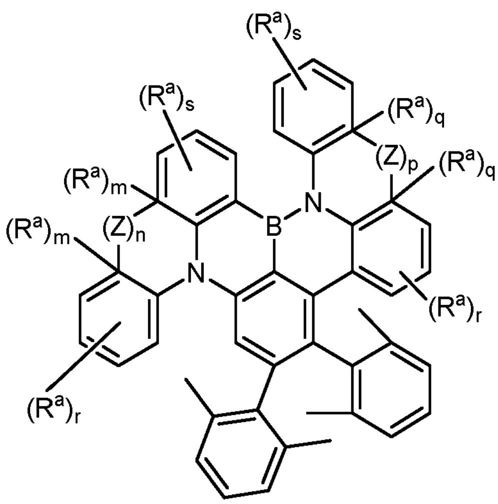

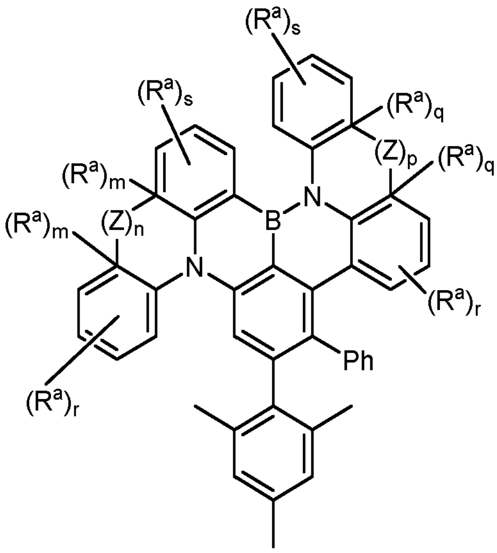

Formula III-9

Formula III-10

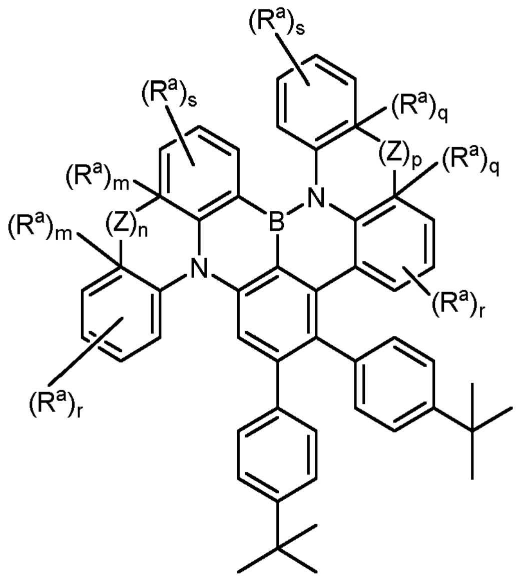

Formula III-11

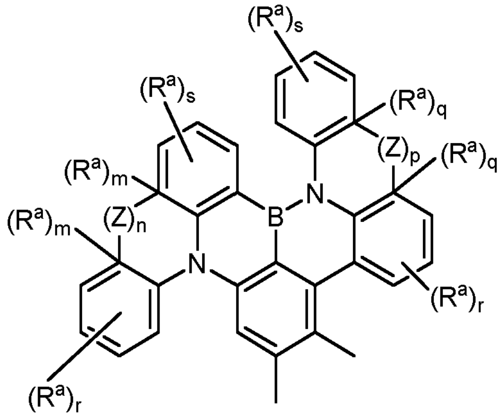

Formula III-12

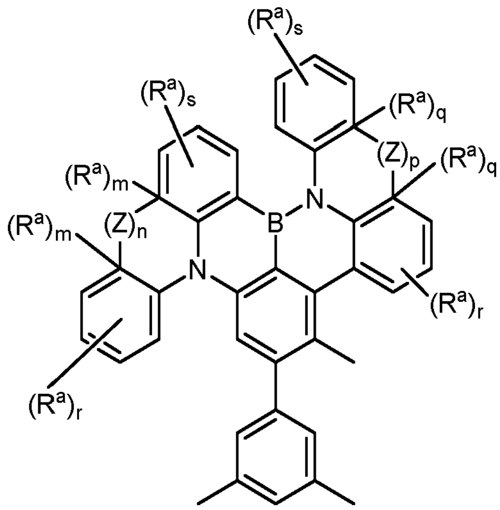

Formula III-13

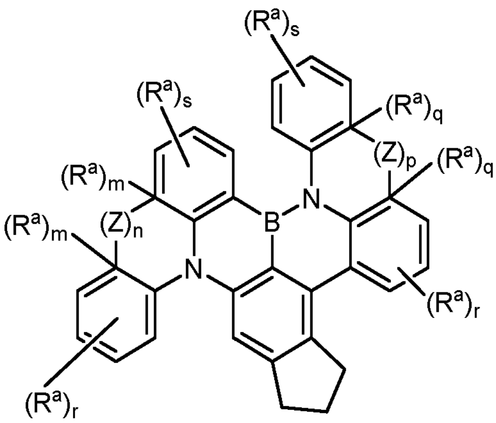

Formula III-14

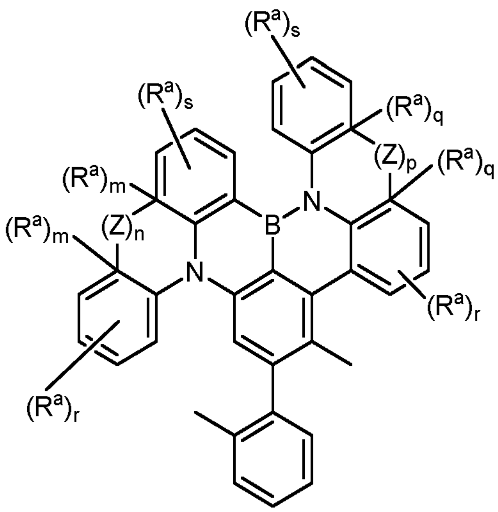

Formula III-15.

In one embodiment of the invention, $R^5$ is at each occurrence independently from another selected from the group consisting of:

hydrogen, deuterium,
Me,
$^{i}Pr$,
$^{t}Bu$,
CN,
$CF_3$,
Ph, which is optionally substituted with one or more substituents independently from each other selected from the group consisting of Me, $^{i}Pr$, $^{t}Bu$, CN, $CF_3$, and Ph,
pyridinyl, which is optionally substituted with one or more substituents independently from each other selected from the group consisting of Me, $^{i}Pr$, $^{t}Bu$, CN, $CF_3$, and Ph,
pyrimidinyl, which is optionally substituted with one or more substituents independently from each other selected from the group consisting of Me, $^{i}Pr$, $^{t}Bu$, CN, $CF_3$, and Ph,
carbazolyl, which is optionally substituted with one or more substituents independently from each other selected from the group consisting of Me, $^{i}Pr$, $^{t}Bu$, CN, $CF_3$, and Ph,
triazinyl, which is optionally substituted with one or more substituents independently from each other selected from the group consisting of Me, $^{i}Pr$, $^{t}Bu$, CN, $CF_3$, and Ph,
and $N(Ph)_2$.

*Definitions*

Herein, the term "layer" refers to a body that bears an extensively planar geometry. It forms part of the common knowledge of those skilled in that optoelectronic devices may be composed of several layers.

A light-emitting layer (EML) in the context of the present invention is a layer of an optoelectronic device, wherein light emission from said layer is observed when applying a voltage and electrical current to the device. The person skilled in the art understands that light emission from optoelectronic devices is attributed to light emission from at least one EML. The skilled artisan understands that light emission from an EML is typically not (mainly) attributed to all materials comprised in said EML, to specific emitter materials.

An "emitter material" (also referred to as "emitter") in the context of the present invention is a material that emits light when it is comprised in a light-emitting layer (EML) of an optoelectronic device (vide infra), given that a voltage and electrical current are applied to said device. The person skilled in the art knows that an emitter material usually is an "emissive dopant" material, and the skilled artisan understands that a dopant material (may it be emissive or not) is a material that is embedded in a matrix material that is usually (and herein) referred to as host material. Herein, host materials are also in general referred to as $H^B$ when they are comprised in an optoelectronic device (preferably an OLED) comprising at least one organic molecule according to the present invention.

In the context of the present invention, the term "cyclic group" may be understood in the broadest sense as any mono-, bi- or polycyclic moiety.

In the context of the present invention, the term "ring" when referring to chemical structures may be understood in the broadest sense as any monocyclic moiety. Along the same lines, the term "rings" when referring to chemical structures may be understood in the broadest sense as any bi- or polycyclic moiety.

In the context of the present invention, the term "ring system" may be understood in the broadest sense as any mono-, bi- or polycyclic moiety.

In the context of the present invention, the term "ring atom" refers to any atom which is part of the cyclic core of a ring or a ring system, and not part of a non-cyclic substituent optionally attached to the cyclic core.

In the context of the present invention, the term "carbocycle" may be understood in the broadest sense as any cyclic group in which the cyclic core structure comprises only carbon atoms that may of course be substituted with hydrogen or any other substituents defined in the specific embodiments of the invention. It is understood that the term "carbocyclic" as adjective refers to cyclic groups in which the cyclic core structure comprises only carbon atoms that may of course be substituted with hydrogen or any other substituents defined in the specific embodiments of the invention.

In the context of the present invention, the term "heterocycle" may be understood in the broadest sense as any cyclic group in which the cyclic core structure comprises not just carbon atoms, but also at least one heteroatom. It is understood that the term "heterocyclic" as adjective refers to cyclic groups in which the cyclic core structure comprises not just carbon atoms, but also at least one heteroatom. The heteroatoms may, unless stated otherwise in specific embodiments, at each occurrence be the same or different and preferably be individually selected from the group consisting of B, Si, N, O, S, and Se, more preferably B, N, O and S, most preferably N, O, S. All carbon atoms or heteroatoms comprised in a heterocycle in the context of the invention may of course be substituted with hydrogen or any

other substituents defined in the specific embodiments of the invention.

The person skilled in the art understands that any cyclic group (i.e. any carbocycle and heterocycle) may be aliphatic or aromatic or heteroaromatic.

In the context of the present invention, the term aliphatic when referring to a cyclic group (i.e. to a ring, to rings, to a ring system, to a carbocycle, to a heterocycle) means that the cyclic core structure (not counting substituents that are optionally attached to it) contains at least one ring atom that is not part of an aromatic or heteroaromatic ring or ring system. Preferably, the majority of ring atoms and more preferably all ring atoms within an aliphatic cyclic group are not part of an aromatic or heteroaromatic ring or ring system (such as in cyclohexane or in piperidine for example). Herein, no differentiation is made between carbocyclic and heterocyclic groups when referring to aliphatic rings or ring systems in general, whereas the term "aliphatic" may be used as adjective to describe a carbocycle or heterocycle in order to indicate whether or not a heteroatom is comprised in the aliphatic cyclic group.

As understood by the skilled artisan, the terms "aryl" and "aromatic" may be understood in the broadest sense as any mono-, bi- or polycyclic aromatic moieties, i.e. cyclic groups in which all ring atoms are part of an aromatic ring system, preferably part of the same aromatic ring system. However, throughout the present application, the terms "aryl" and "aromatic" are restricted to mono-, bi- or polycyclic aromatic moieties wherein all aromatic ring atoms are carbon atoms. In contrast, the terms "heteroaryl" and "heteroaromatic" herein refer to any mono-, bi- or polycyclic aromatic moieties, wherein at least one aromatic carbon ring atom is replaced by a heteroatom (i.e. not carbon). Unless stated otherwise in specific embodiments of the invention, the at least one heteroatom within a "heteroaryl" or "heteroaromatic" may at each occurrence be the same or different and be individually selected from the group consisting of N, O, S, and Se, more preferably N, O, and S. The person skilled in the art understands that the adjectives "aromatic" and "heteroaromatic" may be used to describe any cyclic group (i.e. any ring system). This is to say that an aromatic cyclic group (i.e. an aromatic ring system) is an aryl group and a heteroaromatic cyclic group (i.e. a heteroaromatic ring system) is a heteroaryl group.

Unless indicated differently in specific embodiments of the invention, an aryl group herein preferably contains 6 to 60 aromatic ring atoms, more preferably 6 to 40 aromatic ring atoms, and even more preferably 6 to 18 aromatic ring atoms. Unless indicated differently in specific embodiments of the invention, a heteroaryl group herein preferably contains 5 to 60 aromatic ring atoms, preferably 5 to 40 aromatic ring atoms, more preferably 5 to 20 aromatic ring atoms, out of which at least one is a heteroatom, preferably selected from N, O, S, and Se, more preferably from N, O, and S. If more than one heteroatom is comprised an a heteroaromatic group, all heteroatoms are preferably independently of each other selected from N, O, S, and Se, more preferably from N, O, and S.

In the context of the present invention, for both aromatic and heteroaromatic groups (for example aryl or heteroaryl substituents), the number of aromatic ring carbon atoms may be given as subscripted number in the definition of certain substituents, for example in the form of "$C_6$-$C_{60}$-aryl", which means that the respective aryl substituent comprises 6 to 60 aromatic carbon ring atoms. The same subscripted numbers are herein also used to indicate the allowable number of carbon atoms in all other kinds of substituents, regardless of whether they are aliphatic, aromatic or heteroaromatic substituents. For example,

the expression "$C_1$-$C_{40}$-alkyl" refers to an alkyl substituent comprising 1 to 40 carbon atoms.

Preferred examples of aryl groups comprise groups derived from benzene, naphthalene, anthracene, phenanthrene, pyrene, dihydropyrene, chrysene, perylene, fluoranthene, benzanthracene, benzophenanthrene, tetracene, pentacene, benzopyrene or combinations of these groups.

Preferred examples of heteroaryl groups comprise groups derived from furan, benzofuran, isobenzofuran, dibenzofuran, thiophene, benzothiophene, isobenzothiophene, dibenzothiophene; pyrrole, indole, isoindole, carbazole, indolocarbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthoimidazole, phenanthroimidazole, pyridoimidazole, pyrazinoimidazole, quinoxalinoimidazole, oxazole, benzoxazole, napthooxazole, anthroxazol, phenanthroxazol, isoxazole, 1,2-thiazole, 1,3-thiazole, benzothiazole, pyridazine, benzopyridazine, pyrimidine, benzopyrimidine, 1,3,5-triazine, 1,2,4-triazine, 1,2,3-triazine, quinoxaline, pyrazine, phenazine, naphthyridine, carboline, benzocarboline, phenanthroline, 1,2,3-triazole, 1,2,4-triazole, benzotriazole, 1,2,3-oxadiazole, 1,2,4-oxadiazole, 1,2,5-oxadiazole, 1,2,3,4-tetrazine, 1,2,4,5-tetrazine, purine, pteridine, indolizine and benzothiadiazole or combinations of these groups.

As used throughout the present application, the term "arylene" refers to a divalent aryl substituent that bears two binding sites to other molecular structures, thereby serving as a linker structure. Along the same lines, the term "heteroarylene" refers to a divalent aryl substituent that bears two binding sites to other molecular structures, thereby serving as a linker structure.

In the context of the present invention, the term "fused" when referring to aromatic or heteroaromatic ring systems means that the aromatic or hetroaromatic rings that are "fused" share at least one bond that is part of both ring systems. For example naphthalene (or naphthyl when referred to as substituent) or benzothiophene (or benzothiphenyl when referred to as substituent) are considered fused aromatic ring systems in the context of the present invention, in which two benzene rings (for naphthalene) or a thiophene and a benzene (for benzothiophene) share one bond. It is also understood that

sharing a bond in this context includes sharing the two atoms that build up the respective bond and that fused aromatic or heteroaromatic ring systems can be understood as one aromatic or heteroaromatic ring system. Additionally, it is understood, that more than one bond may be shared by the aromatic or heteroaromatic rings building up a fused aromatic or heteroaromatic ring system (e.g. in pyrene). Furthermore, it will be understood that aliphatic ring systems may also be fused and that this has the same meaning as for aromatic or heteroaromatic ring systems, with the exception of course, that fused aliphatic ring systems are not aromatic. Furthermore, it is understood that an aromatic or heteroaromatic ring system may also be fused to (in other words: share at least one bond with) an aliphatic ring system.

In the context of the present invention, the term "condensed" ring system has the same meaning as "fused" ring system.

In certain embodiments of the invention, adjacent substituents bonded to a ring or a ring system may together form an additional mono- or polycyclic, aliphatic, aromatic or heteroaromatic ring system which is fused to the aromatic or heteroaromatic ring or ring system to which the substituents are bonded. It is understood that the optionally so formed fused ring system will be larger (meaning it comprises more ring atoms) than the aromatic or heteroaromatic ring or ring system to which the adjacent substituents are bonded. In these cases (and if such a number is provided), the "total" amount of ring atoms comprised in the fused ring system is to be understood as the sum of ring atoms comprised in the aromatic or heteroaromatic ring or ring system to which the adjacent substituents are bonded and the ring atoms of the additional ring system formed by the adjacent substituents, wherein, however, the ring atoms that are shared by fused rings are counted once and not twice. For example, a benzene ring may have two adjacent substituents that together form another benzene ring so that a naphthalene core is built. This naphthalene core then comprises 10 ring atoms as two carbon atoms are shared by the two benzene rings and are thus only counted once and not twice.

In general, in the context of the present invention, the terms "adjacent substituents" or "adjacent groups" refer to substituents or groups bonded to either the same or to neighboring atoms.

In the context of the present invention, the term "alkyl group" may be understood in the broadest sense as any linear, or branched alkyl substituent. Preferred examples of alkyl groups as substituents comprise methyl (Me), ethyl (Et), n-propyl ($^{n}$Pr), i-propyl ($^{i}$Pr), n-butyl ($^{n}$Bu), i-butyl ($^{i}$Bu), s-butyl ($^{s}$Bu), t-butyl ($^{t}$Bu), 2-methylbutyl, n-pentyl, s-pentyl, t-pentyl, 2-pentyl, neo-pentyl, n-hexyl, s-hexyl, t-hexyl, 2-hexyl, 3-hexyl, neo-hexyl, 2-methylpentyl, n-heptyl, 2-heptyl, 3-heptyl. 4-heptyl, n-octyl, 2-ethylhexyl, 2-(2,6-dimethyl)octyl, 3-(3,7-dimethyl)octyl, 1,1-dimethyl-n-hept-1-yl, 1,1-dimethyl-n-oct-1-yl, 1,1-dimethyl-n-dec-1-yl, 1,1-dimethyl-n-dodec-1-yl, 1,1-dimethyl-n-tetradec-1-yl, 1,1-dimethyl-n-hexadec-1-yl, 1,1-dimethyl-n-octadec-1-yl, 1,1-diethyl-n-hex-1-yl, 1,1-diethyl-n-hept-1-yl, 1,1-diethyl-n-oct-1-yl, 1,1-diethyl-n-dec-1-yl, 1,1-diethyl-n-dodec-1-yl, 1,1-diethyl-n-tetradec-1-yl, 1,1-diethyln-n-hexadec-1-yl, 1 1-diethyl-n-octadec-1-yl.

The "s" in for example s-butyl, s-pentyl and s-hexyl refers to "secondary"; or in other words: s-butyl, s-pentyl and s-hexyl are equal to sec-butyl, *sec*-pentyl and *sec*-hexyl, respectively. The "t" in for example t-butyl, t-pentyl and t-hexyl refers to "tertiary"; or in other words: t-butyl, t-pentyl and t-hexyl are equal to *tert*-butyl, *tert*-pentyl and *tert*-hexyl, respectively.

As used herein, the term "alkenyl" comprises linear, branched, and cyclic alkenyl substituents. The term alkenyl group exemplarily comprises the substituents ethenyl, propenyl, butenyl, pentenyl, cyclopentenyl, hexenyl, cyclohexenyl, heptenyl, cycloheptenyl, octenyl, cyclooctenyl or cyclooctadienyl.

As used herein, the term "alkynyl" comprises linear, branched, and cyclic alkynyl substituents. The term alkynyl group exemplarily comprises ethynyl, propynyl, butynyl, pentynyl, hexynyl, heptynyl or octynyl.

As used herein, the term "alkoxy" comprises linear, branched, and cyclic alkoxy substituents. The term alkoxy group exemplarily comprises methoxy, ethoxy, n-propoxy, i-propoxy, n-butoxy, i-butoxy, s-butoxy, t-butoxy and 2-methylbutoxy.

As used herein, the term "thioalkoxy" comprises linear, branched, and cyclic thioalkoxy substituents, in which the oxygen atom O of the corresponding alkoxy groups is replaced by sulfur, S.

As used herein, the terms "halogen" (or "halo" when referred to as substituent in chemical nomenclature) may be understood in the broadest sense as any atom of an element of the 7$^{th}$ main group (in other words: group 17) of the periodic table of elements, preferably fluorine, chlorine, bromine or iodine.

It is understood that when a molecular fragment is described as being a substituent or otherwise attached to another moiety, its name may be written as if it was a fragment (e.g. naphthyl, dibenzofuryl) or as if it was the intact group (e.g. naphthalene, dibenzofuran). As used herein, these different ways of designating a substituent or attached fragment are considered to be equivalent.

Furthermore, herein, whenever a substituent such as "$C_6$-$C_{60}$-aryl" or "$C_1$-$C_{40}$-alkyl" is referred to without the name indicating the binding site within that substituent, this is to mean that the respective substituent may bond via any atom. For example, a "$C_6$-$C_{60}$-aryl"-substituent may bond via any of the 6 to 60 aromatic carbon atoms and a "$C_1$-$C_{40}$-alkyl"-substituent may bond via any of the 1 to 40 aliphatic carbon atoms. On the other hand, a "2-cyanophenyl"-substituent can only be bonded in such a way that its CN-group is adjacent to the binding site as to allow for the chemical nomenclature to be correct.

In the context of the present invention, whenever a substituent such as "butyl", "biphenyl" or "terphenyl" is

referred to without further detail, this is to mean that any isomer of the respective substituent is allowable as the specific substituent. In this regard, for example the term "butyl" as substituent comprises n-butyl, s-butyl, t-butyl, and iso-butyl as substituents. Along the same lines, the term "biphenyl" as substituent comprises *ortho*-biphenyl, *meta*-biphenyl, or *para*-biphenyl, wherein ortho, meta and para are defined with regard to the binding site of the biphenyl substituent to the respective chemical moiety that bears the biphenyl substituent. Similarly, the term "terphenyl" as substituent comprises 3-*ortho*-terphenyl, 4-*ortho*-terphenyl, 4-*meta*-terphenyl, 5-*meta*-terphenyl, 2-*para*-terphenyl or 3-*para*-terphenyl, wherein, as known to the skilled artisan, *ortho, meta* and *para* indicate the position of the two Ph-moieties within the terphenyl-group to each other and "2-", "3-", "4-" and "5-" denotes the binding site of the terphenyl substituent to the respective chemical moiety that bears the terphenyl substituent.

It is understood that all groups defined above and indeed all chemical moieties, regardless of whether they are cyclic or non-cyclic, aliphatic, aromatic or heteroaromatic, may be further substituted in accordance with the specific embodiments described herein.

All hydrogen atoms (H) comprised in any structure referred to herein may at each occurrence independently and, be replaced by deuterium (D) without this being indicated specifically. The replacement of hydrogen by deuterium is common practice for the person skilled in the art. Thus, there are numerous known methods by which this can be achieved and several review articles describing them.

If experimental or calculated data are compared, the values have to be determined by the same methodology. For example, if an experimental $\Delta E_{ST}$ is determined to be below 0.4 eV by a specific method, a comparison is only valid using the same specific method including the same conditions. To give a specific example, the comparison of the photoluminescence quantum yield (PLQY) of different compounds is only valid if the determination of the PLQY value was performed under the same reaction conditions (measurement in a 10% PMMA film at room temperature). Similarly, calculated energy values need to be determined by the same calculation method (using the same functional and the same basis set).

*An optoelectronic device comprising at least one organic molecule according to the invention*

A further aspect of the invention relates to an optoelectronic device comprising at least one organic molecule according to the present invention.

In one embodiment, the optoelectronic device comprising at least one organic molecule according to the present invention is selected from the group consisting of:

- organic light-emitting diodes (OLEDs),
- light-emitting electrochemical cells,
- OLED sensors, especially in gas and vapor sensors not hermetically externally shielded,
- organic diodes,
- organic solar cells,
- organic transistors,
- organic field-effect transistors,
- organic lasers and
- down-conversion elements.

A light-emitting electrochemical cell consists of three layers, namely a cathode, an anode, and an active layer, which may contain the organic molecule according to the invention.

In a preferred embodiment, the optoelectronic device comprising at least one organic molecule according to the present invention is selected from the group consisting of an organic light emitting diode (OLED), a light emitting electrochemical cell (LEC), an organic laser, and a light-emitting transistor.

In an even more preferred embodiment, the optoelectronic device comprising at least one organic molecule according to the present invention is an organic light-emitting diode (OLED).

In one embodiment, the optoelectronic device comprising at least one organic molecule according to the present invention is an OLED that may exhibit the following layer structure:

1. substrate
2. anode layer A
3. hole injection layer, HIL
4. hole transport layer, HTL
5. electron blocking layer, EBL
6. light-emitting layer (also referred to as emission layer), EML
7. hole blocking layer, HBL

8. electron transport layer, ETL
9. electron injection layer, EIL
10. cathode layer C,

wherein the OLED comprises each layer, except for an anode layer A, a cathode layer C, and an EML, only optionally, and wherein different layers may be merged and the OLED may comprise more than one layer of each layer type defined above.

Furthermore, the optoelectronic device comprising at least one organic molecule according to the present invention may optionally comprise one or more protective layers protecting the device from damaging exposure to harmful species in the environment including, exemplarily moisture, vapor and/or gases.

In one embodiment, the optoelectronic device comprising at least one organic molecule according to the present invention is an OLED, that may exhibit the following (inverted) layer structure:

1. substrate
2. cathode layer C
3. electron injection layer, EIL
4. electron transport layer, ETL
5. hole blocking layer, HBL
6. light-emitting layer (also referred to as emission layer), EML
7. electron blocking layer, EBL
8. hole transport layer, HTL
9. hole injection layer, HIL
10. anode layer A

wherein the OLED (with an inverted layer structure) comprises each layer, except for an anode layer A, a cathode layer C, and an EML, only optionally, and wherein different layers may be merged and the OLED may comprise more than one layer of each layer types defined above.

The organic molecules according to the invention (in accordance with the embodiments indicated above) can be employed in various layers, depending on the precise structure and on the substitution. In the case of the use, the fraction of the organic molecule according to the invention in the respective layer in an optoelectronic device, more particularly in an OLED, is 0.1% to 99% by weight, more particularly 1% to 80% by weight. In an alternative embodiment, the proportion of the organic molecule in the respective layer is 100% by weight.

In one embodiment, of the optoelectronic device comprising at least one organic molecule according to the present invention is an OLED which may exhibit stacked architecture. In this architecture, contrary to the typical arrangement, where the OLEDs are placed side by side, the individual units are stacked on top of each other. Blended light may be generated with OLEDs exhibiting a stacked architecture, in particular white light may be generated by stacking blue, green and red OLEDs. Furthermore, the OLED exhibiting a stacked architecture may optionally comprise a charge generation layer (CGL), which is typically located between two OLED subunits and typically consists of a n-doped and p-doped layer with the n-doped layer of one CGL being typically located closer to the anode layer.

In one embodiment, the optoelectronic device comprising at least one organic molecule according to the present invention is an OLED, which comprises two or more emission layers between anode and cathode. In particular, this so-called tandem OLED comprises three emission layers, wherein one emission layer emits red light, one emission layer emits green light and one emission layer emits blue light, and optionally may comprise further layers such as charge generation layers, blocking or transporting layers between the individual emission layers. In a further embodiment, the emission layers are adjacently stacked. In a further embodiment, the tandem OLED comprises a charge generation layer between each two emission layers. In addition, adjacent emission layers or emission layers separated by a charge generation layer may be merged.

In one embodiment, the optoelectronic device comprising at least one organic molecule according to the present invention may be an essentially white optoelectronic device, which is to say that the device emits white light. Exemplarily, such a white light-emitting optoelectronic device may comprise at least one (deep) blue emitter molecule and one or more emitter molecules emitting green and/or red light. Then, there may also optionally be energy transmittance between two or more molecules as described in a later section of this text (vide infra).

In the case of the optoelectronic device comprising at least one organic molecule according to the present invention, it is preferred that the at least one organic molecule according to the present invention is comprised in a light-emitting layer (EML) of the optoelectronic device, most preferably in an EML of an OLED. However, the organic molecules according to the invention may for example also be employed in an electron transport layer (ETL) and/or in an electron blocking layer (EBL) or exciton-blocking layer and/or in a hole transport layer (HTL) and/or in a hole blocking layer (HBL). In the case of the use, the fraction of the organic molecule according to the invention in the respective layer in an

optoelectronic device, more particularly in an OLED, is 0.1 % to 99 % by weight, more particularly 0.5 % to 80 % by weight, in particular 0.5 % to 10 % by weight. In an alternative embodiment, the proportion of the organic molecule in the respective layer is 100 % by weight.

The selection criteria for suitable materials for the individual layers of optoelectronic devices, in particular OLEDs, are common knowledge of those skilled in the art. The state of the art describes plenty of materials to be used in the individual layers and also teaches which materials are suitable to be used alongside each other. It is understood that any materials used in the state of the art may also be used in optoelectronic devices comprising the organic molecule according to the present invention. In the following, preferred examples of materials for the individual layers will be given. It is understood that this does not imply that all types of layers listed below must be present in an optoelectronic device comprising at least one organic molecule according to the present invention. Additionally, it is understood that an optoelectronic device comprising at least one organic molecule according to the present invention may include more than one of each of the layers listed in the following, for example two or more light-emitting layers (EMLs). It is also understood that two or more layers of the same type (e.g. two or more EMLs or two or more HTLs) do not necessarily comprise the same materials or even the same materials in the same ratios. Furthermore, it is understood that an optoelectronic device comprising at least one organic molecule according to the present invention does not have to comprise all the layer types listed in the following, wherein an anode layer, a cathode layer, and a light-emitting layer will usually be present in all cases.

The substrate may be formed by any material or composition of materials. Most frequently, glass slides are used as substrates. Alternatively, thin metal layers (e.g., copper, gold, silver or aluminum films) or plastic films or slides may be used. This may allow a higher degree of flexibility. The anode layer A is mostly composed of materials allowing to obtain an (essentially) transparent film. As at least one of both electrodes should be (essentially) transparent in order to allow light emission from the OLED, either the anode layer A or the cathode layer C is usually transparent. Preferably, the anode layer A comprises a large content or even consists of transparent conductive oxides (TCOs). Such an anode layer A may, for example, comprise indium tin oxide, aluminum zinc oxide, fluorine doped tin oxide, indium zinc oxide, PbO, SnO, zirconium oxide, molybdenum oxide, vanadium oxide, wolfram oxide, graphite, doped Si, doped Ge, doped GaAs, doped polyaniline, doped polypyrrol and/or doped polythiophene.

Preferably, an anode layer A (essentially) consists of indium tin oxide (ITO) (e.g., $(InO_3)_{0.9}(SnO_2)_{0.1}$). The roughness of an anode layer A caused by the transparent conductive oxides (TCOs) may be compensated by using a hole injection layer (HIL). Further, a HIL may facilitate the injection of quasi charge carriers (i.e., holes) in that the transport of the quasi charge carriers from the TCO to the hole transport layer (HTL) is facilitated. A hole injection layer (HIL) may comprise poly-3,4-ethylendioxy thiophene (PEDOT), polystyrene sulfonate (PSS), $MoO_2$, $V_2O_5$, CuPC or CuI, in particular a mixture of PEDOT and PSS. A hole injection layer (HIL) may also prevent the diffusion of metals from an anode layer A into a hole transport layer (HTL). A HIL may for example comprise PEDOT:PSS (poly-3,4-ethylendioxy thiophene: polystyrene sulfonate), PEDOT (poly-3,4-ethylendioxy thiophene), mMTDATA (4,4',4"-tris[phenyl(m-tolyl)amino]triphenylamine), Spiro-TAD (2,2',7,7'-tetrakis(n,n-diphenylamino)-9,9'-spirobifluorene), DNTPD (N1,N1'-(biphenyl-4,4'-diyl)bis(N1-phenyl-N4,N4-di-m-tolylbenzene-1,4-diamine), NPB (N,N'-bis-(1-naphthalenyl)-N,N'-bis-phenyl-(1,1'-biphenyl)-4,4'-diamine), NPNPB (N,N'-diphenyl-N,N'-di-[4-(N,N-diphenyl-amino)phenyl]benzidine), MeO-TPD (N,N,N',N'-tetrakis(4-methoxyphenyl)benzidine), HAT-CN (1,4,5,8,9,11-hexaazatriphenylen-hexacarbonitrile) and/or Spiro-NPD (N,N'-diphenyl-N,N'-bis-(1-naphthyl)-9,9'-spirobifluorene-2,7-diamine).

Adjacent to an anode layer A or a hole injection layer (HIL), a hole transport layer (HTL) is typically located. Herein, any hole transport material may be used. Exemplarily, electron-rich heteroaromatic compounds such as triarylamines and/or carbazoles may be used as hole transport compound. A HTL may decrease the energy barrier between an anode layer A and a light-emitting layer EML. A hole transport layer (HTL) may also be an electron blocking layer (EBL). Preferably, hole transport compounds bear comparably high energy levels of their lowermost excited triplet states T1. Exemplarily, a hole transport layer (HTL) may comprise a star-shaped heterocyclic compound such as tris(4-carbazoyl-9-ylphenyl)amine (TCTA), poly-TPD (poly(4-butylphenyl-diphenyl-amine)), [alpha]-NPD (poly(4-butylphenyl-diphenyl-amine)), TAPC (4,4'-cyclohexyliden-bis[N,N-bis(4-methylphenyl)benzenamine]), 2-TNATA (4,4',4"-tris[2-naphthyl(phenyl)amino]triphenylamine), Spiro-TAD (2,2',7,7'-tetrakis(n,n-diphenylamino)-9,9'-spirobifluorene), DNTPD (N1,N1'-(biphenyl-4,4'-diyl)bis(N 1-phenyl-N4,N4-di-m-tolylbenzene-1,4-diamine), NPB (N,N'-bis-(1-naphthalenyl)-N,N'-bis-phenyl-(1,1'-biphenyl)-4,4'-diamine)), NPNPB (N,N'-diphenyl-N,N'-di-[4-(N,N-diphenyl-amino)phenyl]benzidine), MeO-TPD (N,N,N',N'-tetrakis(4-methoxyphenyl)benzidine), HAT-CN (1,4,5,8,9,11-hexaazatriphenylen-hexacarbonitrile) and/or TrisPcz (9,9'-diphenyl-6-(9-phenyl-9H-carbazol-3-yl)-9H,9'H-3,3'-bicarbazole). In addition, a HTL may comprise a p-doped layer, which may be composed of an inorganic or organic dopant in an organic hole-transporting matrix. Transition metal oxides such as vanadium oxide, molybdenum oxide or tungsten oxide may be used as inorganic dopant. Tetrafluorotetracyanoquinodimethane (F4-TCNQ), copper-pentafluorobenzoate (Cu(I)pFBz) or transition metal complexes may be used as organic dopant.

An EBL may for example comprise mCP (1,3-bis(carbazol-9-yl)benzene), TCTA (tris(4-carbazoyl-9-ylphenyl) amine), 2-TNATA (4,4',4"-tris[2-naphthyl(phenyl)amino]triphenylamine), mCBP (3,3-di(9H-carbazol-9-yl)biphenyl), tris-Pcz (9-Phenyl-3,6-bis(9-phenyl-9Hcarbazol-3-yl)-9H-carbazole), CzSi (9-(4-tert-Butylphenyl)-3,6-bis(triphenylsilyl)-9H-carbazole), and/or DCB (N,N'-dicarbazolyl-1,4-dimethylbenzene).

Adjacent to a hole transport layer (HTL) or (if present) an electron blocking layer (EBL), typically, a light-emitting layer (EML) is located. A light-emitting layer (EML) comprises at least one light-emitting molecule (i.e. emitter material). Typically, an EML additionally comprises one or more host materials (also referred to as matrix materials). Exemplarily, the host material may be selected from CBP (4,4'-Bis-(N-carbazolyl)-biphenyl), mCP (1,3-bis(carbazol-9-yl)benzene), mCBP (3,3-di(9H-carbazol-9-yl)biphenyl), Sif87 (dibenzo[b,d]thiophen-2-yltriphenylsilane), CzSi (9-(4-tert-Butylphenyl)-3,6-bis(triphenylsilyl)-9H-carbazole), Sif88 (dibenzo[b,d]thiophen-2-yl)diphenylsilane), DPEPO (bis[2-(diphenylphosphino) phenyl] ether oxide), 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole, 9-[3,5-bis(2-dibenzothiophenyl)phenyl]-9H-carbazole, T2T (2,4,6-tris(biphenyl-3-yl)-1,3,5-triazine), T3T (2,4,6-tris(triphenyl-3-yl)-1,3,5-triazine) and/or TST (2,4,6-tris(9,9'-spirobifluorene-2-yl)-1,3,5-triazine). As known to the person skilled in the art, a host material typically should be selected to exhibit first (i.e. lowermost) excited triplet state (T1) and first (i.e. lowermost) excited singlet (S1) energy levels, which are energetically higher than the first (i.e. lowermost) excited triplet state (T1) and first (i.e. lowermost) excited singlet state (S1) energy levels of the at least one light-emitting molecule that is embedded in the respective host material(s).

As stated previously, it is preferred that at least one EML of the optoelectronic device in the context of the invention comprises at least one molecule according to the present invention. The preferred compositions of an EML of an optoelectronic device comprising at least one organic molecule according to the present invention are described in more detail in a later section of this text (vide infra).

Adjacent to a light-emitting layer (EML), an electron transport layer (ETL) may be located. Herein, any electron transport material may be used. Exemplarily, compounds bearing electron-deficient groups, such as for example benzimidazoles, pyridines, triazoles, triazines, oxadiazoles (e.g., 1,3,4-oxadiazole), phosphinoxides and sulfones, may be used. An electron transport material may also be a star-shaped heterocyclic compound such as 1,3,5-tri(1-phenyl-1H-benzo[d]imidazol-2-yl)phenyl (TPBi). An ETL may for example comprise NBphen (2,9-bis(naphthalen-2-yl)-4,7-diphenyl-1,10-phenanthroline), Alq3 (Aluminum-tris(8-hydroxyquinoline)), TSPO1 (diphenyl-4-triphenylsilylphenyl-phosphinoxide), BPyTP2 (2,7-di(2,2'-bipyridin-5-yl)triphenyle), Sif87 (dibenzo[b, d]thiophen-2-yltriphenylsilane), Sif88 (dibenzo[b,d]thiophen-2-yl)diphenylsilane), BmPyPhB (1,3-bis[3,5-di(pyridin-3-yl)phenyl]benzene) and/or BTB (4,4'-bis-[2-(4,6-diphenyl-1,3,5-triazinyl)]-1,1'-biphenyl). Optionally, an ETL may be doped with materials such as Liq ((8-hydroxyquinolinato)lithium). An electron transport layer (ETL) may also block holes or a hole blocking layer (HBL) is introduced, typically between an EML and an ETL.

A hole blocking layer (HBL) may for example comprise BCP (2,9-dimethyl-4,7-diphenyl-1,10-phenanthroline = bathocuproine), 4,6-diphenyl-2-(3-(triphenylsilyl)phenyl)-1,3,5-triazine, 9,9'-(5-(6-([1,1'-biphenyl]-3-yl)-2-phenylpyrimidin-4-yl)-1,3-phenylene)bis(9H-carbazole), BAlq (bis(8-hydroxy-2-methylquinoline)-(4-phenylphenoxy)aluminum), NBphen (2,9-bis(naphthalen-2-yl)-4,7-diphenyl-1,10-phenanthroline), Alq3 (aluminum-tris(8-hydroxyquinoline)), TSPO1 (diphenyl-4-triphenylsilylphenyl-phosphinoxide), T2T (2,4,6-tris(biphenyl-3-yl)-1,3,5-triazine), T3T (2,4,6-tris(triphenyl-3-yl)-1,3,5-triazine), TST (2,4,6-tris(9,9'-spirobifluorene-2-yl)-1,3,5-triazine), and/or TCB/TCP (1,3,5-tris(N-carbazolyl)benzol/ 1,3,5-tris(carbazol)-9-yl) benzene).

A cathode layer C may be located adjacent to the electron transport layer (ETL). For example, the cathode layer C may comprise or may consist of a metal (e.g., Al, Au, Ag, Pt, Cu, Zn, Ni, Fe, Pb, LiF, Ca, Ba, Mg, In, W, or Pd) or a metal alloy. For practical reasons, the cathode layer may consist of (essentially) non-transparent metals such as Mg, Ca or Al. Alternatively or additionally, the cathode layer C may also comprise graphite and/or carbon nanotubes (CNTs). Alternatively, the cathode layer C may also comprise or consist of nanoscalic silver wires.

An OLED comprising at least one organic molecule according to the present invention may further, optionally comprise a protection layer between an electron transport layer (ETL) and a cathode layer C (which may be designated as electron injection layer (EIL)). This layer may comprise lithium fluoride, cesium fluoride, silver, Liq ((8-hydroxyquinolinato) lithium), $Li_2O$, $BaF_2$, MgO and/or NaF.

Optionally, an electron transport layer (ETL) and/or a hole blocking layer (HBL) may also comprise one or more host materials.

As used herein, if not defined more specifically in the particular context, the designation of the colors of emitted and/or absorbed light is as follows:

| | |
|---|---|
| violet: | wavelength range of >380-420 nm; |
| deep blue: | wavelength range of >420-480 nm; |
| sky blue: | wavelength range of >480-500 nm; |
| green: | wavelength range of >500-560 nm; |
| yellow: | wavelength range of >560-580 nm; |

(continued)

| | |
|---|---|
| orange: | wavelength range of >580-620 nm; |
| red: | wavelength range of >620-800 nm. |

With respect to light-emitting molecules (in other words: emitter materials), such colors refer to the emission maximum of the main emission peak. Therefore, exemplarily, a deep blue emitter has an emission maximum in the range of from >420 to 480 nm, a sky-blue emitter has an emission maximum in the range of from >480 to 500 nm, a green emitter has an emission maximum in a range of from >500 to 560 nm, and a red emitter has an emission maximum in a range of from >620 to 800 nm.

A deep blue emitter may preferably have an emission maximum of below 475 nm, more preferably below 470 nm, even more preferably below 465 nm or even below 460 nm. It will typically be above 420 nm, preferably above 430 nm, more preferably above 440 nm or even above 450 nm. In a preferred embodiment, the organic molecules according to the present invention exhibit emission maxima between 420 and 500 nm, more preferably between 430 and 490 nm, even more preferably between 440 and 480 nm, and most preferably between 450 and 470 nm, typically measured at room temperature (i.e. (approximately) 20°C) from a spin-coated film with 1-5 %, preferably 2 % by weight of the organic molecule according to the invention in poly(methyl methacrylate), PMMA, mCBP or alternatively in an organic solvent, preferably DCM or toluene, with 0.001 mg/mL of organic molecule according to the invention.

A further embodiment relates to an OLED comprising at least one organic molecule according to the present invention and emitting light with CIEx and CIEy color coordinates close to the CIEx (= 0.131) and CIEy (= 0.046) color coordinates of the primary color blue (CIEx = 0.131 and CIEy = 0.046) as defined by the ITU-R Recommendation BT.2020 (Rec. 2020) and thus is suited for the use in Ultra High Definition (UHD) displays, e.g. UHD-TVs. Accordingly, a further aspect of the present invention relates to an OLED comprising at least one organic molecule according to the present invention, whose emission exhibits a CIEx color coordinate of between 0.02 and 0.30, preferably between 0.03 and 0.25, more preferably between 0.05 and 0.20 or even more preferably between 0.08 and 0.18 or even between 0.10 and 0.15 and/ or a CIEy color coordinate of between 0.00 and 0.45, preferably between 0.01 and 0.30, more preferably between 0.02 and 0.20 or even more preferably between 0.03 and 0.15 or even between 0.04 and 0.10.

A further embodiment relates to an OLED comprising at least one organic molecule according to the present invention and exhibiting an external quantum efficiency at 1000 cd/$m^2$ of more than 8%, more preferably of more than 10%, more preferably of more than 13%, even more preferably of more than 15% or even more than 20% and/or exhibits an emission maximum 420 and 500 nm, more preferably between 430 and 490 nm, even more preferably between 440 and 480 nm, and most preferably between 450 and 470 nm or still and/or exhibits an LT80 value at 500 cd/$m^2$ of more than 100 h, preferably more than 200 h, more preferably more than 400 h, even more preferably more than 750 h or even more than 1000 h.

A green emitter material may preferably have an emission maximum between 500 and 560 nm, more preferably between 510 and 550 nm, and even more preferably between 520 and 540 nm.

A further preferred embodiment relates to an OLED comprising at least one organic molecule according to the present invention and emitting light at a distinct color point. Preferably, the OLED emits light with a narrow emission band (a small full width at half maximum (FWHM)). In a preferred embodiment, the OLED comprising at least one organic molecule according to the invention emits light with an FWHM of the main emission peak of less than 0.30 eV, preferably less than 25 eV, more preferably less than 0.20 eV, even more preferably less than 0.1 eV, or even less than 0.17 eV.

In accordance with the invention, the optoelectronic devices comprising at least one organic molecule according to the present invention can for example be employed in displays, as light sources in lighting applications and as light sources in medical and/or cosmetic applications (for example light therapy).

*Combination of the organic molecules according to the invention with further materials*

It forms part of the common knowledge of those skilled in the art that any layer within an optoelectronic device (herein preferably an OLED), and in particular the light-emitting layer (EML), may be composed of a single material or a combination of different materials.

For example, the person skilled in the art understands that an EML may be composed of a single material that is capable of emitting light when a voltage (and electrical current) is applied to said device. However, the skilled artisan also understands that it may be beneficial to combine different materials in an EML of an optoelectronic device (herein preferably an OLED), in particular one or more host material(s) (in other words: matrix material(s); herein designated host material(s) $H^B$ when comprised in an optoelectronic device that comprises at least one organic molecule according to the invention) and one or more dopant materials out of which at least one is emissive (i.e. an emitter material) when applying a voltage and electrical current to the device.

In a preferred embodiment of the use of an organic molecule according to the invention in an optoelectronic

device, said optoelectronic device comprises at least one organic molecule according to the invention in an EML or in a layer that is directly adjacent to an EML or in more than one of these layers.

In a preferred embodiment of the use of an organic molecule according to the invention in an optoelectronic device, said optoelectronic device is an OLED and comprises at least one organic molecule according to the invention in an EML or in a layer that is directly adjacent to an EML or in more than one of these layers.

In an even more preferred embodiment of the use of an organic molecule according to the invention in an optoelectronic device, said optoelectronic device is an OLED and comprises at least one organic molecule according to the invention in an EML.

In one embodiment relating to the optoelectronic device, preferably the OLED, comprising at least one organic molecule according to the invention, the at least one, preferably each, organic molecule according to the invention is used as emitter material in a light-emitting layer EML, which is to say that it emits light when a voltage (and electrical current) is applied to said device.

As known to the person skilled in the art, light emission from emitter materials (i.e. emissive dopants), for example in organic light-emitting diodes (OLEDs), may comprise fluorescence from excited singlet states (typically the lowermost excited singlet state S1) and phosphorescence from excited triplet states (typically the lowermost excited triplet state T1).

A fluorescence emitter F is capable of emitting light at room temperature (i.e. (approximately) 20 °C) upon electronic excitation (for example in an optoelectronic device), wherein the emissive excited state is a singlet state. Fluorescence emitters usually display prompt (i.e. direct) fluorescence on a timescale of nanoseconds, when the initial electronic excitation (for example by electron hole recombination) affords an excited singlet state of the emitter.

In the context of the invention, a delayed fluorescence material is a material that is capable of reaching an excited singlet state (typically the lowermost excited singlet state S1) by means of reverse intersystem crossing (RISC; in other words: up intersystem crossing or inverse intersystem crossing) from an excited triplet state (typically from the lowermost excited triplet state T1) and that is furthermore capable of emitting light when returning from the so-reached excited singlet state (typically S1) to its electronic ground state. The fluorescence emission observed after RISC from an excited triplet state (typically T1) to the emissive excited singlet state (typically S1) occurs on a timescale (typically in the range of microseconds) that is slower than the timescale on which direct (i.e. prompt) fluorescence occurs (typically in the range of nanoseconds) and is thus referred to as delayed fluorescence (DF). When RISC from an excited triplet state (typically from T1) to an excited singlet state (typically to S1), occurs through thermal activation, and if the so populated excited singlet state emits light (delayed fluorescence emission), the process is referred to as thermally activated delayed fluorescence (TADF). Accordingly, a TADF material is a material that is capable of emitting thermally activated delayed fluorescence (TADF) as explained above. It is known to the person skilled in the art that, when the energy difference $\Delta E_{ST}$ between the lowermost excited singlet state energy level $E(S1^E)$ and the lowermost excited triplet state energy level $E(T1^E)$ of a fluorescence emitter F is reduced, population of the lowermost excited singlet state from the lowermost excited triplet state by means of RISC may occur with high efficiency. Thus, it forms part of the common knowledge of those skilled in the art that a TADF material will typically have a small $\Delta E_{ST}$ value (vide infra). As known to the person skilled in the art, a TADF material may not just be a material that is on its own capable of RISC from an excited triplet state to an excited singlet state with subsequent emission of TADF as laid out above. It is known to those skilled in the art that a TADF material may in fact also be an exciplex that is formed from two kinds of materials, preferably from two host materials $H^B$, more preferably from a p-host material $H^P$ and an n-host material $H^N$ (vide infra).

The occurrence of (thermally activated) delayed fluorescence may for example be analyzed based on the decay curve obtained from time-resolved (i.e. transient) photoluminescence (PL) measurements. For this purpose, a spin-coated film of the respective emitter (i.e. the assumed TADF material) in poly(methyl methacrylate) (PMMA) with 1-10% by weight, in particular 10% by weight of the respective emitter may be used as sample. The analysis may for example be performed using an FS5 fluorescence spectrometer from Edinburgh instruments. The sample PMMA film may be placed in a cuvette and kept under nitrogen atmosphere during the measurement. Data acquisition may be performed using the well-established technique of time correlated single photon counting (TCSPC, vide infra). To gather the full decay dynamics over several orders of magnitude in time and signal intensity, measurements in four time windows (200 ns, 1 μs, and 20 μs, and a longer measurement spanning > 80 μs) may be carried out and combined (vide infra).

TADF materials preferably fulfill the following two conditions regarding the aforementioned full decay dynamics:

(i) the decay dynamics exhibit two time regimes, one in the nanosecond (ns) range and the other in the microsecond (μs) range; and
(ii) the shapes of the emission spectra in both time regimes coincide;

wherein, the fraction of light emitted in the first decay regime is taken as prompt fluorescence and the fraction emitted in the second decay regime is taken as delayed fluorescence.

The ratio of delayed and prompt fluorescence may be expressed in form of a so-called n-value that may be calculated by the integration of respective photoluminescence decays in time according to the following equation:

$$\frac{\int I_{DF}(t)dt}{\int I_{PF}(t)dt} = n$$

In the context of the present invention, a TADF material preferably exhibits an n-value (ratio of delayed to prompt fluorescence) larger than 0.05 ($n > 0.05$), more preferably larger than 0.1 ($n > 0.1$), even more preferably larger than 0.15 ($n > 0.15$), particularly preferably larger than 0.2 ($n > 0.20$), or even larger than 0.25 ($n > 0.25$).

In a preferred embodiment, the organic molecules according to the invention exhibit an n-value (ratio of delayed to prompt fluorescence) larger than 0.05 ($n > 0.05$).

In the context of the present invention, a TADF material $E^B$ is characterized by exhibiting a $\Delta E_{ST}$ value, which corresponds to the energy difference between the lowermost excited singlet state energy level $E(S1^E)$ and the lowermost excited triplet state energy level $E(T1^E)$, of less than 0.4 eV, preferably of less than 0.3 eV, more preferably of less than 0.2 eV, even more preferably of less than 0.1 eV, or even of less than 0.05 eV. The means of determining the $\Delta E_{ST}$ value of TADF materials $E^B$ are laid out in a later subchapter of this text.

One approach for the design of TADF materials in general is to covalently attach one or more (electron) donor moieties on which the HOMO is distributed and one or more (electron) acceptor moieties on which the LUMO is distributed to the same bridge, herein referred to as linker group. A TADF material $E^B$ may for example also comprise two or three linker groups which are bonded to the same acceptor moiety and additional donor and acceptor moieties may be bonded to each of these two or three linker groups.

One or more donor moieties and one or more acceptor moieties may also be bonded directly to each other (without the presence of a linker group).

Typical donor moieties are derivatives of diphenyl amine, indole, carbazole, acridine, phenoxazine, and related structures. In particular, aliphatic, aromatic or heteroaromatic ring systems may be fused to the aforementioned donor motifs to arrive at for example indolocarbazoles.

Benzene-, biphenyl-, and to some extend also terphenyl-derivatives are common linker groups.

Nitrile groups are common acceptor moieties in TADF materials and known examples thereof include:

(i) carbazolyl dicyanobenzene compounds
such as 2CzPN (4,5-di(9*H*-carbazol-9-yl)phthalonitrile), DCzIPN (4,6-di(9*H*-carbazol-9-yl)isophthalonitrile), 4CzPN (3,4,5,6-tetra(9*H*-carbazol-9-yl)phthalonitrile), 4CzIPN (2,4,5,6-Tetra(9*H*-carbazol-9-yl)isophthalonitrile), 4CzTPN (2,4,5,6-tetra(9*H*-carbazol-9-yl)terephthalonitrile), and derivatives thereof;

(ii) carbazolyl cyanopyridine compounds
such as 4CzCNPy (2,3,5,6-tetra(9*H*-carbazol-9-yl)-4-cyanopyridine) and derivatives thereof;

(iii) carbazolyl cyanobiphenyl compounds
such as CNBPCz (4,4',5,5'-tetra(9*H*-carbazol-9-yl)-[1,1'-biphenyl]-2,2'-dicarbonitrile), CzBPCN (4,4',6,6'-tetra(9*H*-carbazol-9-yl)-[1,1'-biphenyl]-3,3'-dicarbonitrile), DDCzIPN (3,3',5,5'-tetra(9*H*-carbazol-9-yl)-[1,1'-biphenyl]-2,2',6,6'-tetracarbonitrile) and derivatives thereof;

wherein in these materials, one or more of the nitrile groups may be replaced my fluorine (F) or trifluoromethyl ($CF_3$) as acceptor moieties.

Nitrogen-heterocycles such as triazine-, pyrimidine-, triazole-, oxadiazole-, thiadiazole-, heptazine-, 1,4-diazatriphenylene-, benzothiazole-, benzoxazole-, quinoxaline-, and diazafluorene-derivatives are also well-known acceptor moieties used for the construction of TADF molecules. Known examples of TADF molecules comprising for example a triazine acceptor include PIC-TRZ (7,7'-(6-([1,1'-biphenyl]-4-yl)-1,3,5-triazine-2,4-diyl)bis(5-phenyl-5,7-dihydroindolo[2,3-b]carbazole)), *m*BFCzTrz (5-(3-(4,6-diphenyl-1,3,5-triazin-2-yl)phenyl)-5*H*-benzofuro[3,2-c]carbazole), and DCzTrz (9,9'-(5-(4,6-diphenyl-1,3,5-triazin-2-yl)-1,3-phenylene)bis(9H-carbazole)).

Another group of TADF materials comprises diaryl ketones such as benzophenone or (heteroaryl)aryl ketones such as 4-benzoylpyridine, 9,10-anthraquinone, 9H-xanthen-9-one, and derivatives thereof as acceptor moieties to which the donor moieties (usually carbazolyl substituents) are bonded. Examples of such TADF molecules include BPBCz (bis(4-(9'-phenyl-9*H*,9'*H*-[3,3'-bicarbazol]-9-yl)phenyl)methanone), mDCBP ((3,5-di(9*H*-carbazol-9-yl)phenyl)(pyridin-4-yl)methanone), AQ-DTBu-Cz (2,6-bis(4-(3,6-di-tert-butyl-9*H*-carbazol-9-yl)phenyl)anthracene-9,10-dione), and MCz-XT (3-(1,3,6,8-tetramethyl-9*H*-carbazol-9-yl)-9*H*-xanthen-9-one), respectively.

Sulfoxides, in particular diphenyl sulfoxides, are also commonly used as acceptor moieties for the construction of TADF materials and known examples include 4-PC-DPS (9-phenyl-3-(4-(phenylsulfonyl)phenyl)-9*H*-carbazole), DitBu-DPS (9,9'-(sulfonylbis(4,1-phenylene))bis(9H-carbazole)), and TXO-PhCz (2-(9-phenyl-9*H*-carbazol-3-yl)-9*H*-thioxanthen-9-one 10,10-dioxide).

It is understood that a fluorescence emitter F may also display TADF as defined herein and even be a TADF material $E^B$ as defined herein. In consequence, a small FWHM emitter $S^B$ as defined herein may or may not also be a TADF material $E^B$ as defined herein.

Phosphorescence, i.e. light emission from excited triplet states (typically from the lowermost excited triplet state T1) is a spin-forbidden process. As known to the person skilled in the art, phosphorescence may be facilitated (enhanced) by exploiting the (intramolecular) spin-orbit interaction (so called (internal) heavy atom effect). A phosphorescence material $P^B$ in the context of the invention is a phosphorescence emitter capable of emitting phosphorescence at room temperature (i.e. at approximately 20 °C).

Herein, it is preferred that a phosphorescence material $P^B$ comprises at least one atom of an element having a standard atomic weight larger than the standard atomic weight of calcium (Ca). Even more preferably, a phosphorescence material $P^B$ in the context of the invention comprises a transition metal atom, in particular a transition metal atom of an element having a standard atomic weight larger than the standard atomic weight of zinc (Zn). The transition metal atom preferably comprised in the phosphorescence material $P^B$ may be present in any oxidation state (and may also be present as ion of the respective element).

It is common knowledge to those skilled in the art that phosphorescence materials $P^B$ used in optoelectronic devices are oftentimes complexes of Ir, Pd, Pt, Au, Os, Eu, Ru, Re, Ag and Cu, in the context of this invention preferably of Ir, Pt, and Pd, more preferably of Ir and Pt. The skilled artisan knows which materials are suitable as phosphorescence materials $P^B$ in optoelectronic devices and how to synthesize them. Furthermore, the skilled artisan is familiar with the design principles of phosphorescent complexes for use as phosphorescence materials in optoelectronic devices and knows how to tune the emission of the complexes by means of structural variations.

The skilled artisan knows which materials are suitable as phosphorescence materials $P^B$ to be used in optoelectronic devices and how to synthesize them. In this regard, the skilled artisan is in particular familiar with the design principles of phosphorescent complexes for use as phosphorescence materials $P^B$ in optoelectronic devices and knows how to tune the emission of the complexes by means of structural variations.

Examples of phosphorescence materials $P^B$ that may be used alongside the organic molecules according to the present invention (for example in form of a composition or in an EML of an optoelectronic device, vide infra) are disclosed in the state of the art. For example, the following metal complexes are phosphorescence materials $P^B$ that may be used alongside the organic molecules according to the present invention:

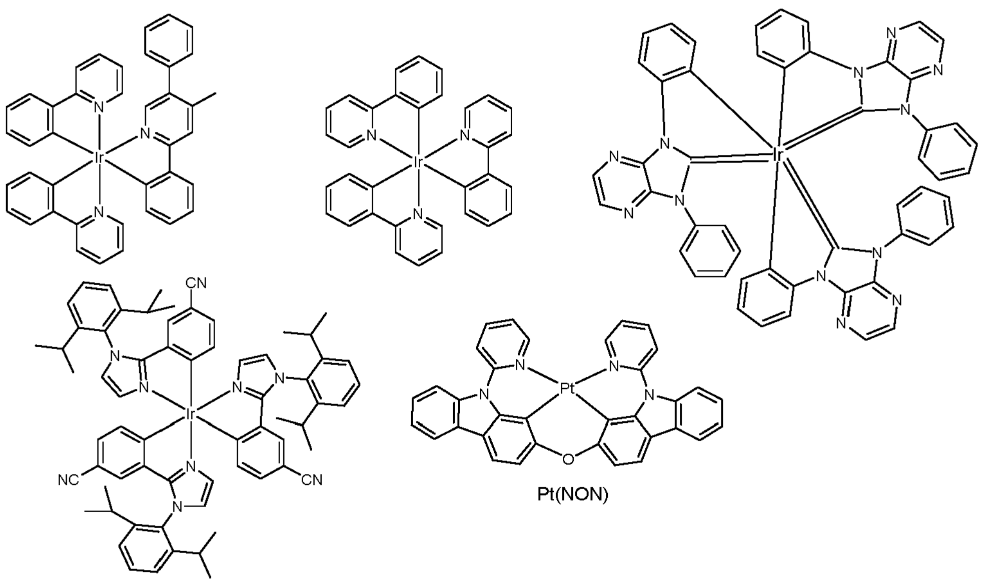

Pt(NON)

A small full width at half maximum (FWHM) emitter $S^B$ in the context of the invention is any emitter (i.e. emitter material) that has an emission spectrum, which exhibits an FWHM of less than or equal to 0.35 eV (≤ 0.35 eV), preferably of less than or equal to 0.30 eV (≤ 0.30 eV), in particular of less than or equal to 0.25 eV (≤ 0.25 eV). Unless stated otherwise, this is judged based on an emission spectrum of the respective emitter at room temperature (i.e., (approximately) 20 °C), typically measured with 1 to 5% by weight, in particular with 2% by weight, of the emitter in poly(methyl methacrylate) PMMA or mCBP. Alternatively, emission spectra of small FWHM emitters $S^B$ may be measured in a solution, typically with 0.001-0.2 mg/mL of the emitter $S^B$ in dichloromethane or toluene at room temperature (i.e., (approximately) 20 °C).

A small FWHM emitter $S^B$ may be a fluorescence emitter F, a phosphorescence emitter (for example a phosphorescence material $P^B$) and/or a TADF emitter (for example a TADF material $E^B$). For TADF materials $E^B$ and

for phosphorescence materials $P^B$ as laid out above, the emission spectrum is recorded at room temperature (i.e. approximately 20°C) from a spin-coated film of the respective material in poly(methyl methacrylate) PMMA, with 10% by weight of the respective molecule of the invention, $E^B$ or $P^B$.

As known to the person skilled in the art, the full width at half maximum (FWHM) of an emitter (for example a small FWHM emitter $S^B$) is readily determined from the respective emission spectrum (fluorescence spectrum for fluorescence emitters and phosphorescence spectrum for phosphorescence emitters). All reported FWHM values typically refer to the main emission peak (i.e. the peak with the highest intensity). The means of determining the FWHM (herein preferably reported in electron volts, eV) are part of the common knowledge of those skilled in the art. Given for example that the main emission peak of an emission spectrum reaches its half maximum emission (i.e. 50% of the maximum emission intensity) at the two wavelengths $\lambda_1$ and $\lambda_2$, both obtained in nanometers (nm) from the emission spectrum, the FWHM in electron volts (eV) is commonly (and herein) determined using the following equation:

$$\text{FWHM [eV]} = \left| \frac{1239.84\,[eV \cdot nm]}{\lambda_2\,[nm]} - \frac{1239.84[eV \cdot nm]}{\lambda_1\,[nm]} \right|$$

In the context of the invention, a small FWHM emitter $S^B$ is an organic emitter, which, in the context of the invention, means that it does not contain any transition metals. Preferably, a small FWHM emitter $S^B$ in the context of the invention predominantly consists of the elements hydrogen (H), carbon (C), nitrogen (N), and boron (B), but may for example also comprise oxygen (O), silicon (Si), fluorine (F), and bromine (Br).

Furthermore, it is preferred that a small FWHM emitter $S^B$ in the context of the invention is a fluorescence emitter F that may or may not additionally exhibit TADF.

Preferably, a small FWHM emitter $S^B$ in the context of the invention preferably fulfills at least one of the following requirements:

(i) it is a boron (B)-containing emitter, which means that at least one atom within the respective small FWHM emitter $S^B$ is boron (B);
(ii) it comprises a polycyclic aromatic or heteroaromatic core structure, wherein at least two aromatic rings are fused together (e.g. anthracene, pyrene or aza-derivatives thereof).

As known to person skilled in the art, a host material $H^B$ of an EML may transport electrons or positive charges through said EML and may also transfer excitation energy to the at least one emitter material doped in the host material(s) $H^B$. The skilled artisan understands that a host material $H^B$ comprised in an EML of an optoelectronic device (e.g. an OLED) is typically not significantly involved in light emission from said device upon applying a voltage and electrical current. The person skilled in the art is also familiar with the fact that any host material $H^B$ may be a p-host $H^P$ exhibiting high hole mobility, an n-host $H^N$ exhibiting high electron mobility, or a bipolar host material $H^{BP}$ exhibiting both, high hole mobility and high electron mobility.

As known to person skilled in the art, an EML may also comprise a so-called mixed-host system with at least one p-host $H^P$ and one n-host $H^N$. In particular, the EML may comprise exactly one emitter material according to the invention and a mixed-host system comprising T2T (2,4,6-tris(biphenyl-3-yl)-1,3,5-triazine) as n-host $H^N$ and a host selected from CBP, mCP, mCBP, 4,6-diphenyl-2-(3-(triphenylsilyl)phenyl)-1,3,5-triazine, 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole and 9-[3,5-bis(2-dibenzothiophenyl)phenyl]-9H-carbazole as p-host $H^P$.

An EML may comprise a so-called mixed-host system with at least one p-host $H^P$ and one n-host $H^N$; wherein the n-host $H^N$ comprises groups derived from pyridine, pyrimidine, benzopyrimidine, 1,3,5-triazine, 1,2,4-triazine, and 1,2,3-triazine, while the p-host $H^P$ comprises groups derived from indole, isoindole, and preferably carbazole.

The person skilled in the art knows which materials are suitable host materials for use in optoelectronic devices. It is understood that any host materials that are used in the state of the art may be suitable host materials $H^B$ in the context of the invention.

Examples of materials $H^B$ that are p-host materials $H^P$ in the context of the invention are listed below:

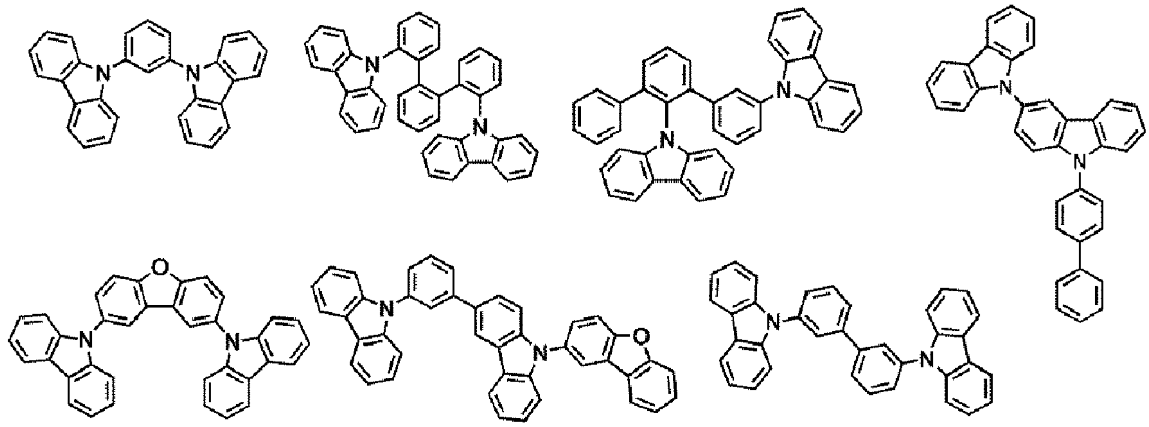

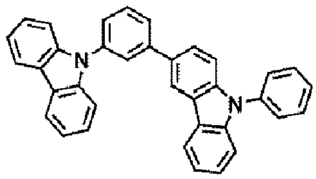

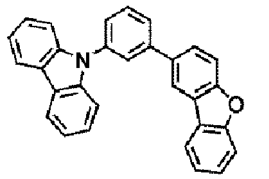

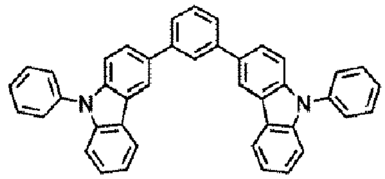

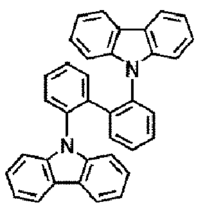

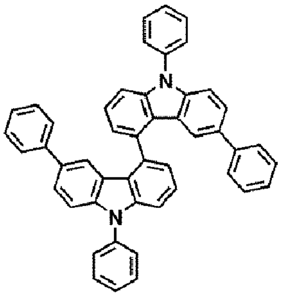

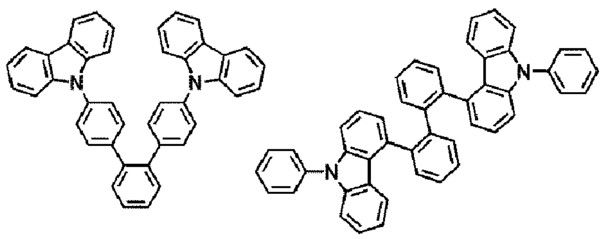

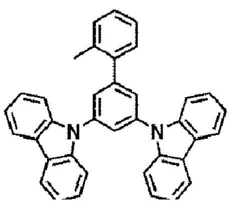

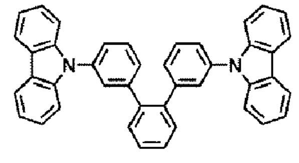

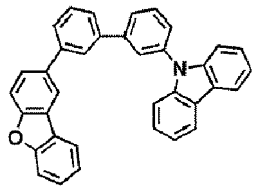

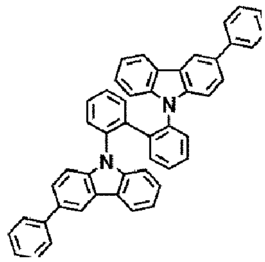

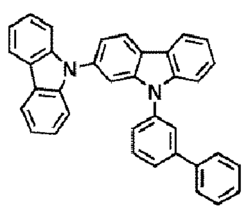

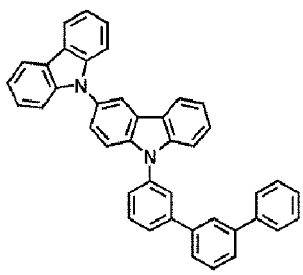

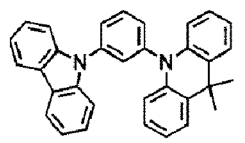

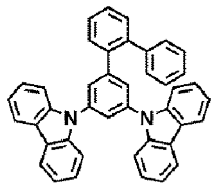

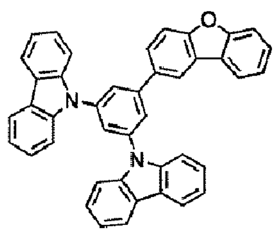
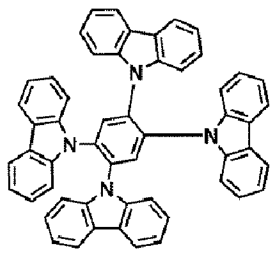
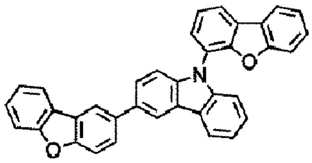
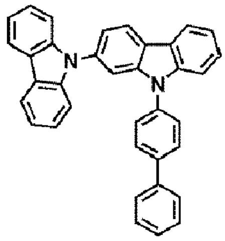

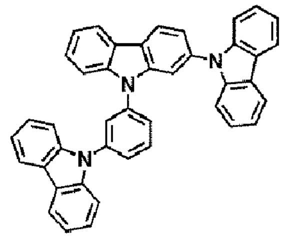
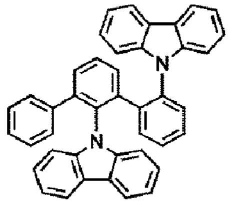
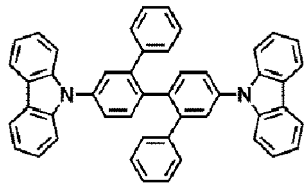
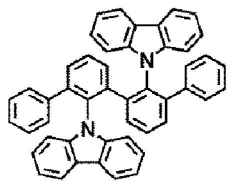

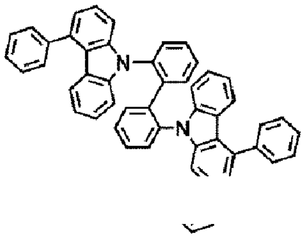
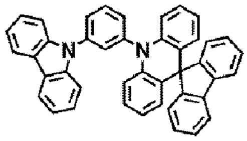
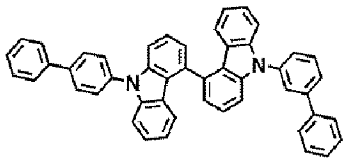

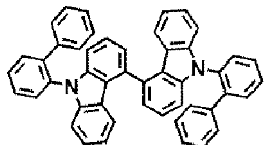
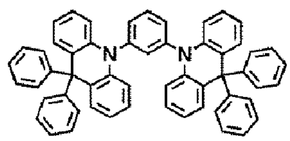
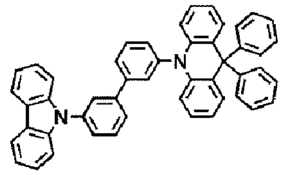

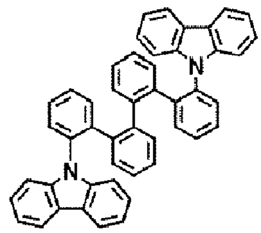
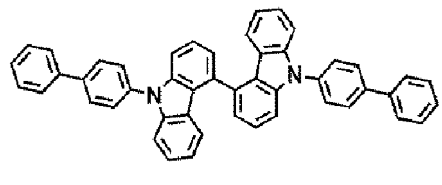
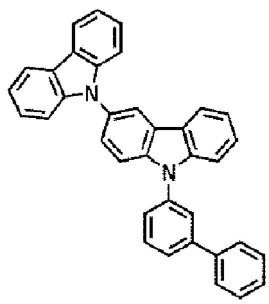

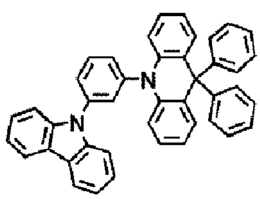
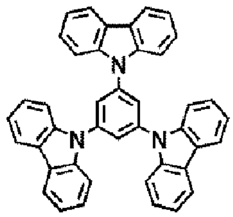
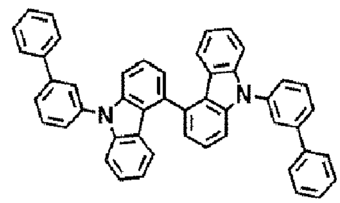

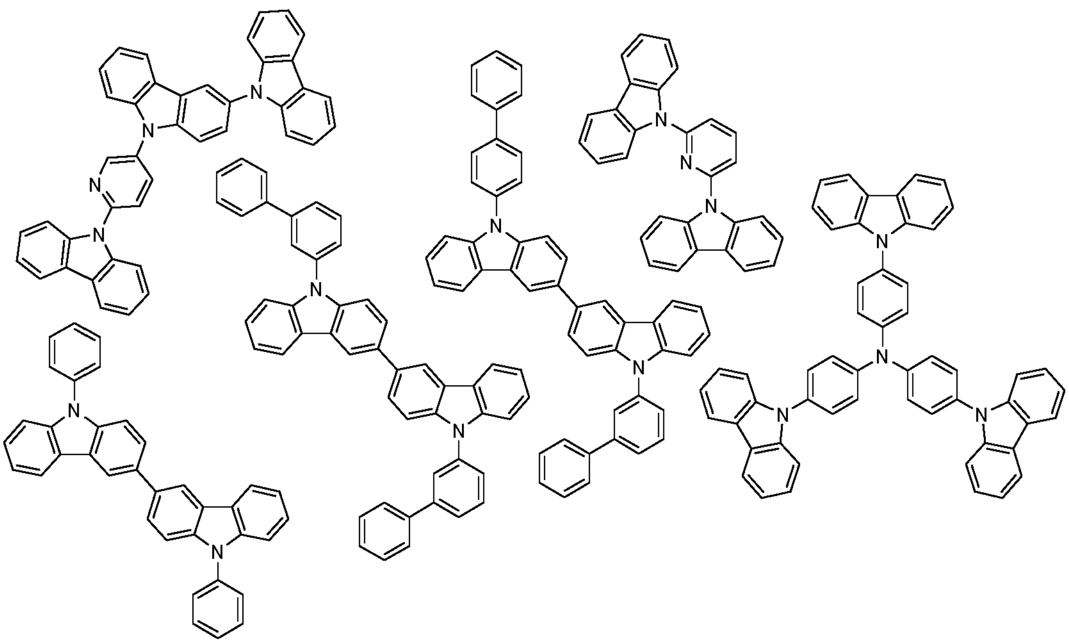

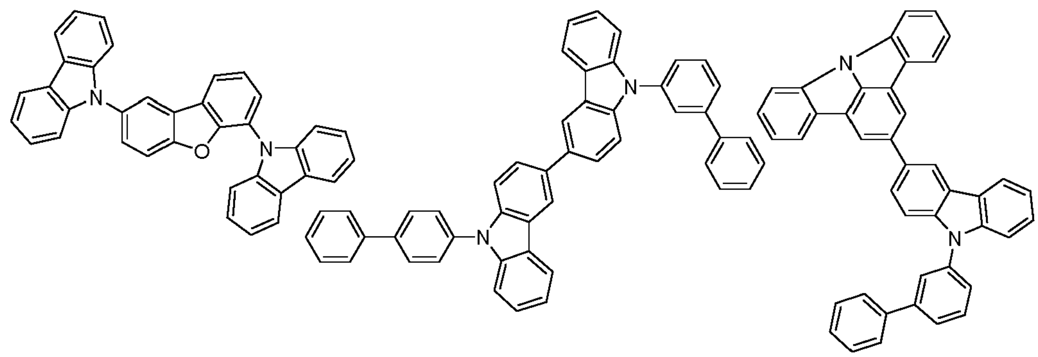

Examples of materials $H^B$ that are n-host materials $H^N$ in the context of the invention are listed below:

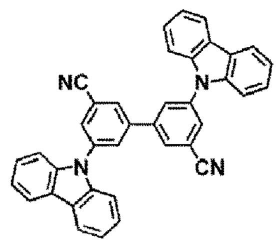

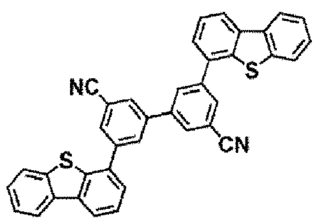

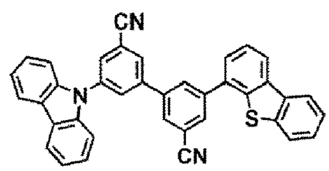

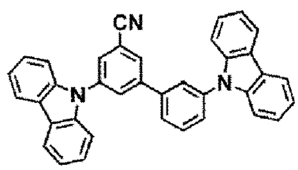

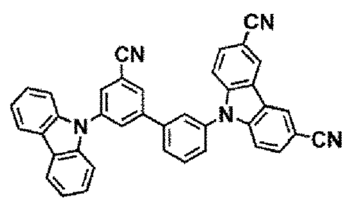

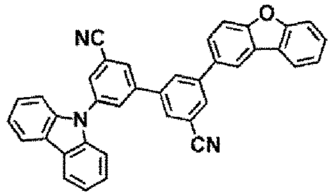

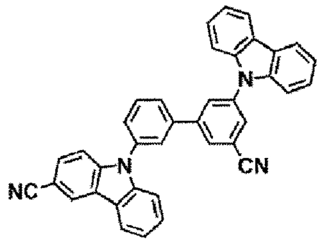

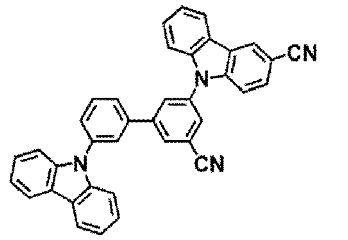

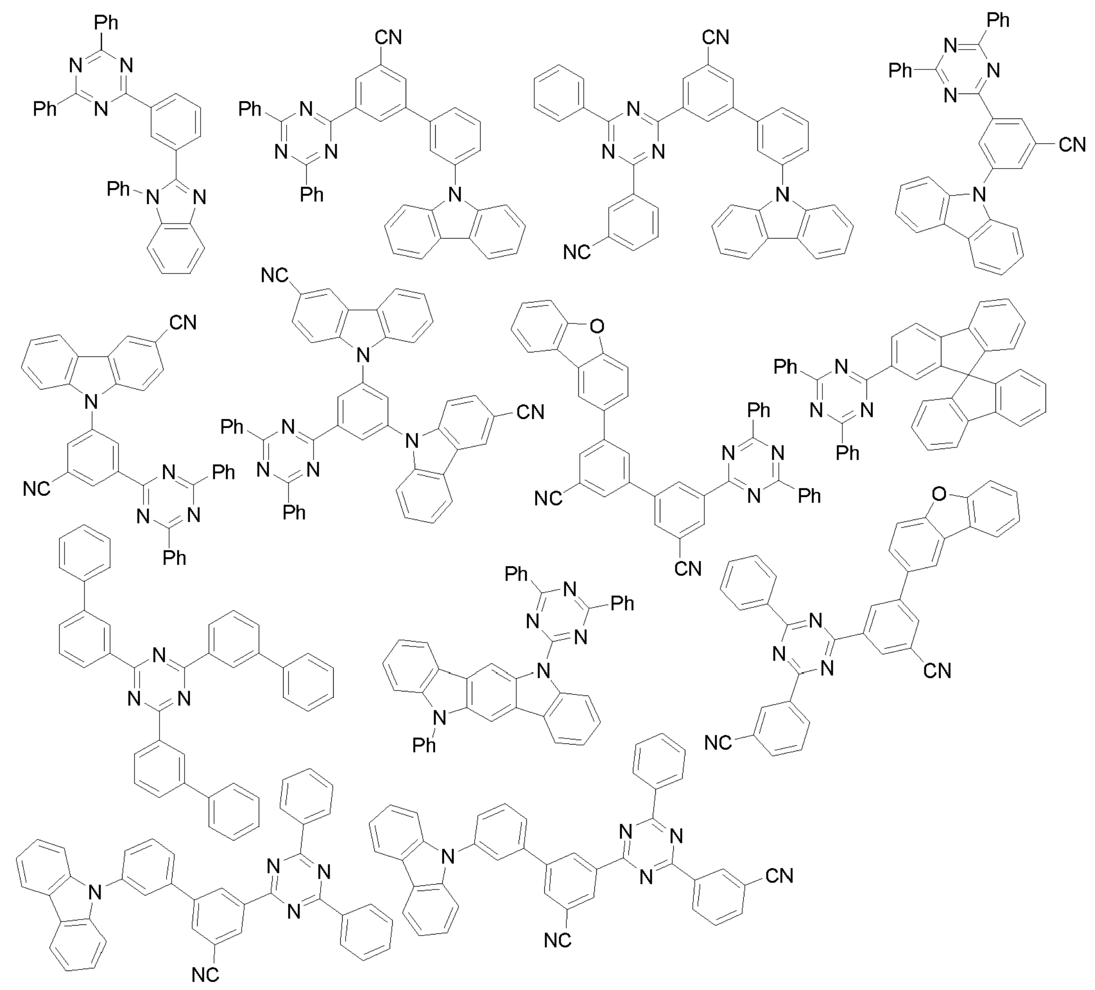

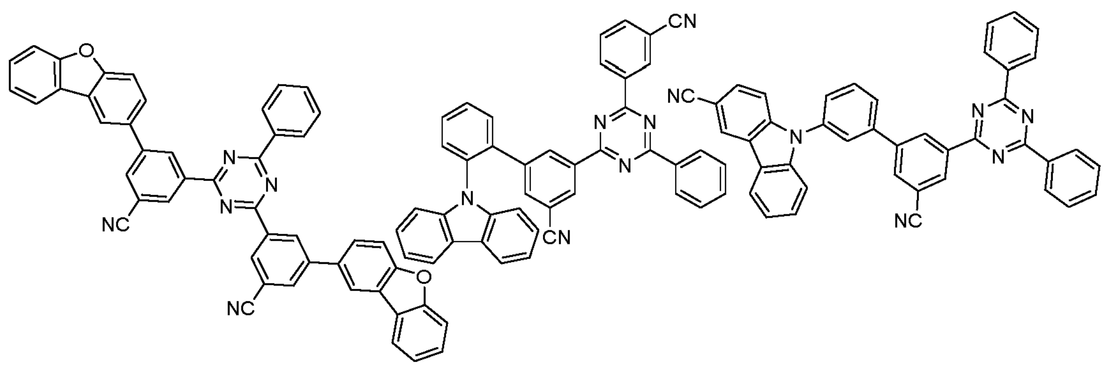

The person skilled in the art understands that any materials that are comprised in the same layer, in particular in the same EML, but also materials that are in adjacent layers and get in close proximity at the interface between these adjacent layers, may together form an exciplex. The person skilled in the art knows how to choose pairs of materials, in

particular pairs of a p-host $H^P$ and an n-host $H^N$, which form an exciplex and the selection criteria for the two components of said pair of materials, including HOMO- and/or LUMO-energy level requirements. This is to say that, in case exciplex formation may be aspired, the highest occupied molecular orbital (HOMO) of the one component, e.g. the p-host material $H^P$, may be at least 0.20 eV higher in energy than the HOMO of the other component, e.g. the n-host material $H^N$, and the lowest unoccupied molecular orbital (LUMO) of the one component, e.g. the p-host material $H^P$, may be at least 0.20 eV higher in energy than the LUMO of the other component, e.g. the n-host material $H^N$. It belongs to the common knowledge of those skilled in the art that, if present in an EML of an optoelectronic device, in particular an OLED, an exciplex may have the function of an emitter material and emit light when a voltage and electrical current are applied to said device. As also commonly known from the state of the art, an exciplex may also be non-emissive and may for example transfer excitation energy to an emitter material, if comprised in an EML of an optoelectronic device.

As known to person skilled in the art, triplet-triplet annihilation (TTA) materials can be used as host materials $H^B$. The TTA material enables triplet-triplet annihilation. Triplet-triplet annihilation may preferably result in a photon up-conversion. Accordingly, two, three or even more photons may facilitate photon up-conversion from the lowermost excited triplet state ($T1^{TTA}$) to the first excited singlet state $S1^{TTA}$ of the TTA material $H^{TTA}$. In a preferred embodiment, two photons facilitate photon up-conversion from $T1^{TTA}$ to $S1^{TTA}$. Triplet-triplet annihilation may thus be a process that through a number of energy transfer steps, may combine two (or optionally more than two) low frequency photons into one photon of higher frequency.

Optionally, the TTA material may comprise an absorbing moiety, the sensitizer moiety, and an emitting moiety (or annihilator moiety). In this context, an emitter moiety may, for example, be a polycyclic aromatic moiety such as, benzene, biphenyl, triphenyl, triphenylene, naphthalene, anthracene, phenalene, phenanthrene, fluorene, pyrene, chrysene, perylene, azulene. In a preferred embodiment, the polycyclic aromatic moiety comprises an anthracene moiety or a derivative thereof. A sensitizer moiety and an emitting moiety may be located in two different chemical compounds (i.e., separated chemical entities) or may be both moieties embraced by one chemical compound.

According to the invention, a triplet-triplet annihilation (TTA) material converts energy from first excited triplet states $T1^N$ to first excited singlet states $S1^N$ by triplet-triplet annihilation.

According to the present invention, a TTA material is characterized in that it exhibits triplet-triplet annihilation from the lowermost excited triplet state ($T1^N$) resulting in a triplet-triplet annihilated first excited singlet state $S1^N$, having an energy of up to two times the energy of $T1^N$.

In one embodiment of the present invention, a TTA material is characterized in that it exhibits triplet-triplet annihilation from $T1^N$ resulting in $S1^N$, having an energy of 1.01 to 2fold, 1.1 to 1.9fold, 1.2 to 1.5fold, 1.4 to 1.6fold, or 1.5 to 2fold times the energy of $T1^N$.

As used herein, the terms "TTA material" and "TTA compound" may be understood interchangeably.

Typical "TTA material" can be found in the state of the art related to blue fluorescent OLEDs, as described by Kondakov (Philosophical Transactions of the Royal Society A: Mathematical, Physical and Engineering Sciences, 2015, 373:20140321). Such blue fluorescent OLEDs employ aromatic hydrocarbons such as anthracene derivatives as the main component (host) in the EML.

In a preferred embodiment, the TTA material enables sensitized triplet-triplet annihilation. Optionally, the TTA material may comprise one or more polycyclic aromatic structures. In a preferred embodiment, the TTA material comprises at least one polycyclic aromatic structure and at least one further aromatic residue.

In a preferred embodiment, the TTA material bears larger singlet-triplet energy splitting, i.e., an energy difference between its first excited singlet state $S1^N$ and its lowermost excited triplet state $T1^N$ of at least 1.1fold, at least 1.2fold, at least 1.3fold, at least 1.5fold and preferably not more than 2fold.

In a preferred embodiment of the invention, the TTA material $H^{TTA}$ is an anthracene derivative.

In one embodiment, the TTA material $H^{TTA}$ is an anthracene derivate of the following formula 4

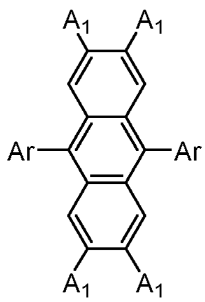

Formula 4,

wherein

each Ar is independently from each other selected from the group consisting of $C_6$-$C_{60}$-aryl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl;

and $C_3$-$C_{57}$-heteroaryl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl; and

each $A_1$ is independently from each other selected from the group consisting of consisting of hydrogen; deuterium;

$C_6$-$C_{60}$-aryl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl; $C_3$-$C_{57}$-heteroaryl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl; and

$C_1$-$C_{40}$-(hetero)alkyl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl.

In one embodiment, the TTA material $H^{TTA}$ is an anthracene derivate of the following formula 4, wherein

each Ar is independently from each other selected from the group consisting of $C_6$-$C_{20}$-aryl, which is optionally substituted with one or more residues selected from the group consisting of $C_6$-$C_{20}$-aryl, $C_3$-$C_{20}$-heteroaryl, halogen, and $C_1$-$C_{210}$-(hetero)alkyl;

and $C_3$-$C_{20}$-heteroaryl, which is optionally substituted with one or more residues selected from the group consisting of $C_6$-$C_{20}$-aryl, $C_3$-$C_{20}$-heteroaryl, halogen, and $C_1$-$C_{10}$-(hetero)alkyl; and

each $A_1$ is independently from each other selected from the group consisting of consisting of hydrogen, deuterium,

$C_6$-$C_{20}$-aryl, which is optionally substituted with one or more residues selected from the group consisting of $C_6$-$C_{20}$-aryl, $C_3$-$C_{20}$-heteroaryl, halogen, and $C_1$-$C_{10}$-(hetero)alkyl,

$C_3$-$C_{20}$-heteroaryl, which is optionally substituted with one or more residues selected from the group consisting of $C_6$-$C_{20}$-aryl, $C_3$-$C_{20}$-heteroaryl, halogen, and $C_1$-$C_{10}$-(hetero)alkyl; and

$C_1$-$C_{10}$-(hetero)alkyl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl.

In one embodiment, $H^{TTA}$ is an anthracene derivate of the following formula 4, wherein at least one of $A_1$ is hydrogen. In one embodiment, $H^{TTA}$ is an anthracene derivate of the following formula (4), wherein at least two of $A_1$ are hydrogen. In one embodiment, $H^{TTA}$ is an anthracene derivate of the following formula (4), wherein at least three of $A_1$ are hydrogen. In one embodiment, $H^{TTA}$ is an anthracene derivate of the following formula (4), wherein all of $A_1$ are each hydrogen.

In one embodiment, $H^{TTA}$ is an anthracene derivate of the following formula (4), wherein one of Ar is a residue selected from the group consisting of phenyl, naphthyl, phenanthryl, pyrenyl, triphenylenyl, dibenzoanthracenyl, fluorenyl, benzofluorenyl, anthracenyl, phenanthrenyl, benzonaphtofuranyl, benzonaphtothiopehnyl, dibenzofuranyl, dibenzothiopehnyl,

which may be each optionally substituted with one or more residues selected from the group consisting of $C_6$-$C_{60}$-aryl, $C_3$-$C_{57}$-heteroaryl, halogen, and $C_1$-$C_{40}$-(hetero)alkyl.

In one embodiment, $H^{TTA}$ is an anthracene derivate of the following formula (4), wherein both Ar are residues each independently from each other selected from the group consisting of phenyl, naphthyl, phenanthryl, pyrenyl, triphenylenyl, dibenzoanthracenyl, fluorenyl, benzofluorenyl, anthracenyl, phenanthrenyl, benzonaphtofuranyl, benzonaphtothiopehnyl, dibenzofuranyl, dibenzothiopehnyl,

which may be each optionally substituted with one or more residues selected from the group consisting of $C_6$-$C_{60}$-aryl, $C_3$-$C_{57}$-heteroaryl, halogen, and $C_1$-$C_{40}$-(hetero)alkyl.

In one embodiment, the TTA material $H^{TTA}$ is an anthracene derivate selected from the following:

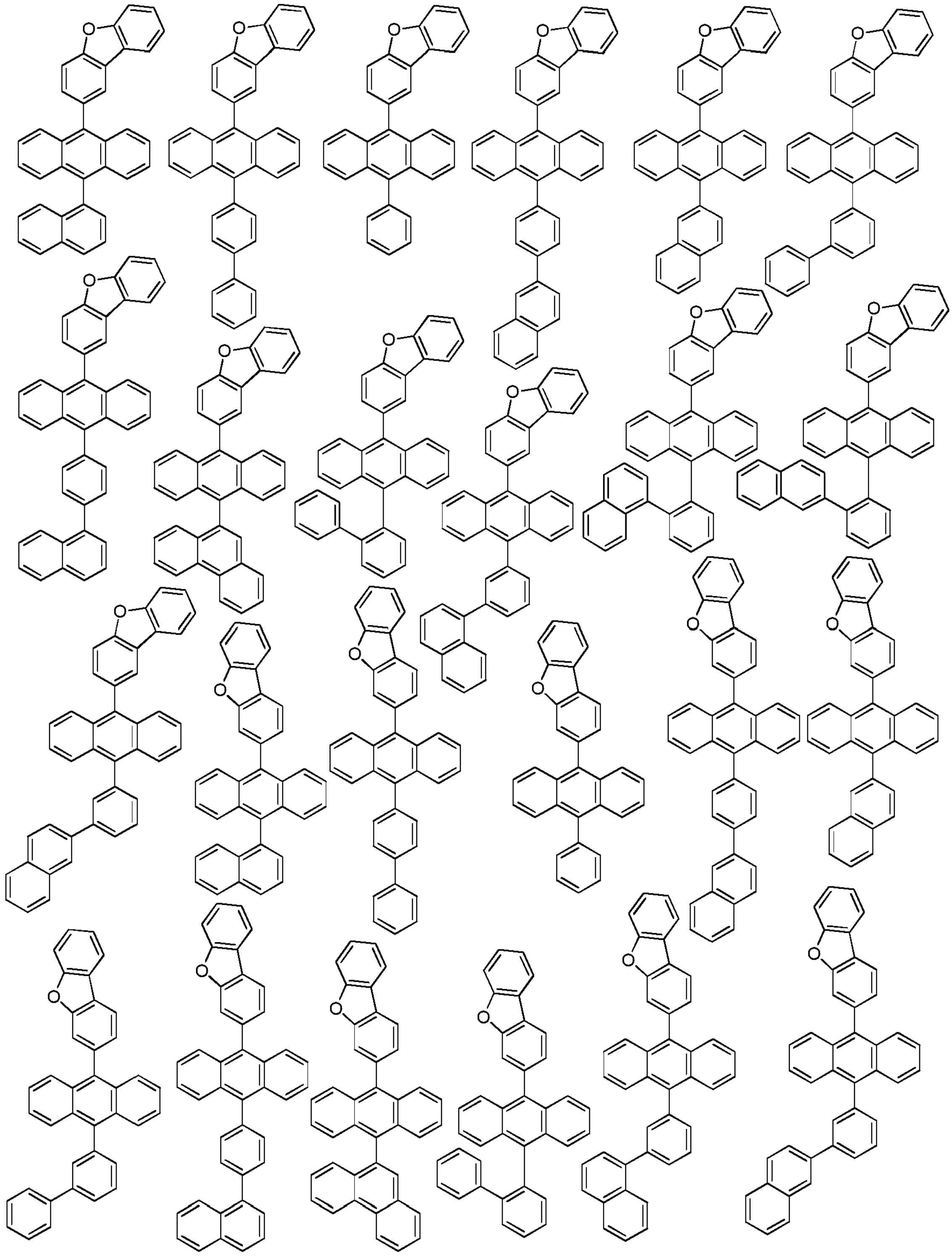

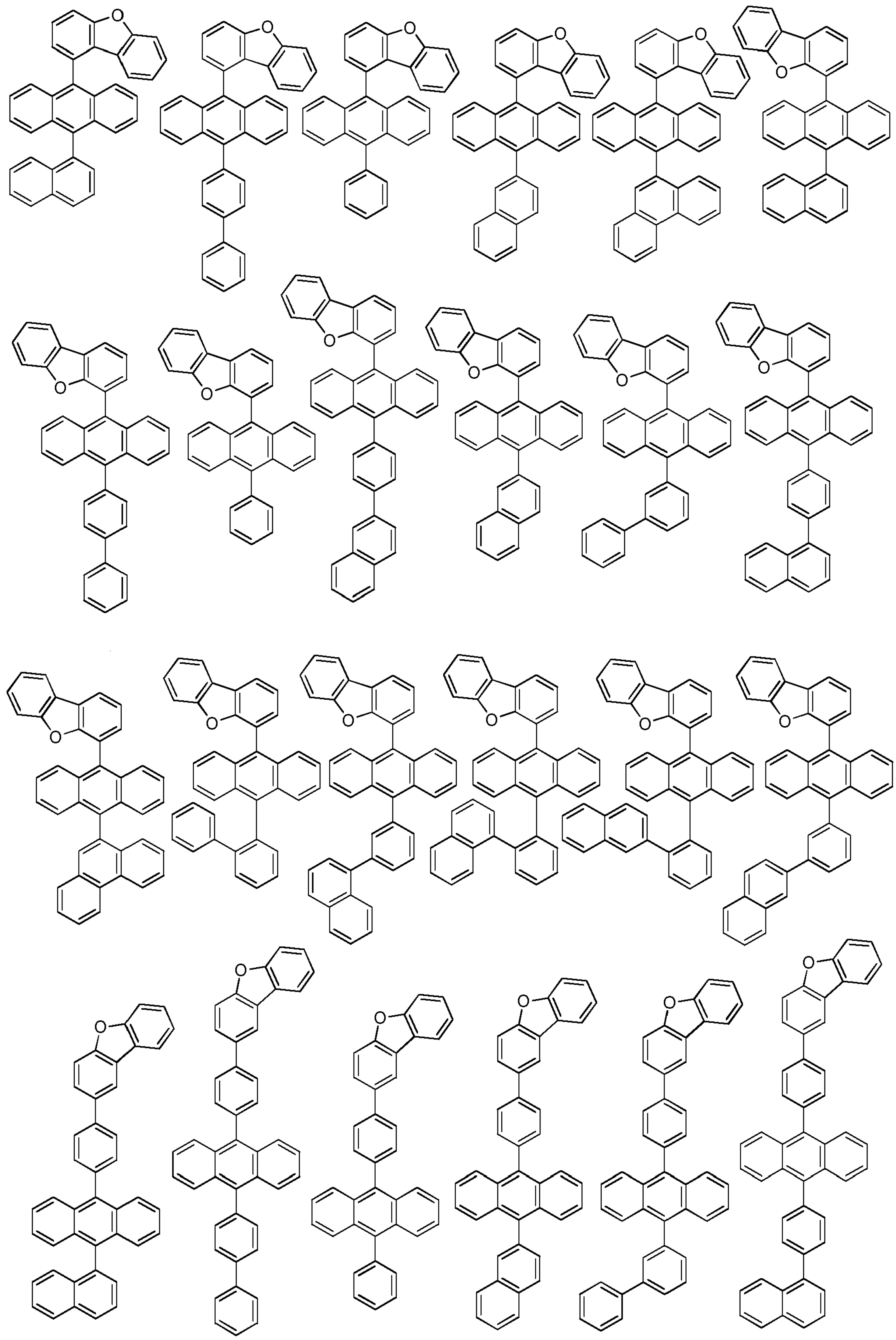

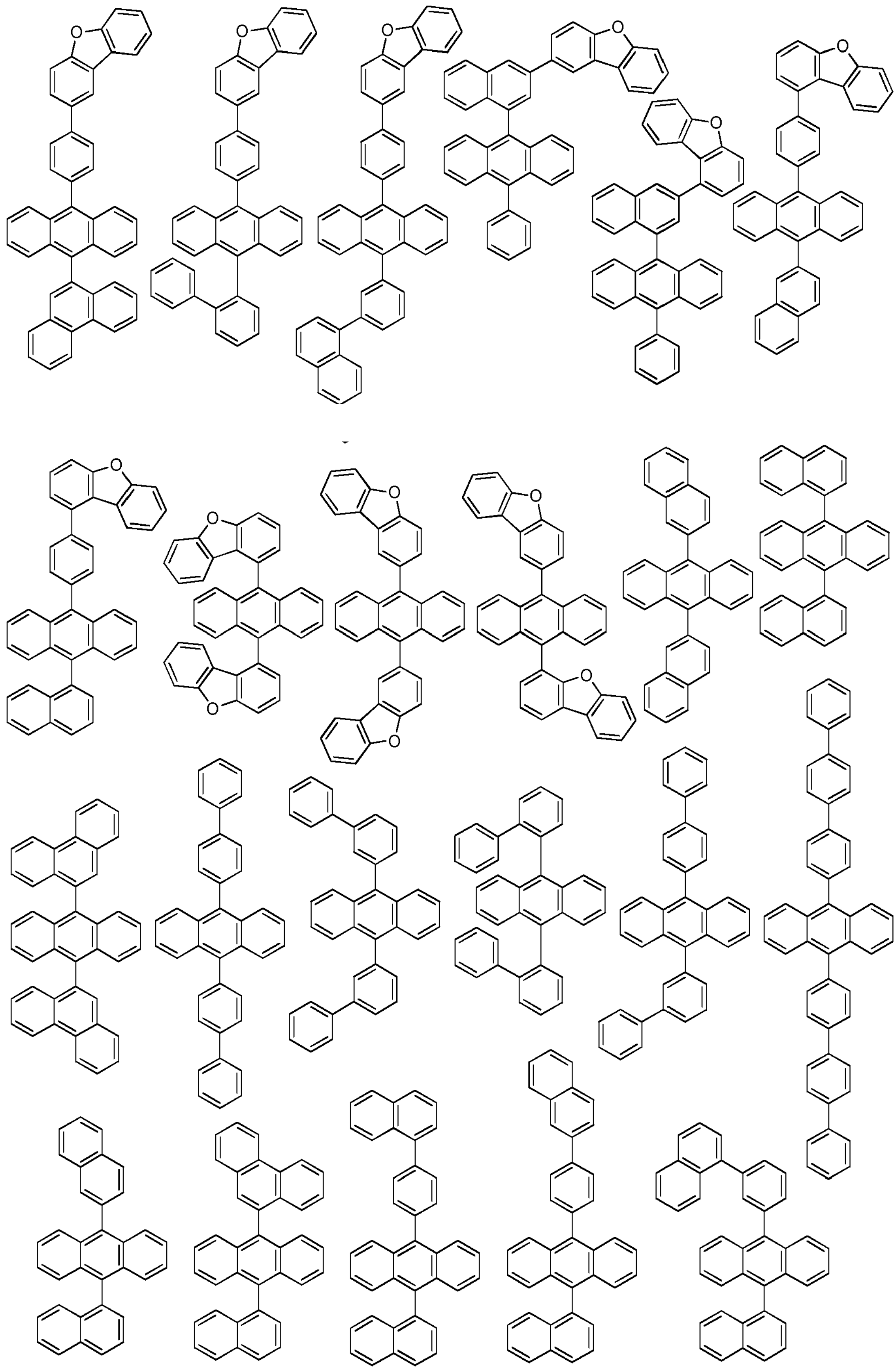

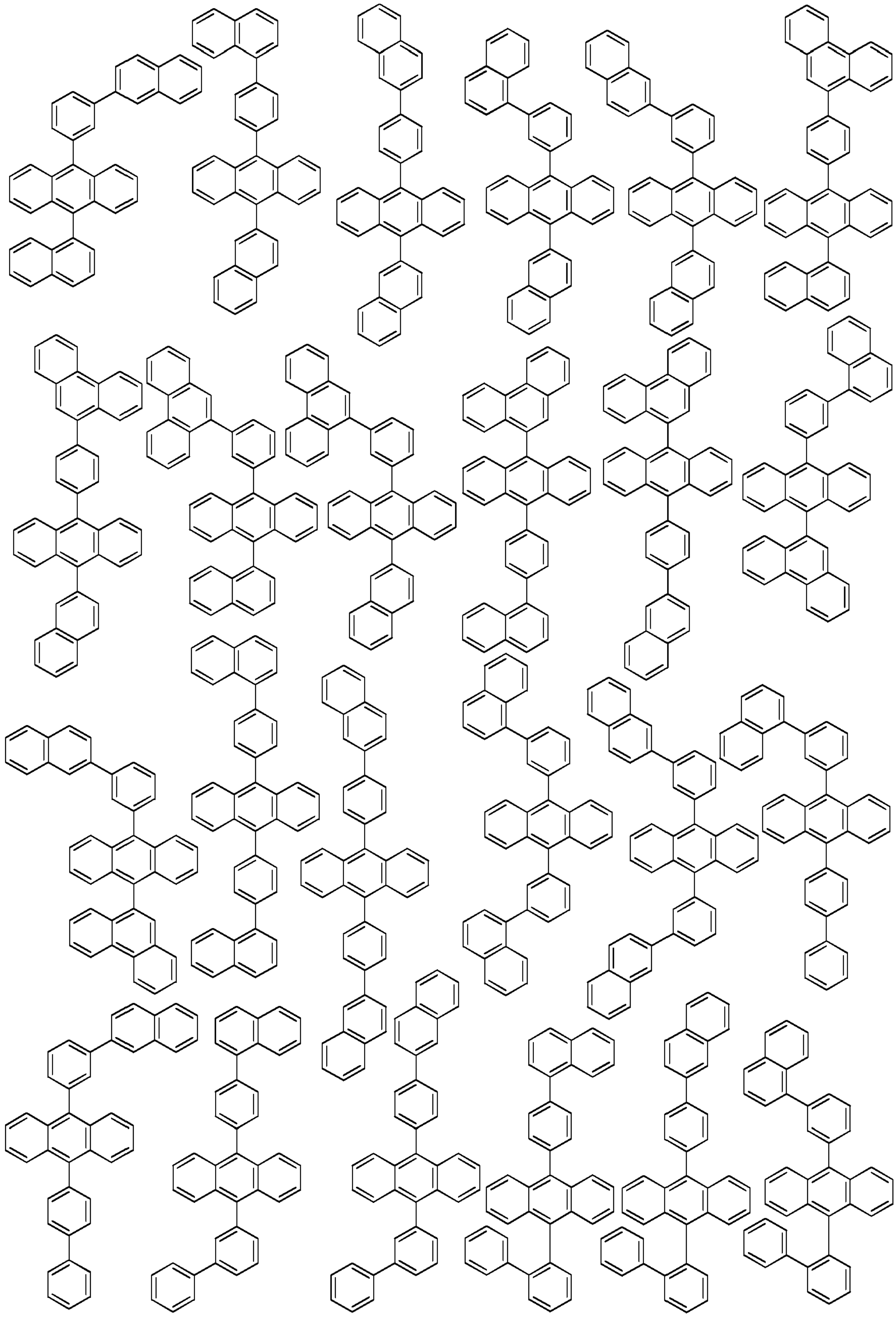

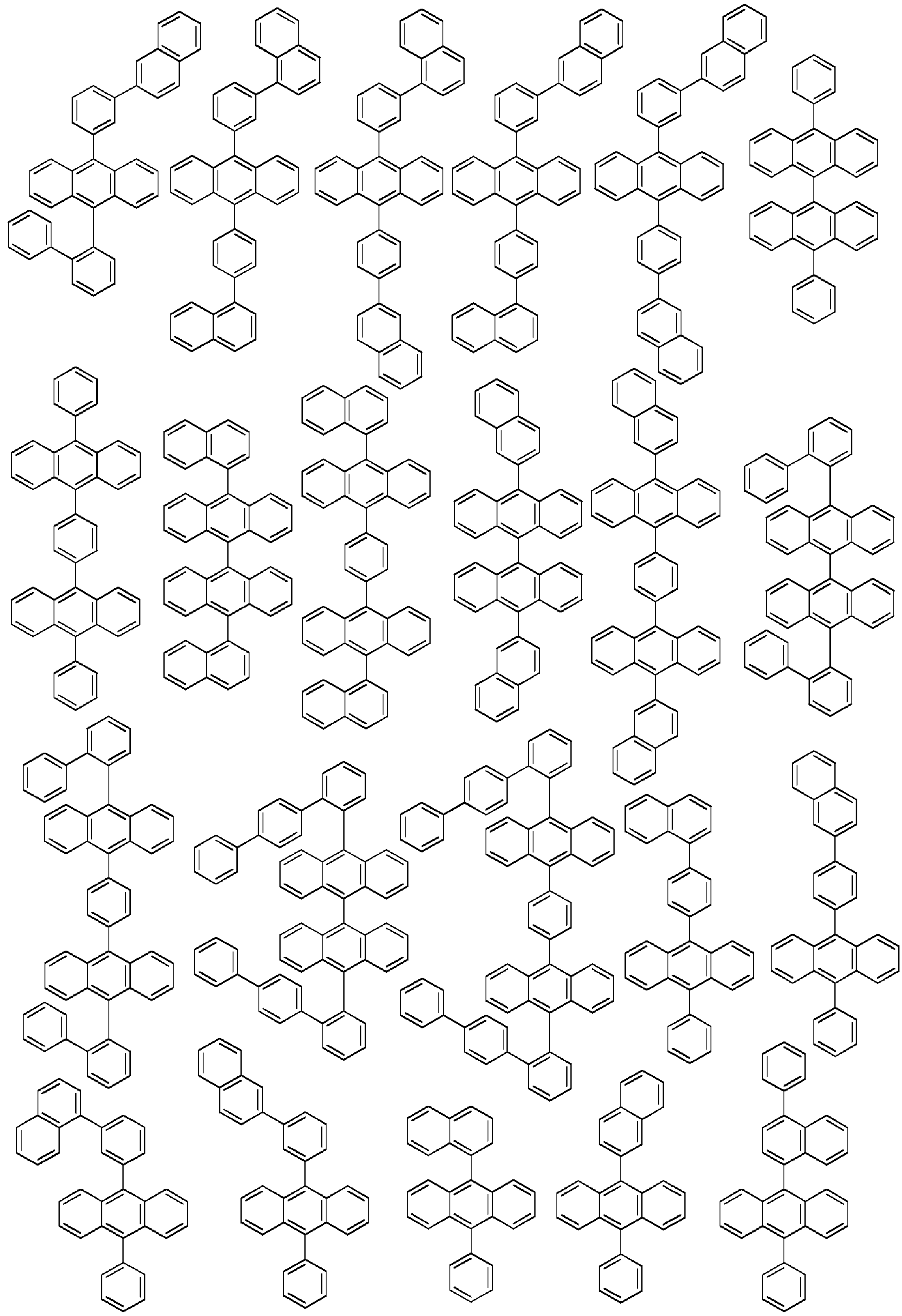

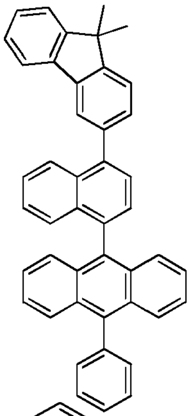
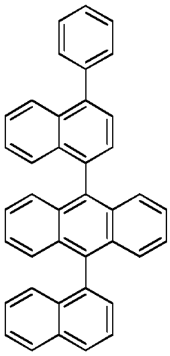
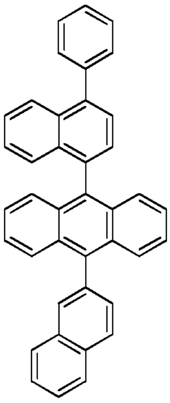
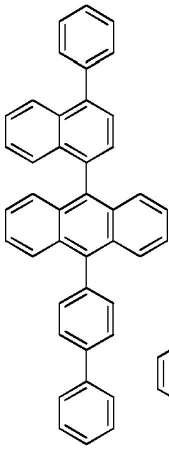
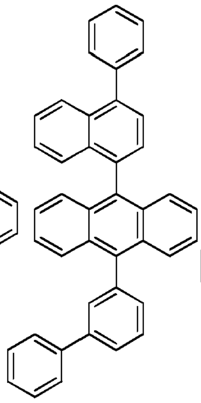
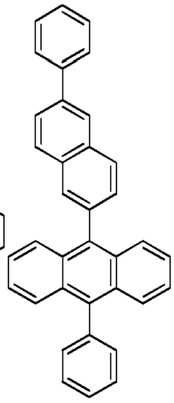

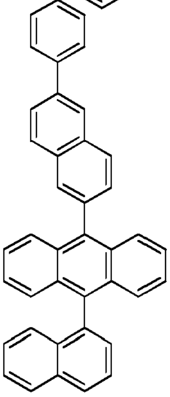
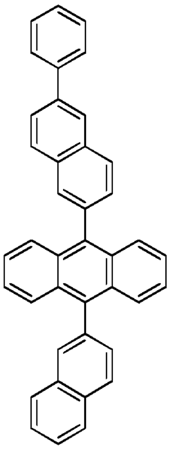
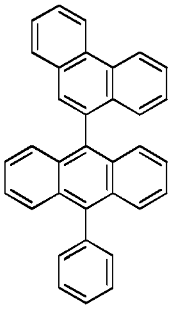
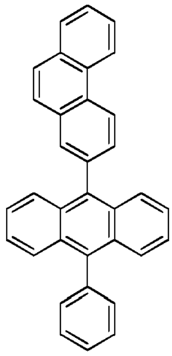
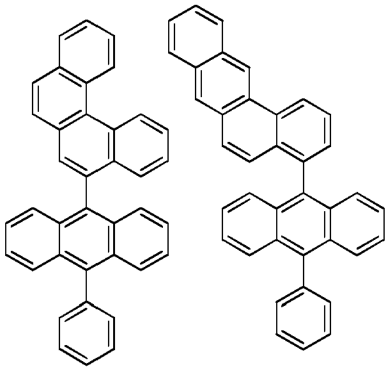

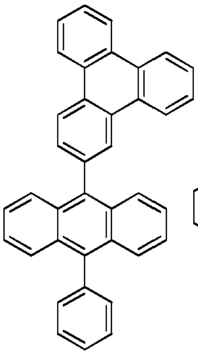
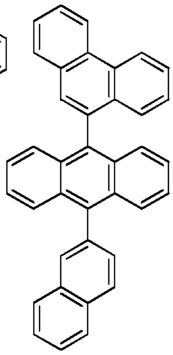
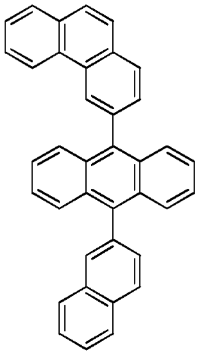
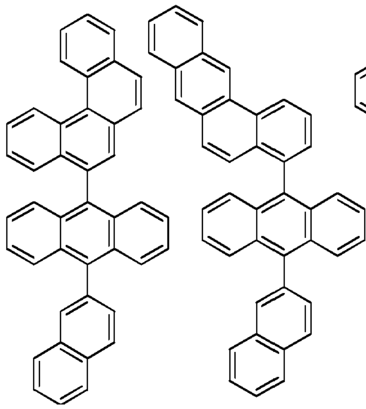
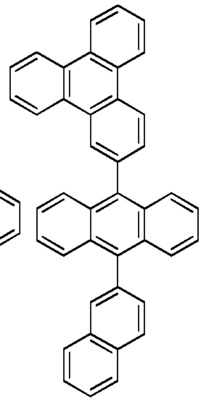

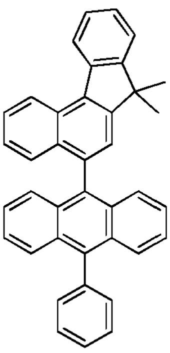
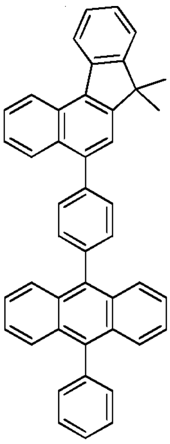
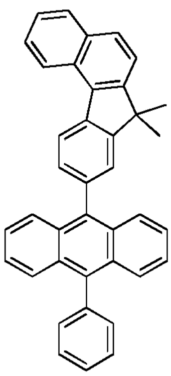
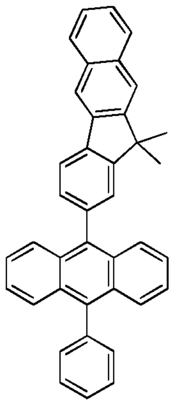
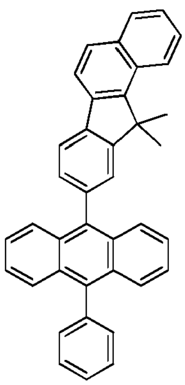
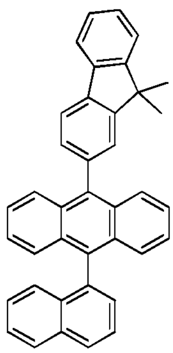

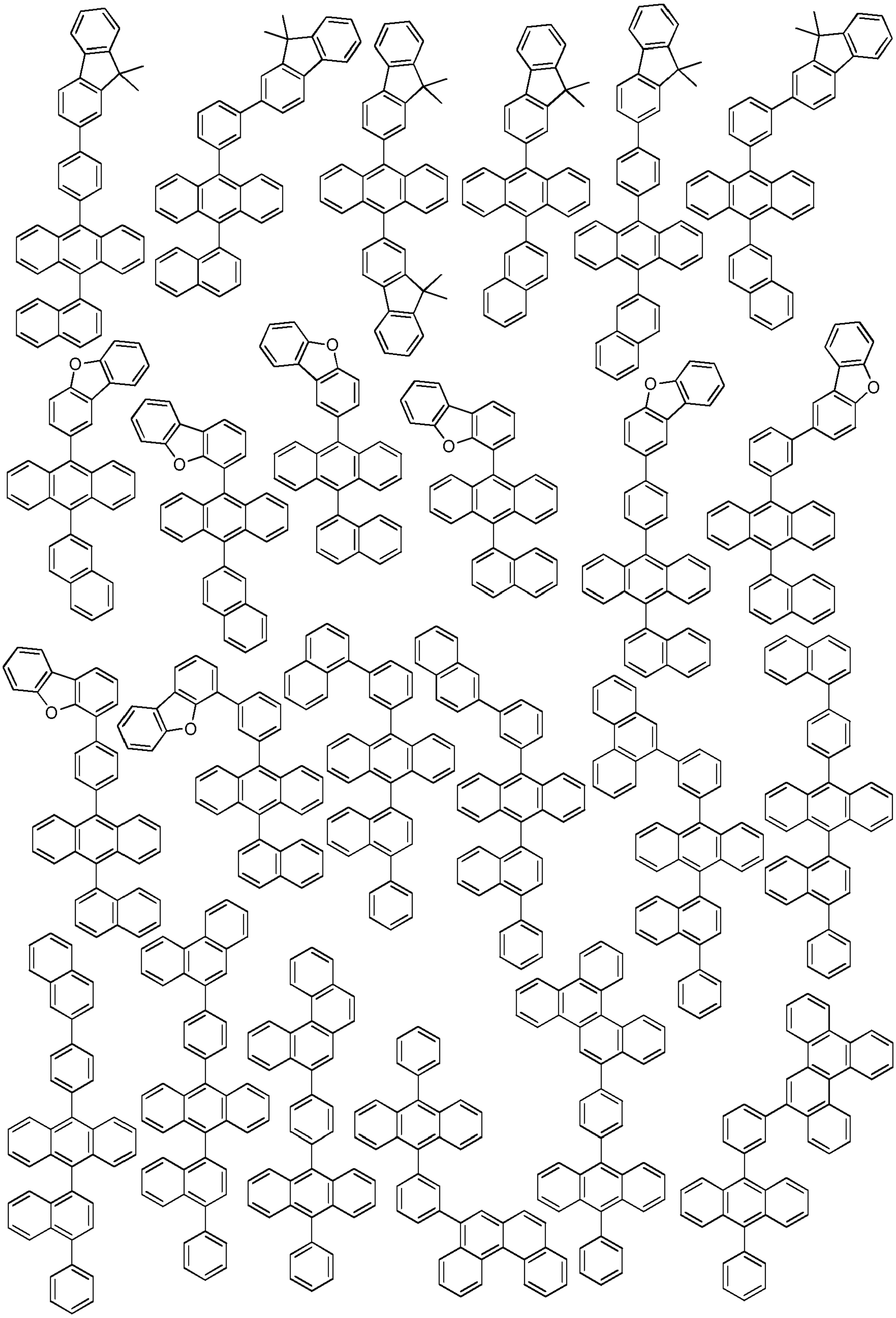

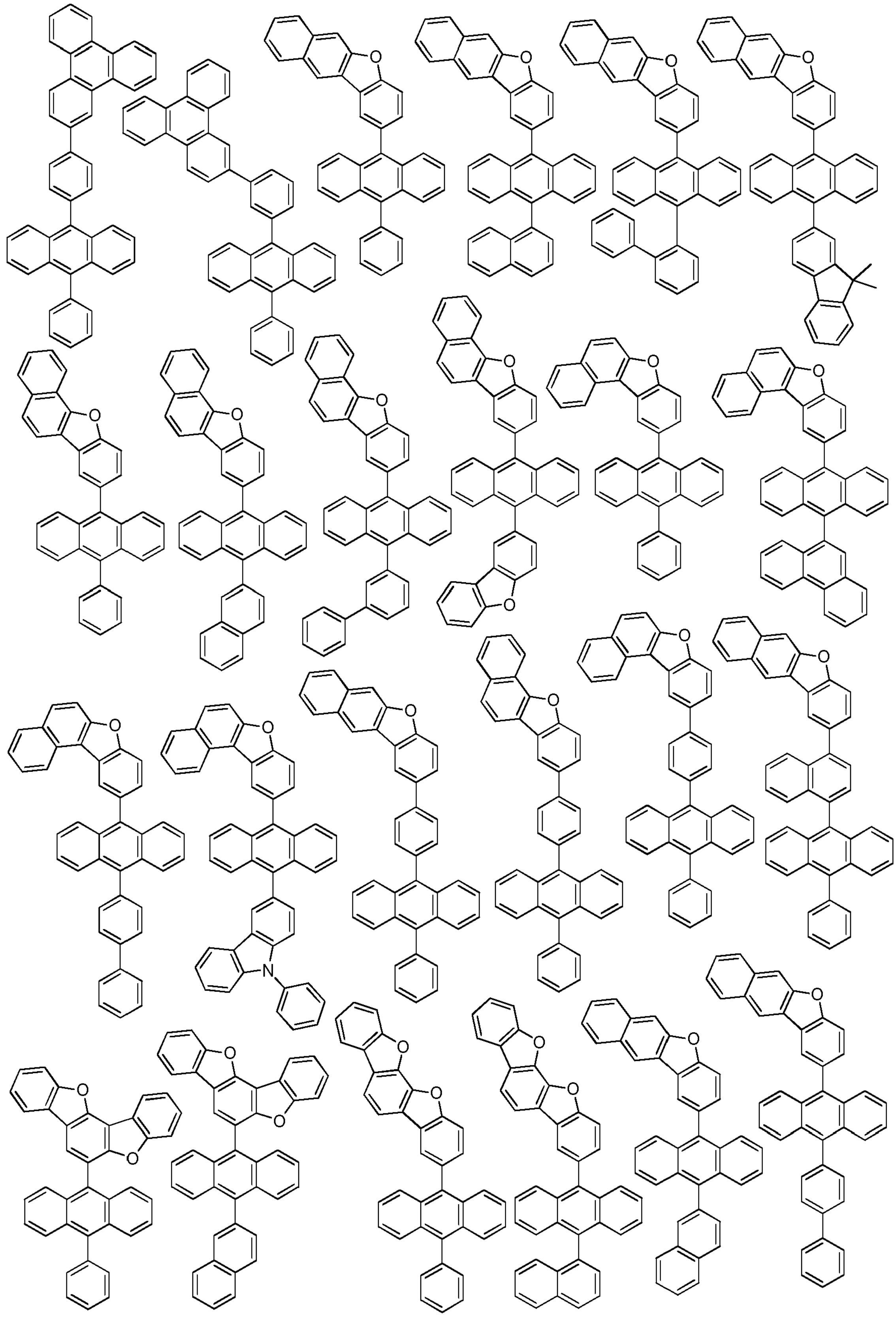

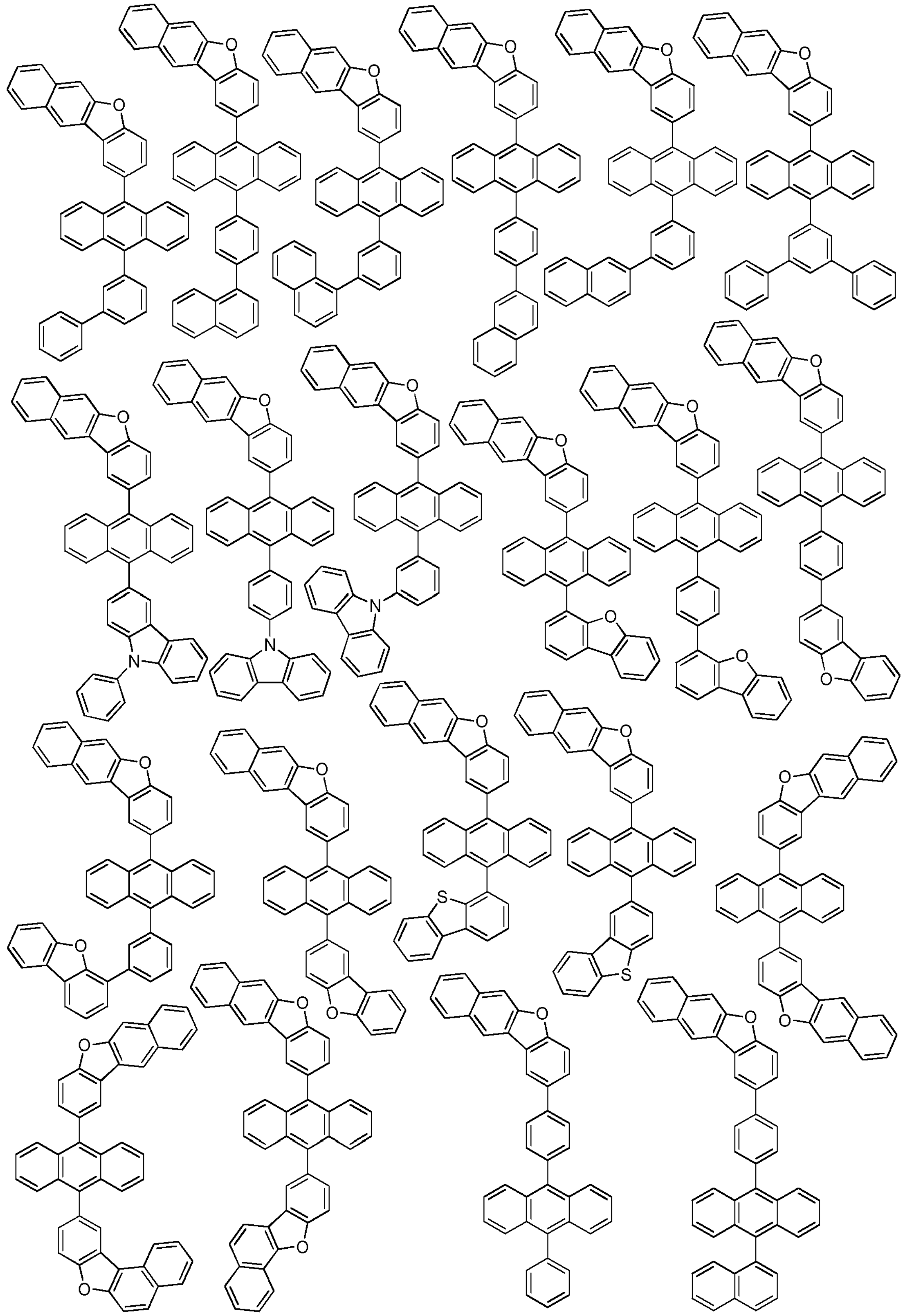

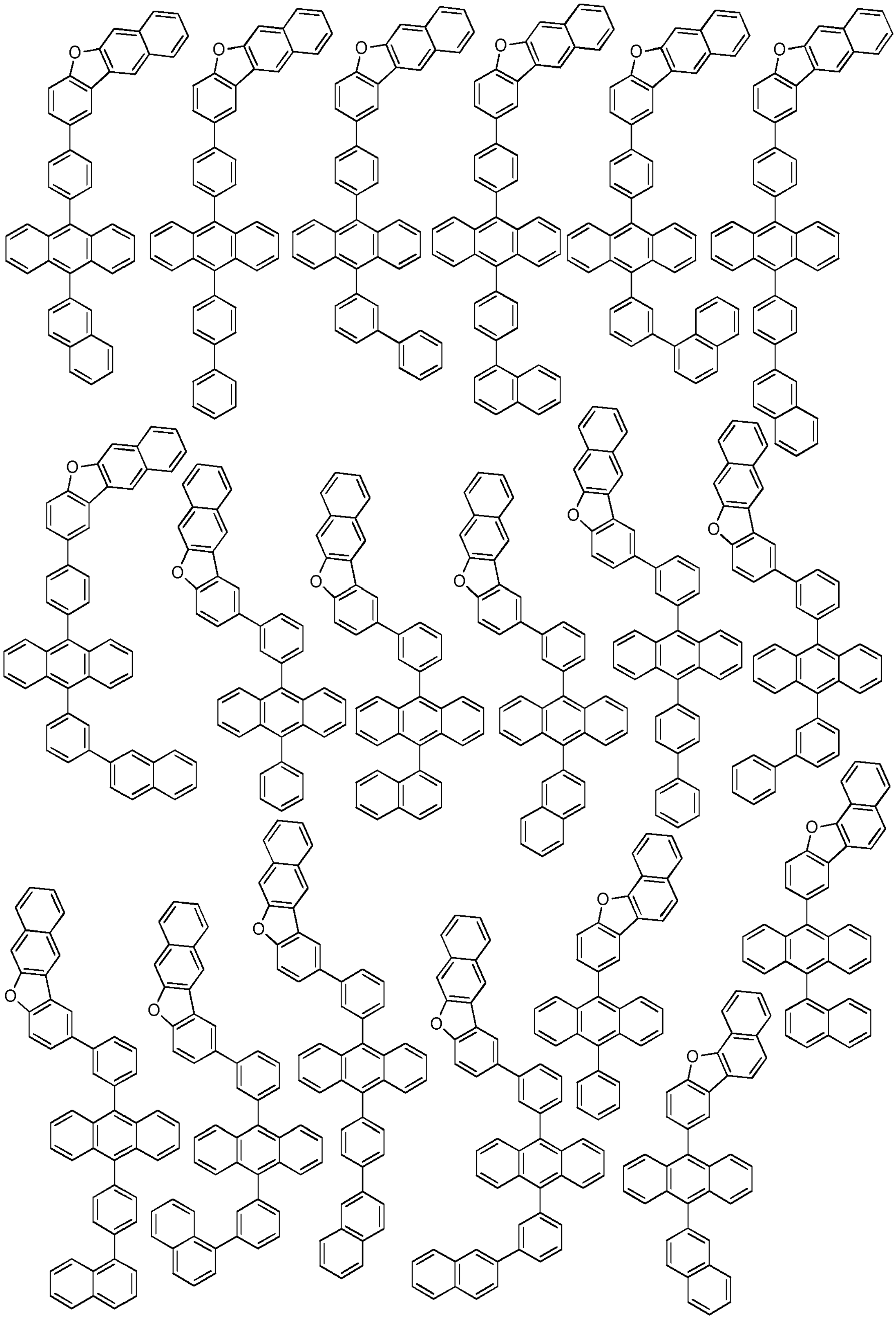

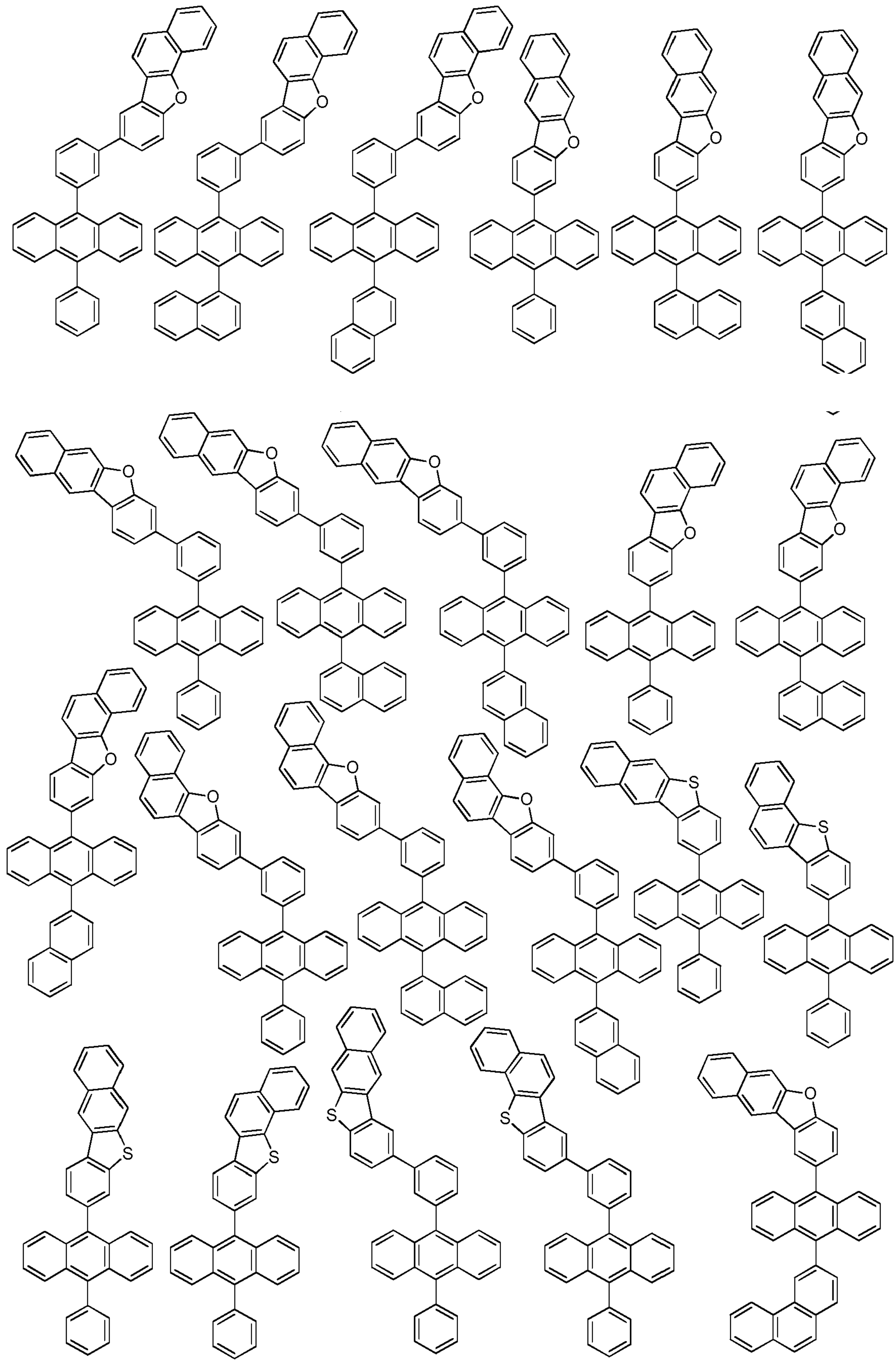

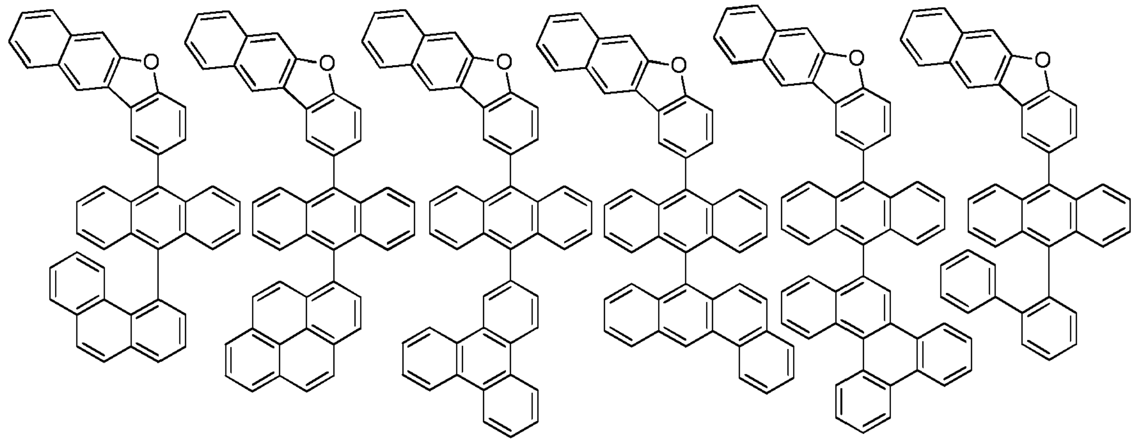

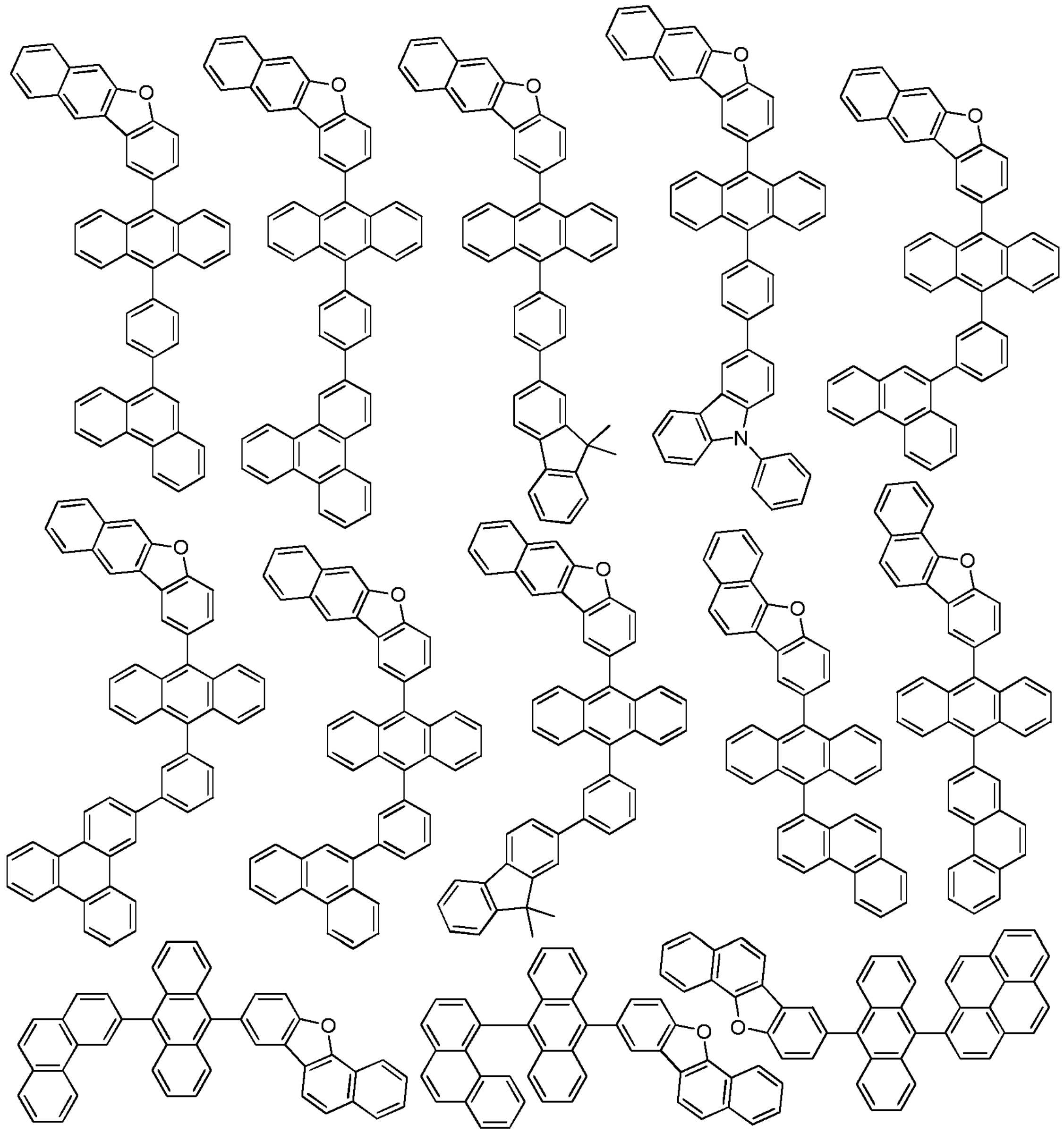

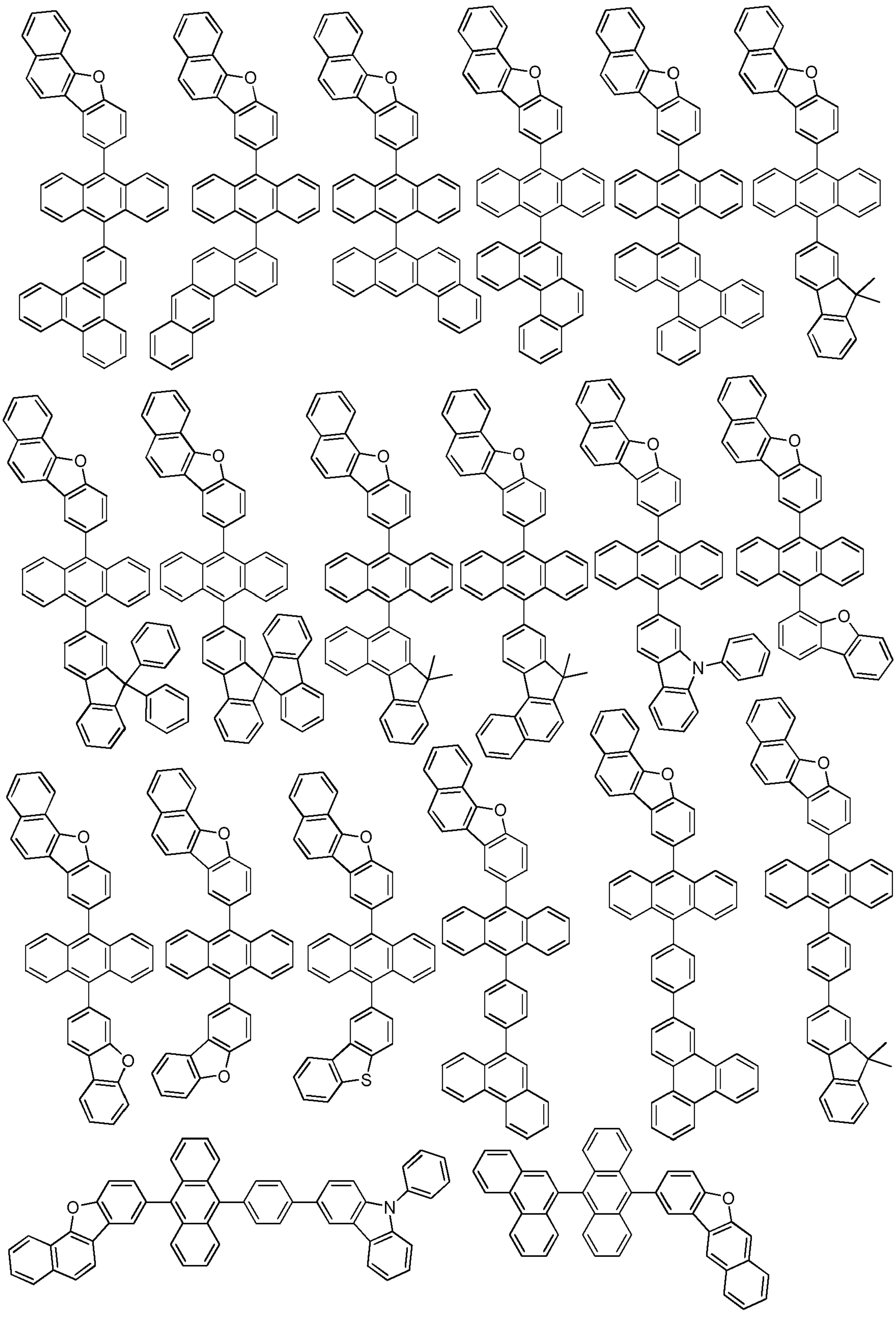

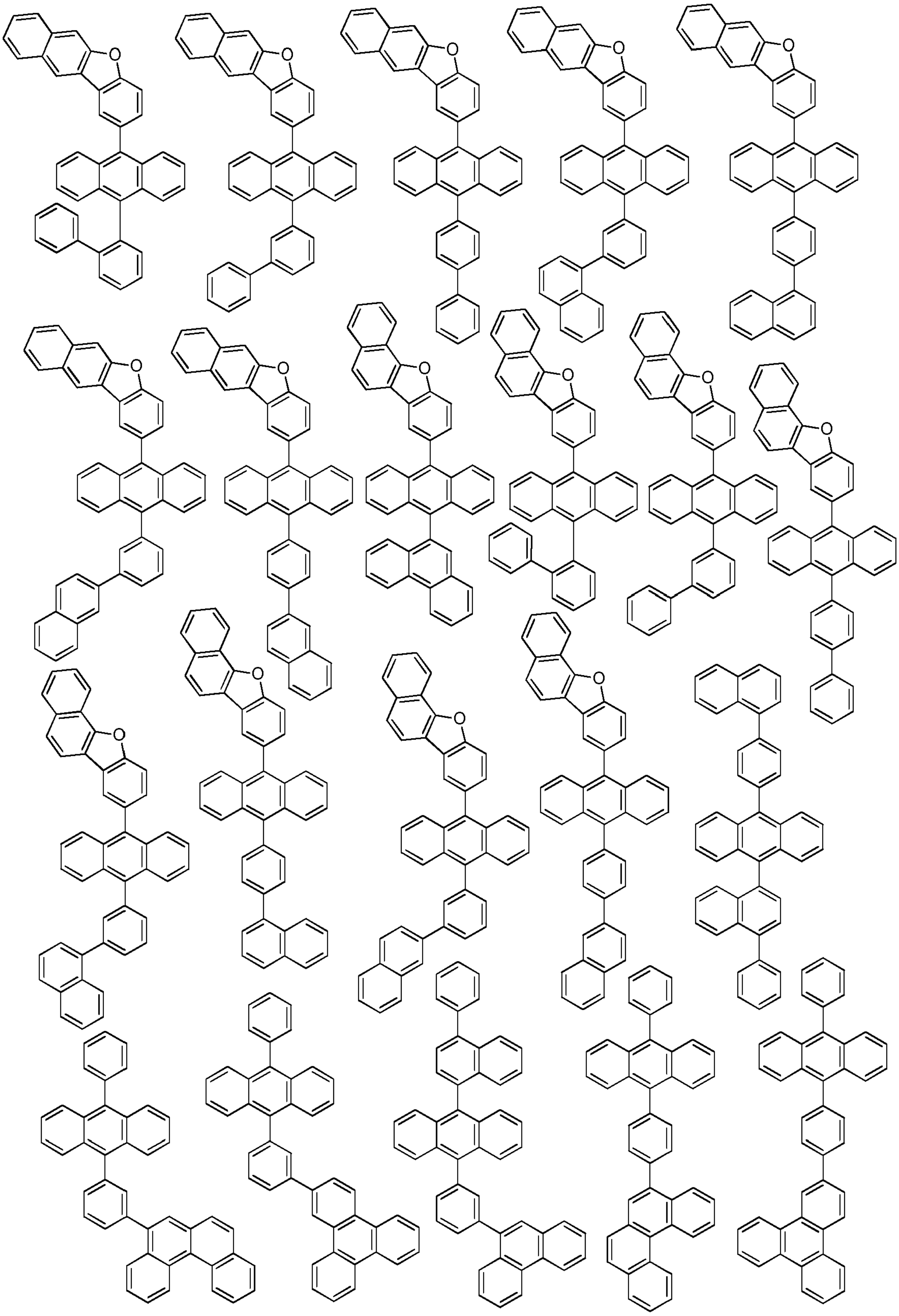

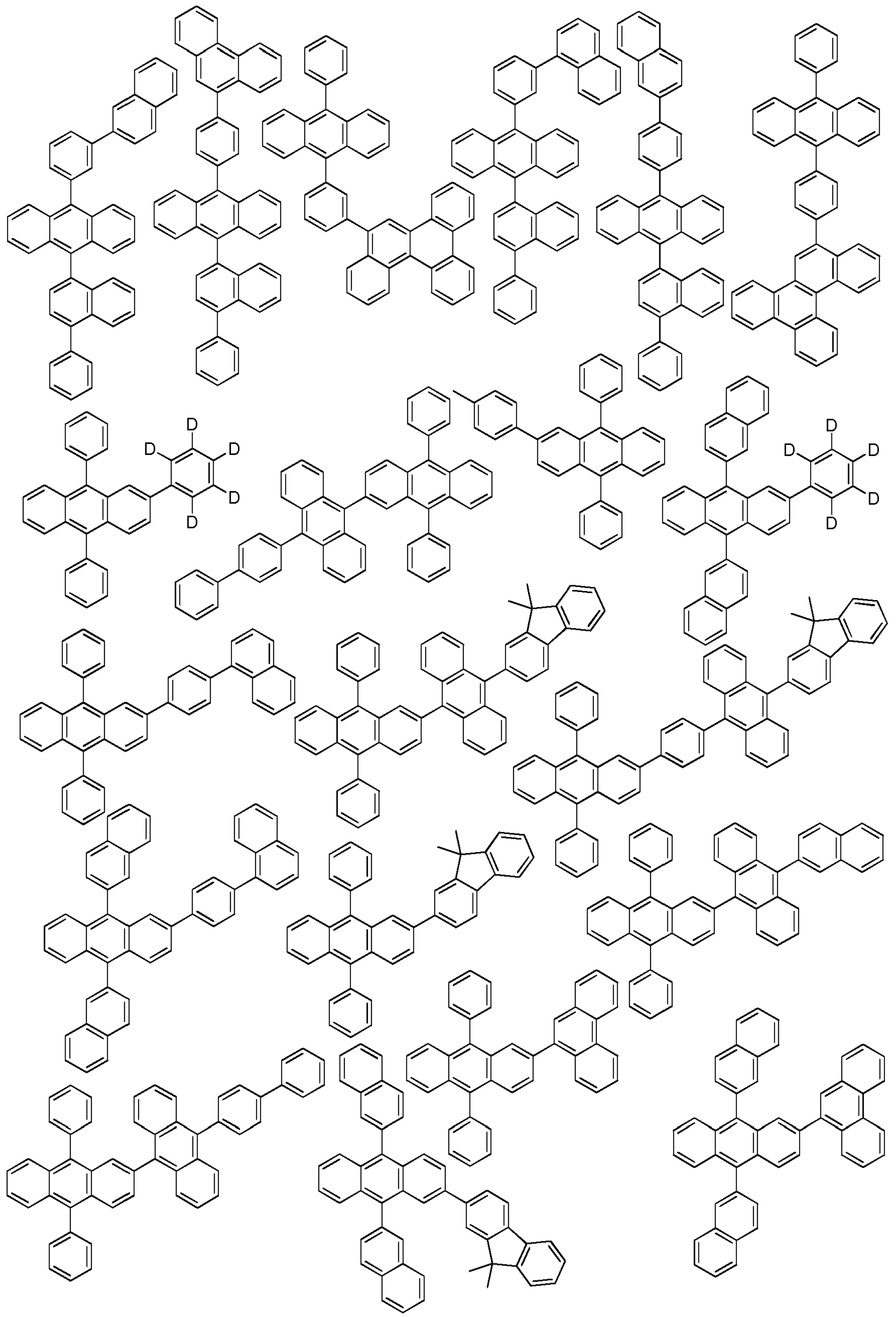

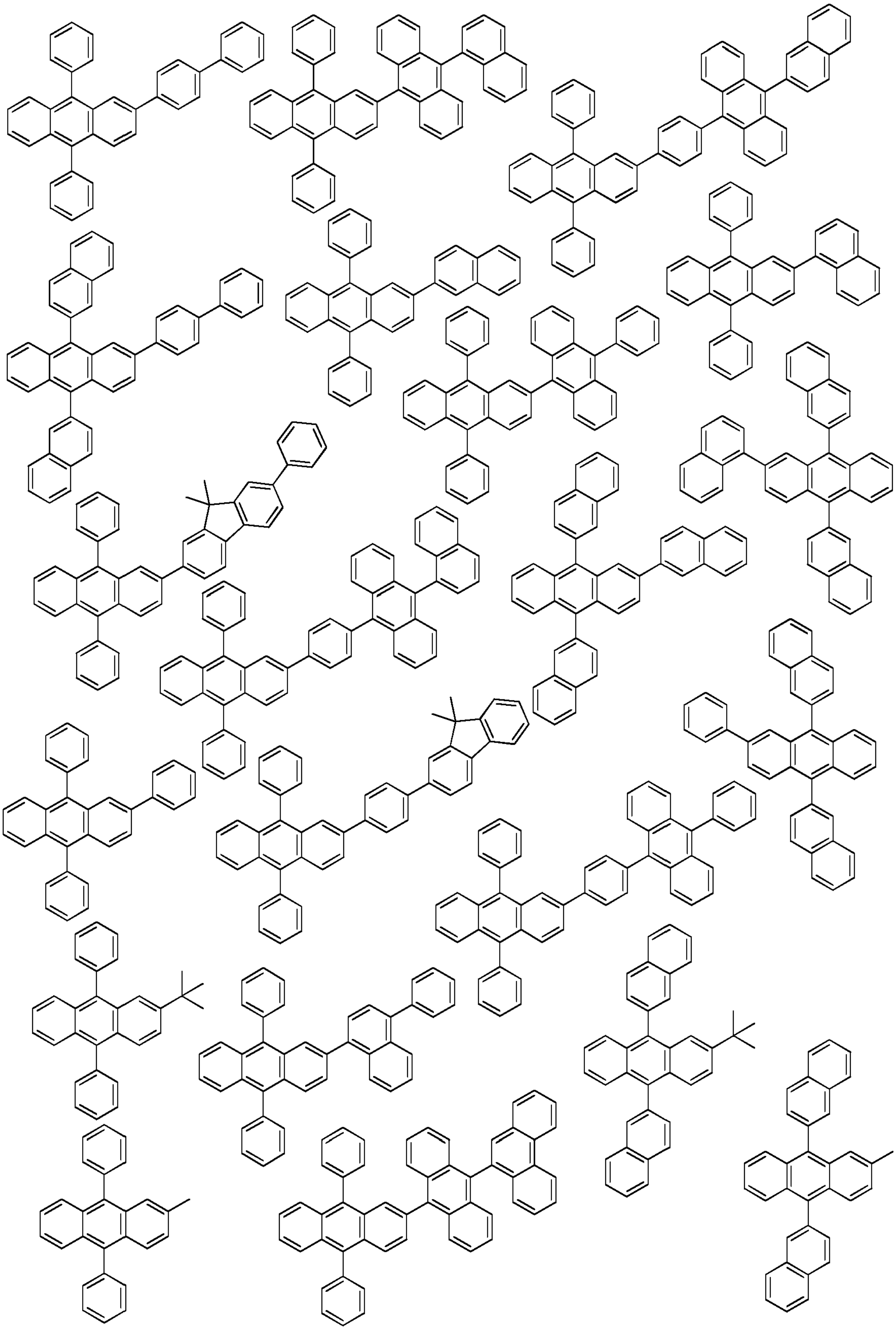

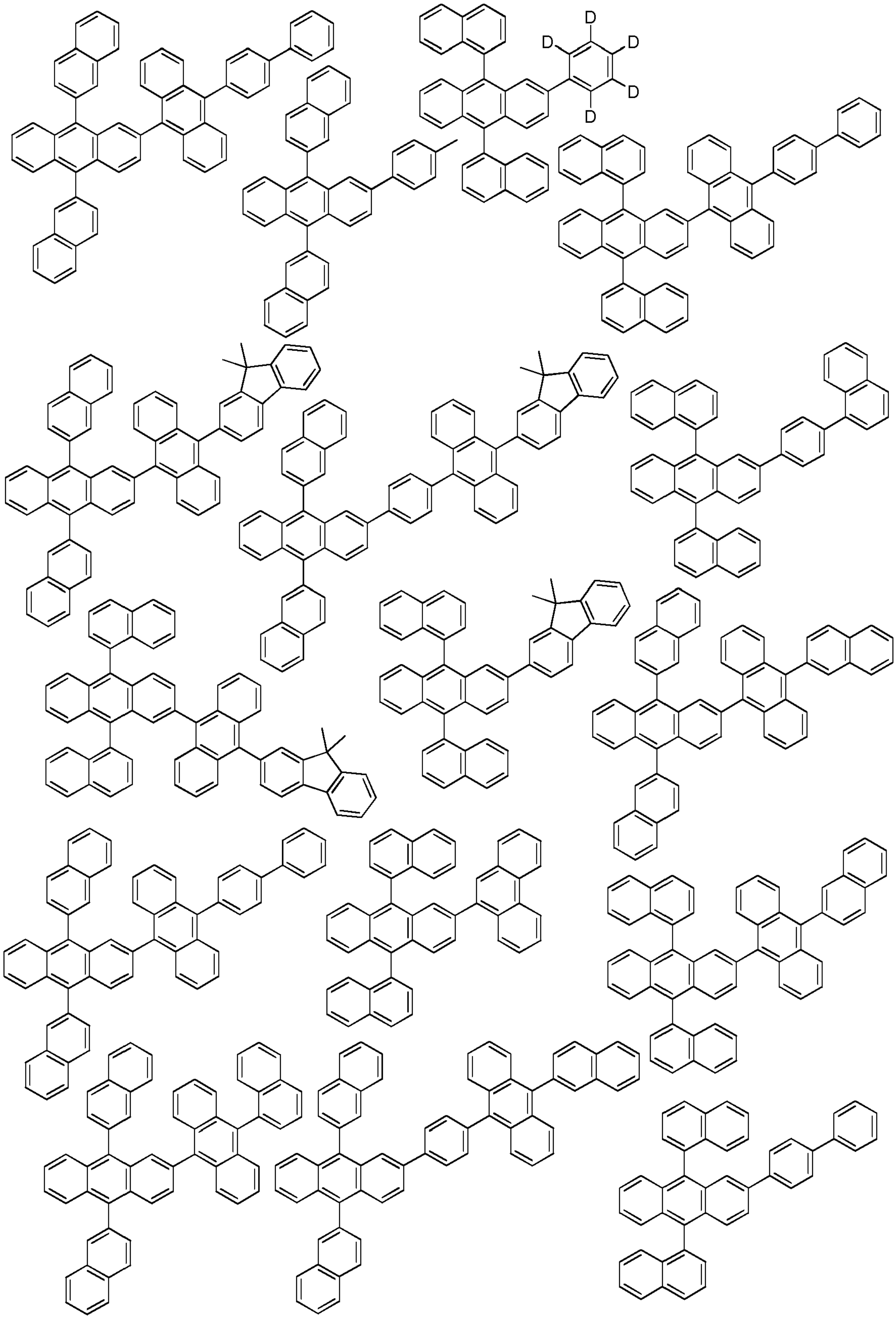

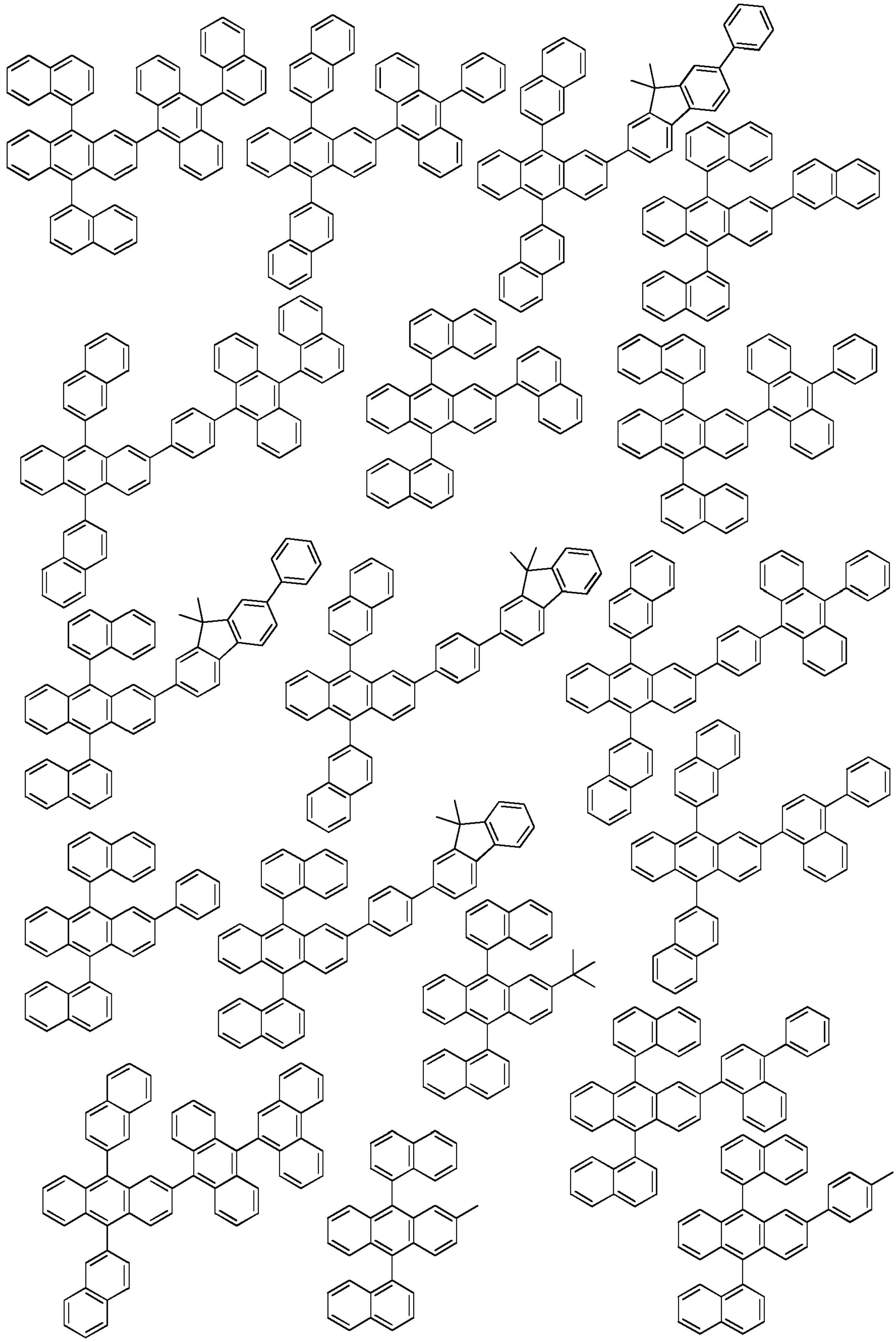

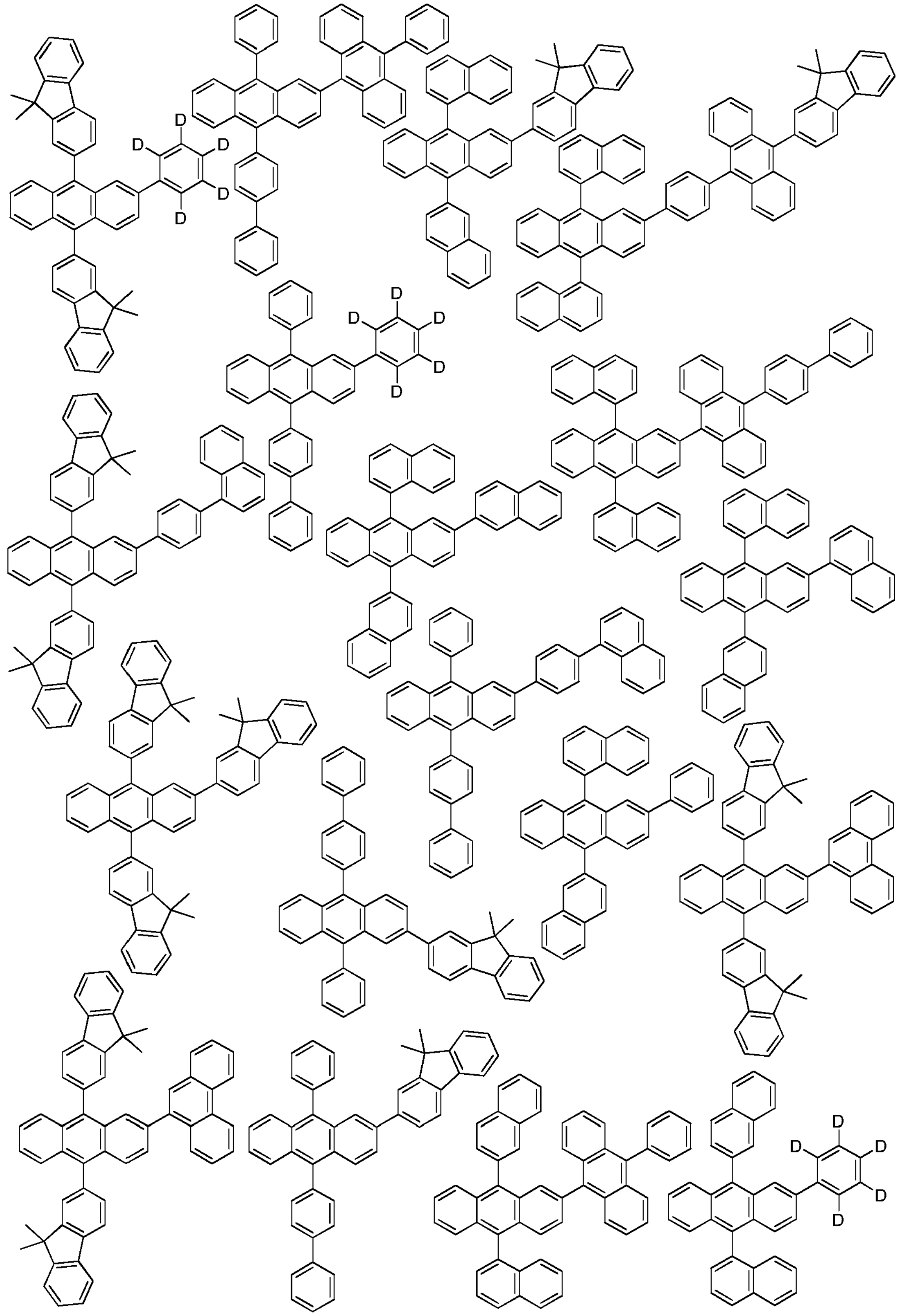

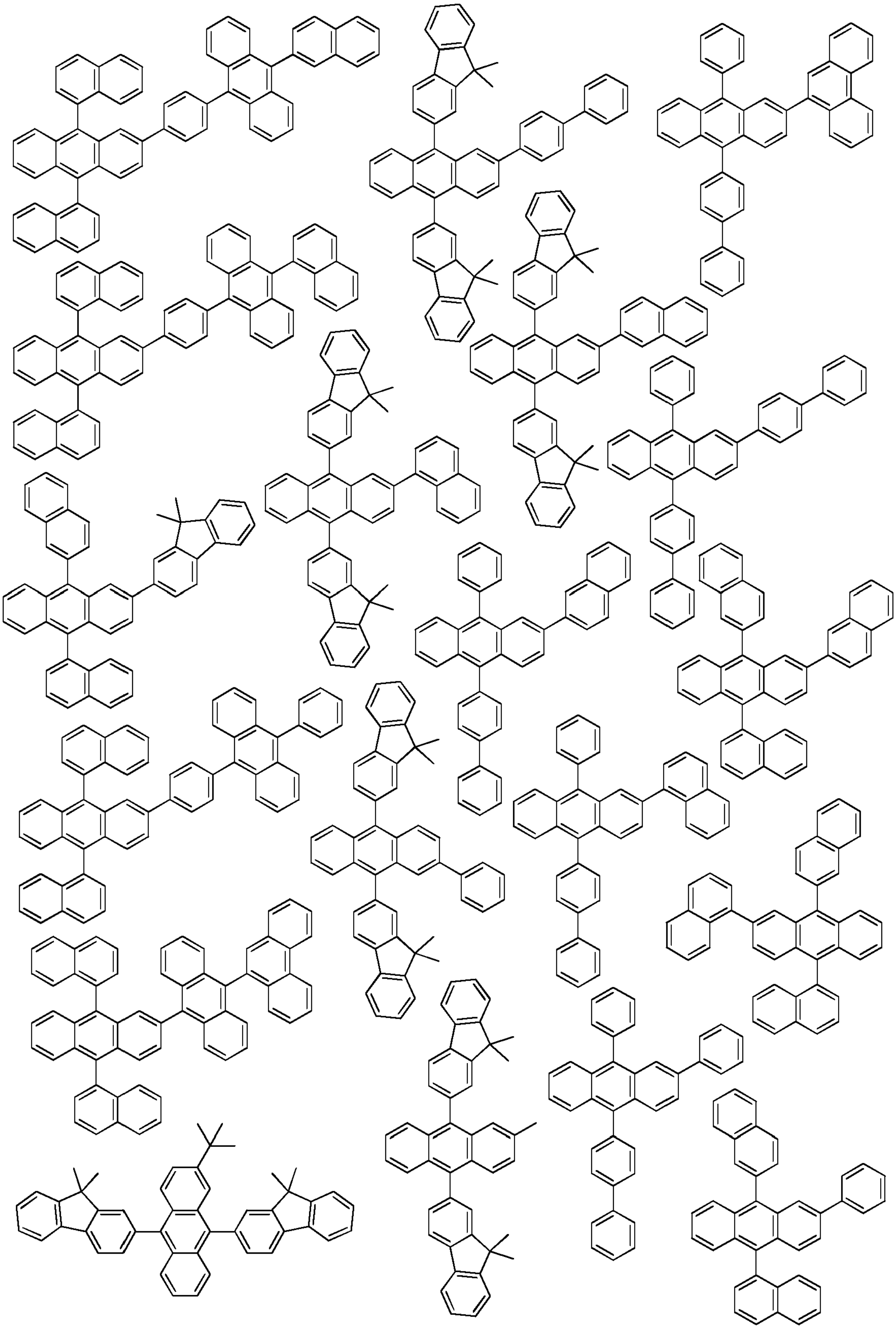

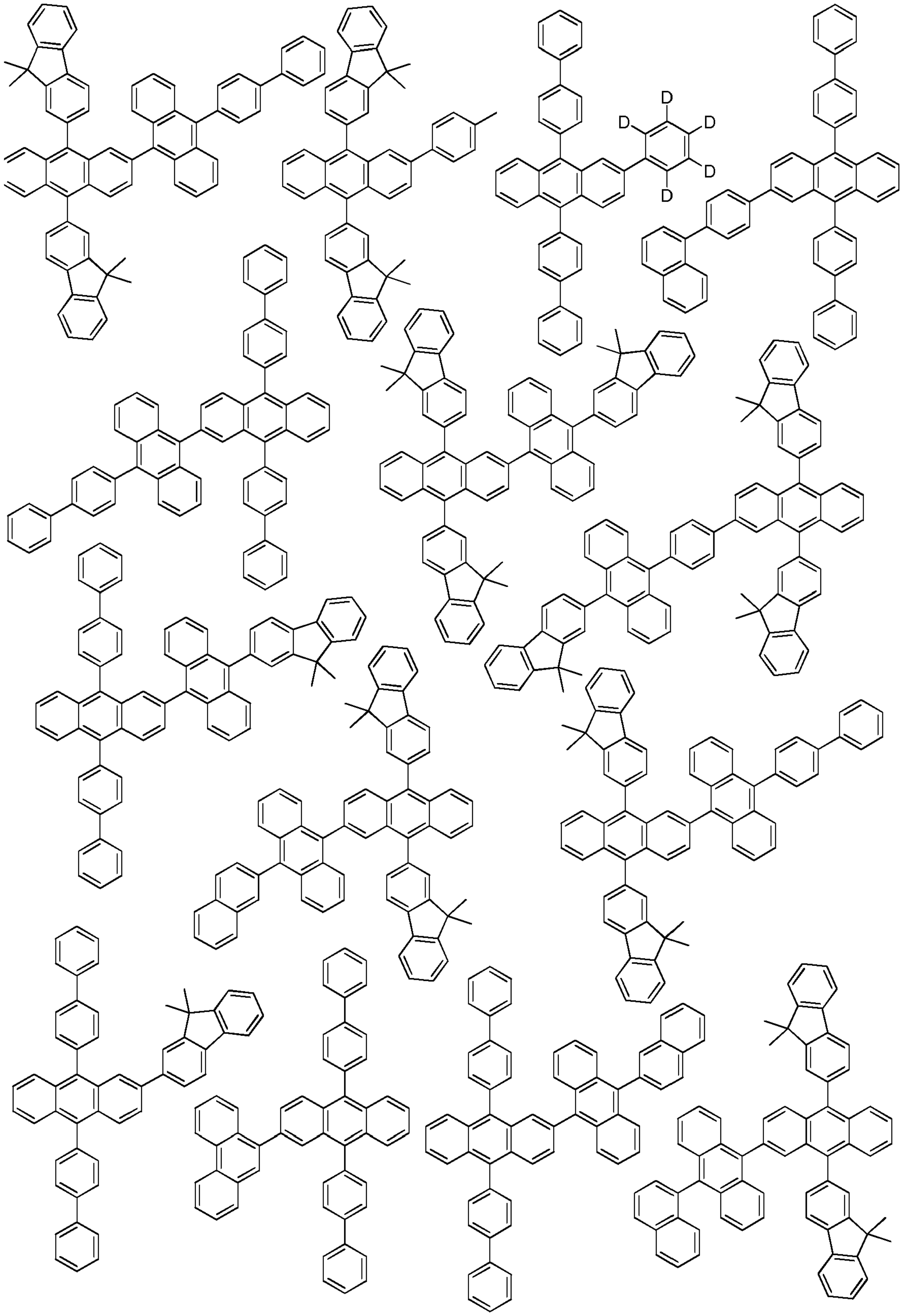

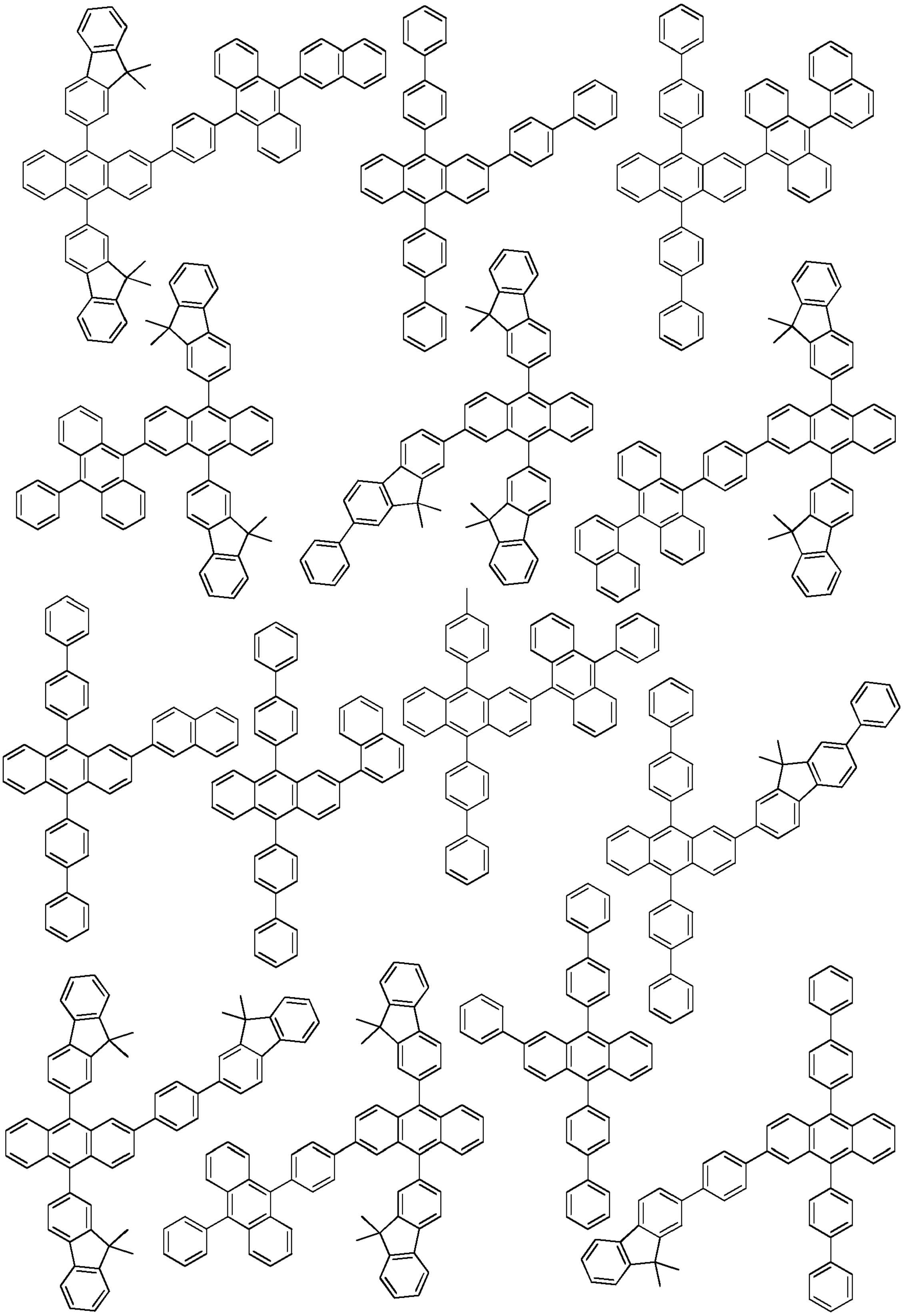

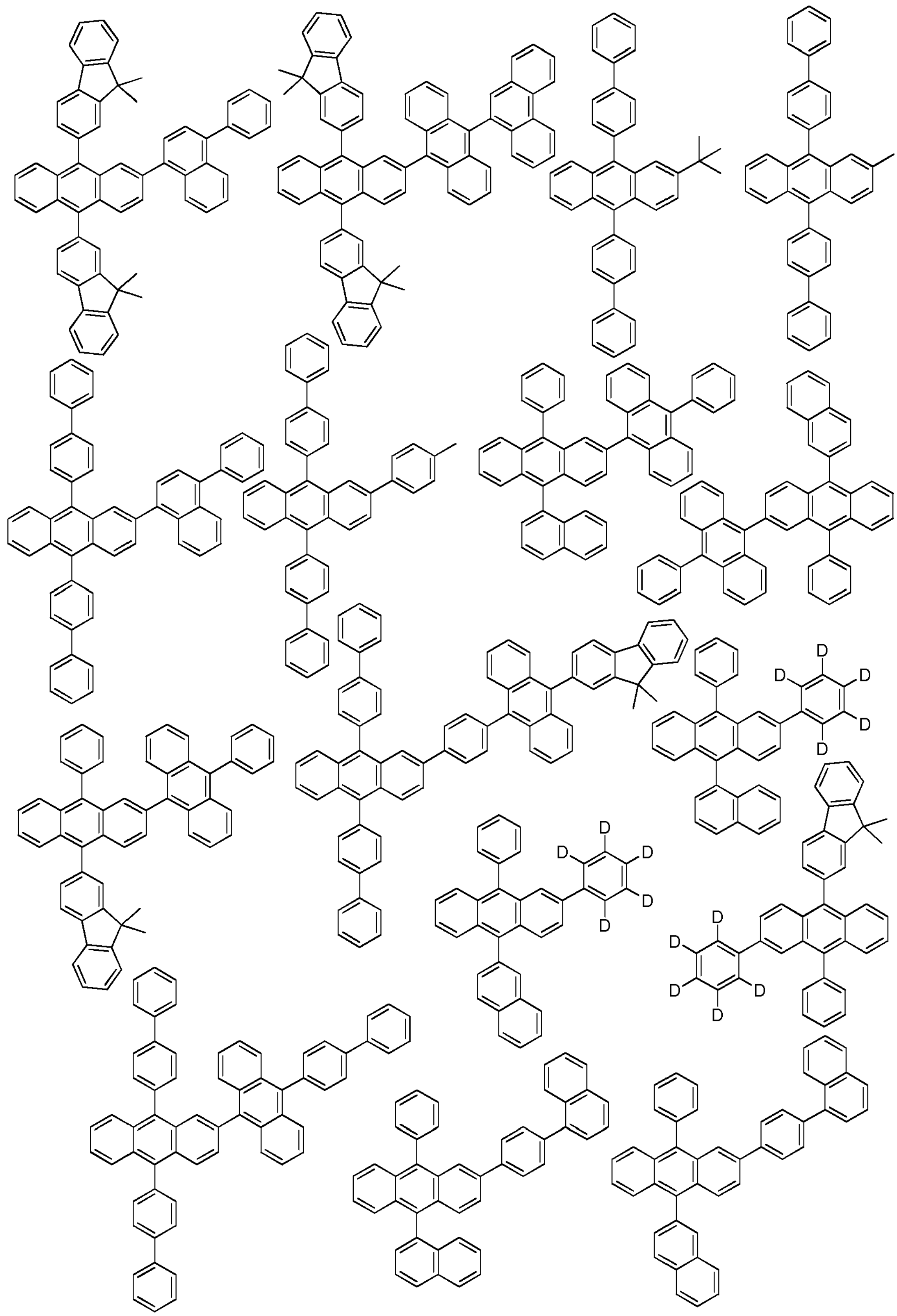

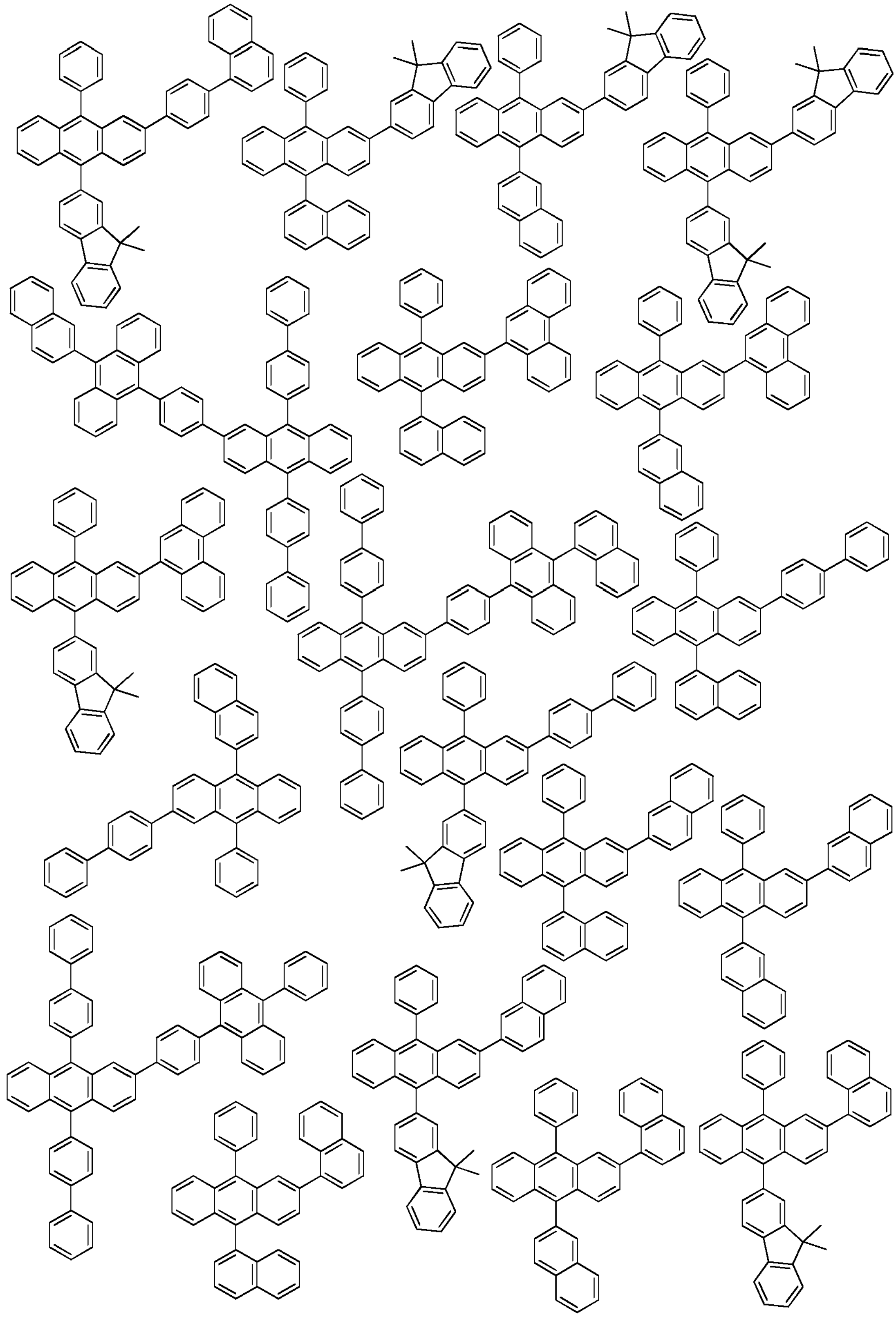

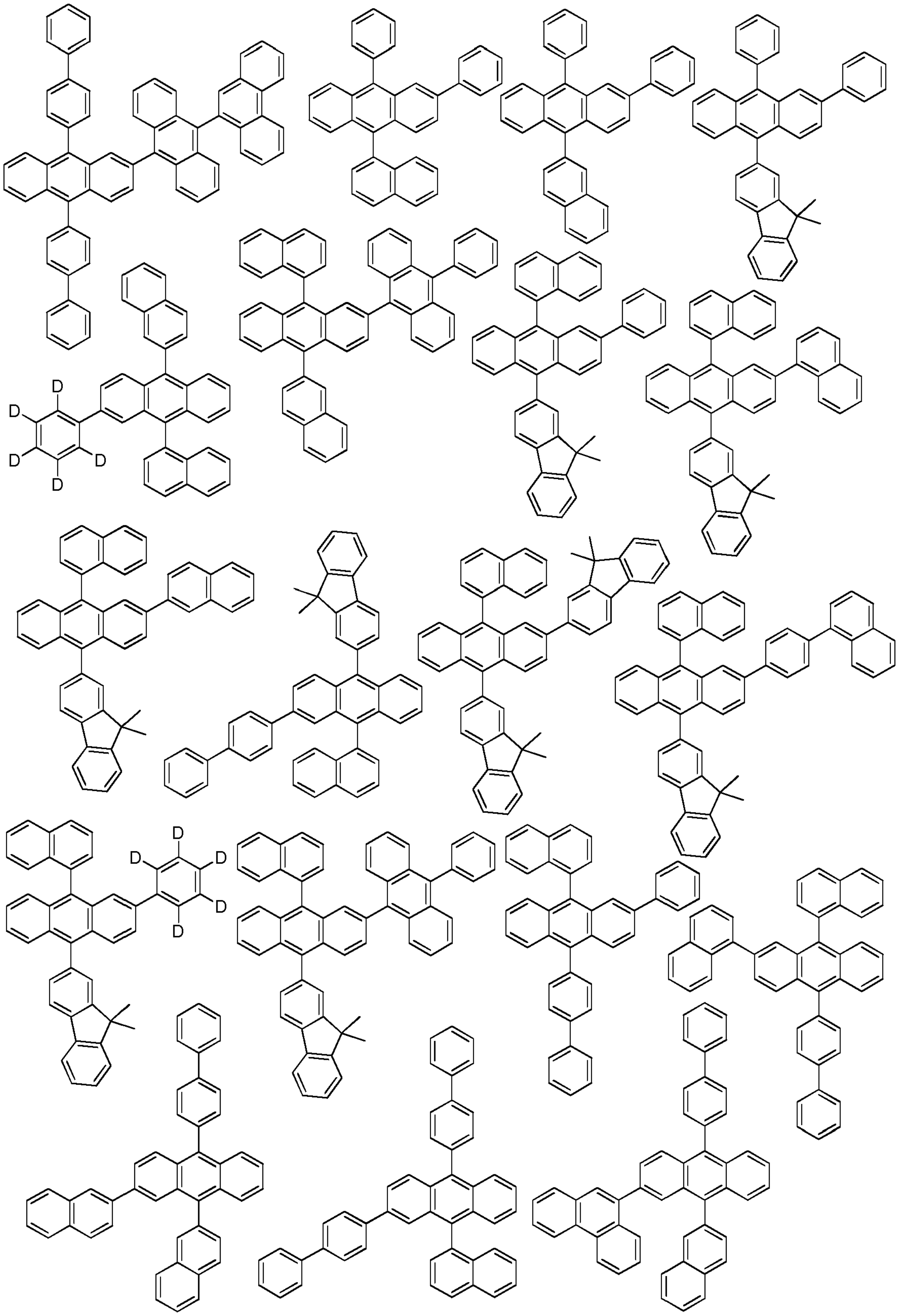

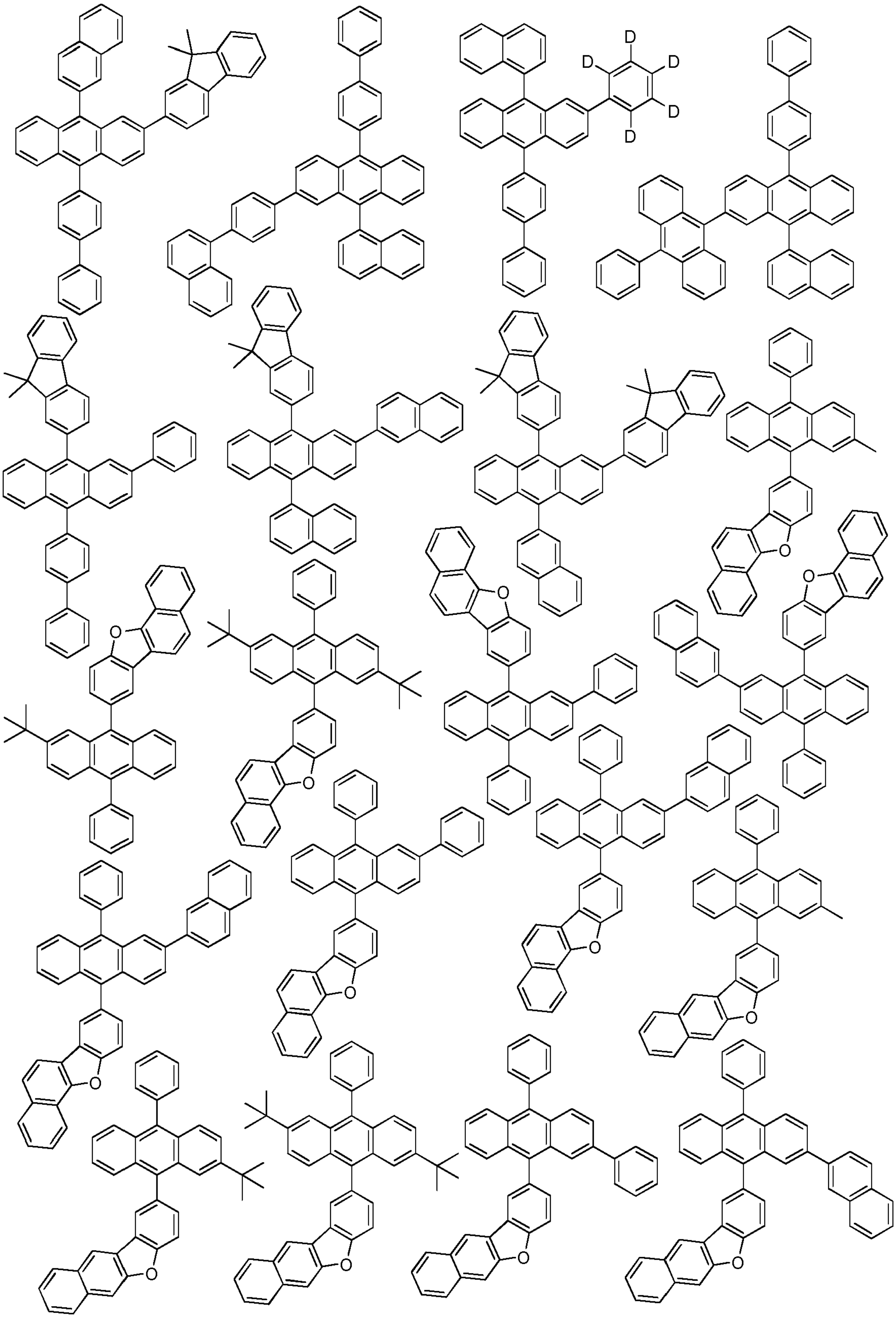

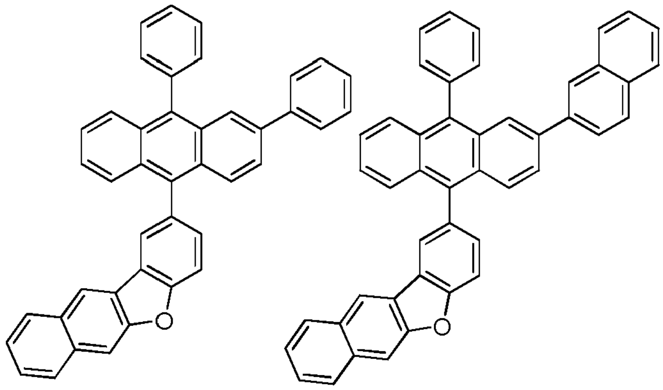

*Compositions comprising at least one organic molecule according to the invention*

One aspect of the invention relates to a composition comprising at least one organic molecule according to the invention. One aspect of the invention relates to the use of this composition in optoelectronic devices, preferably OLEDs, in particular in an EML of said devices.

In the following, when describing the aforementioned composition, reference is in some cases made to the content of certain materials in the respective compositions in form of percentages. It is to be noted that, unless stated otherwise for specific embodiments, all percentages refer to weight percentages, which has the same meaning as percent by weight or % by weight ((weight/weight), (w/w), wt.%). It is understood that, when for example stating that the content of one or more organic molecules according to the invention in a specific composition is exemplarily 30%, this is to mean that the total weight of the one or more organic molecules according to the invention (i.e. of all of these molecules combined) is 30% by weight, i.e. accounts for 30% of the total weight of the respective composition. It is understood that, whenever a composition is specified by providing the preferred content of its components in % by weight, the total content of all components adds up to 100% by weight (i.e. the total weight of the composition).

When in the following describing the embodiments of the invention relating to a composition comprising at least one organic molecule according to the invention, reference will be made to energy transfer processes that may take place between components within these compositions when using said compositions in an optoelectronic device, preferably in an EML of an optoelectronic device, most preferably in an EML of an OLED. The person skilled in the art understands that such excitation energy transfer processes may enhance the emission efficiency when using the composition in an EML of an optoelectronic device.

When describing compositions comprising at least one organic molecule according to the present inventions, it will also be pointed out that certain materials "differ" from other materials.

This is to mean the materials that "differ" from each other do not have the same chemical structure.

In one embodiment, the composition comprises or consists of:

(a) one or more organic molecules according to the invention, and
(b) one or more host materials $H^B$, which differ from the organic molecules of (a), and
(c) optionally, one or more solvents.

In one embodiment, the composition comprises or consists of:

(a) one or more organic molecules according to the invention, and
(b) one or more host materials $H^B$, which differ from the organic molecules of (a),

wherein the fraction of the host materials $H^B$ in % by weight in the composition is higher than the fraction of the organic molecules according to the invention in % by weight, preferably the fraction of the host materials $H^B$ in % by weight in the composition is more than two times higher than the fraction of the organic molecules according to the invention in % by weight.

In one embodiment, the composition comprises or consists of:

(a) 0.1-30% by weight, preferably 0.8-15% by weight, in particular 1.5-5% by weight, of organic molecules according to the invention, and

(b) TTA materials as host materials $H^B$ according to following formula (4):

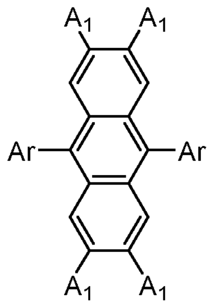
(4).

In one embodiment, the composition comprises or consists of:

(a) organic molecules according to the invention, and
(b) host material $H^B$, which differ from the organic molecules of (a),
(c) TADF material $E^B$ and/or phosphorescence material $P^B$.

In one embodiment, the composition comprises or consists of:

(a) 0.1-20% by weight, preferably 0.5-12% by weight, in particular 1-5% by weight of organic molecules according to the invention, and
(b) 0-98.8% by weight, preferably 35-94% by weight, in particular 60-88% by weight of one or more host materials $H^B$, which differ from the organic molecules according to the invention, and
(c) 0.1-20% by weight, preferably 0.5-10% by weight, in particular 1-3% by weight, of one or more phosphorescence materials $P^B$, which differ from the organic molecules of (a), and
(d) 1-99.8% by weight, preferably 5-50% by weight, in particular 10-30% by weight, of one or more TADF materials $E^B$, which differ from the organic molecules of (a), and
(e) 0-98.8% by weight, preferably 0-59% by weight, in particular 0-28% by weight of one or more solvents.

In a further aspect, the invention relates to an optoelectronic device comprising an organic molecule or a composition of the type described here, more particularly in the form of a device selected from the group consisting of organic light-emitting diode (OLED), light-emitting electrochemical cell, OLED sensor, more particularly gas and vapour sensors not hermetically externally shielded, organic diode, organic solar cell, organic transistor, organic field-effect transistor, organic laser and down-conversion element.
In a preferred embodiment, the optoelectronic device is a device selected from the group consisting of an organic light emitting diode (OLED), a light emitting electrochemical cell (LEC), and a light-emitting transistor.
In one embodiment of the optoelectronic device of the invention, the organic molecule according to the invention E is used as emission material in a light-emitting layer EML.
In one embodiment of the optoelectronic device of the invention, the light-emitting layer EML consists of the composition according to the invention described here.
When the optoelectronic device is an OLED, it may, for example, have the following layer structure:

1. substrate
2. anode layer A
3. hole injection layer, HIL
4. hole transport layer, HTL
5. electron blocking layer, EBL
6. emitting layer, EML
7. hole blocking layer, HBL
8. electron transport layer, ETL
9. electron injection layer, EIL
10. cathode layer,

wherein the OLED comprises each layer selected from the group of HIL, HTL, EBL, HBL, ETL, and EIL only optionally, different layers may be merged and the OLED may comprise more than one layer of each layer type defined above.
Furthermore, the optoelectronic device may, in one embodiment, comprise one or more protective layers protecting the device from damaging exposure to harmful species in the environment including, for example, moisture, vapor and/or gases.

In one embodiment of the invention, the optoelectronic device is an OLED, with the following inverted layer structure:

1. substrate
2. cathode layer
3. electron injection layer, EIL
4. electron transport layer, ETL
5. hole blocking layer, HBL
6. emitting layer, B
7. electron blocking layer, EBL
8. hole transport layer, HTL
9. hole injection layer, HIL
10. anode layer A

wherein the OLED comprises each layer selected from the group of HIL, HTL, EBL, HBL, ETL, and EIL only optionally, different layers may be merged and the OLED may comprise more than one layer of each layer types defined above.

In one embodiment of the invention, the optoelectronic device is an OLED, which may have a stacked architecture. In this architecture, contrary to the typical arrangement in which the OLEDs are placed side by side, the individual units are stacked on top of each other. Blended light may be generated with OLEDs exhibiting a stacked architecture, in particular white light may be generated by stacking blue, green and red OLEDs. Furthermore, the OLED exhibiting a stacked architecture may comprise a charge generation layer (CGL), which is typically located between two OLED subunits and typically consists of a n-doped and p-doped layer with the n-doped layer of one CGL being typically located closer to the anode layer.

In one embodiment of the invention, the optoelectronic device is an OLED, which comprises two or more emission layers between anode and cathode. In particular, this so-called tandem OLED comprises three emission layers, wherein one emission layer emits red light, one emission layer emits green light and one emission layer emits blue light, and optionally may comprise further layers such as charge generation layers, blocking or transporting layers between the individual emission layers. In a further embodiment, the emission layers are adjacently stacked. In a further embodiment, the tandem OLED comprises a charge generation layer between each two emission layers. In addition, adjacent emission layers or emission layers separated by a charge generation layer may be merged.

The substrate may be formed by any material or composition of materials. Most frequently, glass slides are used as substrates. Alternatively, thin metal layers (e.g., copper, gold, silver or aluminum films) or plastic films or slides may be used. This may allow for a higher degree of flexibility. The anode layer A is mostly composed of materials allowing to obtain an (essentially) transparent film. As at least one of both electrodes should be (essentially) transparent in order to allow light emission from the OLED, either the anode layer A or the cathode layer C is transparent. Preferably, the anode layer A comprises a large content or even consists of transparent conductive oxides (TCOs). Such anode layer A may, for example, comprise indium tin oxide, aluminum zinc oxide, fluorine doped tin oxide, indium zinc oxide, PbO, SnO, zirconium oxide, molybdenum oxide, vanadium oxide, tungsten oxide, graphite, doped Si, doped Ge, doped GaAs, doped polyaniline, doped polypyrrol and/or doped polythiophene.

The anode layer A (essentially) may consist of indium tin oxide (ITO) (e.g., $(InO_3)_{0.9}(SnO_2)_{0.1}$). The roughness of the anode layer A caused by the transparent conductive oxides (TCOs) may be compensated by using a hole injection layer (HIL). Further, the HIL may facilitate the injection of quasi charge carriers (i.e., holes) in that the transport of the quasi charge carriers from the TCO to the hole transport layer (HTL) is facilitated. The hole injection layer (HIL) may comprise poly-3,4-ethylendioxy thiophene (PEDOT), polystyrene sulfonate (PSS), $MoO_2$, $V_2O_5$, CuPC or CuI, in particular a mixture of PEDOT and PSS. The hole injection layer (HIL) may also prevent the diffusion of metals from the anode layer A into the hole transport layer (HTL). The HIL may, for example, comprise PEDOT:PSS (poly-3,4-ethylendioxy thiophene: polystyrene sulfonate), PEDOT (poly-3,4-ethylendioxy thiophene), mMTDATA (4,4',4"-tris[phenyl(m-tolyl)amino]triphenylamine), Spiro-TAD (2,2',7,7'-tetrakis(n,n-diphenylamino)-9,9'-spirobifluorene), DNTPD (N1,N1'-(biphenyl-4,4'-diyl) bis(N1-phenyl-N4,N4-di-m-tolylbenzene-1,4-diamine), NPB (N,N'-nis-(1-naphthalenyl)-N,N'-bis-phenyl-(1,1'-biphenyl)-4,4'-diamine), NPNPB (N,N'-diphenyl-N,N'-di-[4-(N,N-diphenyl-amino)phenyl]benzidine), MeO-TPD (N,N,N',N'-tetrakis(4-methoxyphenyl)benzidine), HAT-CN (1,4,5,8,9,11-hexaazatriphenylen-hexacarbonitrile) and/or Spiro-NPD (N,N'-diphenyl-N,N'-bis-(1-naphthyl)-9,9'-spirobifluorene-2,7-diamine).

Adjacent to the anode layer A or the hole injection layer (HIL), a hole transport layer (HTL) is typically located. Herein, any hole transport compound may be used. For example, electron-rich heteroaromatic compounds such as triarylamines and/or carbazoles may be used as hole transport compound. The HTL may decrease the energy barrier between the anode layer A and the light-emitting layer EML. The hole transport layer (HTL) may also be an electron blocking layer (EBL). Preferably, hole transport compounds bear comparably high energy levels of their triplet states T1. For example, the hole transport layer (HTL) may comprise a star-shaped heterocycle such as tris(4-carbazoyl-9-ylphenyl)amine (TCTA), poly-TPD (poly(4-butylphenyl-diphenyl-amine)), [alpha]-NPD (poly(4-butylphenyl-diphenyl-amine)), TAPC (4,4'-cyclohexyliden-bis[N,N-bis(4-methylphenyl)benzenamine]), 2-TNATA (4,4',4"-tris[2-naphthyl(phenyl)amino]triphenylamine), Spiro-TAD, DNTPD, NPB, NPNPB, MeO-TPD, HAT-CN and/or TrisPcz (9,9'-diphenyl-6-(9-phenyl-9H-carbazol-3-yl)-9H,9'H-3,3'-bicarbazole). In addition, the HTL may comprise a p-doped layer, which may be composed of an inorganic or organic dopant in an organic hole-transporting matrix. Transition metal oxides such as vanadium oxide, molybdenum oxide or tungsten oxide may, for example, be used as inorganic dopant. Tetrafluorotetracyanoquinodimethane ($F_4$-TCNQ), copper-pentafluorobenzoate (Cu(I)pFBz) or transition metal complexes may, for example, be used as organic dopant.

The EBL may, for example, comprise mCP (1,3-bis(carbazol-9-yl)benzene), TCTA, 2-TNATA, mCBP (3,3-di(9H-carbazol-9-yl)biphenyl), tris-Pcz, CzSi (9-(4-tert-butylphenyl)-3,6-bis(triphenylsilyl)-9H-carbazole), and/or DCB (N,N'-dicarbazolyl-1,4-dimethylbenzene).

Adjacent to the hole transport layer (HTL), the light-emitting layer EML is typically located. The light-emitting layer EML comprises at least one light emitting molecule. Particularly, the EML comprises at least one light emitting molecule according to the invention E. In one embodiment, the light-emitting layer comprises only the organic molecules according to the invention. Typically, the EML additionally comprises one or more host materials H. For example, the host material H is selected from CBP (4,4'-Bis-(N-carbazolyl)-biphenyl), mCP, mCBP Sif87 (dibenzo[b,d]thiophen-2-yltriphenylsilane), CzSi, Sif88 (dibenzo[b,d]thiophen-2-yl)diphenylsilane), DPEPO (bis[2-(diphenylphosphino)phenyl] ether oxide), 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole, 9-[3,5-bis(2-dibenzothiophenyl)phenyl]-9H-carbazole, T2T (2,4,6-tris(biphenyl-3-yl)-1,3,5-triazine), T3T (2,4,6-tris(triphenyl-3-yl)-1,3,5-triazine) and/or TST (2,4,6-tris(9,9'-spirobifluorene-2-yl)-1,3,5-triazine). The host material H typically should be selected to exhibit first triplet (T1) and first singlet (S1) energy levels, which are energetically higher than the first triplet (T1) and first singlet (S1) energy levels of the organic molecule.

In one embodiment of the invention, the EML comprises a so-called mixed-host system with at least one hole-dominant host and one electron-dominant host. In a particular embodiment, the EML comprises exactly one light emitting organic molecule according to the invention and a mixed-host system comprising T2T as electron-dominant host and a host selected from CBP, mCP, mCBP, 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole and 9-[3,5-bis(2-dibenzothiophenyl)phenyl]-9H-carbazole as hole-dominant host. In a further embodiment the EML comprises 50-80 % by weight, preferably 60-75 % by weight of a host selected from CBP, mCP, mCBP, 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole and 9-[3,5-bis(2-dibenzothiophenyl)phenyl]-9H-carbazole; 10-45 % by weight, preferably 15-30 % by weight of T2T and 5-40 % by weight, preferably 10-30 % by weight of light emitting molecule according to the invention.

Adjacent to the light-emitting layer EML, an electron transport layer (ETL) may be located. Herein, any electron transporter may be used. Exemplarily, electron-poor compounds such as, e.g., benzimidazoles, pyridines, triazoles, oxadiazoles (e.g., 1,3,4-oxadiazole), phosphinoxides and sulfone, may be used. An electron transporter may also be a star-shaped heterocycle such as 1,3,5-tri(1-phenyl-1H-benzo[d]imidazol-2-yl)phenyl (TPBi). The ETL may comprise NBphen (2,9-bis(naphthalen-2-yl)-4,7-diphenyl-1,10-phenanthroline), $Alq_3$ (Aluminum-tris(8-hydroxyquinoline)), TSPO1 (diphenyl-4-triphenylsilylphenyl-phosphinoxide), BPyTP2 (2,7-di(2,2'-bipyridin-5-yl)triphenyle), Sif87 (dibenzo[b,d]thiophen-2-yltriphenylsilane), Sif88 (dibenzo[b,d]thiophen-2-yl)diphenylsilane), BmPyPhB (1,3-bis[3,5-di(pyridin-3-yl)phenyl]benzene) and/or BTB (4,4'-bis-[2-(4,6-diphenyl-1,3,5-triazinyl)]-1,1'-biphenyl). Optionally, the ETL may be doped with materials such as Liq. The electron transport layer (ETL) may also block holes or a holeblocking layer (HBL) is introduced.

The HBL may, for example, comprise BCP (2,9-dimethyl-4,7-diphenyl-1,10-phenanthroline = Bathocuproine), BAlq (bis(8-hydroxy-2-methylquinoline)-(4-phenylphenoxy)aluminum), NBphen (2,9-bis(naphthalen-2-yl)-4,7-diphenyl-1,10-phenanthroline), $Alq_3$ (Aluminum-tris(8-hydroxyquinoline)), TSPO1 (diphenyl-4-triphenylsilylphenyl-phosphinoxide), T2T (2,4,6-tris(biphenyl-3-yl)-1,3,5-triazine), T3T (2,4,6-tris(triphenyl-3-yl)-1,3,5-triazine), TST (2,4,6-tris(9,9'-spirobifluorene-2-yl)-1,3,5-triazine), and/or TCB/TCP (1,3,5-tris(N-carbazolyl)benzol/ 1,3,5-tris(carbazol)-9-yl) benzene).

Adjacent to the electron transport layer (ETL), a cathode layer C may be located.The cathode layer C may, for example, comprise or may consist of a metal (e.g., Al, Au, Ag, Pt, Cu, Zn, Ni, Fe, Pb, LiF, Ca, Ba, Mg, In, W, or Pd) or a metal alloy. For practical reasons, the cathode layer may also consist of (essentially) intransparent metals such as Mg, Ca or Al. Alternatively or additionally, the cathode layer C may also comprise graphite and/or carbon nanotubes (CNTs). Alternatively, the cathode layer C may also consist of nanoscalic silver wires.

An OLED may further, optionally, comprise a protection layer between the electron transport layer (ETL) and the cathode layer C (which may be designated as electron injection layer (EIL)). This layer may comprise lithium fluoride, cesium fluoride, silver, Liq (8-hydroxyquinolinolatolithium), $Li_2O$, $BaF_2$, MgO and/or NaF.

Optionally, the electron transport layer (ETL) and/or a hole blocking layer (HBL) may also comprise one or more

host compounds H.

In order to modify the emission spectrum and/or the absorption spectrum of the light-emitting layer EML further, the light-emitting layer EML may further comprise one or more further emitter molecules F. Such an emitter molecule F may be any emitter molecule known in the art. Preferably such an emitter molecule F is a molecule with a structure differing from the structure of the molecules according to the invention E. The emitter molecule F may optionally be a TADF emitter. Alternatively, the emitter molecule F may optionally be a fluorescent and/or phosphorescent emitter molecule which is able to shift the emission spectrum and/or the absorption spectrum of the light-emitting layer EML. Exemplarily, the triplet and/or singlet excitons may be transferred from the organic emitter molecule according to the invention to the emitter molecule F before relaxing to the ground state S0 by emitting light typically red-shifted in comparison to the light emitted by an organic molecule. Optionally, the emitter molecule F may also provoke two-photon effects (i.e., the absorption of two photons of half the energy of the absorption maximum).

Optionally, an optoelectronic device (e.g., an OLED) may, for example, be an essentially white optoelectronic device. For example, such a white optoelectronic device may comprise at least one (deep) blue emitter molecule and one or more emitter molecules emitting green and/or red light. Then, there may also optionally be energy transmittance between two or more molecules as described above.

As used herein, if not defined more specifically in the particular context, the designation of the colors of emitted and/or absorbed light is as follows:

| | |
|---|---|
| violet: | wavelength range of >380-420 nm; |
| deep blue: | wavelength range of >420-480 nm; |
| sky blue: | wavelength range of >480-500 nm; |
| green: | wavelength range of >500-560 nm; |
| yellow: | wavelength range of >560-580 nm; |
| orange: | wavelength range of >580-620 nm; |
| red: | wavelength range of >620-800 nm. |

With respect to emitter molecules, such colors refer to the emission maximum. Therefore, for example, a deep blue emitter has an emission maximum in the range of from >420 to 480 nm, a sky blue emitter has an emission maximum in the range of from >480 to 500 nm, a green emitter has an emission maximum in a range of from >500 to 560 nm, a red emitter has an emission maximum in a range of from >620 to 800 nm.

A deep blue emitter may preferably have an emission maximum of below 480 nm, more preferably below 470 nm, even more preferably below 465 nm or even below 460 nm. It will typically be above 420 nm, preferably above 430 nm, more preferably above 440 nm or even above 450 nm.

A green emitter has an emission maximum of below 560 nm, more preferably below 550 nm, even more preferably below 545 nm or even below 540 nm. It will typically be above 500 nm, more preferably above 510 nm, even more preferably above 515 nm or even above 520 nm.

Accordingly, a further aspect of the present invention relates to an OLED, which exhibits an external quantum efficiency at 1000 cd/$m^2$ of more than 8 %, more preferably of more than 10 %, more preferably of more than 13 %, even more preferably of more than 15 % or even more than 20 % and/or exhibits an emission maximum between 420 nm and 500 nm, preferably between 430 nm and 490 nm, more preferably between 440 nm and 480 nm, even more preferably between 450 nm and 470 nm and/or exhibits a LT80 value at 500 cd/$m^2$ of more than 100 h, preferably more than 200 h, more preferably more than 400 h, even more preferably more than 750 h or even more than 1000 h. Accordingly, a further aspect of the present invention relates to an OLED, whose emission exhibits a CIEy color coordinate of less than 0.45, preferably less than 0.30, more preferably less than 0.20 or even more preferably less than 0.15 or even less than 0.10.

A further aspect of the present invention relates to an OLED, which emits light at a distinct color point. According to the present invention, the OLED emits light with a narrow emission band (small full width at half maximum (FWHM)). In one aspect, the OLED according to the invention emits light with a FWHM of the main emission peak of less than 0.25 eV, preferably less than 0.20 eV, more preferably less than 0.17 eV, even more preferably less than 0.15 eV or even less than 0.13 eV.

A further aspect of the present invention relates to an OLED, which emits light with CIEx and CIEy color coordinates close to the CIEx (= 0.131) and CIEy (= 0.046) color coordinates of the primary color blue (CIEx = 0.131 and CIEy = 0.046) as defined by ITU-R Recommendation BT.2020 (Rec. 2020) and thus is suited for the use in Ultra High Definition (UHD) displays, e.g. UHD-TVs. Accordingly, a further aspect of the present invention relates to an OLED, whose emission exhibits a CIEx color coordinate of between 0.02 and 0.30, preferably between 0.03 and 0.25, more preferably between 0.05 and 0.20 or even more preferably between 0.08 and 0.18 or even between 0.10 and 0.15 and/ or a CIEy color coordinate of between 0.00 and 0.45, preferably between 0.01 and 0.30, more preferably between 0.02 and 0.20 or even

more preferably between 0.03 and 0.15 or even between 0.04 and 0.10.

In a further embodiment of the invention, the composition has a photoluminescence quantum yield (PLQY) of more than 20 %, preferably more than 30 %, more preferably more than 35 %, more preferably more than 40 %, more preferably more than 45 %, more preferably more than 50 %, more preferably more than 55 %, even more preferably more than 60 % or even more than 70 % at room temperature.

In a further aspect, the invention relates to a method for producing an optoelectronic component. In this case an organic molecule of the invention is used.

In a further aspect, the invention relates to a method for generating light at a wavelength range from 440 nm to 470 nm, comprising the steps of:

(i) providing an optoelectronic device comprising an organic molecule of the invention and
(ii) applying an electrical current to said optoelectronic device.

The optoelectronic device, in particular the OLED according to the present invention can be fabricated by any means of vapor deposition and/ or liquid processing. Accordingly, at least one layer is

- prepared by means of a sublimation process,
- prepared by means of an organic vapor phase deposition process,
- prepared by means of a carrier gas sublimation process,
- solution processed or printed.

The methods used to fabricate the optoelectronic device, in particular the OLED according to the present invention are known in the art. The different layers are individually and successively deposited on a suitable substrate by means of subsequent deposition processes. The individual layers may be deposited using the same or differing deposition methods.

Vapor deposition processes, for example, comprise thermal (co)evaporation, chemical vapor deposition and physical vapor deposition. For active matrix OLED display, an AMOLED backplane is used as substrate. The individual layer may be processed from solutions or dispersions employing adequate solvents. Solution deposition process, for example, comprise spin coating, dip coating and jet printing. Liquid processing may optionally be carried out in an inert atmosphere (e.g., in a nitrogen atmosphere) and the solvent may be completely or partially removed by means known in the state of the art.

In another aspect, the invention also refers to an organic light-emitting molecule comprising or consisting of a structure of formula 100

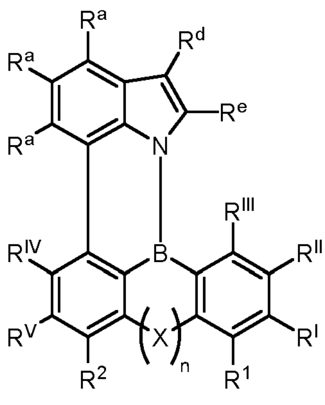

Formula 100

wherein

n = 0 or 1;

X is at each occurrence independently selected from the group consisting of a direct bond, $CR^3R^4$, $C=CR^3R^4$, C=O, $C=NR^3$, $NR^3$, O, $SiR^3R^4$, S, S(O) and $S(O)_2$;

$R^1$, $R^2$, $R^3$, $R^4$, $R^I$, $R^{II}$, $R^{III}$, $R^{IV}$ and $R^V$ is selected from the group consisting of:

hydrogen, deuterium, $N(R^5)_2$, $OR^5$, $Si(R^5)_3$, $B(OR^5)_2$, $B(R^5)_2$, $OSO_2R^5$, $CF_3$, CN, F, Br, I, $C_1$-$C_{40}$-alkyl,

which is optionally substituted with one or more substituents $R^5$ and wherein one or more non-adjacent $CH_2$-groups are optionally substituted by $R^5C=CR^5$, $C\equiv C$, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-alkoxy,

which is optionally substituted with one or more substituents $R^5$ and wherein one or more non-adjacent $CH_2$-groups are optionally substituted by $R^5C=CR^5$, $C\equiv C$, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-thioalkoxy,

which is optionally substituted with one or more substituents $R^5$ and wherein one or more non-adjacent $CH_2$-groups are optionally substituted by $R^5C=CR^5$, $C\equiv C$, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkenyl,

which is optionally substituted with one or more substituents $R^5$ and wherein one or more non-adjacent $CH_2$-groups are optionally substituted by $R^5C=CR^5$, $C\equiv C$, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkynyl,

which is optionally substituted with one or more substituents $R^5$ and wherein one or more non-adjacent $CH_2$-groups are optionally substituted by $R^5C=CR^5$, $C\equiv C$, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_6$-$C_{60}$-aryl,

which is optionally substituted with one or more substituents $R^5$; and $C_2$-$C_{57}$-heteroaryl, which is optionally substituted with one or more substituents $R^5$;

$R^d$ and $R^e$ is independently selected from the group consisting of: hydrogen, deuterium, $CF_3$, CN, F, Br, I, $C_1$-$C_{40}$-alkyl,

which is optionally substituted with one or more substituents $R^a$ and wherein one or more non-adjacent $CH_2$-groups are optionally substituted by $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_6$-$C_{60}$-aryl,

which is optionally substituted with one or more substituents $R^a$; and $C_2$-$C_{57}$-heteroaryl, which is optionally substituted with one or more substituents $R^a$;

$R^a$ are at each occurrence independently selected from the group consisting of: hydrogen, deuterium, $N(R^5)_2$, $OR^5$, $Si(R^5)_3$, $B(OR^5)_2$, $B(R^5)_2$, $OSO_2R^5$, $CF_3$, CN, F, Br, I,
$C_1$-$C_{40}$-alkyl,

which is optionally substituted with one or more substituents $R^5$ and wherein one or more non-adjacent $CH_2$-groups are optionally substituted by $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-alkoxy,

which is optionally substituted with one or more substituents $R^5$ and

wherein one or more non-adjacent $CH_2$-groups are optionally substituted by $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-thioalkoxy,

which is optionally substituted with one or more substituents $R^5$ and wherein one or more non-adjacent $CH_2$-groups are optionally substituted by $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkenyl,

which is optionally substituted with one or more substituents $R^5$ and wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkynyl,

which is optionally substituted with one or more substituents $R^5$ and wherein one or more non-adjacent $CH_2$-groups are optionally substituted by $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_6$-$C_{60}$-aryl,
which is optionally substituted with one or more substituents $R^5$; and
$C_2$-$C_{57}$-heteroaryl,
which is optionally substituted with one or more substituents $R^5$;
$R^5$ is at each occurrence independently from another selected from the group consisting of: hydrogen, deuterium, $N(R^6)_2$, $OR^6$, $Si(R^6)_3$, $B(OR^6)_2$, $B(R^6)_2$,, $OSO_2R^6$, $CF_3$, CN, F, Br, I,
$C_1$-$C_{40}$-alkyl,

which is optionally substituted with one or more substituents $R^6$ and wherein one or more non-adjacent $CH_2$-groups are optionally substituted by $R^6C=CR^6$, C=C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S or $CONR^6$;

$C_1$-$C_{40}$-alkoxy,

which is optionally substituted with one or more substituents $R^6$ and wherein one or more non-adjacent $CH_2$-groups are optionally substituted by $R^6C=CR^6$, C=C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S or $CONR^6$;

$C_1$-$C_{40}$-thioalkoxy,

which is optionally substituted with one or more substituents $R^6$ and wherein one or more non-adjacent $CH_2$-groups are optionally substituted by $R^6C=CR^6$, C=C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S or $CONR^6$;

$C_2$-$C_{40}$-alkenyl,

which is optionally substituted with one or more substituents $R^6$ and wherein one or more non-adjacent $CH_2$-groups are optionally substituted by $R^6C=CR^6$, C=C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S or $CONR^6$;

$C_2$-$C_{40}$-alkynyl,

which is optionally substituted with one or more substituents $R^6$ and wherein one or more non-adjacent $CH_2$-groups are optionally substituted by $R^6C=CR^6$, C≡C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S or $CONR^6$;

$C_6$-$C_{60}$-aryl,

which is optionally substituted with one or more substituents $R^6$; and $C_2$-$C_{57}$-heteroaryl, which is optionally substituted with one or more substituents $R^6$;

$R^6$ is at each occurrence independently from another selected from the group consisting of: hydrogen, deuterium, OPh, $CF_3$, CN, F,
$C_1$-$C_5$-alkyl,
wherein one or more hydrogen atoms are optionally, independently from each other substituted by deuterium, CN, $CF_3$, or F;
$C_1$-$C_5$-alkoxy,
wherein one or more hydrogen atoms are optionally, independently from each other substituted by deuterium, CN, $CF_3$, or F;
$C_1$-$C_5$-thioalkoxy,
wherein one or more hydrogen atoms are optionally, independently from each other substituted by deuterium, CN, $CF_3$, or F;
$C_2$-$C_5$-alkenyl,
wherein one or more hydrogen atoms are optionally, independently from each other substituted by deuterium, CN, $CF_3$, or F;
$C_2$-$C_5$-alkynyl,
wherein one or more hydrogen atoms are optionally, independently from each other substituted by deuterium, CN, $CF_3$, or F;
$C_6$-$C_{18}$-aryl,

which is optionally substituted with one or more $C_1$-$C_5$-alkyl substituents; $C_2$-$C_{17}$-heteroaryl, which is optionally substituted with one or more $C_1$-$C_5$-alkyl substituents; N($C_6$-$C_{18}$-aryl)$_2$;

N($C_2$-$C_{17}$-heteroaryl)$_2$, and
N($C_2$-$C_{17}$-heteroaryl)($C_6$-$C_{18}$-aryl);
wherein the substituents $R^a$, $R^d$, $R^e$, $R^5$, independently from each other, optionally form a mono- or polycyclic, aliphatic, aromatic, heteroaromatic and/or benzo-fused ring system with one or more substituents $R^a$, $R^d$, $R^e$, $R^5$; and
wherein the substituents $R^1$, $R^2$, $R^3$, $R^4$, $R^5$, $R^I$, $R^{II}$, $R^{III}$, $R^{IV}$, $R^V$ independently from each other, optionally form a mono- or polycyclic, aliphatic, aromatic, heteroaromatic and/or benzo-fused ring system with one or more substituents $R^1$, $R^2$, $R^3$, $R^4$, $R^5$, $R^I$, $R^{II}$, $R^{III}$, $R^{IV}$, $R^V$.

## Examples

General synthesis scheme I

**AAV5**

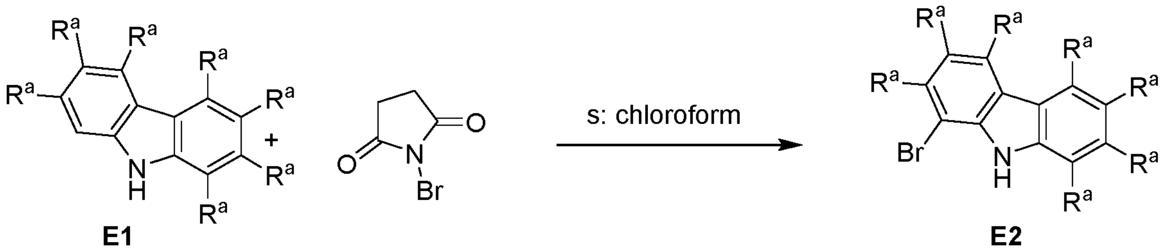


**E1** **E2**

**AAV6**

**E2** +

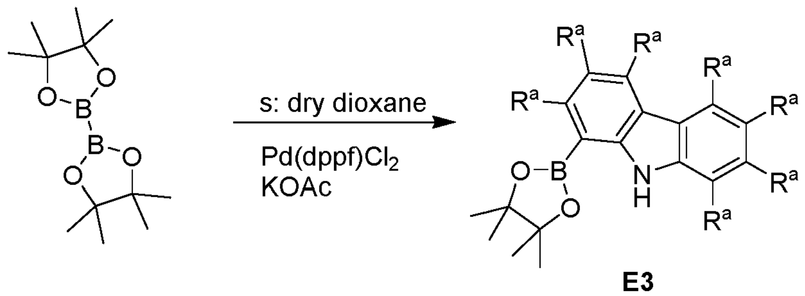


**E3**

**AAV5a**

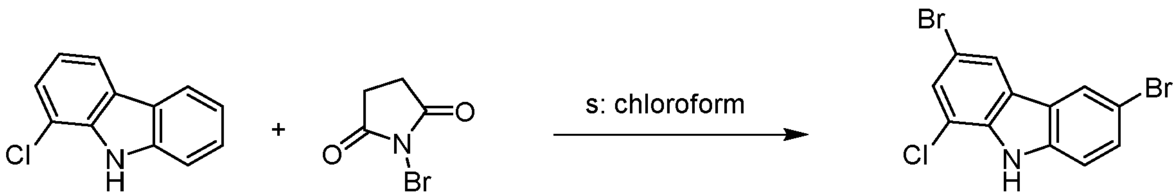


**E1a** **E2a**

**AAV6a**

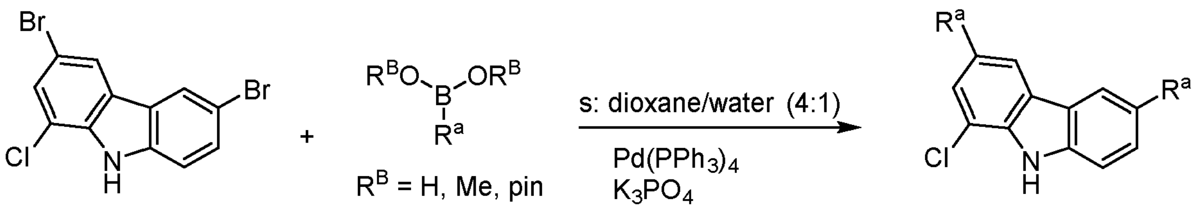


**E2a** **E5** **E2b**

**AAV6b**

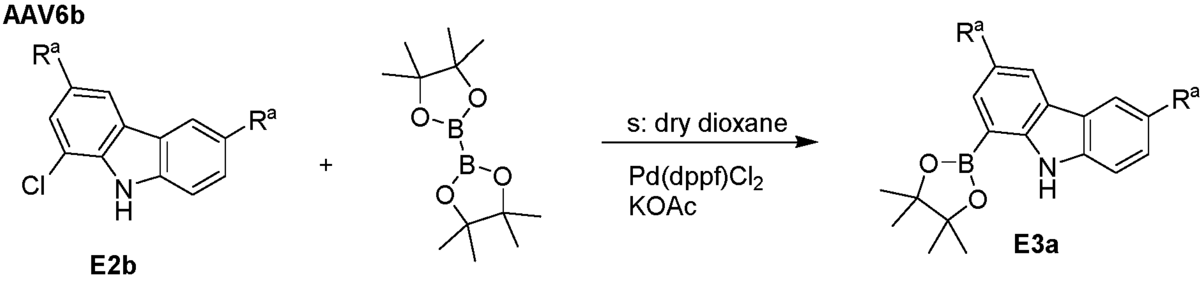


E2b E3a

**AAV7**

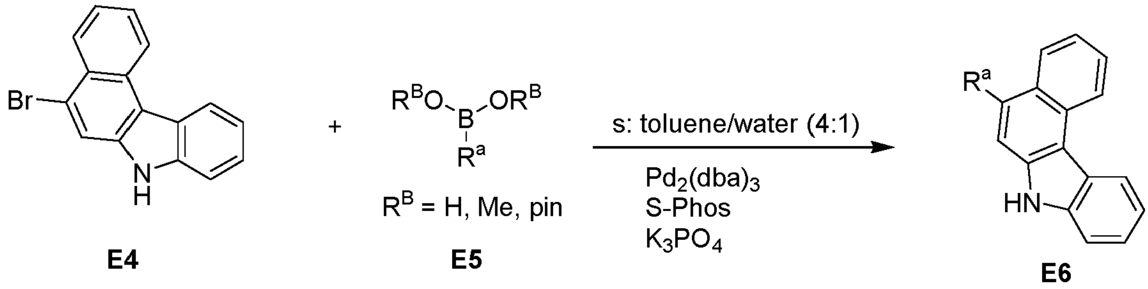


E4 E5 E6

**AAV7b**

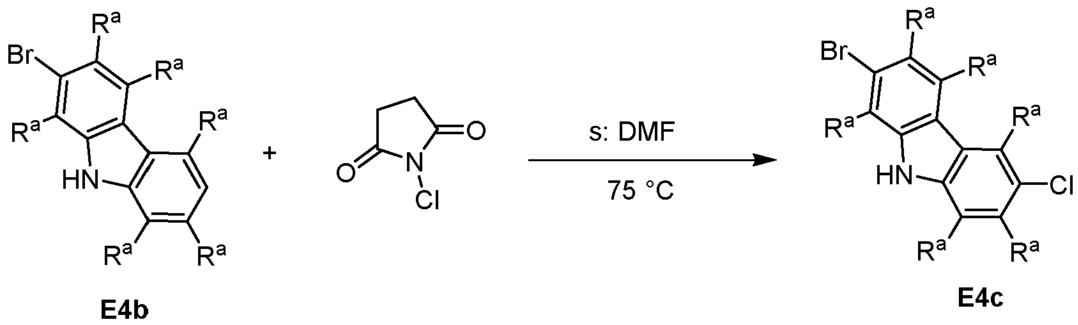


E4b E4c

**AAV8**

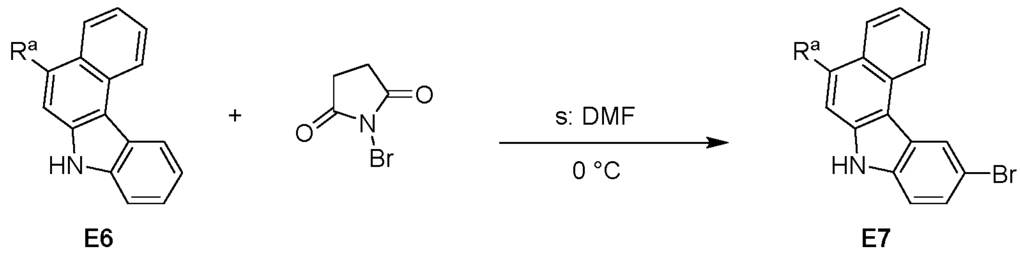


E6 E7

**AAV9**

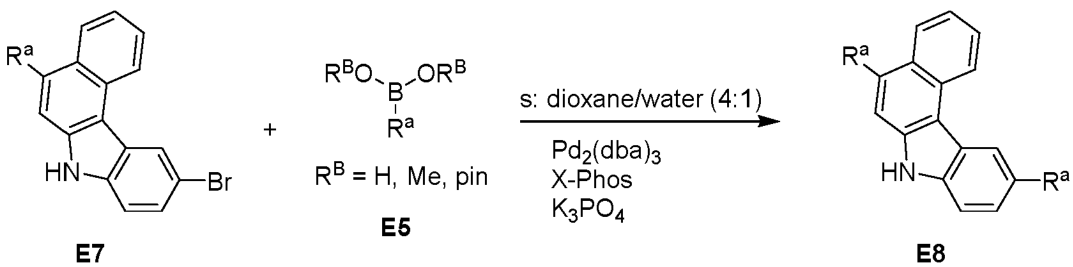


E7 E5 E8

**AAV9b**

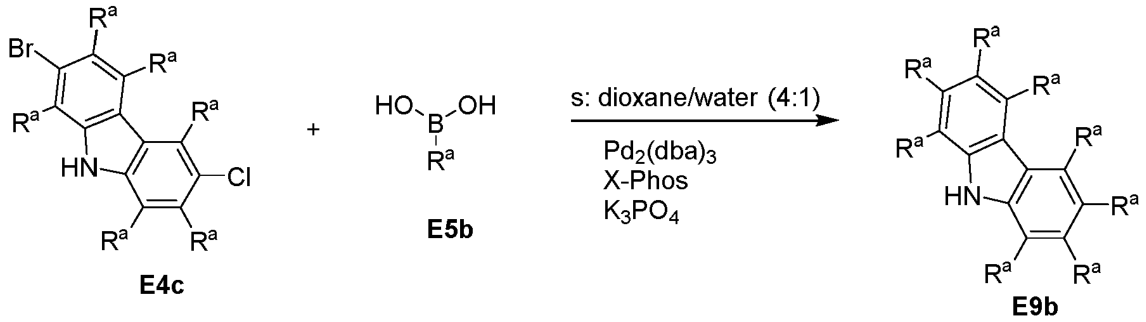


E4c E5b E9b

**AAV10**

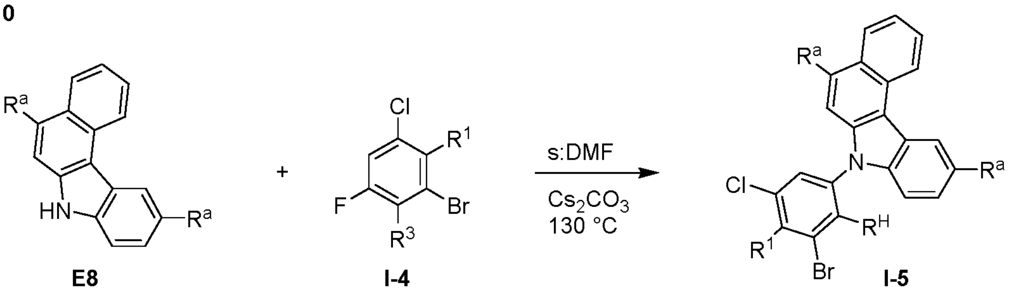


E8 I-4 I-5

**AAV10a**

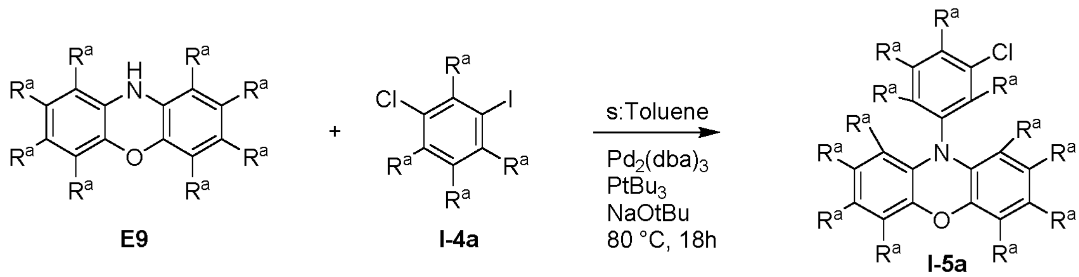


E9 I-4a I-5a

**AAV10b**

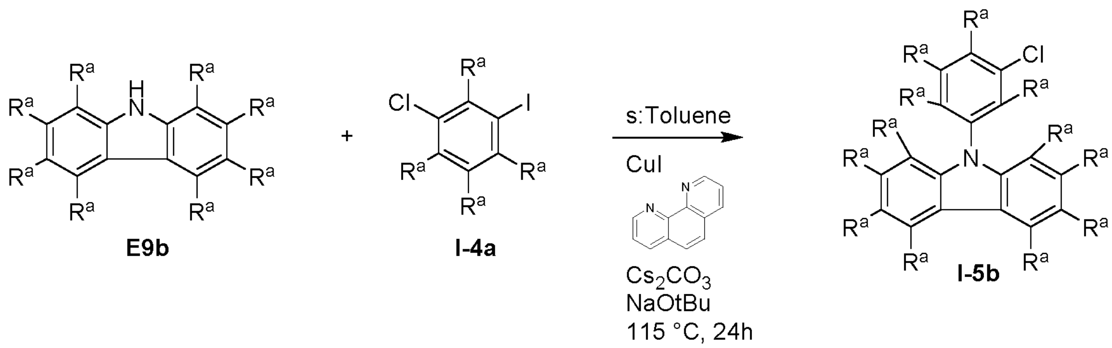


E9b I-4a I-5b

**AAV10c**

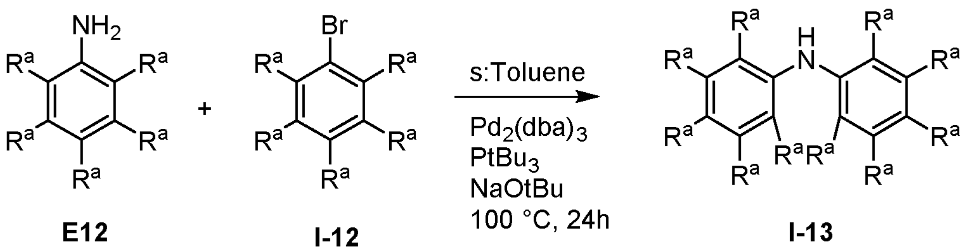


E12 I-12 I-13

**AAV10d**

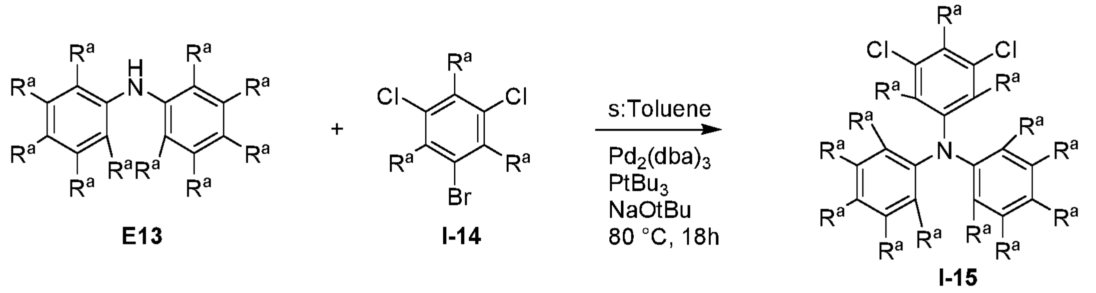


E13 + I-14 → I-15

**AAV10e**

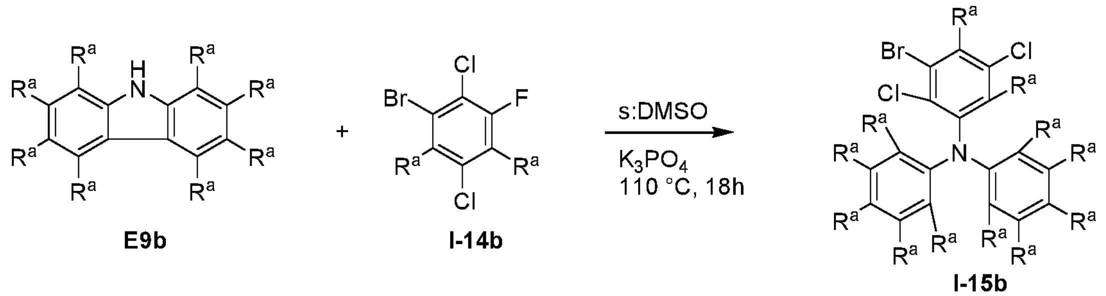


E9b + I-14b → I-15b

**AAV11**

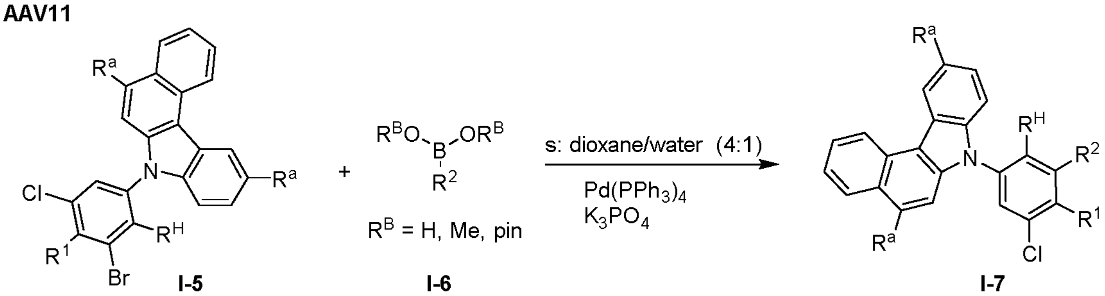


I-5 + I-6 → I-7

**AAV12**

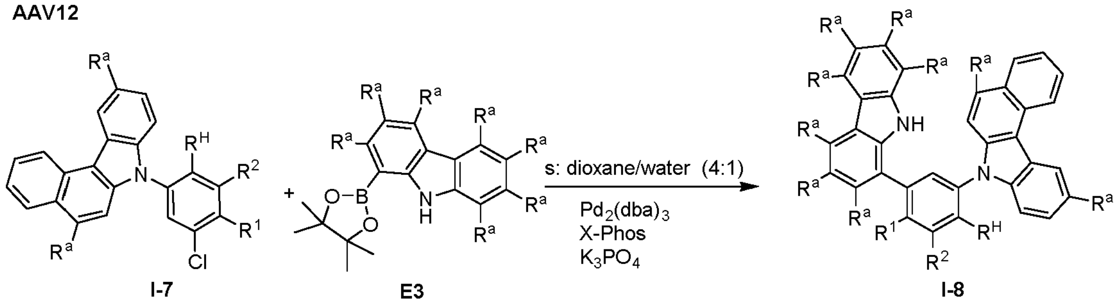


I-7 + E3 → I-8

**AAV12a**

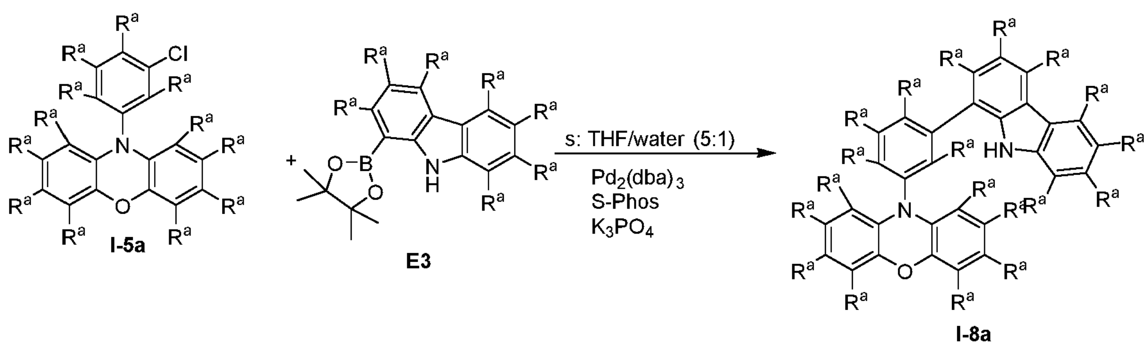


I-5a + E3 → I-8a

**AAV12b**

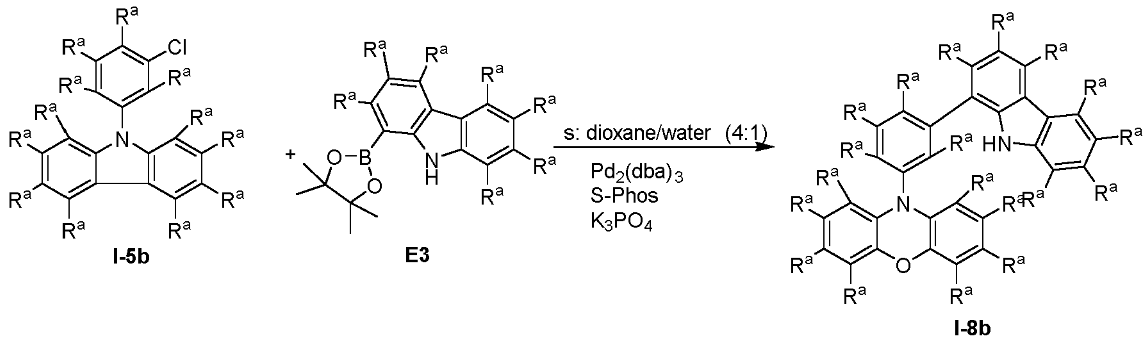


I-5b E3 I-8b

**AAV12c**

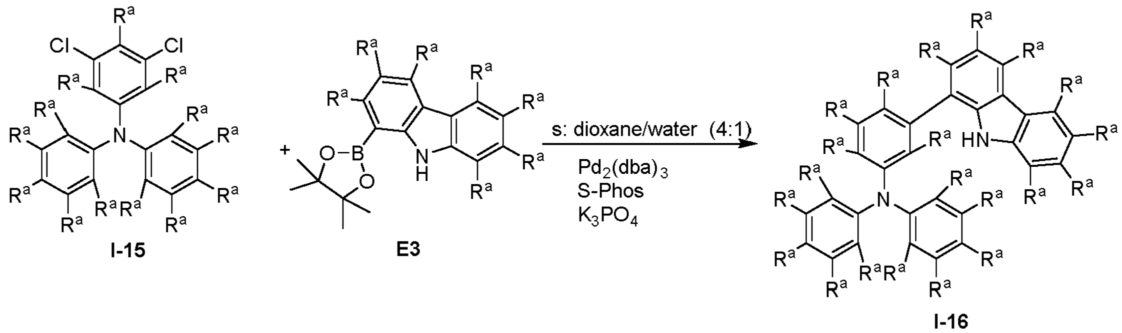


I-15 E3 I-16

**AAV12d**

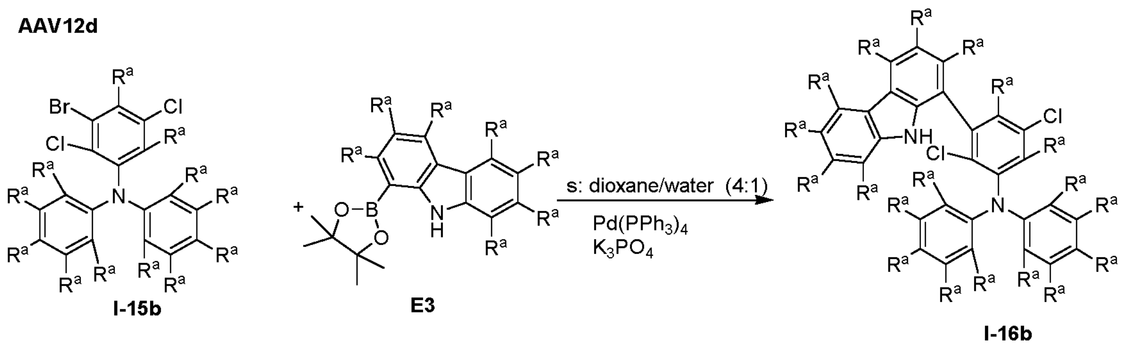


I-15b E3 I-16b

**AAV13**

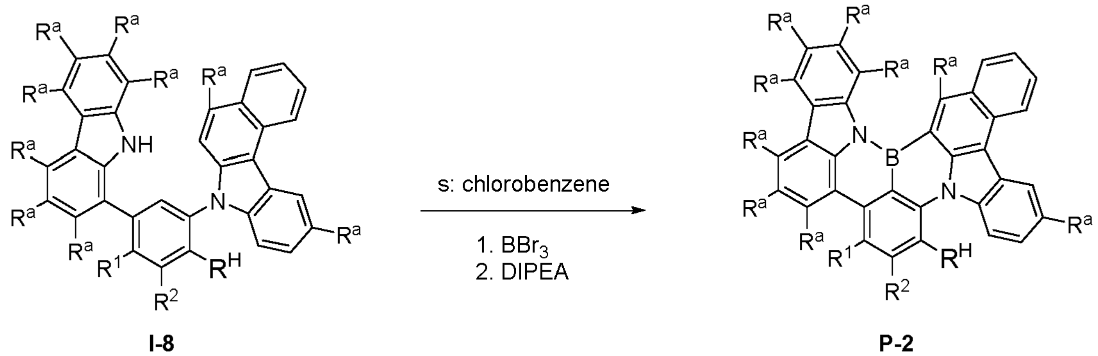


I-8 P-2

**AAV13a**

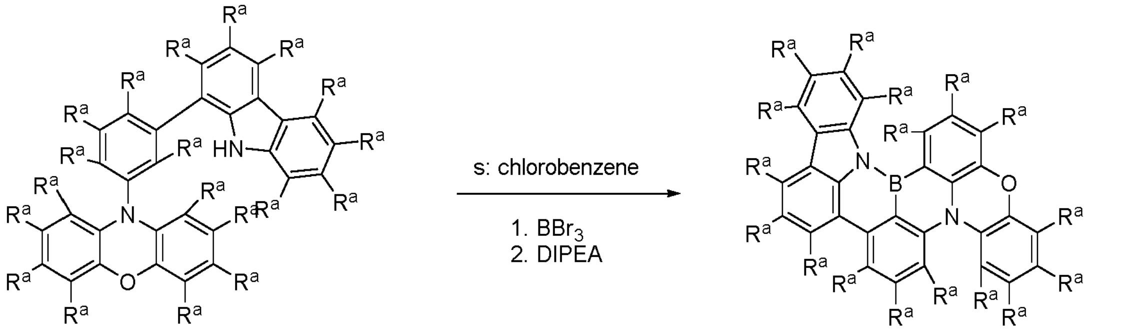


I-8a

P-2

**AAV13b**

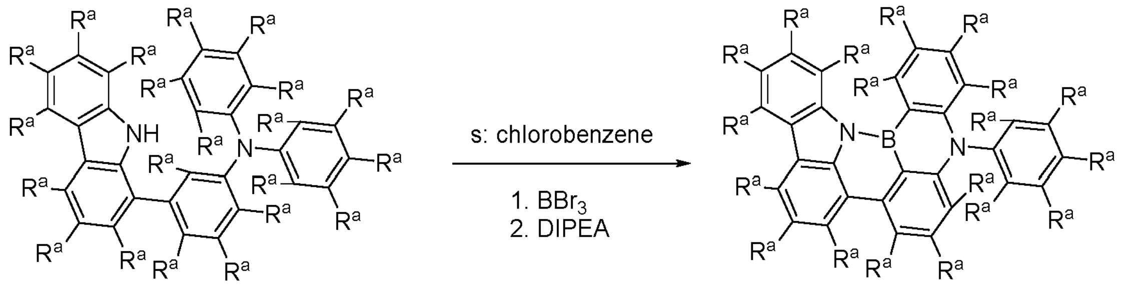


I-8b

P-2

**AAV14**

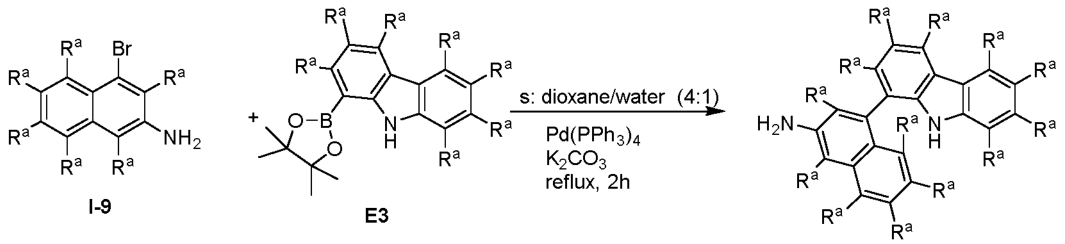


I-9

E3

I-10

**AAV15**

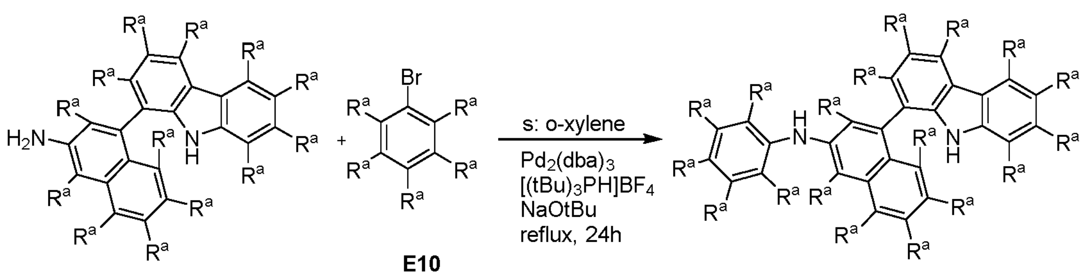


E10

I-11

I-10

**AAV16**

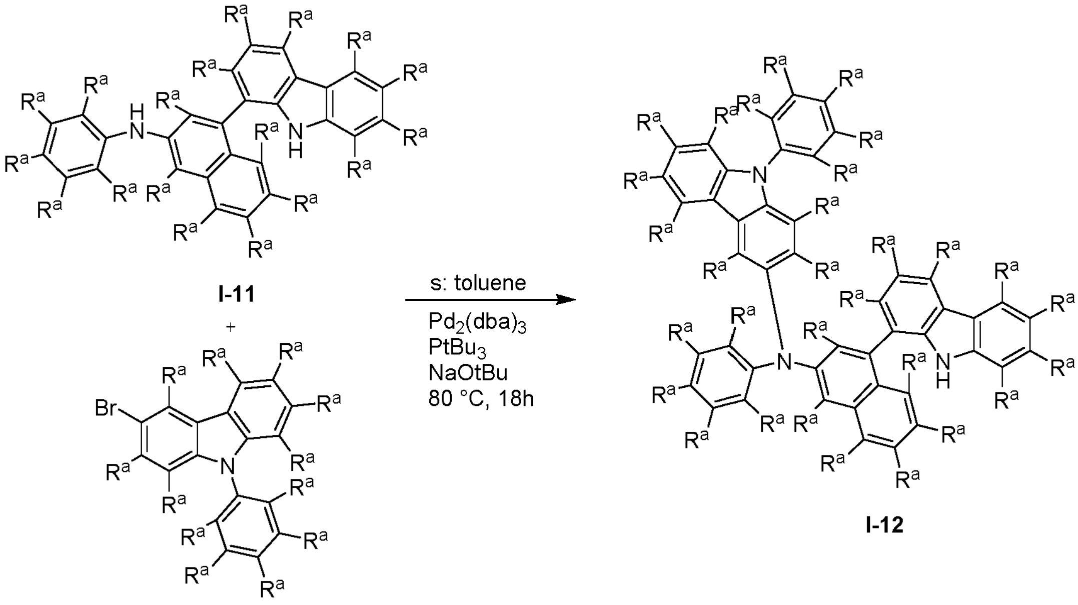


I-11 + E-11 → I-12

**AAV17**

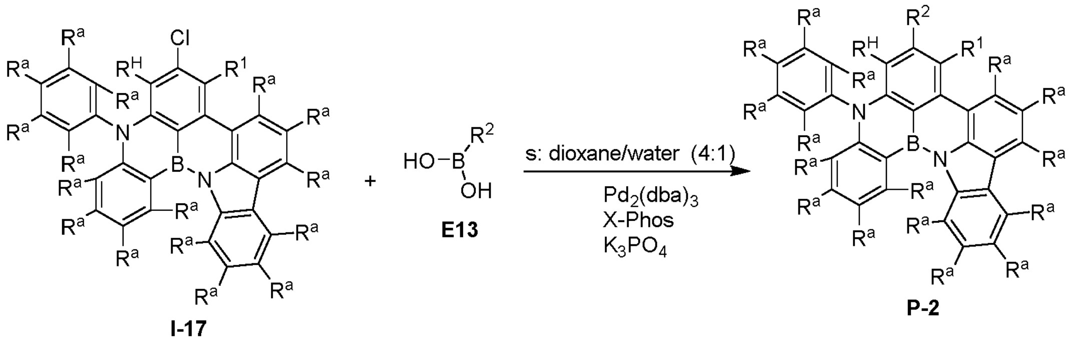


I-17 + E13 → P-2

**AAV18**

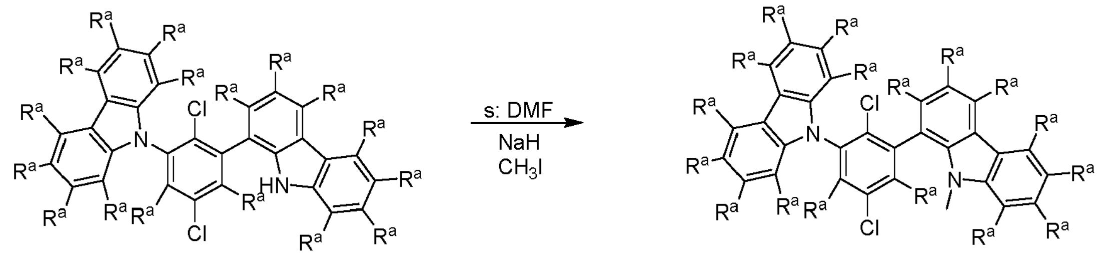


I-18 → I-19

**AAV19**

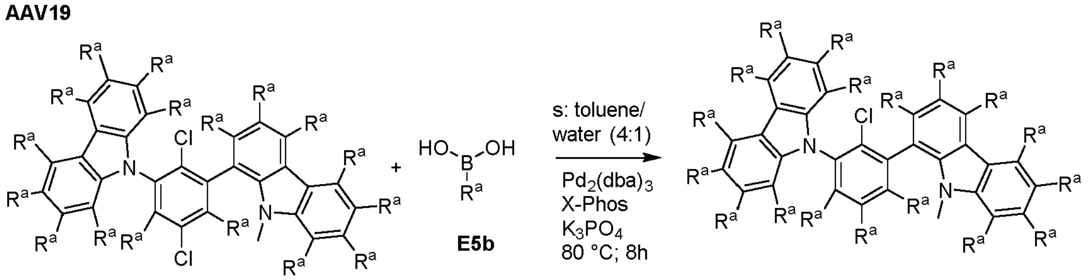


I-19 + E5b → I-20

**AAV20**

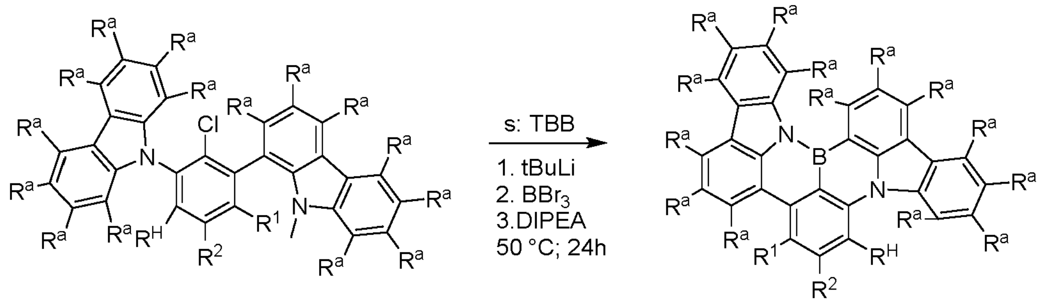


I-20

P2

*General procedure for synthesis:*

**AAV5:**

E1 (1.00 equivalents) is dissolved in dry chloroform or dichloromethane or DMF. N-bromosuccinimide (CAS: 128-08-5, 1.05 equivalents) is added in portions under nitrogen atmosphere at 0 °C. The mixture is stirred at room temperature for 2 h and subsequently extracted between chloroform and water and the combined organic layers concentrated under reduced pressure. The crude is purified by column chromatography or recrystallization and E2 is obtained as a solid.

**AAV6:**

E2 (1.00 equivalents), bis(pinacolato)diboron (CAS: 73183-34-3, 1.5 equivalents), [1,1'-bis(diphenylphosphino) ferrocene]palladium (II) dichloride (CAS: 72287-26-4, 0.02 equivalents) and potassium acetate (KOAc; CAS: 127-08-2, 3.00 equivalents) are stirred under nitrogen atmosphere in dry dioxane under reflux for 24 h. After cooling down to room temperature (rt) the reaction mixture is extracted between dichloromethane and water and the combined organic layers concentrated under reduced pressure. The crude is purified by column chromatography or recrystallization and E3 is obtained as a solid.

**AAV5a:**

**E1a** (1.00 equivalents) is dissolved in dry chloroform or dichloromethane or DMF. *N*-bromosuccinimide (CAS: 128-08-5, 2.70 equivalents) is added in portions under nitrogen atmosphere at 0 °C. After warming up to rt, stirring at room temperature is continued for 24 h. Subsequently, the mixture is extracted between chloroform and water. The combined organic layers are dried over $MgSO_4$, filtered and concentrated under reduced pressure. The crude is purified by column chromatography or recrystallization and **E2a** is obtained as a solid.

**AAV6a:**

**E2a** (1.0 equivalent), **E5** (2.50 equivalents), tetrakis(triphenylphosphine)palladium(0) (CAS-No. 14221-01-3, 0.08 equivalents), and $K_3PO_4$ (CAS-No. 7778-53-2, 5.0 equivalents) are reacted in a mixture of dioxane and water (4:1 by vol.) under reflux for 1 h. After cooling down to rt, the reaction mixture is extracted between ethyl acetate and water. The combined organic layers are dried over MgSO4, filtered and concentrated under reduced pressure. After purification through recrystallization or column chromatography, compound **E2b** is obtained as a solid.

**AAV6b:**

**E2b** (1.00 equivalents), bis(pinacolato)diboron (CAS: 73183-34-3, 2.0 equivalents), tris(dibenzylideneacetone) dipalladium(0) (CAS: 51364-51-3, 0.02 equivalents), X-Phos (CAS: 564483-18-7, 0.08 equivalents) and potassium acetate (KOAc; CAS: 127-08-2, 4.00 equivalents) are stirred under nitrogen atmosphere in dry dioxane at 100 °C for 1 h. After cooling down to room temperature (rt) the reaction mixture is extracted between ethyl acetate and water. The combined organic layers are dried over $MgSO_4$, filtered and concentrated under reduced pressure. The crude is purified by column chromatography or recrystallization and **E3a** is obtained as a solid.

**AAV7:**

**E4** (1.00 equivalents), **E5** (1.50 equivalents), tris(dibenzylideneacetone)-dipalladium(0) (CAS: 51364-51-3 , 0.01 equivalents), S-Phos (CAS: 657408-07-6, 0.04 eqivalents) and tribasic potassium phosphate (CAS: 7778-53-2, 3 0 equivalemts) are stirred under nitrogen atmosphere in dioxane/water (4:1 by vol.) under reflux. After cooling down to room temperature (rt) the reaction mixture is extracted between ethyl acetate and water. The combined organic layers are dried over $MgSO_4$, concentrated under reduced pressure. The crude is purified by column chromatography or recrystallization. E6 is obtained as a solid.

**AAV7b:**

**E4b** (1.00 equivalents) is dissolved in dry DMF. N-chlorosuccinimide (CAS: 128-09-6, 1.00 equivalents) is added in portions under nitrogen atmosphere at 75 °C. Temperature is kept at 75 °C for 2 h. Subsequently the reaction is quenched through addition of water and ethyl acetate. The phases are separated and the organic layer washed with water. The organic layer is dried over MgSO4, filtered and concentrated under reduced pressure. The crude is purified by column chromatography or recrystallization and **E4c** is obtained as a solid.

**AAV8:**

**E6** (1.00 equivalents) is dissolved in dry DMF. N-bromosuccinimide (CAS: 128-08-5, 1.00 equivalents) is added in portions under nitrogen atmosphere at 0 °C. Temperature is kept at 0 °C for 5 h. Subsequently the reaction is quenched through addition of water and ethyl acetate. The phases are separated and the organic layer washed with water. The organic layer is dried over MgSO4, filtered and concentrated under reduced pressure. The crude is purified by column chromatography or recrystallization and E7 is obtained as a solid.

**AAV9:** **E7** (1.0 equivalent), **E5** (2.5 equivalents), tris(dibenzylideneacetone)dipalladium(0) (CAS-No. 51364-51-3, 0.01 equivalents), X-PHOS (CAS-No. 564483-18-7, 0.04 equivalents) and $K_3PO_4$ (CAS-No. 7778-53-2, 5.0 equivalents) are reacted in a mixture of dioxane and water (4:1 by vol.) under reflux for 24 h. After cooling down to rt, the reaction mixture is extracted between ethyl acetate and water. The combined organic layers are dried over MgSO4, filtered and concentrated under reduced pressure. After purification through recrystallization or column chromatography, compound E8 is obtained as a solid.

**AAV9b:** E4c (1.0 equivalent), E5b (3.0 equivalents), tris(dibenzylideneacetone)dipalladium(0) (CAS-No. 51364-51-3, 0.01 equivalents), X-PHOS (CAS-No. 564483-18-7, 0.04 equivalents) and $K_3PO_4$ (CAS-No. 7778-53-2, 5.0 equivalents) are reacted in a mixture of dioxane and water (4:1 by vol.) under reflux for 24 h. After cooling down to rt, the reaction mixture is extracted between ethyl acetate and water. The combined organic layers are dried over MgSO4, filtered and concentrated under reduced pressure. After purification through recrystallization or column chromatography, compound E9b is obtained as a solid.

**AAV10:** A suspension of **E8** (1.0 equivalent), **I-4** (1.05 equivalents) and $Cs_2CO_3$ (CAS-No. 534-17-8, 3.0 equivalents) is stirred at 130 °C in dry DMF for 12 h. After cooling down to rt, water and ethyl acetate are added and the phases were separated. The combined organic layers are washed with water, dried over $MgSO_4$, filtered and concentrated. Purification of the crude product through recrystallization or column chromatography yields compound **I-5** as a solid.

**AAV10a:** A suspension of **E9** (1.05 equivalents), **I-4a** (1.0 equivalent), tris(dibenzylideneacetone)-dipalladium(0) (CAS-no. 51364-51-3, 0.02 equivalents), tri-tert-butylphosphine (CAS-no. 13716-12-6, 0.08 equivalents) and sodium tert-butoxide (CAS-no. 865-48-5, 2.5 equivalents) in degassed toluene and was stirred at 80 °C for 18 h. After cooling down to room temperature (rt) an aqueous workup was performed, followed by purification of the crude product through recrystallization or column chromatography. The desired compound **I-5a** was obtained as a solid.

**AAV10b:** A suspension of **E9b** (1.05 equivalents), **I-4a** (1.6 equivalent), Copper(I) iodide (CAS-no. 7681-65-4, 0.15 equivalents), 1,10-Phenanthroline (CAS-no. 66-71-7, 0.3 equivalents) and cesium carbonate (CAS-no. 534-17-8, 1.5 equivalents) in degassed DMF was stirred at 115 °C for 24 h. After cooling down to room temperature (rt) an aqueous workup was performed, followed by purification of the crude product through recrystallization or column chromatography. The desired compound **I-5b** was obtained as a solid.

**AAV10c:** A suspension of **E12** (1.0 equivalents), **I-12** (1.1 equivalent), tris(dibenzylideneacetone)-dipalladium(0) (CAS-no. 51364-51-3, 0.06 equivalents), tri-tert-butylphosphine (CAS-no. 13716-12-6, 0.12 equivalents) and sodium tert-butoxide (CAS-no. 865-48-5, 5.0 equivalents) in degassed toluene andwas stirred at 100 °C for 24 h. After cooling down to room temperature (rt) an aqueous workup was performed, followed by purification of the crude product through recrystallization or column chromatography. The desired compound **I-13** was obtained as a solid.

**AAV10d:** A suspension of **E13** (1.0 equivalents), **I-14** (1.0 equivalent), tris(dibenzylideneacetone)-dipalladium(0) (CAS-no. 51364-51-3, 0.01 equivalents), tri-tert-butylphosphine (CAS-no. 13716-12-6, 0.04 equivalents) and

sodium tert-butoxide (CAS-no. 865-48-5, 3.0 equivalents) in degassed toluene and was stirred at 80 °C for 18 h. After cooling down to room temperature (rt) an aqueous workup was performed, followed by purification of the crude product through recrystallization or column chromatography. The desired compound **I-15** was obtained as a solid.

**AAV10e:** A suspension of **E9b** (1.0 equivalent), **I-14b** (1.0 equivalents) and $K_3PO_4$ (CAS-No. 7778-53-2, 2.0 equivalents) is stirred at 110 °C in dry DMSO for 24 h. After cooling down to rt, water and ethyl acetate are added and the phases were separated. The combined organic layers are washed with water, dried over $MgSO_4$, filtered and concentrated. Purification of the crude product through recrystallization or column chromatography yields compound **I-15b** as a solid.

**AAV11: I-5** (1.0 equivalent), **I-6** (1.10 equivalents), tetrakis(triphenylphosphine)palladium(0) (CAS-No. 14221-01-3, 0.05 equivalents), and $K_3PO_4$ (CAS-No. 7778-53-2, 2.0 equivalents) are reacted in a mixture of dioxane and water (4:1 by vol.) under reflux for 24 h. After cooling down to rt, the reaction mixture is extracted between ethyl acetate and water. The combined organic layers are dried over MgSO4, filtered and concentrated under reduced pressure. After purification through recrystallization or column chromatography, compound **I-7** is obtained as a solid.

**AAV12: I-7** (1.0 equivalent), **E3** (1.3 equivalents), tris(dibenzylideneacetone)dipalladium(0) (CAS-No. 51364-51-3, 0.015 equivalents), X-PHOS (CAS-No. 564483-18-7, 0.06 equivalents) and $K_3PO_4$ (CAS-No. 7778-53-2, 3.6 equivalents) are reacted in a mixture of dioxane and water (4:1 by vol.) under reflux for 4 h. After cooling down to rt, the reaction mixture is extracted between ethyl acetate and water. The combined organic layers are dried over $MgSO_4$, filtered and concentrated under reduced pressure. After purification through recrystallization or column chromatography, compound **I-8** is obtained as a solid.

**AAV12a: I-5a** (1.0 equivalent), **E3** (1.3 equivalents), tris(dibenzylideneacetone)dipalladium(0) (CAS-No. 51364-51-3, 0.015 equivalents), S-PHOS (CAS-No. 657408-07-6, 0.06 equivalents) and $K_3PO_4$ (CAS-No. 7778-53-2, 3.6 equivalents) are reacted in a mixture of THF and water (5:1 by vol.) under reflux for 4 h. After cooling down to rt, the reaction mixture is extracted between ethyl acetate and water. The combined organic layers are dried over $MgSO_4$, filtered and concentrated under reduced pressure. After purification through recrystallization or column chromatography, compound **I-8a** is obtained as a solid.

**AAV12b: I-5b** (1.0 equivalent), **E3** (1.1 equivalents), tris(dibenzylideneacetone)dipalladium(0) (CAS-No. 51364-51-3, 0.015 equivalents), S-PHOS (CAS-No. 657408-07-6, 0.06 equivalents) and $K_3PO_4$ (CAS-No. 7778-53-2, 3.6 equivalents) are reacted in a mixture of dioxane and water (4:1 by vol.) under reflux for 4 h. After cooling down to rt, the reaction mixture is extracted between ethyl acetate and water. The combined organic layers are dried over $MgSO_4$, filtered and concentrated under reduced pressure. After purification through recrystallization or column chromatography, compound **I-8b** is obtained as a solid.

**AAV12c: I-15** (1.2 equivalent), **E3** (1.0 equivalents), tris(dibenzylideneacetone)dipalladium(0) (CAS-No. 51364-51-3, 0.01 equivalents), S-PHOS (CAS-No. 657408-07-6, 0.04 equivalents) and $K_3PO_4$ (CAS-No. 7778-53-2, 2.0 equivalents) are reacted in a mixture of dioxane and water (4:1 by vol.) under reflux for 4 h. After cooling down to rt, the reaction mixture is extracted between ethyl acetate and water. The combined organic layers are dried over $MgSO_4$, filtered and concentrated under reduced pressure. After purification through recrystallization or column chromatography, compound **I-16** is obtained as a solid.

**AAV12d: I-15b** (1.0 equivalent), **E3** (1.10 equivalents), tetrakis(triphenylphosphine)palladium(0) (CAS-No. 14221-01-3, 0.05 equivalents), and $K_3PO_4$ (CAS-No. 7778-53-2, 2.0 equivalents) are reacted in a mixture of dioxane and water (4:1 by vol.) under reflux for 24 h. After cooling down to rt, the reaction mixture is extracted between ethyl acetate and water. The combined organic layers are dried over MgSO4, filtered and concentrated under reduced pressure. After purification through recrystallization or column chromatography, compound **I-16b** is obtained as a solid.

**AAV13:** At 0 °C a solution of **I-8** (1.0 equivalent) in dry chlorobenzene (20 mL per 1 mmol**I-8**) is added boron tribromide (99%, CAS-No. 10294-33-4, 4.0 equivalents). The mixture was allowed to warm to rt, followed by heating at 50 °C for 24 h. The mixture was allowed to cool down to rt. Subsequently, the mixture was extracted between water and ethyl acetate and the combined organic layers were dried over $MgSO_4$, filtered and concentrated. After purification through recrystallization or column chromatography, the target compound **P-2** was obtained as a solid.

**AAV13a:** At 0 °C a solution of **I-8a** (1.0 equivalent) in dry chlorobenzene (20 mL per 1 mmol **I-8a**) is added boron tribromide (99%, CAS-No. 10294-33-4, 4.0 equivalents). The mixture was allowed to warm to rt, followed by heating at 50 °C for 24 h. The mixture was allowed to cool down to rt. Subsequently, the mixture was extracted between water and ethyl acetate and the combined organic layers were dried over $MgSO_4$, filtered and concentrated. After purification through recrystallization or column chromatography, the target compound **P-2** was obtained as a solid.

**AAV13b:** At 0 °C a solution of **I-8b** (1.0 equivalent) in dry chlorobenzene (20 mL per 1 mmol **I-8b**) is added boron tribromide (99%, CAS-No. 10294-33-4, 4.0 equivalents). The mixture was allowed to warm to rt, followed by heating at 50 °C for 24 h. The mixture was allowed to cool down to rt. Subsequently, the mixture was extracted between water and ethyl acetate and the combined organic layers were dried over $MgSO_4$, filtered and concentrated. After purification through recrystallization or column chromatography, the target compound **P-2** was obtained as a solid.

**AAV14:** A suspension of **I-9** (1.0 equivalent), E3 (1.0 equivalent), tetrakis(triphenylphosphine)palladium(0)

(CAS-No. 14221-01-3, 0.04 equivalents) and $K_3PO_4$ (CAS-No. 7778-53-2, 2.5 equivalents) in a degassed mixture of dioxane and water (4:1 by vol.) is stirred under reflux for 2 h. After cooling down to rt an aqueous workup was performed, followed by purification of the crude product through recrystallization or column chromatography. The desired compound **I-10** was obtained as a solid.

**AAV15:** A suspension of **E-10** (1.05 equivalents), **I-10** (1.0 equivalent), tris(dibenzylideneacetone)-dipalladium(0) (CAS-no. 51364-51-3, 0.02 equivalents), tri-tert-butylphosphonium tetrafluoroborate (CAS-no. 131274-22-1, 0.08 equivalents) and sodium tert-butoxide (CAS-no. 865-48-5, 2.5 equivalents) in degassed toluene or toluene was stirred at 80 °C for 24 h. After cooling down to room temperature (rt) an aqueous workup was performed, followed by purification of the crude product through recrystallization or column chromatography. The desired compound **I-11** was obtained as a solid.

**AAV16:** A suspension of **I-11** (1.05 equivalents), **E-11** (1.0 equivalent), tris(dibenzylideneacetone)-dipalladium(0) (CAS-no. 51364-51-3, 0.02 equivalents), tri-tert-butylphosphine (CAS-no. 13716-12-6, 0.08 equivalents) and sodium tert-butoxide (CAS-no. 865-48-5, 2.5 equivalents) in degassed toluene or toluene was stirred at 80 °C for 18 h. After cooling down to room temperature (rt) an aqueous workup was performed, followed by purification of the crude product through recrystallization or column chromatography. The desired compound **I-12** was obtained as a solid.

**AAV17:** **I-17** (1.0 equivalent), **E13** (1.5 equivalents), tris(dibenzylideneacetone)dipalladium(0) (CAS-No. 51364-51-3, 0.02 equivalents), X-PHOS (CAS-No. 564483-18-7, 0.08 equivalents) and $K_3PO_4$ (CAS-No. 7778-53-2, 1.5 equivalents) are reacted in a mixture of dioxane and water (4:1 by vol.) under reflux for 4 h. After cooling down to rt, the reaction mixture is extracted between ethyl acetate and water. The combined organic layers are dried over $MgSO_4$, filtered and concentrated under reduced pressure. After purification through recrystallization or column chromatography, compound **P-2** is obtained as a solid.

**AAV18:** **I-18** (1.00 equivalents) is dissolved in dry DMF. Sodium hydride (CAS: 7646-69-7, 1.5 equivalents) is added in portions under nitrogen atmosphere at room temperature (rt). The mixture is stirred at room temperature for 15 min and subsequently Methyl iodide (CAS: 74-88-4, 1.25 equivalents) was added trop wise. After stirring for 4h an aqueous workup was performed, followed by purification of the crude product through recrystallization or column chromatography. The desired compound **I-19** was obtained as a solid.

**AAV19:** **I-19** (1.0 equivalent), **E5b** (1.3 equivalents), tris(dibenzylideneacetone)dipalladium(0) (CAS-No. 51364-51-3, 0.01 equivalents), X-PHOS (CAS-No. 564483-18-7, 0.04 equivalents) and $K_3PO_4$ (CAS-No. 7778-53-2, 3.0 equivalents) are reacted in a mixture of toluene and water (4:1 by vol.) at 80 °C for 4 h. After cooling down to rt, the reaction mixture is extracted between ethyl acetate and water. The combined organic layers are dried over $MgSO_4$, filtered and concentrated under reduced pressure. After purification through recrystallization or column chromatography, compound **I-20** is obtained as a solid.

**AAV20:** To a solution of **I-20** (1.0 equivalent) in dry TBB (20 mL per 1 mmol **I-8b**) tert-Butyllithium (CAS-No. 594-19-4, 3.0 equivalents) is added. The mixture was allowed to warm to rt, followed by heating at 50 °C for 4 h. The mixture was allowed to cool down to rt. Subsequently, boron trichloride (CAS-No. 10294-34-5, 4.5 equivalents) was added at -78 °C and the reaction mixture was stirred at 50 °C for 24h. After stirring for 24h an aqueous workup was performed, followed by purification of the crude product through recrystallization or column chromatography. The desired compound P2 was obtained as a solid.

Procedure 1 was employed to synthesize example 19:

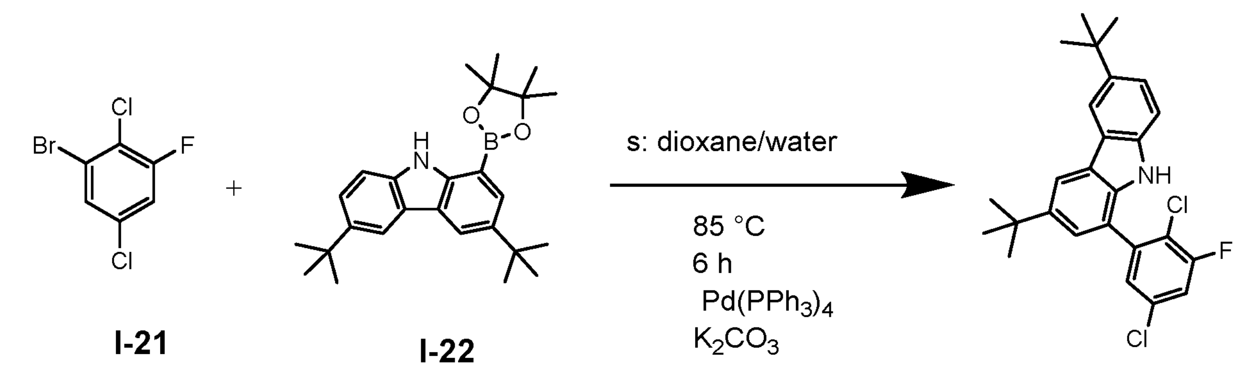


**I-21** **I-22** **I-23**

A suspension of **I-21** (1.00 equivalent) (CAS-No. 202865-57-4), tetrakis(triphenylphosphine)palladium(0) (CAS-No. 14221-01-3, 0.05 equivalents), and potassium carbonate (CAS-No. 584-08-7, 3.0 equivalents) in degassed dioxane/-water were stirred and **I-22** (1.1 equivalent) (CAS-No. 1510810-80-6) is added portionwise. After cooling down to rt an aqueous workup was performed, followed by purification of the crude product through recrystallization or column

chromatography. The desired compound **I-23** was obtained as a solid.

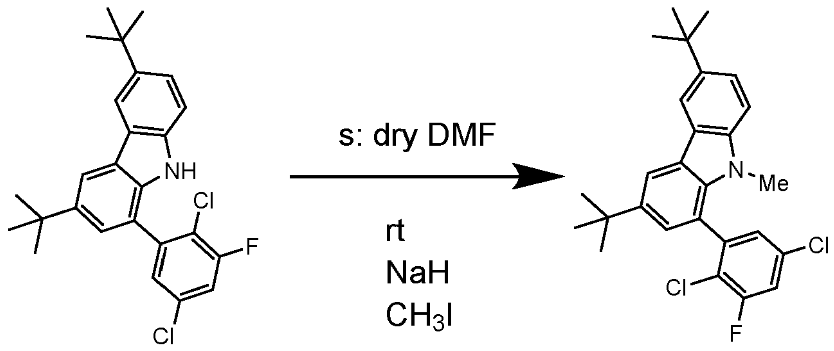


**I-23** **I-24**

Sodium hydride (1.5 equivalents) (CAS-No. 7646-69-7) is added portionwise to a suspension of **I-23** (1.00 equivalent) (CAS-No. 202865-57-4) at stirred at rt, followed by the addition of Methyl iodide (1.25 equivalents) (CAS-No. 74-88-4) for an hour. The desired compound **I-24** was obtained as a solid after precipitation with 10% $NH_3$.

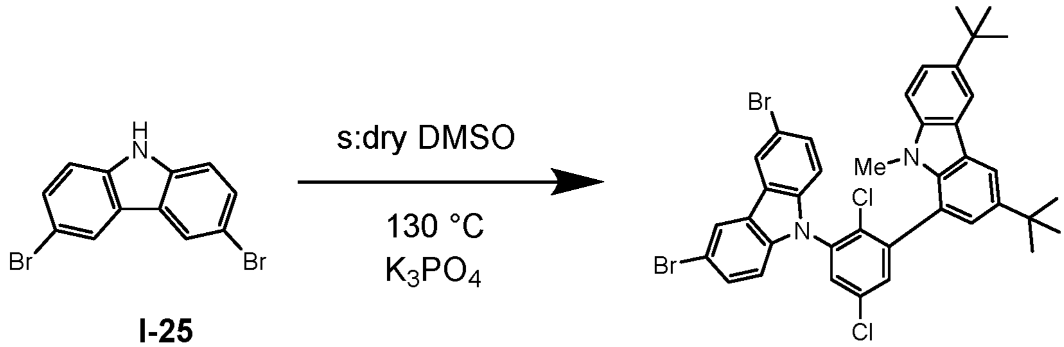


**I-24** +

**I-25**

**I-26**

**I-24** (1.00 equivalent), **I-25** (CAS-No. 6825-20-3, 1.2 equivalents), and potassium phosphate (CAS-No. 7778-53-2, 2.4 equivalents) in dry DMSO were stirred until completion at 130 °C. After cooling down to rt an aqueous workup was performed, followed by purification of the crude product through recrystallization or column chromatography. The desired compound **I-26** was obtained as a solid.

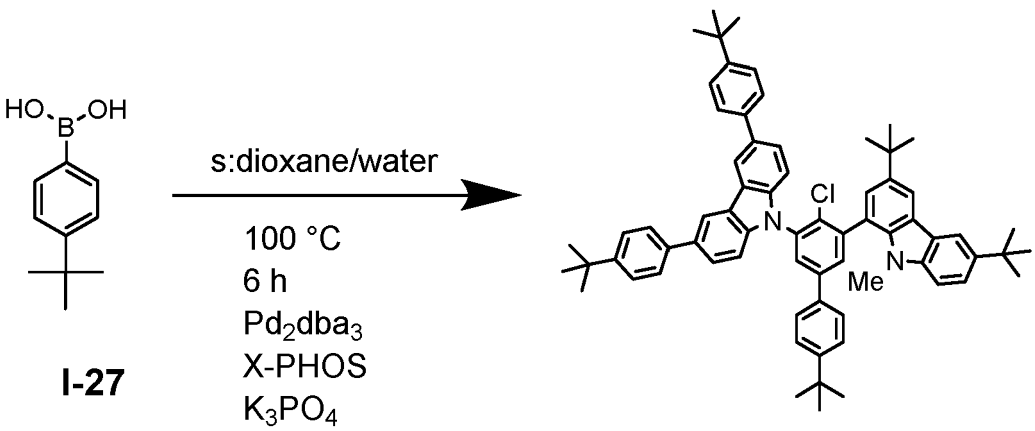


**I-26** +

**I-27**

**I-28**

A suspension of **I-26** (1.00 equivalent), Tris(dibenzylideneacetone)dipalladium(0) (CAS-No. 51364-51-3, 0.02

equivalents), X-Phos (CAS-No. 564483-18-7, 0.08 equivalents), potassium phosphate (CAS-No. 7778-53-2, 6 equivalents) in degassed dioxane/water were stirred and **I-27** (4 equivalents) (CAS-No. 123324-71-0) is added dropwise. After cooling down to rt an aqueous workup was performed, followed by purification of the crude product through recrystallization or column chromatography. The desired compound **I-28** was obtained as a solid.

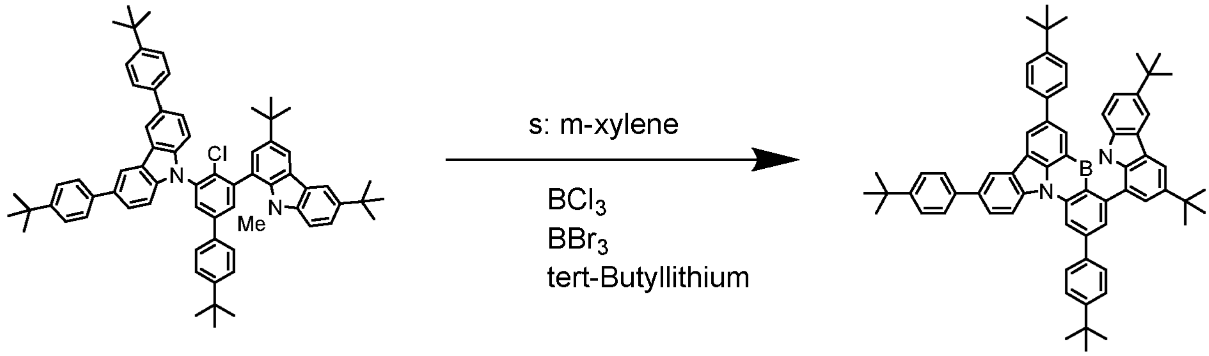


**I-28** **Example 19**

A suspension of **I-28** (1.00 equivalent), Boron tribromide (CAS-No. 10294-33-4, 2.00 equivalents) and Boron trichloride (CAS-No. 10294-34-5, 2.00 equivalents) in degassed m-xylene were stirred and tert.-Butyllithium (CAS-No. 594-19-4, 3.00 equivalents) is added the reaction mixture is stirred at 70° C for 4h 30m. After cooling down to rt an aqueous workup was performed, followed by purification of the crude product through recrystallization or column chromatography. The desired compound example **19** was obtained as a solid.

Procedure 2 was employed to synthesize example 20:

**I-21** +

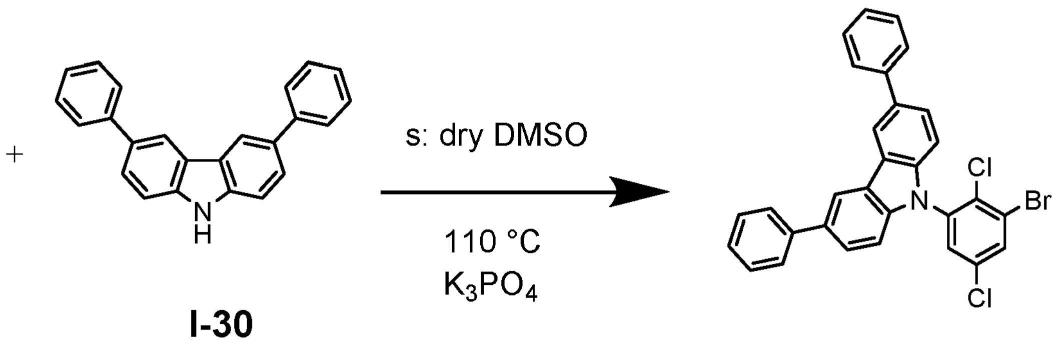


**I-30** **I-31**

A suspension of **I-21** (1.00 equivalent) (CAS-No. 202865-57-4) and potassium phosphate (CAS-No. 7778-53-2, 2.0 equivalents) in dry DMSO are stirred and temperature raised until 110 °C. **I-30** (CAS-No. 56525-79-2, 1.15 equivalents), is added portion-wise during stirring. After cooling down to rt an aqueous workup was performed, followed by purification of the crude product through recrystallization or column chromatography. The desired compound **I-31** was obtained as a solid.

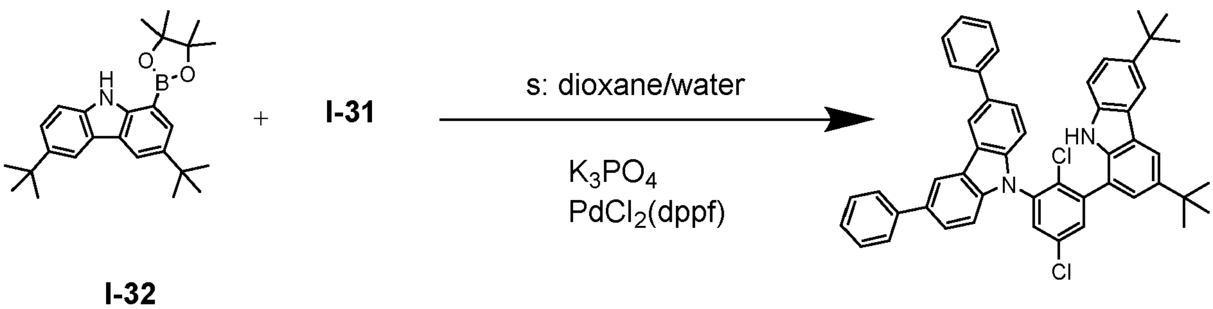


**I-32** **I-33**

A suspension of **I-31** (1.00 equivalent), $PdCl_2(dppf)$ (CAS-No. 72287-26-4, 0.04 equivalents), and potassium phosphate (CAS-No. 7778-53-2, 3.0 equivalents) in degassed dioxane/water were stirred. A solution of **I-32** (1.00 equivalent) (CAS-No. 1510810-80-6) in degassed dioxane is added to the reaction mixture at 80 °C.. After cooling down to rt an aqueous workup was performed, followed by purification of the crude product through recrystallization or column chromatography. The desired compound **I-33** was obtained as a solid.

**I-33**

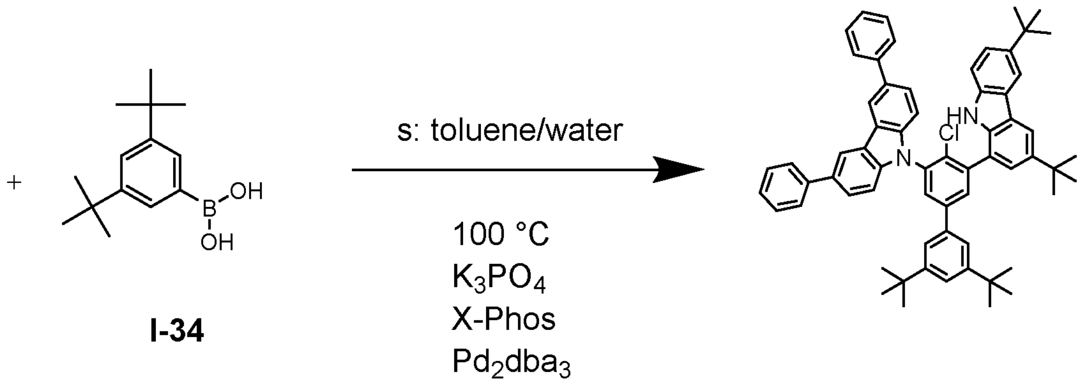


**I-34**

**I-35**

A suspension of **I-33** (0.63 equivalent), **I-34** (3,5-di-t-Butylphenylboronic acid) (CAS-No. 197223-39-5, 1.2 equivalents), Tris(dibenzylideneacetone)dipalladium(0) (CAS-No. 51364-51-3, 0.01 equivalents), X-Phos (CAS-No. 564483-18-7, 0.04 equivalents), potassium phosphate (CAS-No. 7778-53-2, 3.5 equivalents) in degassed toluene/water were stirred for 13 h at 80 °C. After cooling down to rt an aqueous workup was performed, followed by purification of the crude product through recrystallization or column chromatography. The desired compound **I-35** was obtained as a solid.

**I-35**

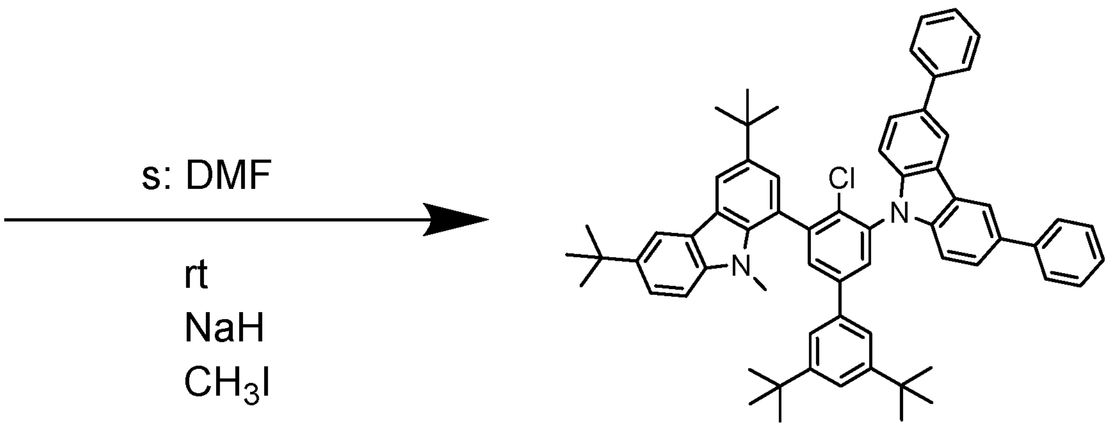


**I-36**

Sodium hydride (1.5 equivalents) (CAS-No. 7646-69-7) is added portion-wise to a suspension of **I-35** (1.00 equivalent) (CAS-No. 202865-57-4) stirred at rt, followed by the addition of methyl iodide (1.25 equivalents) (CAS-No. 74-88-4) for an hour. The desired compound **I-36** was obtained as a solid after precipitation with 10% $NH_3$.

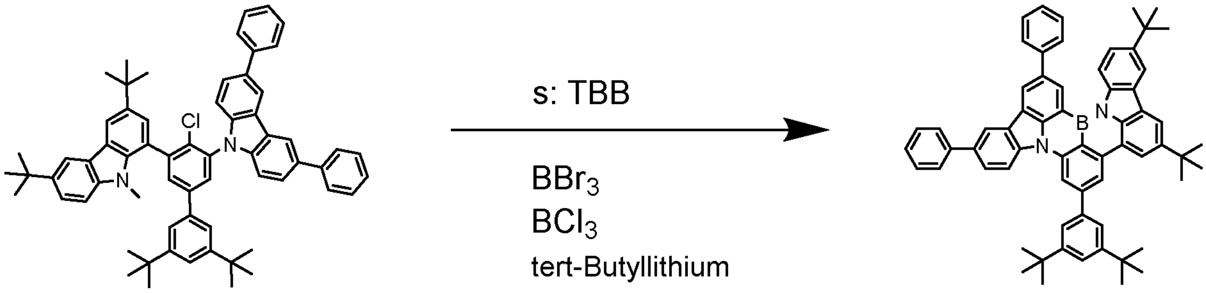


I-36

Example 20

A suspension of **I-36** (1.00 equivalent), Boron tribromide (CAS-No. 10294-33-4, 2.00 equivalents) and Boron trichloride (CAS-No. 10294-34-5, 2.00 equivalents) in dry TBB were stirred and tert.-butyllithium (CAS-No. 594-19-4, 3.00 equivalents) is added the reaction mixture is stirred at 70° C for 4h 30m. After cooling down to rt an aqueous workup was performed, followed by purification of the crude product through recrystallization or column chromatography. The desired compound example **20** was obtained as a solid.

Procedure 3 was employed to synthesize example 21:

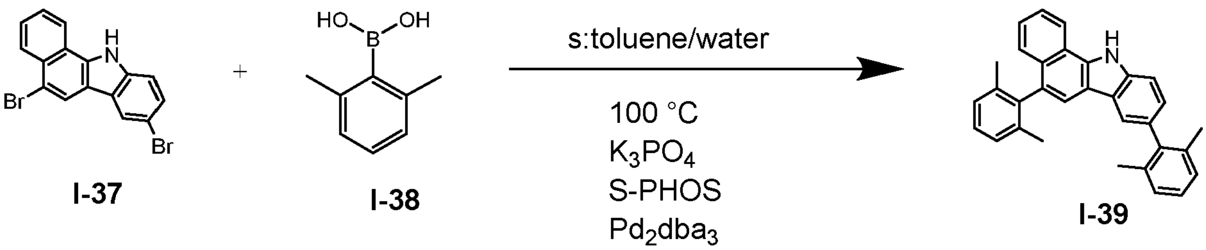


I-37 + I-38 → I-39

A suspension of **I-37** (1.00 equivalent), **I-38** (2,6-Dimethylphenylboronic acid) (CAS-No. 100379-00-8, 2.5 equivalents), tris(dibenzylideneacetone)dipalladium(0) (CAS-No. 51364-51-3, 0.01 equivalents), S-Phos (CAS-No. 564483-18-7, 0.04 equivalents), potassium phosphate (CAS-No. 7778-53-2, 3.00 equivalents) in degassed toluene/water were overnight stirred at 100 °C. After cooling down to rt an aqueous workup was performed, followed by purification of the crude product through recrystallization or column chromatography. The desired compound **I-39** was obtained as a solid.

I-21 +

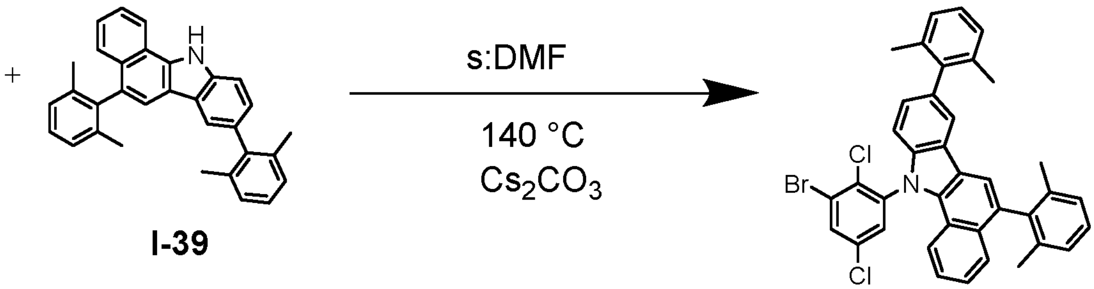


I-39

I-40

A suspension of **I-39** (1.00 equivalents) in dry DMF was heated up until 140 °C, **I-21** (2.00 equivalent) (CAS-No. 202865-57-4), and cesium carbonate (CAS-No. 534-17-8, 3.0 equivalents) were added. After cooling down to rt an aqueous workup was performed, followed by purification of the crude product through recrystallization or column chromatography. The desired compound **I-40** was obtained as a solid.

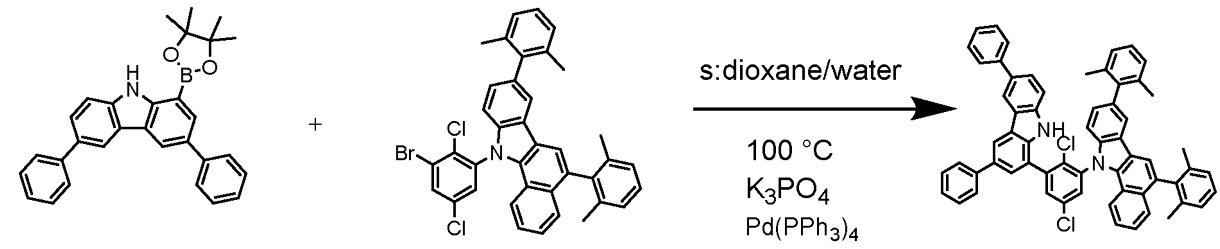


I-41 I-40 I-42

A suspension of **I-41** (1.00 equivalent), **I-40** (1.00 equivalents), tris(dibenzylideneacetone)dipalladium(0) (CAS-No. 51364-51-3, 0.04 equivalents), potassium phosphate (CAS-No. 7778-53-2, 3.00 equivalents) in degassed dioxane/-water were overnight stirred at 100 °C until completion. After cooling down to rt an aqueous workup was performed, followed by purification of the crude product through recrystallization or column chromatography. The desired compound **I-42** was obtained as a solid.

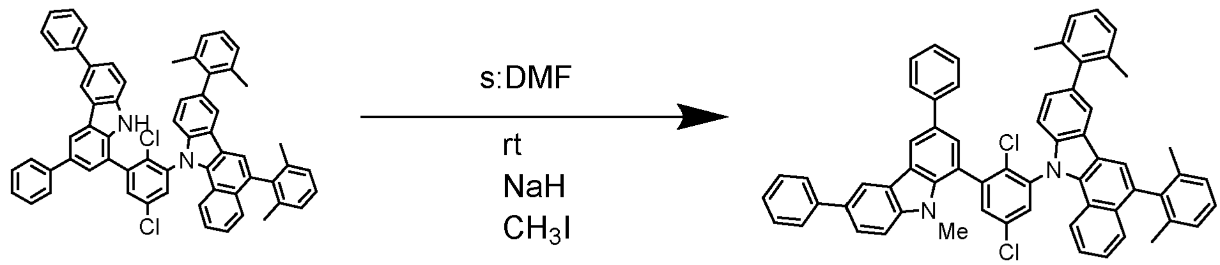


I-42

I-43

Sodium hydride (1.5 equivalents) (CAS-No. 7646-69-7) is added portionwise to a suspension of **I-42** (1.00 equivalent) (CAS-No. 202865-57-4) stirred at rt,for followed by the addition of Methyl iodide (1.25 equivalents) (CAS-No. 74-88-4) for an hour. The desired compound **I-43** was obtained as a solid after precipitation with 10% $NH_3$.

I-43 +

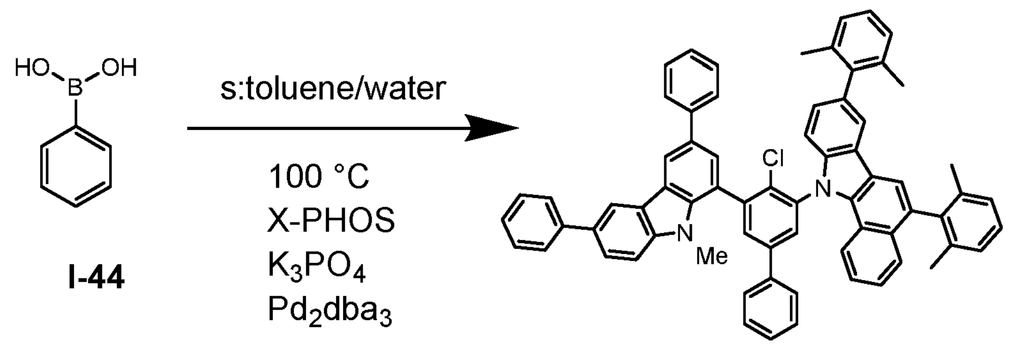


I-44

I-45

A suspension of **I-43** (1.00 equivalent), **I-44** (Phenylboronic acid) (CAS-No. 98-80-6, 1.3 equivalents), tris(dibenzylideneacetone)dipalladium(0) (CAS-No. 51364-51-3, 0.01 equivalents), X-Phos (CAS-No. 564483-18-7, 0.04 equivalents), potassium phosphate (CAS-No. 7778-53-2, 3.00 equivalents) in degassed toluene/water was overnight stirred at 100 °C. After cooling down to rt an aqueous workup was performed, followed by purification of the crude product through recrystallization or column chromatography. The desired compound **I-45** was obtained as a solid

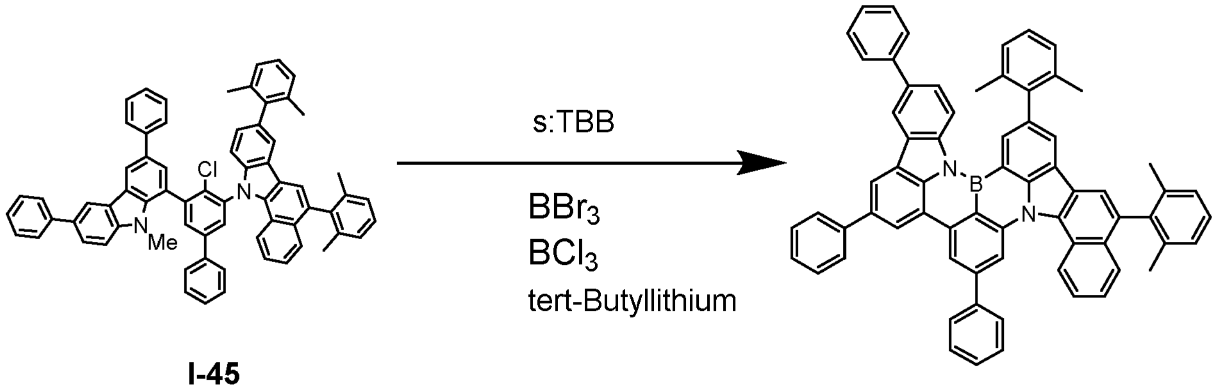


**I-45**

**Example 21**

A suspension of **I-45** (1.00 equivalent), Boron tribromide (CAS-No. 10294-33-4, 2.00 equivalents) and Boron trichloride (CAS-No. 10294-34-5, 2.00 equivalents) in dry TBB were stirred and tert.-Butyllithium (CAS-No. 594-19-4, 3.00 equivalents) is added the reaction mixture is stirred at 70° C for 4h 30m. After cooling down to rt an aqueous workup was performed, followed by purification of the crude product through recrystallization or column chromatography. The desired compound example 21 was obtained as a solid.

*Cyclic voltammetry*

Cyclic voltammograms are measured from solutions having concentration of $10^{-3}$ mol/L of the organic molecules in dichloromethane or a suitable solvent and a suitable supporting electrolyte (e.g. 0.1 mol/L of tetrabutylammonium hexafluorophosphate). The measurements are conducted at room temperature under nitrogen atmosphere with a three-electrode assembly (Working and counter electrodes: Pt wire, reference electrode: Pt wire) and calibrated using $FeCp_2/FeCp_2^+$ as internal standard. The HOMO data was corrected using ferrocene as internal standard against a saturated calomel electrode (SCE).

*Density functional theory calculation*

Molecular structures are optimized employing the BP86 functional and the resolution of identity approach (RI). Excitation energies are calculated using the (BP86) optimized structures employing Time-Dependent DFT (TD-DFT) methods. Orbital and excited state energies are calculated with the B3LYP functional. Def2-SVP basis sets (and a m4-grid for numerical integration are used. The Turbomole program package is used for all calculations.

*Absorption measurements*

A Thermo Scientific Evolution 201 UV-Visible Spectrophotometer is used to determine the wavelength of the absorption maximum of the sample in the wavelength region above 270 nm. This wavelength is used as excitation wavelength for photoluminescence spectral and quantum yield measurements.

*Photophysical measurements*

Sample pretreatment: Spin-coating
Apparatus: Spin150, SPS euro.
The sample concentration is 10 mg/ml, dissolved in a suitable solvent.
Program: 1) 3 s at 400 U/min; 20 s at 1000 U/min at 1000 Upm/s. 3) 10 s at 4000 U/min at 1000 Upm/s. After coating, the films are tried at 70 °C for 1 min.

Photoluminescence spectroscopy and Time-Correlated Single-Photon Counting (TCSPC) Steady-state emission spectroscopy is measured by a Horiba Scientific, Modell FluoroMax-4 equipped with a 150 W Xenon-Arc lamp, excitation- and emissions monochromators and a Hamamatsu R928 photomultiplier and a time-correlated single-photon counting option. Emissions and excitation spectra are corrected using standard correction fits.

Excited state lifetimes are determined employing the same system using the TCSPC method with FM-2013

equipment and a Horiba Yvon TCSPC hub.

Excitation sources:

NanoLED 370 (wavelength: 371 nm, puls duration: 1,1 ns)
NanoLED 290 (wavelength: 294 nm, puls duration: <1 ns)
SpectraLED 310 (wavelength: 314 nm)
SpectraLED 355 (wavelength: 355 nm).

Data analysis (exponential fit) is done using the software suite DataStation and DAS6 analysis software. The fit is specified using the chi-squared-test.

Photoluminescence quantum yield measurements

For photoluminescence quantum yield (PLQY) measurements an *Absolute PL Quantum Yield Measurement C9920-03G* system (*Hamamatsu Photonics*) is used. Quantum yields and CIE coordinates are determined using the software U6039-05 version 3.6.0.

Emission maxima are given in nm, quantum yields Φ in % and CIE coordinates as x,y values. PLQY is determined using the following protocol:

1) Quality assurance: Anthracene in ethanol (known concentration) is used as reference
2) Excitation wavelength: the absorption maximum of the organic molecule is determined and the molecule is excited using this wavelength
3) Measurement

Quantum yields are measured, for sample, of solutions or films under nitrogen atmosphere. The yield is calculated using the equation:

$$\Phi_{PL} = \frac{n_{photon}, emited}{n_{photon}, absorbed} = \frac{\int \frac{\lambda}{hc}\left[Int_{emitted}^{sample}(\lambda) - Int_{absorbed}^{sample}(\lambda)\right]d\lambda}{\int \frac{\lambda}{hc}\left[Int_{emitted}^{reference}(\lambda) - Int_{absorbed}^{reference}(\lambda)\right]d\lambda}$$

wherein $n_{photon}$ denotes the photon count and Int. the intensity.

**Production and characterization of optoelectronic devices**

Optoelectronic devices, such as OLED devices comprising organic molecules according to the invention can be produced via vacuum-deposition methods. If a layer contains more than one compound, the weight-percentage of one or more compounds is given in %. The total weight-percentage values amount to 100 %, thus if a value is not given, the fraction of this compound equals to the difference between the given values and 100 %.

The not fully optimized OLEDs are characterized using standard methods and measuring electroluminescence spectra, the external quantum efficiency (in %) in dependency on the intensity, calculated using the light detected by the photodiode, and the current. The OLED device lifetime is extracted from the change of the luminance during operation at constant current density. The LT50 value corresponds to the time, where the measured luminance decreased to 50 % of the initial luminance, analogously LT80 corresponds to the time point, at which the measured luminance decreased to 80 % of the initial luminance, LT 95 to the time point, at which the measured luminance decreased to 95 % of the initial luminance etc.

Accelerated lifetime measurements are performed (e.g. applying increased current densities).

For example, LT80 values at 500 cd/m$^2$ are determined using the following equation:

$$\mathrm{LT80}\left(500\,\frac{cd^2}{m^2}\right) = \mathrm{LT80}(L_0)\left(\frac{L_0}{500\,\frac{cd^2}{m^2}}\right)^{1.6}$$

wherein $L_0$ denotes the initial luminance at the applied current density.

The values correspond to the average of several pixels (typically two to eight), the standard deviation between these pixels is given.

## HPLC-MS

HPLC-MS analysis is performed on an HPLC by Agilent (1100 series) with MS-detector (Thermo LTQ XL).

Exemplary a typical HPLC method is as follows: a reverse phase column 4,6mm x 150mm, particle size 3,5 μm from Agilent *(ZORBAX Eclipse Plus 95Å* C18, *4.6 x 150 mm, 3.5 μm HPLC column)* is used in the HPLC. The HPLC-MS measurements are performed at room temperature (rt) following gradients:

| Flow rate [ml/min] | Time [min] | A[%] | B[%] | C[%] |
|---|---|---|---|---|
| 2.5 | 0 | 40 | 50 | 10 |
| 2.5 | 5 | 40 | 50 | 10 |
| 2.5 | 25 | 10 | 20 | 70 |
| 2.5 | 35 | 10 | 20 | 70 |
| 2.5 | 35.01 | 40 | 50 | 10 |
| 2.5 | 40.01 | 40 | 50 | 10 |
| 2.5 | 41.01 | 40 | 50 | 10 |

using the following solvent mixtures:

| | | |
|---|---|---|
| Solvent A: | H2O (90%) | MeCN (10%) |
| Solvent B: | H2O (10%) | MeCN (90%) |
| Solvent C: | THF (50%) | MeCN (50%) |

An injection volume of 5 μL from a solution with a concentration of 0.5 mg/mL of the analyte is taken for the measurements.

Ionization of the probe is performed using an APCI (atmospheric pressure chemical ionization) source either in positive (APCI +) or negative (APCI -) ionization mode.

## Example 1

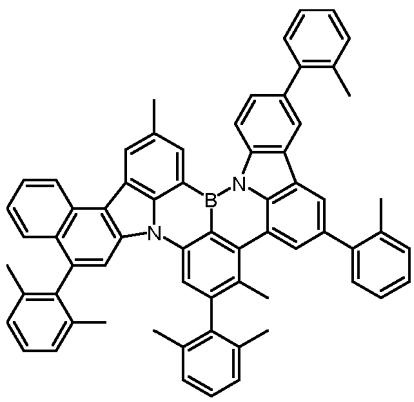

Example 1 was synthesized according to

***AAV5a*** (49% yield), where **E1a** was represented by 1-Chloro-9H-carbazole (CAS: 5599-70-2);
***AAV6a*** (53% yield), where **E2a** and **E5** were represented by 3,6-Dibromo-1-chloro-9H-carbazole (CAS: 2619632-07-2) and o-tolylboronic acid (CAS: 16419-60-6), respectively;
***AAV6b*** (49% yield);

***AAV7*** (quantitative yield), wherein compound **E4** and **E5** were represented by 5-Bromo-7H-benzo[c]carbazole (CAS: 131409-18-2) and 2,6-Dimethylphenylboronic acid (CAS: 100379-00-8), respectively;
***AAV8*** (63% yield);
***AAV9*** (17% yield), wherein compound **E5** was represented by methaneboronic acid (CAS: 13061-96-6);
***AAV10*** (77% yield), wherein compound **I-4** was represented by 1-bromo-3-chloro-5-fluoro-2-methylbenzene (CAS: 1780876-62-1);
***AAV11*** (65% yield), wherein compound **I-6** was represented by 2,6-dimethylphenylboronic acid (CAS: 100379-00-8);
***AAV12*** (52% yield);
And ***AAV13*** (17% yield).

MS (LC-MS, APPI ion source): 884 m/z at rt: 8.66 min.
The emission maximum of example **1** (0.001 mg/mL in toluene) is at 454 nm, the CIEx coordinate is 0.14 and the CIEy coordinate is 0.08 and the PLQY is 87%.
The absorption maximum of example **1** (0.01 mg/mL in toluene) is at 445 nm and the molar extinction coefficient at the absorption maximum is 49000 $M^{-1}$ $cm^{-1}$.
The emission maximum of example **1** in doped film (1% by weight in mCBP) is 458 nm, the CIEx coordinate is 0.14, the CIEy coordinate is 0.10.

**Example 2**

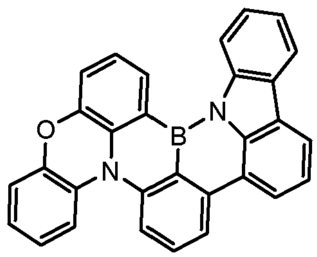

Example 2 was synthesized according to

***AAV10a*** (86% yield), where **E9** was represented by phenoxazine (CAS: 135-67-1);
***AAV12a*** (71% yield), where **I-5a** and **E3** were represented by 10-(3-chlorophenyl)-10H-phenoxazine and 1-(tetramethyl-1,3,2-dioxaborolan-2-yl)-9H-carbazole (CAS: 1219637-88-3), respectively;
***AAV13a*** (8% yield), wherein compound **I-8a** was represented by 10-(3-(9H-carbazol-1-yl)phenyl)-10H-phenoxazine;

**Example 3**

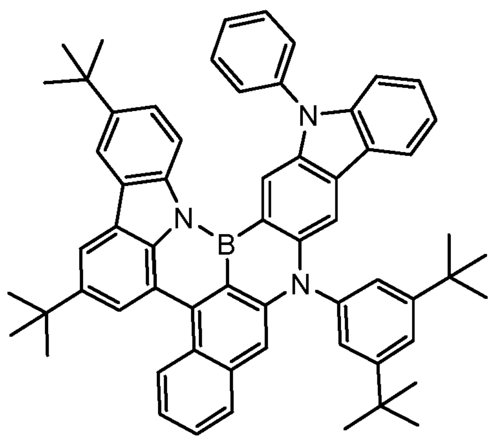

Example 3 was synthesized according to

***AAV14*** (70% yield), where **I-9** and **E3** were represented by 4-bromonaphthalen-2-amine (CAS: 74924-94-0) and 3,6-Bis(1,1-dimethylethyl)-1-(4,4,5,5-tetramethyl-1,3,2-dioxaborolan-2-yl)-9H-carbazole (CAS: 1510810-80-6), respectively;
***AAV15*** (65% yield), where **I-10** and **E10** were represented by 4-(3,6-di-tert-butyl-9H-carbazol-1-yl)naphthalen-2-amine and 1-Bromo-3,5-di-tert-butylbenzene (CAS: 22385-77-9), respectively;
***AAV16*** (75% yield), where **I-11** and **E11** were represented by 4-(3,6-di-tert-butyl-9H-carbazol-1-yl)-N-(3,5-di-tert-butylphenyl)naphthalen-2-amine and 3-Bromo-9-phenyl-9H-carbazole (CAS: 1153-85-1), respectively;
***AAV13*** (16% yield), wherein compound **I-8** was represented by N-(4-(3,6-di-tert-butyl-9H-carbazol-1-yl)naphthalen-2-yl)-N-(3,5-di-tert-butylphenyl)-9-phenyl-9H-carbazol-3-amine;
MS (LC-MS, APPI ion source): 859 m/z at rt: 8.85 min.

The emission maximum of example 3 (0.001 mg/mL in toluene) is at 544 nm with a full-width at half maximum (FWHM) of 32 nm, the CIEx coordinate is 0.39 and the CIEy coordinate is 0.59 and the PLQY is 77%.

## Example 4

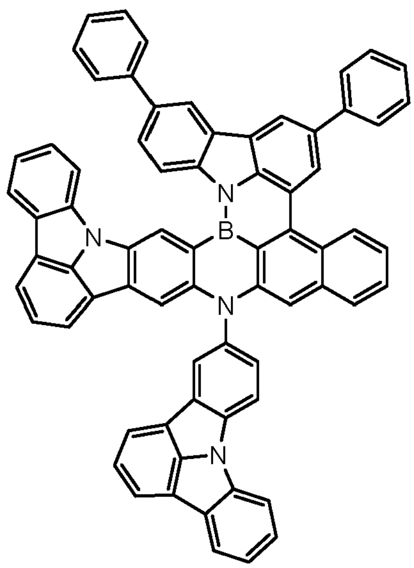

Example 4 was synthesized according to

***AAV5*** (25% yield), where **E1** was represented by 3,6-Diphenylcarbazole (CAS: 56525-79-2);
***AAV6*** (49% yield), where **E2** was represented by 1-bromo-3,6-diphenyl-9H-carbazole;
***AAV14*** (quantitative yield), wherein compound **I-9** and E3 were represented by 4-Bromonaphthalen-2-amine (CAS: 74924-94-0) and 3,6-Bis(Phenyl)-1-(4,4,5,5-tetramethyl-1,3,2-dioxaborolan-2-yl)-9H-carbazole, respectively;
***AAV15*** (62% yield), wherein compound **I-10** and **E10** (2.2 equivalents instead of 1.05 equivalents) were represented by 4-(3,6-diphenyl-9H-carbazol-1-yl)naphthalen-2-amine and 5-Bromoindolo[3,2,1-jk]carbazole (CAS: 109589-98-2), respectively;
***AAV13b*** (4% yield), wherein compound **I-8b** was represented by N-(4-(3,6-diphenyl-9H-carbazol-1-yl)naphthalen-2-yl)-N-(indolo[3,2,1-jk]carbazol-5-yl)indolo[3,2,1-jk]carbazol-5-amine.

MS (LC-MS, APPI ion source): 433 m/z at rt: 8.59 min.
The emission maximum of example 4 (0.001 mg/mL in toluene) is at 541 nm with a full-width at half maximum (FWHM) of 33 nm, the CIEx coordinate is 0.33 and the CIEy coordinate is 0.51.

## Example 5

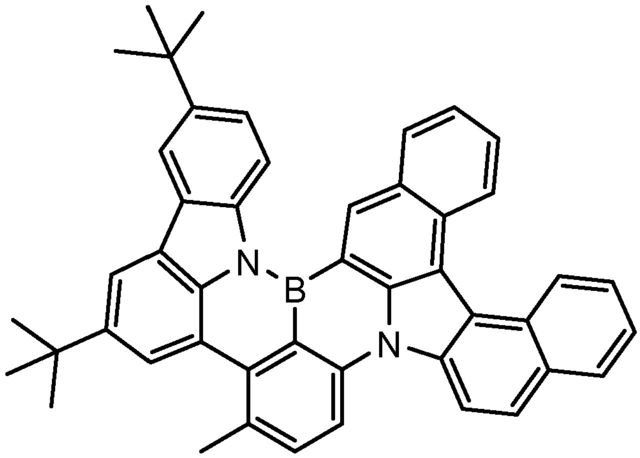

Example 5 was synthesized according to

***AAV14*** (quantitative yield), wherein compound **I-9** and **E3** were represented by 4-bromonaphthalen-2-amine (CAS: 74924-94-0) and 3,6-Bis(Phenyl)-1-(4,4,5,5-tetramethyl-1,3,2-dioxaborolan-2-yl)-9H-carbazole, respectively;
***AAV12b*** (48% yield), wherein compound **I-5b** and **E3** were represented by 7-(3-chloro-4-methylphenyl)-7H-dibenzo[c,g]carbazole and 3,6-Bis(1,1-dimethylethyl)-1-(4,4,5,5-tetramethyl-1,3,2-dioxaborolan-2-yl)-9H-carbazole (CAS: 1510810-80-6), respectively;
***AAV13b*** (2% yield), where **I-8b** was represented by 7-(3-(3,6-di-tert-butyl-9H-carbazol-1-yl)-4-methylphenyl)-7H-dibenzo[c,g]carbazole.

MS (LC-MS, APPI ion source): 643 m/z at rt: 8.25 min.
The emission maximum of example **5** (0.001 mg/mL in toluene) is at 472 nm with a full-width at half maximum (FWHM) of 28 nm, the CIEx coordinate is 0.13 and the CIEy coordinate is 0.22 and the PLQY is 82%.

**Example 6**

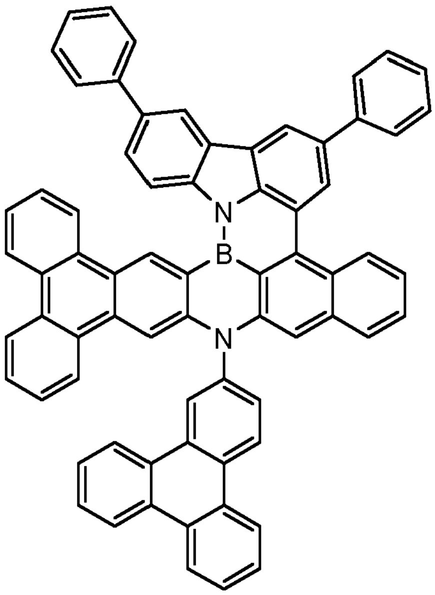

Example 6 was synthesized according to

***AAV10b*** (85% yield), wherein compound E9b and **I-4a** were represented by 3,4:5,6-dibenzocarbazole (CAS: 194-59-2) and 2-chloro-4-iodotoluene (CAS: 83846-48-4), respectively;

***AAV15*** (46% yield), wherein compound **I-10** and **E10** were represented by 4-(3,6-diphenyl-9H-carbazol-1-yl) naphthalen-2-amine and 2-bromotriphenylene (CAS: 19111-87-6), respectively;
***AAV13b*** (2% yield), where **I-8b** was represented by N-(4-(3,6-diphenyl-9H-carbazol-1-yl)naphthalen-2-yl)-N-(triphenylen-2-yl)triphenylen-2-amine.

MS (LC-MS, APPI ion source): 923 m/z at rt: 8.31 min.
The emission maximum of example 6 (0.001 mg/mL in toluene) is at 529 nm with a full-width at half maximum (FWHM) of 31 nm, the CIEx coordinate is 0.32 and the CIEy coordinate is 0.65 and the PLQY is 96%.

**Example 7**

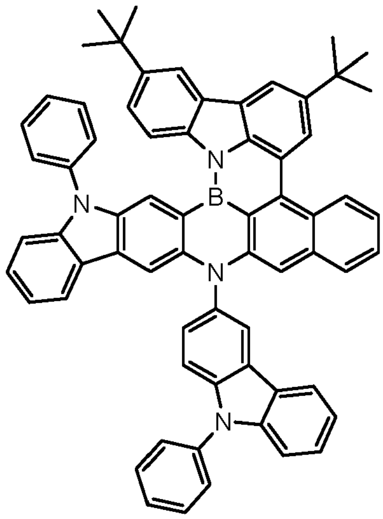

Example 7 was synthesized according to

***AAV14*** (70% yield), where **I-9** and **E3** were represented by 4-bromonaphthalen-2-amine (CAS: 74924-94-0) and 3,6-bis(1,1-dimethylethyl)-1-(4,4,5,5-tetramethyl-1,3,2-dioxaborolan-2-yl)-9H-carbazole (CAS: 1510810-80-6), respectively;
***AAV15*** (70% yield), where **I-10** and **E10** (2.05 equivalents instead of 1.05 equivalents) were represented by 4-(3,6-di-tert-butyl-9H-carbazol-1-yl)naphthalen-2-amine and 3-bromo-9-phenyl-9H-carbazole (CAS: 1153-85-1), respectively;
***AAV13b*** (14% yield), where **I-8b** was represented by N-(4-(3,6-di-tert-butyl-9H-carbazol-1-yl)naphthalen-2-yl)-9-phenyl-N-(9-phenyl-9H-carbazol-3-yl)-9H-carbazol-3-amine.

MS (LC-MS, APPI ion source): 912 m/z at rt: 8.24 min.
The emission maximum of example 7 (0.001 mg/mL in toluene) is at 541 nm with a full-width at half maximum (FWHM) of 36 nm, the CIEx coordinate is 0.38 and the CIEy coordinate is 0.61 and the PLQY is 74%.

**Example 8**

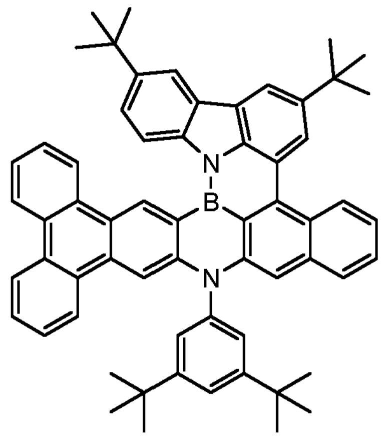

Example 8 was synthesized according to

***AAV14*** (70% yield), where **I-9** and **E3** were represented by 4-bromonaphthalen-2-amine (CAS: 74924-94-0) and 3,6-Bis(1,1-dimethylethyl)-1-(4,4,5,5-tetramethyl-1,3,2-dioxaborolan-2-yl)-9H-carbazole (CAS: 1510810-80-6), respectively;
***AAV15*** (65% yield), where **I-10** and **E10** were represented by 4-(3,6-di-tert-butyl-9H-carbazol-1-yl)naphthalen-2-amine and 1-Bromo-3,5-ditertbutylbenzene (CAS: 22385-77-9), respectively;
***AAV16*** (77% yield), where **I-11** and **E11** were represented by 4-(3,6-di-tert-butyl-9H-carbazol-1-yl)-N-(3,5-di-tert-butylphenyl)naphthalen-2-amine and 2-Bromotriphenylene (CAS: 19111-87-6), respectively;
***AAV13b*** (24% yield), where **I-8b** was represented by N-(4-(3,6-di-tert-butyl-9H-carbazol-1-yl)naphthalen-2-yl)-N-(3,5-di-tert-butylphenyl)triphenylen-2-amine.

MS (LC-MS, APPI ion source): 844 m/z at rt: 9.29 min.

The emission maximum of example 8 (0.001 mg/mL in toluene) is at 525 nm with a full-width at half maximum (FWHM) of 30 nm, the CIEx coordinate is 0.30 and the CIEy coordinate is 0.66.

**Example 9**

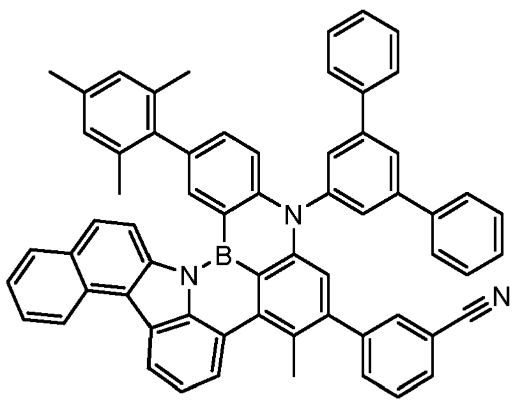

Example 9 was synthesized according to

***AAV10c*** (47% yield), where **I-12** and **E12** were represented by 1-bromo-3,5-diphenylbenzene (CAS: 103068-20-8) and 2',4',6'-trimethyl-[1,1'-biphenyl]-4-amine, respectively;
***AAV10d*** (48% yield), where **I-14** and **E13** were represented by 5-bromo-1,3-dichloro-2-methylbenzene (CAS: 204930-37-0) and N-(2',4',6'-trimethyl-[1,1'-biphenyl]-4-yl)-[1,1':3',1"-terphenyl]-5'-amine, respectively;
***AAV12c*** (32% yield), where **I-15** and **E3** were represented by N-(3,5-dichloro-4-methylphenyl)-N-(2',4',6'-trimethyl-[1,1'-biphenyl]-4-yl)-[1,1':3',1"-terphenyl]-5'-amine and 8-(4,4,5,5-tetramethyl-1,3,2-dioxaborolan-2-yl)-7H-benzo[c]carbazole, respectively;

***AAV13b*** (65% yield), where **I-8b** was represented by N-(3-(7H-benzo[c]carbazol-8-yl)-5-chloro-4-methylphenyl)-N-(2',4',6'-trimethyl-[1,1'-biphenyl]-4-yl)-[1,1':3',1"-terphenyl]-5'-amine;
***AA V17*** (52% yield), where **I-17** and **E13** were represented by 5-([1,1':3',1"-terphenyl]-5'-yl)-7-chloro-2-mesityl-8-methyl-5H-5,17b-diaza-17c-borabenzo[gh]benzo[6,7]indeno[1,2,3-no]tetraphene and 3-Cyanophenylboronic acid (CAS: 150255-96-2), respectively.

MS (LC-MS, APPI ion source): 855 m/z at rt: 7.41 min.

The emission maximum of example 9 (0.001 mg/mL in toluene) is at 452 nm with a full-width at half maximum (FWHM) of 32 nm, the CIEx coordinate is 0.14 and the CIEy coordinate is 0.08 and the PLQY is 82%.

**Example 10**

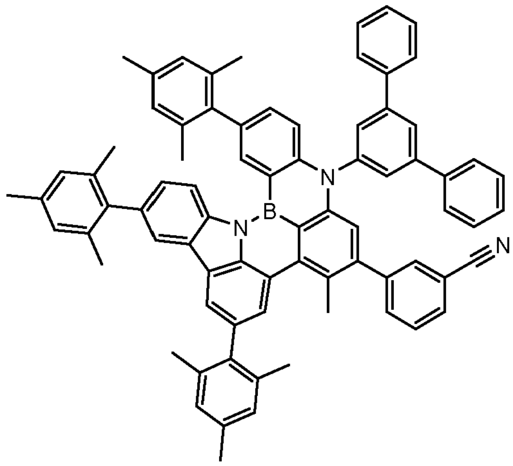

Example 10 was synthesized according to

***AAV10c*** (47% yield), where **I-12** and **E12** were represented by 1-bromo-3,5-diphenylbenzene (CAS: 103068-20-8) and 2',4',6'-trimethyl-[1,1'-biphenyl]-4-amine, respectively;
***AAV10d*** (48% yield), where **I-14** and **E13** were represented by 5-bromo-1,3-dichloro-2-methylbenzene (CAS: 204930-37-0) and N-(2',4',6'-trimethyl-[1,1'-biphenyl]-4-yl)-[1,1':3',1"-terphenyl]-5'-amine, respectively;
***AAV12c*** (20% yield), where **I-15** and **E3** were represented by N-(3,5-dichloro-4-methylphenyl)-N-(2',4',6'-trimethyl-[1,1'-biphenyl]-4-yl)-[1,1':3',1"-terphenyl]-5'-amine and 3,6-dimesityl-1-(4,4,5,5-tetramethyl-1,3,2-dioxaborolan-2-yl)-9H-carbazole, respectively;
***AAV13b*** (65% yield), where **I-8b** was represented by N-(3-chloro-5-(3,6-dimesityl-9H-carbazol-1-yl)-4-methylphenyl)-N-(2',4',6'-trimethyl-[1,1'-biphenyl]-4-yl)-[1,1':3',1"-terphenyl]-5'-amine;
***AA V17*** (15% yield), where **I-17** and **E13** were represented by 5-([1,1':3',1"-terphenyl]-5'-yl)-7-chloro-2,10,13-trimesityl-8-methyl-5H-5,15b-diaza-15c-borabenzo[gh]indeno[1,2,3-no]tetraphene and 3-Cyanophenylboronic acid (CAS: 150255-96-2), respectively.

MS (LC-MS, APPI ion source): 663 m/z at rt: 8.59 min.

The emission maximum of example 10 (0.001 mg/mL in toluene) is at 449 nm with a full-width at half maximum (FWHM) of 33 nm, the CIEx coordinate is 0.14 and the CIEy coordinate is 0.07 and the PLQY is 77%.

**Example 11**

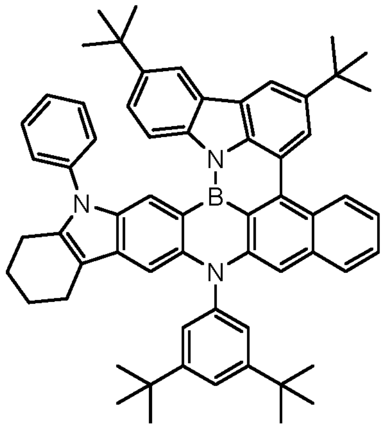

Example 11 was synthesized according to

***AAV14*** (70% yield), where **I-9** and **E3** were represented by 4-bromonaphthalen-2-amine (CAS: 74924-94-0) and 3,6-Bis(1,1-dimethylethyl)-1-(4,4,5,5-tetramethyl-1,3,2-dioxaborolan-2-yl)-9H-carbazole (CAS: 1510810-80-6), respectively;
***AAV15*** (65% yield), where **I-10** and **E10** were represented by 4-(3,6-di-tert-butyl-9H-carbazol-1-yl)naphthalen-2-amine and 1-bromo-3,5-ditertbutylbenzene (CAS: 22385-77-9), respectively;
***AAV16*** (60% yield), where **I-11** and **E11** were represented by 4-(3,6-di-tert-butyl-9H-carbazol-1-yl)-N-(3,5-di-tert-butylphenyl)naphthalen-2-amine and 6-bromo-9-phenyl-2,3,4,9-tetrahydro-1H-carbazole, respectively;
***AAV13b*** (36% yield), where **I-8b** was represented by N-(4-(3,6-di-tert-butyl-9H-carbazol-1-yl)naphthalen-2-yl)-N-(3,5-di-tert-butylphenyl)-9-phenyl-2,3,4,9-tetrahydro-1 H-carbazol-6-amine.

MS (LC-MS, APPI ion source): 863 m/z at rt: 8.73 min.
The emission maximum of example 11 (0.001 mg/mL in toluene) is at 533 nm with a full-width at half maximum (FWHM) of 40 nm, the CIEx coordinate is 0.35 and the CIEy coordinate is 0.63 and the PLQY is 84%.

**Example 12**

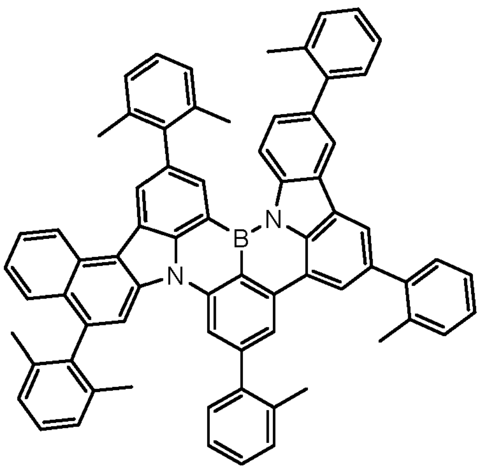

Example 12 was synthesized according to

***AAV7b*** (56% yield), where **E4b** was represented by 5-bromo-7H-benzo[c]carbazole (CAS: 131409-18-2);
***AAV9b*** (76% yield), where **E4c** and **E5b** were represented by 5-bromo-10-chloro-7H-benzo[c]carbazole and 2,6-Dimethylphenylboronic acid (CAS: 100379-00-8), respectively;
***AAV10e*** (60% yield), where **E9b** and **I-14b** were represented by 5,10-bis(2,6-dimethylphenyl)-7H-benzo[c]carbazole and 1-Bromo-2,5-dichloro-3-fluorobenzene (CAS: 202865-57-4), respectively;

***AAV12d*** (54% yield), where **E15b** and **E3** were represented by 7-(3-bromo-2,5-dichlorophenyl)-5,10-bis(2,6-dimethylphenyl)-7H-benzo[c]carbazole and 1-(4,4,5,5-tetramethyl-1,3,2-dioxaborolan-2-yl)-3,6-di-o-tolyl-9H-carbazole, respectively;
***AAV18*** (99% yield), where **I18** was represented by 7-(2,5-dichloro-3-(3,6-di-o-tolyl-9H-carbazol-1-yl)phenyl)-5,10-bis(2,6-dimethylphenyl)-7H-benzo[c]carbazole;
***AAV19*** (92% yield), where **I-19** and **E5b** were represented by 7-(2,5-dichloro-3-(9-methyl-3,6-di-o-tolyl-9H-carbazol-1-yl)phenyl)-5,10-bis(2,6-dimethylphenyl)-7H-benzo[c]carbazole and o-Tolylboronic acid (CAS: 16419-60-6), respectively.
***AAV20*** (5% yield), where **I-19** was represented by 7-(4-chloro-2'-methyl-5-(9-methyl-3,6-di-o-tolyl-9H-carbazol-1-yl)-[1,1'-biphenyl]-3-yl)-5,10-bis(2,6-dimethylphenyl)-7H-benzo[c]carbazole.

MS (LC-MS, APPI ion source): 946 m/z at rt: 9.16 min.
The emission maximum of example 12 (0.001 mg/mL in toluene) is at 451 nm with a full-width at half maximum (FWHM) of 18 nm, the CIEx coordinate is 0.15 and the CIEy coordinate is 0.07 and the PLQY is 75%.

**Example 13**

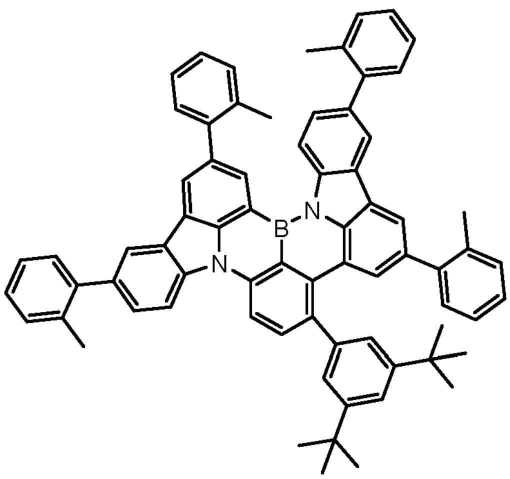

Example 13 was synthesized according to

***AAV10e*** (80% yield), where **E9b** and **I-14b** were represented by 3,6-bis(2-methylphenyl)-9H-carbazole (CAS: 850264-86-7) and 2-Bromo-1-chloro-4-fluorobenzene (CAS: 201849-15-2), respectively;
***AAV12d*** (30% yield), where **E15b** and **E3** were represented by 9-(3-bromo-4-chlorophenyl)-3,6-di-o-tolyl-9H-carbazole and 1-(4,4,5,5-tetramethyl-1,3,2-dioxaborolan-2-yl)-3,6-di-o-tolyl-9H-carbazole, respectively;
***AAV19*** (77% yield), where **I-19** and **E5b** were represented by 1-(2-chloro-5-(3,6-di-o-tolyl-9H-carbazol-9-yl)phenyl)-3,6-di-o-tolyl-9H-carbazole and 3,5-di-t-Butylphenylboronic acid (CAS: 197223-39-5), respectively.
***AAV13b*** (47% yield), where **I-8b** was represented by 1-(3',5'-di-tert-butyl-4-(3,6-di-o-tolyl-9H-carbazol-9-yl)-[1,1'-biphenyl]-2-yl)-3,6-di-o-tolyl-9H-carbazole and were boron triiodide (CAS: 13517-10-7) was used instead of boron tribromide (99%, CAS-No. 10294-33-4).

MS (LC-MS, APPI ion source): 966 m/z at rt: 9.39 min.
The emission maximum of example 13 (0.001 mg/mL in toluene) is at 456 nm with a full-width at half maximum (FWHM) of 34 nm, the CIEx coordinate is 0.14 and the CIEy coordinate is 0.10 and the PLQY is 95%.

Example **14**

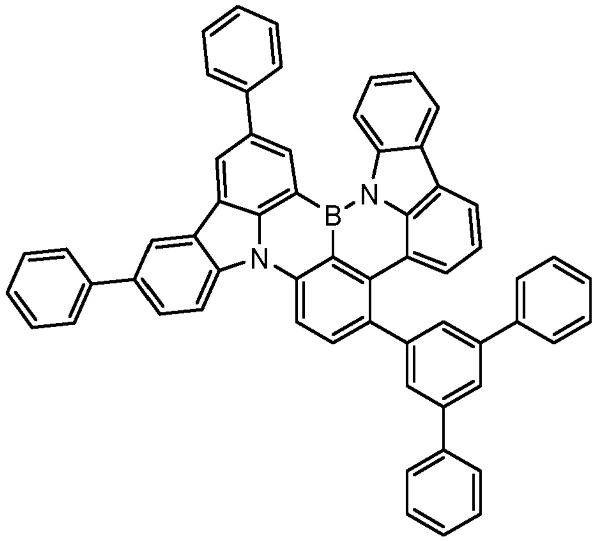

Example 14 was synthesized according to

***AAV10e*** (96% yield), where **E9b** and **I-14b** were represented by 3,6-diphenylcarbazole (CAS: 56525-79-2) and 1-Bromo-2-chloro-4-fluorobenzene (CAS: 110407-59-5), respectively;
***AAV6*** (73% yield), where **E2a** and **E5** were represented by 9-(4-bromo-3-chlorophenyl)-3,6-diphenyl-9H-carbazole and 1,1':3',1"-Terphenyl-5'-boronic acid (CAS: 128388-54-5), respectively and where [1,1'-bis(diphenylphosphino) ferrocene]palladium (II) dichloride (CAS: 72287-26-4) was used instead of $Pd(PPh_3)_4$;
***AAV12b*** (41% yield), where **I-5b** and **E3** were represented by 9-(2-chloro-5'-phenyl-[1,1':3',1"-terphenyl]-4-yl)-3,6-diphenyl-9H-carbazole and 1-(tetramethyl-1,3,2-dioxaborolan-2-yl)-9H-carbazole (CAS: 1219637-88-3), respectively.
***AAV13b,*** where **I-8b** was represented by 9-(2-(9H-carbazol-1-yl)-5'-phenyl-[1,1':3',1"-terphenyl]-4-yl)-3,6-diphenyl-9H-carbazole and were boron triiodide (CAS: 13517-10-7) was used instead of boron tribromide (99%, CAS-No. 10294-33-4).

MS (LC-MS, APPI ion source): 663 m/z at rt: 7.81 min.
The emission maximum of example 14 (0.001 mg/mL in toluene) is at 460 nm with a full-width at half maximum (FWHM) of 37 nm, the CIEx coordinate is 0.14 and the CIEy coordinate is 0.12.

**Example 15**

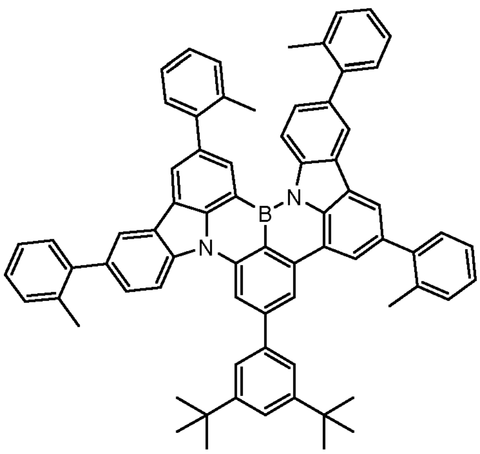

Example 15 was synthesized according to

***AAV10e*** (29% yield), where **E9b** and **I-14b** were represented by 3,6-bis(2-methylphenyl)-9H-carbazole (CAS: 850264-86-7) and 1-Bromo-2,5-dichloro-3-fluorobenzene (CAS: 202865-57-4), respectively;

***AAV12d*** (50% yield), where **I-15b** and **E3** were represented by 9-(3-bromo-2,5-dichlorophenyl)-3,6-di-o-tolyl-9H-carbazole and 9-methyl-1-(4,4,5,5-tetramethyl-1,3,2-dioxaborolan-2-yl)-3,6-di-o-tolyl-9H-carbazole, respectively;

***AAV19*** (71% yield), where **I-19** and **E5b** were represented by 1-(2,5-dichloro-3-(3,6-di-o-tolyl-9H-carbazol-9-yl) phenyl)-9-methyl-3,6-di-o-tolyl-9H-carbazole and 3,5-di-t-Butylphenylboronic acid (CAS: 197223-39-5), respectively;

***AAV20*** (15% yield), where **I-20** was represented by 1-(3',5'-di-tert-butyl-4-chloro-5-(3,6-di-o-tolyl-9H-carbazol-9-yl)-[1,1'-biphenyl]-3-yl)-9-methyl-3,6-di-o-tolyl-9H-carbazole.

MS (LC-MS, APPI ion source): 966 m/z at rt: 9.73 min.

The emission maximum of example 15 (0.001 mg/mL in toluene) is at 451 nm with a full-width at half maximum (FWHM) of 24 nm, the CIEx coordinate is 0.14 and the CIEy coordinate is 0.07 and the PLQY is 93%.

**Example 16**

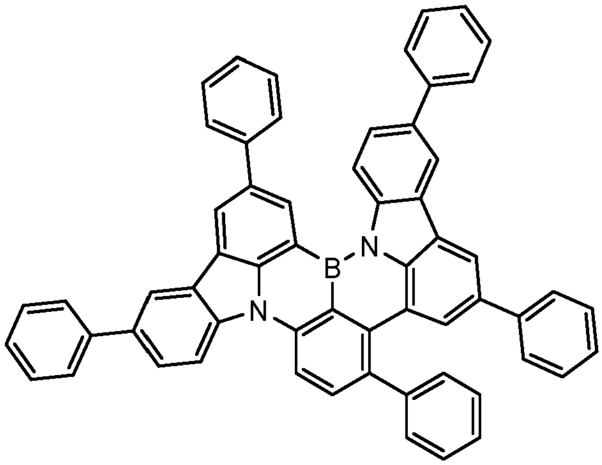

Example 16 was synthesized according to

***AAV10e*** (82% yield), where **E9b** and **I-14b** were represented by 3,6-Diphenylcarbazole (CAS: 56525-79-2) and 2-Bromo-1-chloro-4-fluorobenzene (CAS: 201849-15-2), respectively;

***AAV12d*** (33% yield), where **I-15b** and **E3** were represented by 9-(3-bromo-4-chlorophenyl)-3,6-diphenyl-9H-carbazole and 3,6-Bis(Phenyl)-1-(4,4,5,5-tetramethyl-1,3,2-dioxaborolan-2-yl)-9H-carbazole, respectively;

***AAV19*** (44% yield), where **I-19** and **E5b** were represented by 1-(2-chloro-5-(3,6-diphenyl-9H-carbazol-9-yl)phenyl)-3,6-diphenyl-9H-carbazole and Phenylboronic acid (CAS: 98-80-6), respectively;

***AAV13b*** (96% yield), where **I-8b** was represented by 1-(4-(3,6-diphenyl-9H-carbazol-9-yl)-[1,1'-biphenyl]-2-yl)-3,6-diphenyl-9H-carbazole and where boron triiodide (CAS: 13517-10-7) was used instead of boron tribromide (99%, CAS-No. 10294-33-4).

MS (LC-MS, APPI ion source): 797 m/z at rt: 9.95 min.

The emission maximum of example 16 (0.001 mg/mL in toluene) is at 462 nm with a full-width at half maximum (FWHM) of 27 nm, the CIEx coordinate is 0.13 and the CIEy coordinate is 0.12 and the PLQY is 91%.

**Example 17**

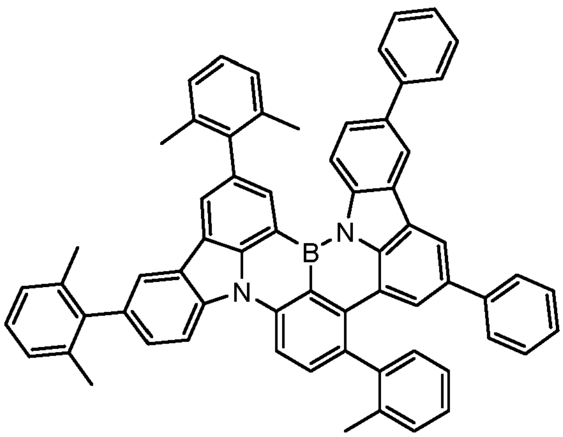

Example 17 was synthesized according to

***AAV10e*** (93% yield), where **E9b** and **I-14b** were represented by 3,6-bis(2,6-dimethylphenyl)-9H-carbazole (CAS: 1246891-46-2) and 1-Bromo-2-chloro-4-fluorobenzene (CAS: 110407-59-5), respectively;
***AAV6*** (84% yield), where **E2a** and **E5** were represented by 9 9-(4-bromo-3-chlorophenyl)-3,6-bis(2,6-dimethylphenyl)-9H-carbazole and 4,4,5,5-tetramethyl-2-(2-methylphenyl)-1,3,2-dioxaborolane (CAS: 195062-59-0) , respectively and where [1,1'-bis(diphenylphosphino)ferrocene]palladium (II) dichloride (CAS: 72287-26-4) was used instead of $Pd(PPh_3)_4$;
***AAV12b*** (38% yield), where **I-5b** and **E3** were represented by 9-(2-chloro-2'-methyl-[1,1'-biphenyl]-4-yl)-3,6-bis(2,6-dimethylphenyl)-9H-carbazole and 3,6-Bis(Phenyl)-1-(4,4,5,5-tetramethyl-1,3,2-dioxaborolan-2-yl)-9H-carbazole, respectively and where Palladium(II)acetat (CAS: 3375-31-3) and XPhos (CAS: 564483-18-7) are used instead of tris(dibenzylideneacetone)dipalladium(0) (CAS-No. 51364-51-3) and S-PHOS (CAS-No. 657408-07-6), respectively.
***AAV13b*** (44% yield), where **I-8b** was represented by 1-(4-(3,6-bis(2,6-dimethylphenyl)-9H-carbazol-9-yl)-2'-methyl-[1,1'-biphenyl]-2-yl)-3,6-diphenyl-9H-carbazole and where boron triiodide (CAS: 13517-10-7) was used instead of boron tribromide (99%, CAS-No. 10294-33-4).

MS (LC-MS, APPI ion source): 868 m/z at rt: 8.43 min.
The emission maximum of example 17 (2 % in PMMA) is at 457 nm with a full-width at half maximum (FWHM) of 31 nm, the CIEx coordinate is 0.14 and the CIEy coordinate is 0.10 and the PLQY is 81%.

**Example 18**

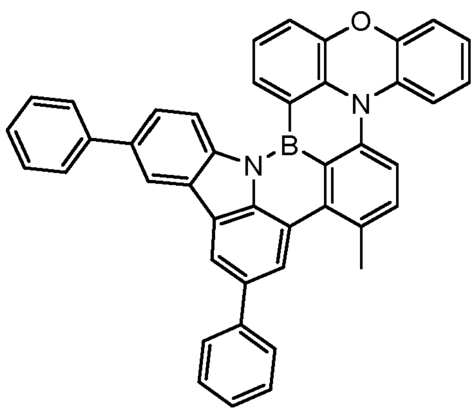

Example 18 was synthesized according to

***AAV10a*** (72% yield), where **E9** and **I-4a** were represented by Phenoxazine (CAS: 135-67-1) and 2-Chloro-4-iodotoluene (CAS: 83846-48-4), respectively;

***AAV12a*** (80% yield), where **I-5a** and **E3** were represented by 10-(3-chloro-4-methylphenyl)-10H-phenoxazine and 3,6-Bis(Phenyl)-1-(4,4,5,5-tetramethyl-1,3,2-dioxaborolan-2-yl)-9H-carbazole, respectively and where XPhos (CAS: 564483-18-7) is used instead of S-PHOS (CAS-No. 657408-07-6);

***AAV13a*** (12% yield), where **I-8a** was represented by 10-(3-(3,6-diphenyl-9H-carbazol-1-yl)-4-methylphenyl)-10H-phenoxazine and where boron triiodide (CAS: 13517-10-7) was used instead of boron tribromide (99%, CAS-No. 10294-33-4).

MS (LC-MS, APPI ion source): 599 m/z at rt: 6.78 min.

The emission maximum of example 18 (2 % in PMMA) is at 485 nm with a full-width at half maximum (FWHM) of 54 nm, the CIEx coordinate is 0.15 and the CIEy coordinate is 0.40 and the PLQY is 73%.

**Example 19**

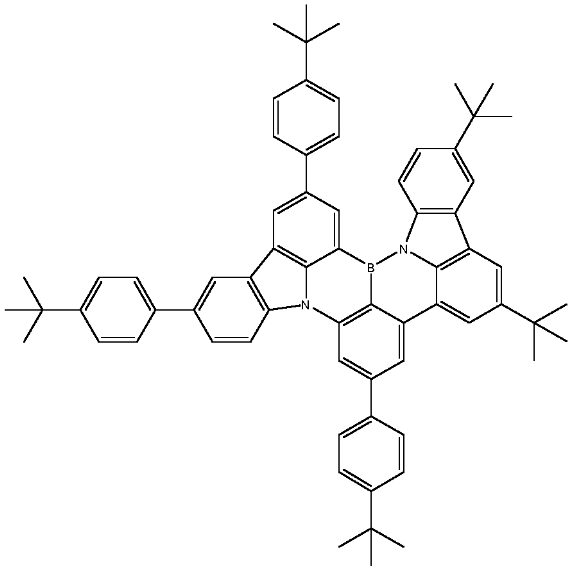

Example 19 was synthesized according to procedure 1.

MS (LC-MS, APPI ion source): 925 m/z at rt: 10.20 min.

The emission maximum of example 19 (2% in PMMA) is at 487 nm with a full-width at half maximum (FWHM) of 49 nm the CIEx coordinate is 0.12 and the CIEy coordinate is 0.31.

**Example 20**

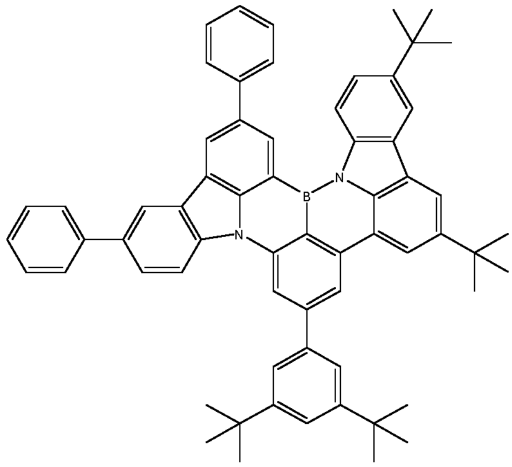

Example 20 was synthesized according to procedure 2.
The emission maximum of example **20** (2% in PMMA) is at 471 nm with a full-width at half maximum (FWHM) of 46 nm the CIEx coordinate is 0.13 and the CIEy coordinate is 0.20. The photoluminescence quantum yield (PLQY) is 72%.

**Example 21**

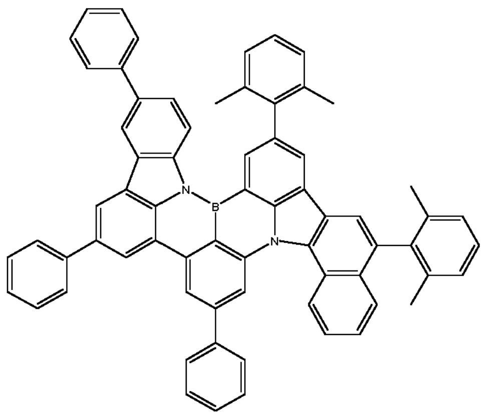

Example 21 was synthesized according to procedure 3.
MS (LC-MS, APPI ion source): 904 m/z at rt: 8.68 min.
The emission maximum of example **21** (2% in PMMA) is at 471 nm with a full-width at half maximum (FWHM) of 33 nm the CIEx coordinate is 0.13 and the CIEy coordinate is 0.21.

**Additional Examples of Organic Molecules**

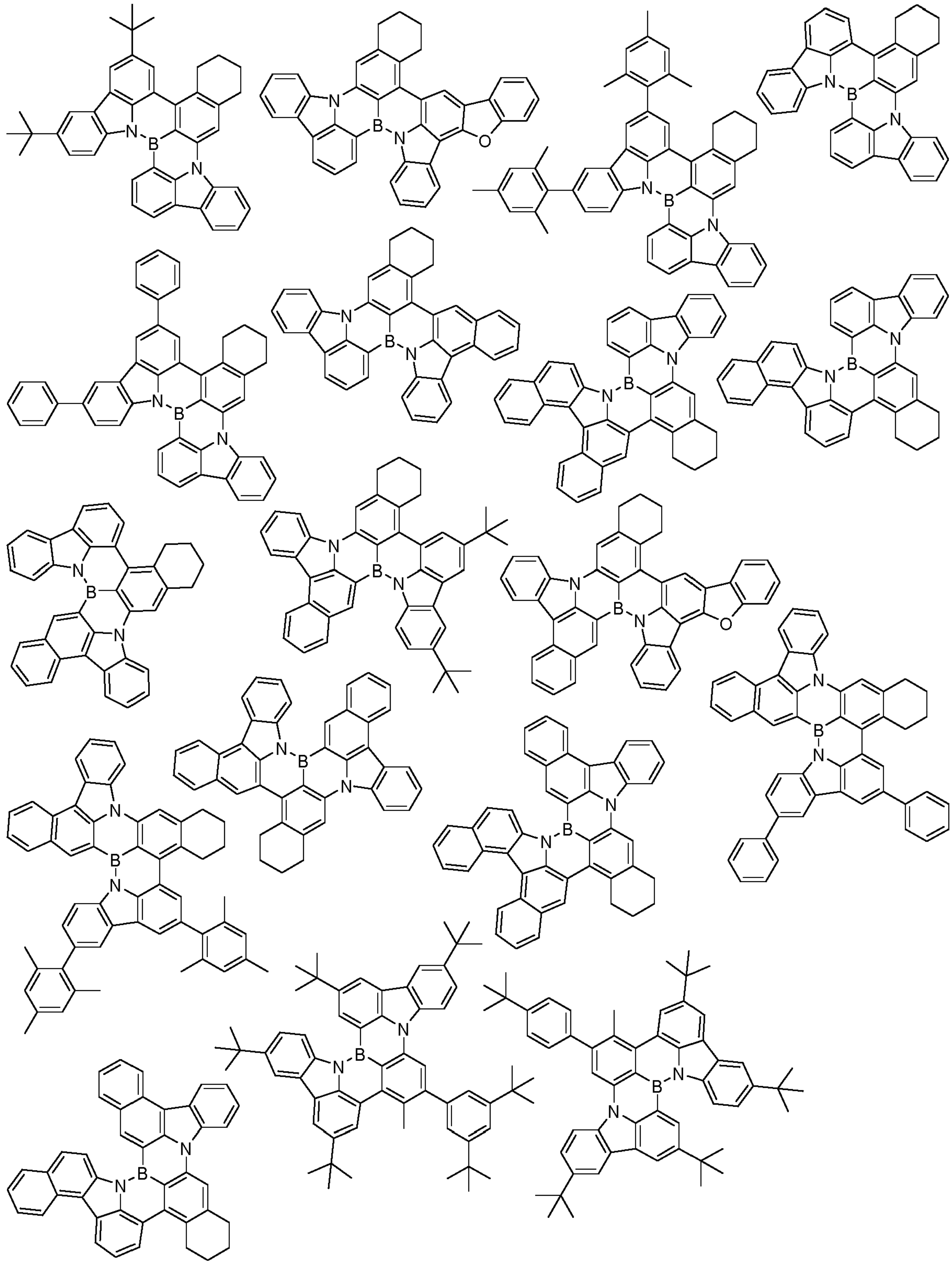

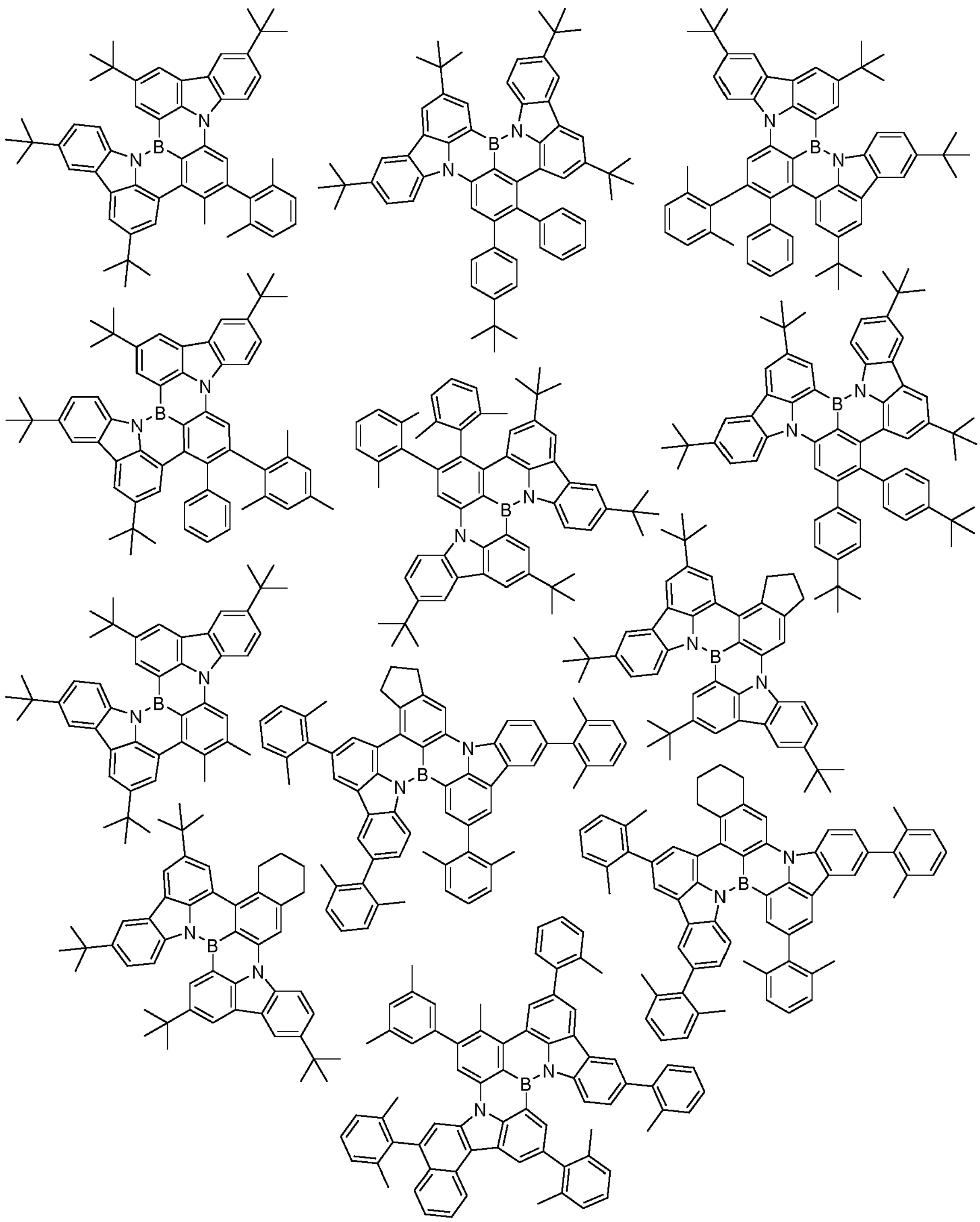

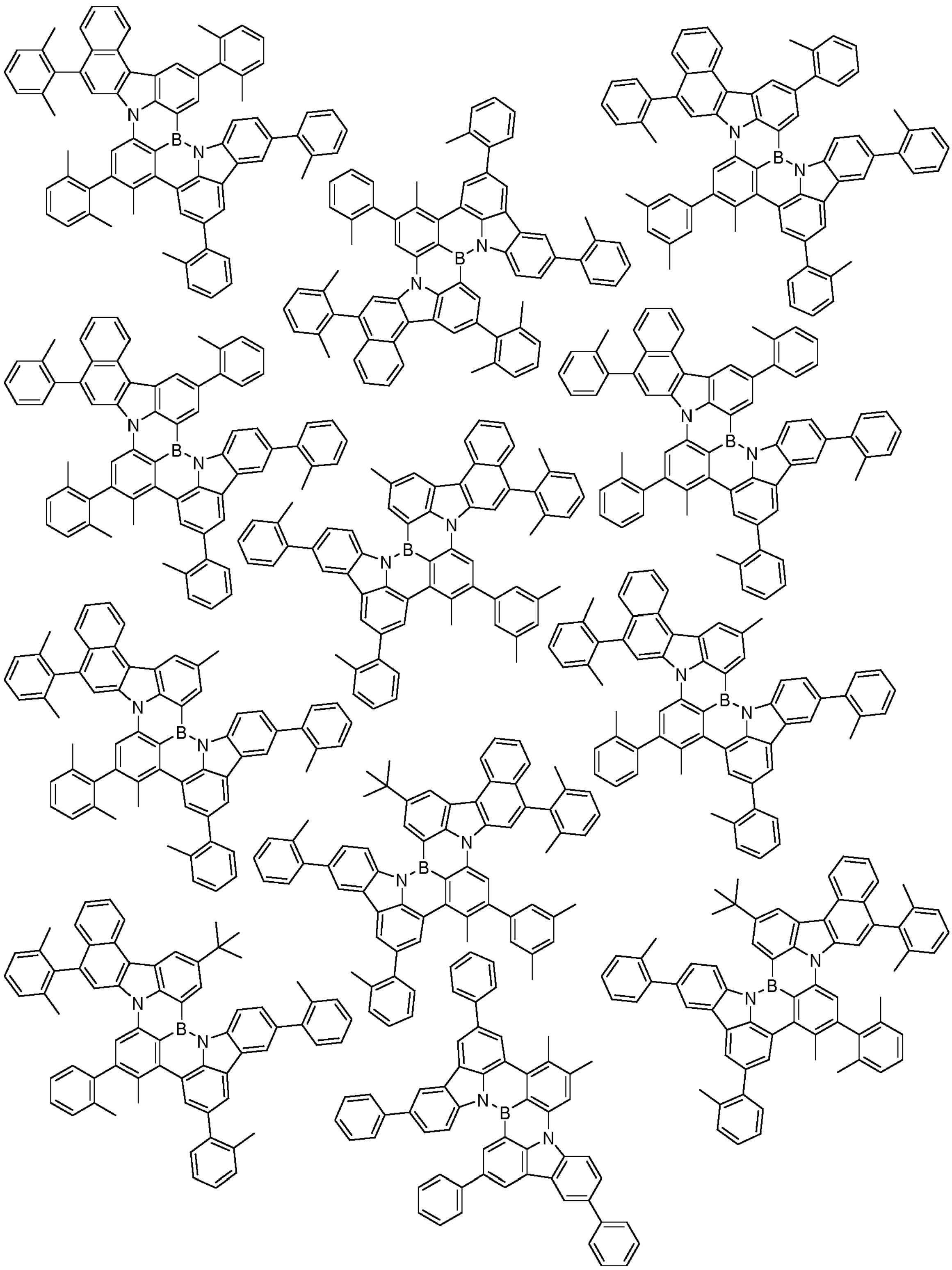

## Claims

**1.** Organic molecule, comprising a structure represented by formula I

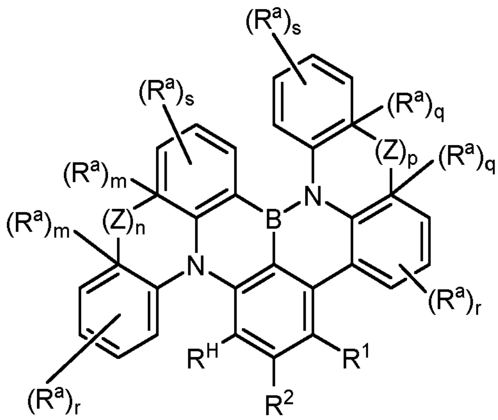

Formula I

wherein

$R^1$ and $R^2$ are independently from each other selected from the group consisting of:

$C_1$-$C_{40}$-alkyl, which is optionally substituted with one or more substituents $R^5$, and
$C_6$-$C_{60}$-aryl, which is optionally substituted with one or more substituents $R^5$;
$R^H$ is selected from the group consisting of hydrogen, deuterium, F, Br, I, and $C_1$-$C_4$-alkyl;
n, m, p, q are integers selected from 0 and 1,
wherein n + m = 1 and p + q = 1;
r is at each occurrence an integer independently selected from the group consisting of 0, 1, 2, 3 and 4;
s is at each occurrence an integer independently selected from the group consisting of 0, 1, 2 and 3;
Z is at each occurrence independently selected from the group consisting of a direct bond, $CR^3R^4$, $C=CR^3R^4$, C=O, $C=NR^3$, $NR^3$, O, $SiR^3R^4$, S, S(O) and $S(O)_2$;
$R^a$, $R^3$ and $R^4$ is at each occurrence independently selected from the group consisting of:

hydrogen, deuterium, $N(R^5)_2$, $OR^5$, $Si(R^5)_3$, $B(OR^5)_2$, $B(R^5)_2$, $OSO_2R^5$, $CF_3$, CN, F, Br, I,
$C_1$-$C_{40}$-alkyl,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-alkoxy,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-thioalkoxy,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkenyl,

which is optionally substituted with one or more substituents $R^5$ and
wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkynyl,

which is optionally substituted with one or more substituents $R^5$ and

wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_6$-$C_{60}$-aryl,

which is optionally substituted with one or more substituents $R^5$; and $C_2$-$C_{57}$-heteroaryl, which is optionally substituted with one or more substituents $R^5$;

$R^5$ is at each occurrence independently from another selected from the group consisting of:

hydrogen, deuterium, $N(R^6)_2$, $OR^6$, $Si(R^6)_3$, $B(OR^6)_2$, $B(R^6)_2$, $OSO_2R^6$, $CF_3$, CN, F, Br, I, $C_1$-$C_{40}$-alkyl,

which is optionally substituted with one or more substituents $R^6$ and wherein one or more non-adjacent $CH_2$-groups are optionally substituted by $R^6C=CR^6$, C≡C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S or $CONR^6$;

$C_1$-$C_{40}$-alkoxy,

which is optionally substituted with one or more substituents $R^6$ and wherein one or more non-adjacent $CH_2$-groups are optionally substituted by $R^6C=CR^6$, C≡C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S or $CONR^6$;

$C_1$-$C_{40}$-thioalkoxy,

which is optionally substituted with one or more substituents $R^6$ and wherein one or more non-adjacent $CH_2$-groups are optionally substituted by $R^6C=CR^6$, C≡C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S or $CONR^6$;

$C_2$-$C_{40}$-alkenyl,

which is optionally substituted with one or more substituents $R^6$ and wherein one or more non-adjacent $CH_2$-groups are optionally substituted by $R^6C=CR^6$, C≡C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S or $CONR^6$;

$C_2$-$C_{40}$-alkynyl,

which is optionally substituted with one or more substituents $R^6$ and wherein one or more non-adjacent $CH_2$-groups are optionally substituted by $R^6C=CR^6$, C≡C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S or $CONR^6$;

$C_6$-$C_{60}$-aryl,

which is optionally substituted with one or more substituents $R^6$; and $C_2$-$C_{57}$-heteroaryl, which is optionally substituted with one or more substituents $R^6$;

$R^6$ is at each occurrence independently from another selected from the group consisting of:

hydrogen, deuterium, OPh, $CF_3$, CN, F,
$C_1$-$C_5$-alkyl,
wherein one or more hydrogen atoms are optionally, independently substituted by deuterium, CN, $CF_3$, or F;
$C_1$-$C_5$-alkoxy,
wherein one or more hydrogen atoms are optionally, independently substituted by deuterium, CN, $CF_3$, or F;
$C_1$-$C_5$-thioalkoxy,
wherein one or more hydrogen atoms are optionally, independently substituted by deuterium, CN, $CF_3$, or F;

$C_2$-$C_5$-alkenyl,
wherein one or more hydrogen atoms are optionally, independently substituted by deuterium, CN, $CF_3$, or F;
$C_2$-$C_5$-alkynyl,
wherein one or more hydrogen atoms are optionally, independently substituted by deuterium, CN, $CF_3$, or F;
$C_6$-$C_{18}$-aryl,
which is optionally substituted with one or more $C_1$-$C_5$-alkyl substituents;
$C_2$-$C_{17}$-heteroaryl,
which is optionally substituted with one or more $C_1$-$C_5$-alkyl substituents;
$N(C_6$-$C_{18}$-aryl$)_2$;
$N(C_2$-$C_{17}$-heteroaryl$)_2$, and
$N(C_2$-$C_{17}$-heteroaryl$)(C_6$-$C_{18}$-aryl);
wherein optionally, any of the substituents $R^a$, $R^1$, $R^2$, $R^3$, $R^4$, $R^5$, and $R^6$ independently form a mono- or polycyclic, aliphatic, aromatic, heteroaromatic and/or benzo-fused ring system with one or more substituents of $R^a$, $R^1$, $R^2$, $R^3$, $R^4$, $R^5$ and/or $R^6$.

**2.** The organic molecule according to claim 1, wherein $R^H$ is hydrogen.

**3.** The organic molecule according to claim 1 or 2, wherein $R^1$ and $R^2$ is independently from each other selected from

$C_1$-$C_6$ alkyl, and
Ph, which is optionally substituted with one or more substituents independently from each other selected from the group consisting of Me, $^i$Pr, $^t$Bu, CN, $CF_3$, and Ph,
wherein optionally, $R^1$ and $R^2$ together form a mono- or polycyclic, aliphatic and/or aromatic ring system.

**4.** The organic molecule according to any of claims 1 to 3, wherein at least one mono- or polycyclic, aliphatic, aromatic, heteroaromatic and/or benzo-fused ring system is formed by $R^a$, $R^3$, $R^4$, $R^5$, and $R^6$ substituents together with one or more further substituents $R^a$, $R^3$, $R^4$, $R^5$ and/or $R^6$.

**5.** The organic molecule according to any of claims 1 to 4, wherein $R^a$ is at each occurrence independently from another selected from the group consisting of:

hydrogen,
deuterium,
Me, $^i$Pr, $^t$Bu, CN, $CF_3$,
Ph, which is optionally substituted with one or more substituents independently from each other selected from the group consisting of Me, $^i$Pr, $^t$Bu, CN, $CF_3$, and Ph,
pyridinyl, which is optionally substituted with one or more substituents independently from each other selected from the group consisting of Me, $^i$Pr, $^t$Bu, CN, $CF_3$, and Ph,
pyrimidinyl, which is optionally substituted with one or more substituents independently from each other selected from the group consisting of Me, $^i$Pr, $^t$Bu, CN, $CF_3$, and Ph,
carbazolyl, which is optionally substituted with one or more substituents independently from each other selected from the group consisting of Me, $^i$Pr, $^t$Bu, CN, $CF_3$, and Ph,
triazinyl, which is optionally substituted with one or more substituents independently from each other selected from the group consisting of Me, $^i$Pr, $^t$Bu, CN, $CF_3$, and Ph,
and $N(Ph)_2$, which is optionally substituted with one or more substituents independently from each other selected from the group consisting of Me, $^i$Pr, $^t$Bu, CN, $CF_3$, and Ph;
wherein optionally, two or more adjacent substituents $R^a$ form attachment points for a ring system selected from the group consisting of:

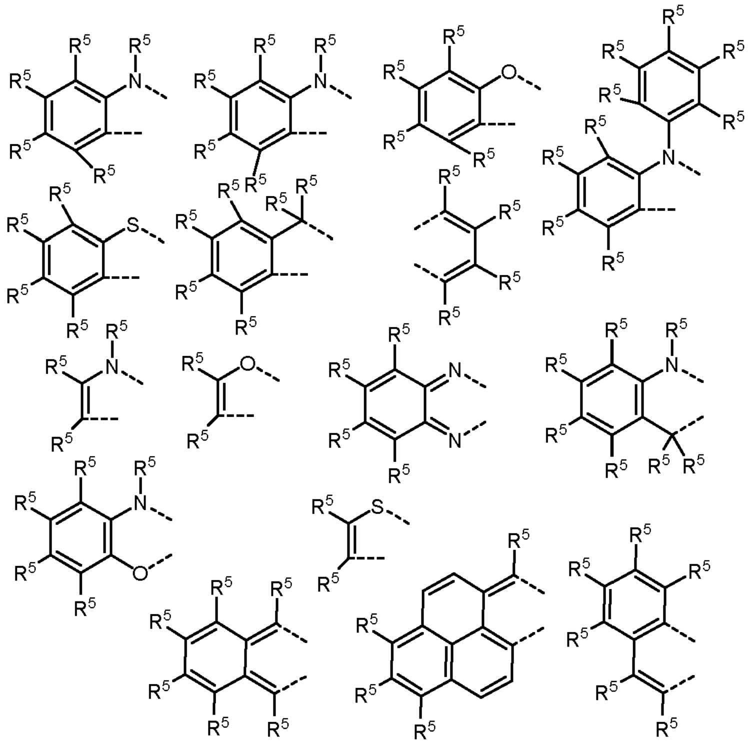

wherein each dashed line indicates a direct bond connecting one of the above shown ring systems to the positions of two adjacent substituents $R^a$.

**6.** The organic molecule according to any of claims 1 to 5, comprising a structure of formula IIa-21:

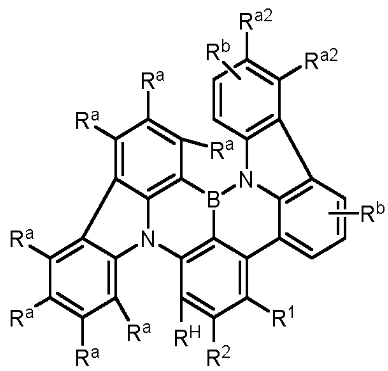

Formula IIa-21

wherein both $R^{a2}$ are independently selected from $R^a$ and together form a mono- or polycyclic, aliphatic, aromatic, heteroaromatic and/or benzo-fused ring system with each other; and $R^b$ is at each occurrence independently from another selected from the group consisting of

hydrogen, deuterium, $N(R^5)_2$, $OR^5$, $Si(R^5)_3$, $B(OR^5)_2$, $OSO_2R^5$, $CF_3$, CN, F, Br, I, $C_1$-$C_{40}$-alkyl,

which is optionally substituted with one or more substituents $R^5$ and wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-alkoxy,

which is optionally substituted with one or more substituents $R^5$ and wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-thioalkoxy,

which is optionally substituted with one or more substituents $R^5$ and wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkenyl,

which is optionally substituted with one or more substituents $R^5$ and wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkynyl,

which is optionally substituted with one or more substituents $R^5$ and wherein one or more non-adjacent $CH_2$-groups are optionally substituted by $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_6$-$C_{60}$-aryl,

which is optionally substituted with one or more substituents $R^5$; and $C_2$-$C_{57}$-heteroaryl, which is optionally substituted with one or more substituents $R^5$.

**7.** The organic molecule according to any of claims 1 to 6, wherein $R^1$ is $C_1$-$C_6$ alkyl.

**8.** Composition, comprising:

(a) an organic molecule according to any of claims 1 to 7, in particular in the form of an emitter, and
(b) a host material, which differs from the organic molecule, and
(c) optionally, a dye and/or a solvent.

**9.** The composition according to claim 8 containing 0.1-30% by weight, in particular 0.8-15% by weight, in particular 1.5-5% by weight, of the organic molecule.

**10.** The composition according to claim 8 or 9, wherein the host material comprises a structure represented by formula 4

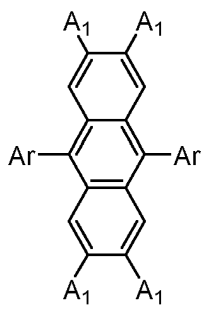

Formula 4

wherein
each Ar is independently from each other selected from the group consisting of

$C_6$-$C_{60}$-aryl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl; and

$C_3$-$C_{57}$-heteroaryl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl; and
each $A_1$ is independently from each other selected from the group consisting of consisting of hydrogen; deuterium;
$C_6$-$C_{60}$-aryl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl;
$C_3$-$C_{57}$-heteroaryl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl; and
$C_1$-$C_{40}$-(hetero)alkyl, which is optionally substituted with one or more residues selected from the group consisting of $C_6$-$C_{60}$-aryl, $C_3$-$C_{57}$-heteroaryl, halogen, and $C_1$-$C_{40}$-(hetero)alkyl.

**11.** The composition according to any of claims 8 to 10, comprising a TADF material and/or a phosphorescence material.

**12.** Optoelectronic device, comprising an organic molecule according to any of claims 1 to 7, in particular as a luminescent emitter, or a composition according to any of claims 8 to 11.

**13.** The optoelectronic device according to claim 12 selected from the group consisting of:

- organic diodes,
- organic light-emitting diodes (OLEDs),
- light-emitting electrochemical cells,
- OLED-sensors,
- organic solar cells,
- organic transistors,
- organic field-effect transistors,
- organic lasers, and
- down-conversion elements.

**14.** The optoelectronic device according to claim 12 or 13, comprising:

- a substrate,
- an anode, and
- a cathode, wherein the anode or the cathode are disposed on the substrate, and
- a light-emitting layer, which is arranged between the anode and the cathode and which comprises the organic molecule or the composition.

**15.** A method for generating light of a wavelength from 440 nm to 560 nm, in particular from 440 nm to 470 nm, comprising the steps of:

(i) providing an optoelectronic device according to any of claims 12 to 14; and
(ii) applying an electrical current to the optoelectronic device.

## Patentansprüche

**1.** Organisches Molekül, umfassend eine Struktur, dargestellt durch Formel I

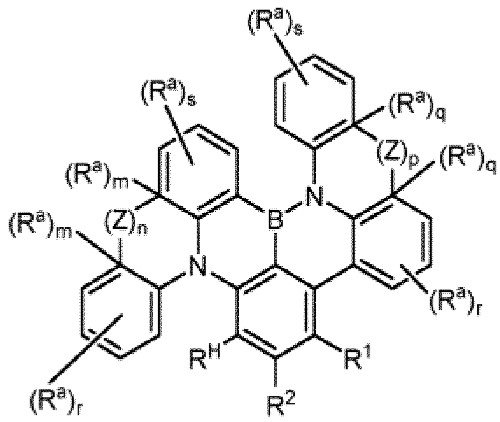

Formel I

wobei
$R^1$ und $R^2$ unabhängig voneinander ausgewählt sind aus der Gruppe bestehend aus:

$C_1$-$C_{40}$-Alkyl, das gegebenenfalls mit einem oder mehreren Substituenten $R^5$ substituiert ist, und
$C_6$-$C_{60}$-Aryl, das gegebenenfalls mit einem oder mehreren Substituenten $R^5$ substituiert ist;
$R^H$ ausgewählt ist aus der Gruppe bestehend aus Wasserstoff, Deuterium, F, Br, I und $C_1$-$C_4$-Alkyl;
n, m, p, q ganze Zahlen von 0 and 1 sind,
wobei n + m = 1 und p + q = 1;
r bei jedem Auftreten eine ganze Zahl ist, die unabhängig ausgewählt ist aus der Gruppe bestehend aus 0, 1, 2, 3, und 4;
s bei jedem Auftreten eine ganze Zahl ist, die unabhängig ausgewählt ist aus der Gruppe bestehend aus 0, 1, 2 und 3;
Z bei jedem Auftreten unabhängig ausgewählt ist aus der Gruppe bestehend aus einer direkten Bindung, $CR^3R^4$, $C=CR^3R^4$, C=O, $C=NR^3$, $NR^3$, O, $SiR^3R^4$, S, S(O) und $S(O)_2$;
$R^a$, $R^3$ und $R^4$ bei jedem Auftreten unabhängig ausgewählt sind aus der Gruppe bestehend aus:

Wasserstoff, Deuterium, $N(R^5)_2$, $OR^5$, $Si(R^5)_3$, $B(OR^5)_2$, $B(R^5)_2$, $OSO_2R^5$, $CF_3$, CN, F, Br, I, $C_1$-$C_{40}$-Alkyl, das gegebenenfalls mit einem oder mehreren Substituenten $R^5$ substituiert ist, und
wobei eine oder mehrere nicht benachbarte $CH_2$-Gruppen gegebenenfalls durch $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S oder $CONR^5$ substituiert sind;
$C_1$-$C_{40}$-Alkoxy,
das gegebenenfalls mit einem oder mehreren Substituenten $R^5$ substituiert ist, und
wobei eine oder mehrere nicht benachbarte $CH_2$-Gruppen gegebenenfalls durch $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S oder $CONR^5$ substituiert sind;
$C_1$-$C_{40}$-Thioalkoxy,
das gegebenenfalls mit einem oder mehreren Substituenten $R^5$ substituiert ist, und
wobei eine oder mehrere nicht benachbarte $CH_2$-Gruppen gegebenenfalls durch $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S oder $CONR^5$ substituiert sind;
$C_2$-$C_{40}$-Alkenyl,
das gegebenenfalls mit einem oder mehreren Substituenten $R^5$ substituiert ist, und
wobei eine oder mehrere nicht benachbarte $CH_2$-Gruppen gegebenenfalls durch $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S oder $CONR^5$ substituiert sind;
$C_2$-$C_{40}$-Alkinyl,
das gegebenenfalls mit einem oder mehreren Substituenten $R^5$ substituiert ist, und
wobei eine oder mehrere nicht benachbarte $CH_2$-Gruppen gegebenenfalls durch $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S oder $CONR^5$ substituiert sind;
$C_6$-$C_{60}$-Aryl,
das gegebenenfalls mit einem oder mehreren Substituenten $R^5$ substituiert ist; und
$C_2$-$C_{57}$-Heteroaryl,
das gegebenenfalls mit einem oder mehreren Substituenten $R^5$ substituiert ist;
$R^5$ bei jedem Auftreten unabhängig voneinander ausgewählt ist aus der Gruppe bestehend aus:

Wasserstoff, Deuterium, $N(R^6)_2$, $OR^6$, $Si(R^6)_3$, $B(OR^6)_2$, $B(R^6)_2$, $OSO_2R^6$, $CF_3$, CN, F, Br, I, $C_1$-$C_{40}$-Alkyl,
das gegebenenfalls mit einem oder mehreren Substituenten $R^6$ substituiert ist, und
wobei eine oder mehrere nicht benachbarte $CH_2$-Gruppen gegebenenfalls durch $R^6C=CR^6$, C=C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S oder $CONR^6$ substituiert sind;
$C_1$-$C_{40}$-Alkoxy,
das gegebenenfalls mit einem oder mehreren Substituenten $R^6$ substituiert ist, und
wobei eine oder mehrere nicht benachbarte $CH_2$-Gruppen gegebenenfalls durch $R^6C=CR^6$, C=C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S oder $CONR^6$ substituiert sind;
$C_1$-$C_{40}$-Thioalkoxy,
das gegebenenfalls mit einem oder mehreren Substituenten $R^6$ substituiert ist, und
wobei eine oder mehrere nicht benachbarte $CH_2$-Gruppen gegebenenfalls durch $R^6C=CR^6$, C=C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S oder $CONR^6$ substituiert sind;
$C_2$-$C_{40}$-Alkenyl,
das gegebenenfalls mit einem oder mehreren Substituenten $R^6$ substituiert ist, und
wobei eine oder mehrere nicht benachbarte $CH_2$-Gruppen gegebenenfalls durch $R^6C=CR^6$, C=C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S oder $CONR^6$ substituiert sind;
$C_2$-$C_{40}$-Alkinyl,
das gegebenenfalls mit einem oder mehreren Substituenten $R^6$ substituiert ist, und
wobei eine oder mehrere nicht benachbarte $CH_2$-Gruppen gegebenenfalls durch $R^6C=CR^6$, C=C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S oder $CONR^6$ substituiert sind;
$C_6$-$C_{60}$-Aryl,
das gegebenenfalls mit einem oder mehreren Substituenten $R^6$ substituiert ist; und
$C_2$-$C_{57}$-Heteroaryl,
das gegebenenfalls mit einem oder mehreren Substituenten $R^6$ substituiert ist;
$R^6$ bei jedem Auftreten unabhängig voneinander ausgewählt ist aus der Gruppe bestehend aus:

Wasserstoff, Deuterium, OPh, $CF_3$, CN, F,
$C_1$-$C_5$-Alkyl,
wobei ein oder mehrere Wasserstoffatome gegebenenfalls unabhängig durch Deuterium, CN, $CF_3$ oder F substituiert sind;
$C_1$-$C_5$-Alkoxy,
wobei ein oder mehrere Wasserstoffatome gegebenenfalls unabhängig durch Deuterium, CN, $CF_3$ oder F substituiert sind;
$C_1$-$C_5$-Thioalkoxy,
wobei ein oder mehrere Wasserstoffatome gegebenenfalls unabhängig durch Deuterium, CN, $CF_3$ oder F substituiert sind;
$C_2$-$C_5$-Alkenyl,
wobei ein oder mehrere Wasserstoffatome gegebenenfalls unabhängig durch Deuterium, CN, $CF_3$ oder F substituiert sind;
$C_2$-$C_5$-Alkinyl,
wobei ein oder mehrere Wasserstoffatome gegebenenfalls unabhängig durch Deuterium, CN, $CF_3$ oder F substituiert sind;
$C_6$-$C_{18}$-Aryl,
das gegebenenfalls mit einem oder mehreren $C_1$-$C_5$-Alkyl-Substituenten substituiert ist;
$C_2$-$C_{17}$-Heteroaryl,
das gegebenenfalls mit einem oder mehreren $C_1$-$C_5$-Alkyl-Substituenten substituiert ist;
$N(C_6$-$C_{18}$-$Aryl)_2$;
$N(C_2$-$C_{17}$-$Heteroaryl)_2$ und
$N(C_2$-$C_{17}$-Heteroaryl)$(C_6$-$C_{18}$-Aryl);
wobei gegebenenfalls ein beliebiger der Substituenten $R^a$, $R^1$, $R^2$, $R^3$, $R^4$, $R^5$ und
$R^6$ unabhängig ein mono- oder polycyclisches, aliphatisches, aromatisches, heteroaromatisches und/oder benzokondensiertes Ringsystem mit einem oder mehreren Substituenten von $R^a$, $R^1$, $R^2$,

$R^3$, $R^4$, $R^5$ und/oder $R^6$ bildet.

**2.** Organisches Molekül nach Anspruch 1, wobei $R^H$ Wasserstoff ist.

**3.** Organisches Molekül nach Anspruch 1 oder 2, wobei $R^1$ und $R^2$ unabhängig voneinander ausgewählt sind aus

$C_1$-$C_6$-Alkyl und
Ph, das gegebenenfalls mit einem oder mehreren Substituenten substituiert ist, die unabhängig voneinander ausgewählt sind aus der Gruppe bestehend aus Me, $^i$Pr, $^t$Bu, CN, $CF_3$ und Ph,
wobei gegebenenfalls $R^1$ und $R^2$ zusammen ein mono- oder polycyclisches, aliphatisches und/oder aromatisches Ringsystem bilden.

**4.** Organisches Molekül nach einem der Ansprüche 1 bis 3, wobei mindestens ein mono- oder polycyclisches, aliphatisches, aromatisches, heteroaromatisches und/oder benzokondensiertes Ringsystem durch Substituenten $R^a$, $R^3$, $R^4$, $R^5$ und $R^6$ zusammen mit einem oder mehreren weiteren Substituenten $R^a$, $R^3$, $R^4$, $R^5$ und/oder $R^6$ gebildet wird.

**5.** Organisches Molekül nach einem der Ansprüche 1 bis 4, wobei $R^a$ bei jedem Auftreten unabhängig voneinander ausgewählt ist aus der Gruppe bestehend aus:

Wasserstoff,
Deuterium,
Me, $^i$Pr, $^t$Bu, CN, $CF_3$,
Ph, das gegebenenfalls mit einem oder mehreren Substituenten substituiert ist, die unabhängig voneinander ausgewählt sind aus der Gruppe bestehend aus Me, $^i$Pr, $^t$Bu, CN, $CF_3$ und Ph,
Pyridinyl, das gegebenenfalls mit einem oder mehreren Substituenten substituiert ist, die unabhängig voneinander ausgewählt sind aus der Gruppe bestehend aus Me, $^i$Pr, $^t$Bu, CN, $CF_3$ und Ph,
Pyrimidinyl, das gegebenenfalls mit einem oder mehreren Substituenten substituiert ist, die unabhängig voneinander ausgewählt sind aus der Gruppe bestehend aus Me, $^i$Pr, $^t$Bu, CN, $CF_3$ und Ph,
Carbazolyl, das gegebenenfalls mit einem oder mehreren Substituenten substituiert ist, die unabhängig voneinander ausgewählt sind aus der Gruppe bestehend aus Me, $^i$Pr, $^t$Bu, CN, $CF_3$ und Ph,
Triazinyl, das gegebenenfalls mit einem oder mehreren Substituenten substituiert ist, die unabhängig voneinander ausgewählt sind aus der Gruppe bestehend aus Me, $^i$Pr, $^t$Bu, CN, $CF_3$ und Ph,
und $N(Ph)_2$, das gegebenenfalls mit einem oder mehreren Substituenten substituiert ist, die unabhängig voneinander ausgewählt sind aus der Gruppe bestehend aus Me, $^i$Pr, $^t$Bu, CN, $CF_3$ und Ph;
wobei gegebenenfalls zwei oder mehr benachbarte Substituenten $R^a$ Anlagerungspunkte für ein Ringsystem bilden, ausgewählt aus der Gruppe bestehend aus:

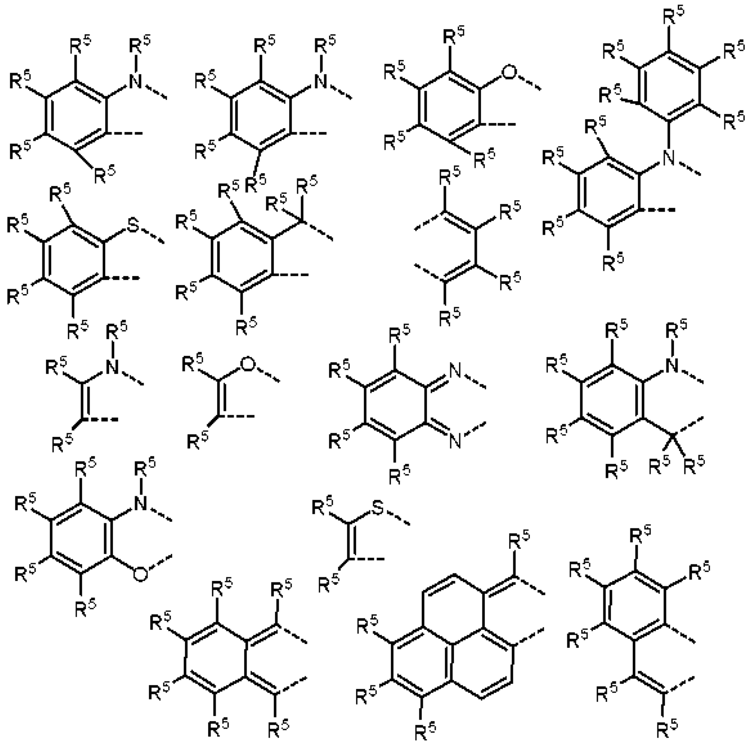

wobei jede gestrichelte Linie eine direkte Bindung angibt, die eines der vorstehend gezeigten Ringsysteme mit den Positionen von zwei benachbarten Substituenten $R^a$ verbindet.

**6.** Organisches Molekül nach einem der Ansprüche 1 bis 5, umfassend eine Struktur der Formel IIa-21:

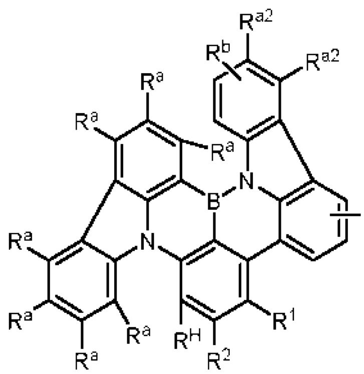

Formula IIa-21

wobei beide $R^{a2}$ unabhängig ausgewählt sind aus $R^a$ und zusammen ein mono- oder polycyclisches, aliphatisches, aromatisches, heteroaromatisches und/oder benzokondensiertes Ringsystem miteinander bilden; und $R^b$ bei jedem Auftreten unabhängig voneinander ausgewählt ist aus der Gruppe bestehend aus Wasserstoff, Deuterium, $N(R^5)_2$, $OR^5$, $Si(R^5)_3$, $B(OR^5)_2$, $OSO_2R^5$, $CF_3$, CN, F, Br, I,

$C_1$-$C_{40}$-Alkyl,

das gegebenenfalls mit einem oder mehreren Substituenten $R^5$ substituiert ist, und

wobei eine oder mehrere nicht benachbarte $CH_2$-Gruppen gegebenenfalls durch $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S oder $CONR^5$ substituiert sind;

$C_1$-$C_{40}$-Alkoxy,

das gegebenenfalls mit einem oder mehreren Substituenten $R^5$ substituiert ist, und

wobei eine oder mehrere nicht benachbarte $CH_2$-Gruppen gegebenenfalls durch $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S oder $CONR^5$ substituiert sind;

$C_1$-$C_{40}$-Thioalkoxy,
das gegebenenfalls mit einem oder mehreren Substituenten $R^5$ substituiert ist, und
wobei eine oder mehrere nicht benachbarte $CH_2$-Gruppen gegebenenfalls durch $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S oder $CONR^5$ substituiert sind;
$C_2$-$C_{40}$-Alkenyl,
das gegebenenfalls mit einem oder mehreren Substituenten $R^5$ substituiert ist, und
wobei eine oder mehrere nicht benachbarte $CH_2$-Gruppen gegebenenfalls durch $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S oder $CONR^5$ substituiert sind;
$C_2$-$C_{40}$-Alkinyl,
das gegebenenfalls mit einem oder mehreren Substituenten $R^5$ substituiert ist, und
wobei eine oder mehrere nicht benachbarte $CH_2$-Gruppen gegebenenfalls durch $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S oder $CONR^5$ substituiert sind;
$C_6$-$C_{60}$-Aryl,
das gegebenenfalls mit einem oder mehreren Substituenten $R^5$ substituiert ist; und
$C_2$-$C_{57}$-Heteroaryl,
das gegebenenfalls mit einem oder mehreren Substituenten $R^5$ substituiert ist.

**7.** Organisches Molekül nach einem der Ansprüche 1 bis 6, wobei $R^1$ $C_1$-$C_6$-Alkyl ist.

**8.** Zusammensetzung, umfassend:

(a) ein organisches Molekül nach einem der Ansprüche 1 bis 7, insbesondere in Form eines Emitters, und
(b) ein Wirtsmaterial, das sich von dem organischen Molekül unterscheidet, und
(c) gegebenenfalls einen Farbstoff und/oder ein Lösungsmittel.

**9.** Zusammensetzung nach Anspruch 8, enthaltend 0,1-30 Gew.-%, insbesondere 0,8-15 Gew.-%, insbesondere 1,5-5 Gew.-% des organischen Moleküls.

**10.** Zusammensetzung nach Anspruch 8 oder 9, wobei das Wirtsmaterial eine Struktur umfasst, die durch Formel 4 dargestellt ist

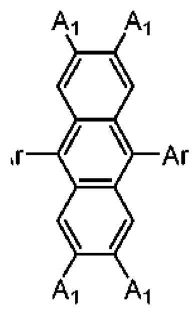

Formel 4

wobei
jedes Ar unabhängig voneinander ausgewählt ist aus der Gruppe bestehend aus:

$C_6$-$C_{60}$-Aryl, das gegebenenfalls mit einem oder mehreren Resten substituiert ist, die ausgewählt sind aus der Gruppe bestehend aus $C_6$-$C_{60}$-Aryl, $C_3$-$C_{57}$-Heteroaryl, Halogen und $C_1$-$C_{40}$-(Hetero)alkyl; und
$C_3$-$C_{57}$-Heteroaryl, das gegebenenfalls mit einem oder mehreren Resten substituiert ist, die ausgewählt sind aus der Gruppe bestehend aus $C_6$-$C_{60}$-Aryl, $C_3$-$C_{57}$-Heteroaryl, Halogen und $C_1$-$C_{40}$-(Hetero)alkyl; und
jedes $A_1$ unabhängig voneinander ausgewählt ist aus der Gruppe bestehend aus Wasserstoff; Deuterium;
$C_6$-$C_{60}$-Aryl, das gegebenenfalls mit einem oder mehreren Resten substituiert ist, die ausgewählt sind aus der Gruppe bestehend aus $C_6$-$C_{60}$-Aryl, $C_3$-$C_{57}$-Heteroaryl, Halogen und $C_1$-$C_{40}$-(Hetero)alkyl;
$C_3$-$C_{57}$-Heteroaryl, das gegebenenfalls mit einem oder mehreren Resten substituiert ist, die ausgewählt sind aus der Gruppe bestehend aus $C_6$-$C_{60}$-Aryl, $C_3$-$C_{57}$-Heteroaryl, Halogen und $C_1$-$C_{40}$-(Hetero)alkyl; und
$C_1$-$C_{40}$-(Hetero)alkyl, das gegebenenfalls mit einem oder mehreren Resten substituiert ist, die ausgewählt sind aus der Gruppe bestehend aus $C_6$-$C_{60}$-Aryl, $C_3$-$C_{57}$-Heteroaryl, Halogen und $C_1$-$C_{40}$-(Hetero)alkyl.

**11.** Zusammensetzung nach einem der Ansprüche 8 bis 10, umfassend ein TADF-Material und/oder ein Phosphoreszenzmaterial.

**12.** Optoelektronische Vorrichtung, umfassend ein organisches Molekül nach einem der Ansprüche 1 bis 7, insbesondere als Lumineszenzemitter, oder eine Zusammensetzung nach einem der Ansprüche 8 bis 11.

**13.** Optoelektronische Vorrichtung nach Anspruch 12, ausgewählt aus der Gruppe bestehend aus:

- organischen Dioden,
- organischen Leuchtdioden (OLEDs),
- lichtemittierenden elektrochemischen Zellen,
- OLED-Sensoren,
- organischen Solarzellen,
- organischen Transistoren,
- organischen Feldeffekt-Transistoren,
- organischen Lasern und
- Abwärtskonvertierungselementen.

**14.** Optoelektronische Vorrichtung nach Anspruch 12 oder 13, umfassend:

- ein Substrat,
- eine Anode und
- eine Kathode, wobei die Anode oder die Kathode auf dem Substrat angeordnet sind, und
- eine lichtemittierende Schicht, die zwischen der Anode und der Kathode angeordnet ist und die das organische Molekül oder die Zusammensetzung umfasst.

**15.** Verfahren zum Erzeugen von Licht mit einer Wellenlänge von 440 nm bis 560 nm, insbesondere von 440 nm bis 470 nm, die folgenden Schritte umfassend:

(i) Bereitstellen einer optoelektronischen Vorrichtung nach einem der Ansprüche 12 bis 14; und
(ii) Anlegen eines elektrischen Stroms an die optoelektronische Vorrichtung.

**Revendications**

**1.** Molécule organique, comprenant une structure représentée par la formule I

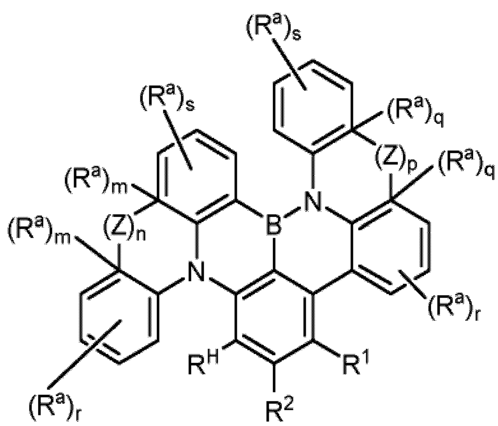

Formule I

dans laquelle
$R^1$ et $R^2$ sont, indépendamment l'un de l'autre, choisis dans le groupe consistant en :

alkyle en $C_1$ à $C_{40}$, qui est facultativement substitué par un ou plusieurs substituants $R^5$, et

aryle en $C_6$ à $C_{60}$, qui est facultativement substitué par un ou plusieurs substituants $R^5$;
$R^H$ est choisi dans le groupe consistant en hydrogène, deutérium, F, Br, I, et alkyle en $C_1$ à $C_4$ ;
n, m, p, q sont des entiers choisis parmi 0 et 1,
dans laquelle n + m = 1 et p + q = 1 ;
r est, à chaque occurrence, un entier indépendamment choisi dans le groupe consistant en 0, 1, 2, 3 et 4 ;
s est, à chaque occurrence, un entier indépendamment choisi dans le groupe consistant en 0, 1, 2 et 3 ;
Z est, à chaque occurrence, indépendamment choisi dans le groupe consistant en une liaison directe, $CR^3R^4$, $C=CR^3R^4$, C=O, $C=NR^3$, $NR^3$, O, $SiR^3R^4$, S, S(O) et $S(O)_2$ ;
$R^a$, $R^3$ et $R^4$ sont, à chaque occurrence, indépendamment choisis dans le groupe consistant en :

hydrogène, deutérium, $N(R^5)_2$, $OR^5$, $Si(R^5)_3$, $B(OR^5)_2$, $B(R^5)_2$, $OSO_2R_5$, $CF_3$, CN, F, Br, I,
alkyle en $C_1$ à $C_{40}$,
qui est facultativement substitué par un ou plusieurs substituants $R^5$ et
dans lequel un ou plusieurs groupes $CH_2$ non adjacents sont facultativement substitués par $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S ou $CONR^5$ ;
alcoxy en $C_1$ à $C_{40}$,
qui est facultativement substitué par un ou plusieurs substituants $R^5$ et
dans lequel un ou plusieurs groupes $CH_2$ non adjacents sont facultativement substitués par $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S ou $CONR^5$ ;
thioalcoxy en $C_1$ à $C_{40}$,
qui est facultativement substitué par un ou plusieurs substituants $R^5$ et
dans lequel un ou plusieurs groupes $CH_2$ non adjacents sont facultativement substitués par $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S ou $CONR^5$ ;
alcényle en $C_2$ à $C_{40}$,
qui est facultativement substitué par un ou plusieurs substituants $R^5$ et
dans lequel un ou plusieurs groupes $CH_2$ non adjacents sont facultativement substitués par $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S ou $CONR^5$ ;
alcynyle en $C_2$ à $C_{40}$,
qui est facultativement substitué par un ou plusieurs substituants $R^5$ et
dans lequel un ou plusieurs groupes $CH_2$ non adjacents sont facultativement substitués par $R^5C=CR^5$, C≡C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S ou $CONR^5$ ;
aryle en $C_6$ à $C_{60}$,
qui est facultativement substitué par un ou plusieurs substituants $R^5$ ; et
hétéroaryle en $C_2$ à $C_{57}$,
qui est facultativement substitué par un ou plusieurs substituants $R^5$ ;
$R^5$ est, à chaque occurrence indépendamment d'une autre, choisi dans le groupe consistant en :

hydrogène, deutérium, $N(R^6)_2$, $OR^6$, $Si(R^6)_3$, $B(OR^6)_2$, $B(R^6)_2$, $OSO_2R^6$, $CF_3$, CN, F, Br, I,
alkyle en $C_1$ à $C_{40}$,
qui est facultativement substitué par un ou plusieurs substituants $R^6$ et
dans lequel un ou plusieurs groupes $CH_2$ non adjacents sont facultativement substitués par $R^6C=CR^6$, C≡C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S ou $CONR^6$ ;
alcoxy en $C_1$ à $C_{40}$,
qui est facultativement substitué par un ou plusieurs substituants $R^6$ et
dans lequel un ou plusieurs groupes $CH_2$ non adjacents sont facultativement substitués par $R^6C=CR^6$, C≡C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S ou $CONR^6$ ;
thioalcoxy en $C_1$ à $C_{40}$,
qui est facultativement substitué par un ou plusieurs substituants $R^6$ et
dans lequel un ou plusieurs groupes $CH_2$ non adjacents sont facultativement substitués par $R^6C=CR^6$, C≡C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S ou $CONR^6$ ;
alcényle en $C_2$ à $C_{40}$,
qui est facultativement substitué par un ou plusieurs substituants $R^6$ et
dans lequel un ou plusieurs groupes $CH_2$ non adjacents sont facultativement substitués par $R^6C=CR^6$, C≡C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S ou $CONR^6$ ;
alcynyle en $C_2$ à $C_{40}$,
qui est facultativement substitué par un ou plusieurs substituants $R^6$ et
dans lequel un ou plusieurs groupes $CH_2$ non adjacents sont facultativement substitués par $R^6C=CR^6$, C≡C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S ou $CONR^6$ ;

aryle en $C_6$ à $C_{60}$,
qui est facultativement substitué par un ou plusieurs substituants $R^6$ ; et
hétéroaryle en $C_2$ à $C_{57}$,
qui est facultativement substitué par un ou plusieurs substituants $R^6$ ;
$R^6$ est, à chaque occurrence indépendamment d'une autre, choisi dans le groupe consistant en :

hydrogène, deutérium, OPh, $CF_3$, CN, F,
alkyle en $C_1$ à $C_5$,
dans lequel un ou plusieurs atomes d'hydrogène sont facultativement, indépendamment substitués par du deutérium, CN, $CF_3$ ou F ;
alcoxy en $C_1$ à $C_5$,
dans lequel un ou plusieurs atomes d'hydrogène sont facultativement, indépendamment substitués par du deutérium, CN, $CF_3$ ou F ;
thioalcoxy en $C_1$ à $C_5$,
dans lequel un ou plusieurs atomes d'hydrogène sont facultativement, indépendamment substitués par du deutérium, CN, $CF_3$ ou F ;
alcényle en $C_2$ à $C_5$,
dans lequel un ou plusieurs atomes d'hydrogène sont facultativement, indépendamment substitués par du deutérium, CN, $CF_3$ ou F ;
alcynyle en $C_2$ à $C_5$,
dans lequel un ou plusieurs atomes d'hydrogène sont facultativement, indépendamment substitués par du deutérium, CN, $CF_3$ ou F ;
aryle en $C_6$ à $C_{18}$,
qui est facultativement substitué par un ou plusieurs substituants alkyle en $C_1$ à $C_5$ ;
hétéroaryle en $C_2$ à $C_{17}$,
qui est facultativement substitué par un ou plusieurs substituants alkyle en $C_1$ à $C_5$ ;
N(aryle en $C_6$ à $C_{18})_2$ ;
N(hétéroaryle en $C_2$ à $C_{17})_2$, et
N(hétéroaryl en $C_2$ à $C_{17}$)(aryle en $C_6$ à $C_{18}$) ;
dans laquelle facultativement, l'un quelconque des substituants $R^a$, $R^1$, $R^2$, $R^3$, $R^4$, $R^5$ et $R^6$ indépendamment forment un système de cycle mono- ou polycyclique, aliphatique, aromatique, hétéroaromatique et/ou benzo-fusionné avec un ou plusieurs substituants de $R^a$, $R^1$, $R^2$, $R^3$, $R^4$, $R^5$ et/ou $R^6$.

**2.** Molécule organique selon la revendication 1, dans laquelle $R^H$ est hydrogène.

**3.** Molécule organique selon la revendication 1 ou 2, dans laquelle $R^1$ et $R^2$ sont, indépendamment l'un de l'autre, choisis parmi

alkyle en $C_1$ à $C_6$, et
Ph, qui est facultativement substitué par un ou plusieurs substituants choisis indépendamment les uns des autres dans le groupe consistant en Me, $^i$Pr, $^t$Bu, CN, $CF_3$ et Ph,
dans laquelle facultativement, $R^1$ et $R^2$ forment conjointement un système de cycle mono- ou polycyclique, aliphatique et/ou aromatique.

**4.** Molécule organique selon l'une quelconque des revendications 1 à 3, dans laquelle au moins un système de cycle mono- ou polycyclique, aliphatique, aromatique, hétéroaromatique et/ou benzo-fusionné est formé par des substituants $R^a$, $R^3$, $R^4$, $R^5$ et $R^6$ conjointement avec un ou plusieurs autres substituants $R^a$, $R^3$, $R^4$, $R^5$ et/ou $R^6$.

**5.** Molécule organique selon l'une quelconque des revendications 1 à 4, dans laquelle $R^a$ est, à chaque occurrence indépendamment d'une autre, choisi dans le groupe consistant en :

hydrogène,
deutérium,
Me, $^i$Pr, $^t$Bu, CN, $CF_3$,
Ph, qui est facultativement substitué par un ou plusieurs substituants choisis indépendamment les uns des autres dans le groupe consistant en Me, $^i$Pr, $^t$Bu, CN, $CF_3$ et Ph,
pyridinyle, qui est facultativement substitué par un ou plusieurs substituants choisis indépendamment les uns des

autres dans le groupe consistant en Me, $^{i}$Pr, $^{t}$Bu, CN, $CF_3$ et Ph,
pyrimidinyle, qui est facultativement substitué par un ou plusieurs substituants choisis indépendamment les uns des autres dans le groupe consistant en Me, $^{i}$Pr, $^{t}$Bu, CN, $CF_3$ et Ph,
carbazolyle, qui est facultativement substitué par un ou plusieurs substituants choisis indépendamment les uns des autres dans le groupe consistant en Me, $^{i}$Pr, $^{t}$Bu, CN, $CF_3$ et Ph,
triazinyle, qui est facultativement substitué par un ou plusieurs substituants choisis indépendamment les uns des autres dans le groupe consistant en Me, $^{i}$Pr, $^{t}$Bu, CN, $CF_3$ et Ph,
et $N(Ph)_2$, qui est facultativement substitué par un ou plusieurs substituants choisis indépendamment les uns des autres dans le groupe consistant en Me, $^{i}$Pr, $^{t}$Bu, CN, $CF_3$ et Ph ;
dans laquelle facultativement, deux substituants $R^a$ adjacents ou plus forment des points d'attache pour un système de cycle choisi dans le groupe consistant en :

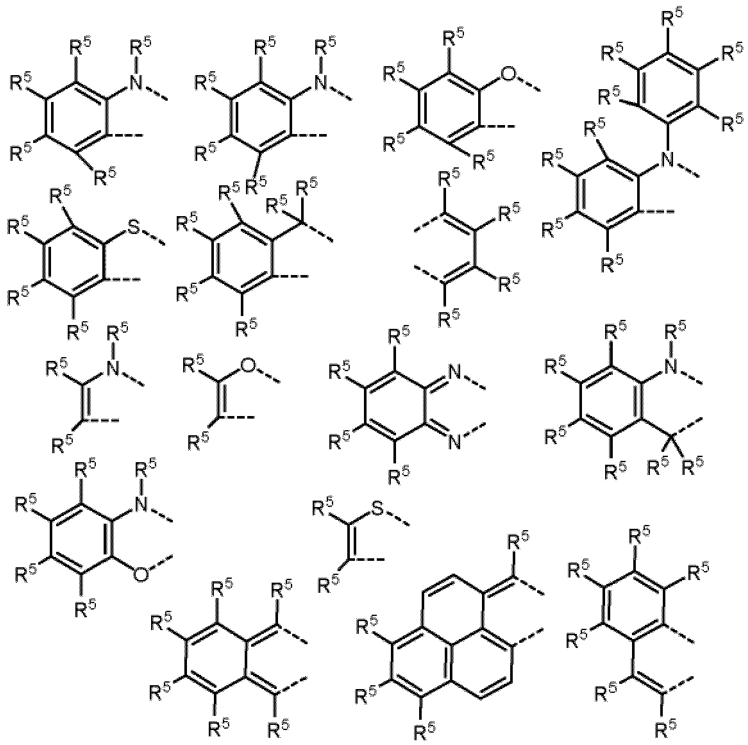

dans laquelle chaque ligne tiretée indique une liaison directe reliant l'un des systèmes de cycle illustrés ci-dessus aux positions des deux substituants $R^a$ adjacents.

**6.** Molécule organique selon l'une quelconque des revendications 1 à 5, comprenant une structure de formule IIa-21 :

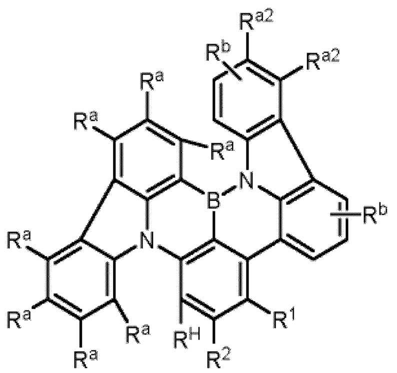

Formule IIa-21

dans laquelle les deux $R^{a2}$ sont indépendamment choisis parmi $R^a$ et forment conjointement un système de cycle mono- ou polycyclique, aliphatique, aromatique, hétéroaromatique et/ou benzo-fusionné l'un avec l'autre ; et $R^b$ est, à chaque occurrence indépendamment d'une autre, choisi dans le groupe consistant en hydrogène, deutérium, $N(R^5)_2$, $OR^5$, $Si(R^5)_3$, $B(OR^5)_2$, $OSO_2R^5$, $CF_3$, CN, F, Br, I, alkyle en $C_1$ à $C_{40}$,
qui est facultativement substitué par un ou plusieurs substituants $R^5$ et
dans lequel un ou plusieurs groupes $CH_2$ non adjacents sont facultativement substitués par $R^5C=CR^5$, $C\equiv C$, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S ou $CONR^5$ ;
alcoxy en $C_1$ à $C_{40}$,
qui est facultativement substitué par un ou plusieurs substituants $R^5$ et
dans lequel un ou plusieurs groupes $CH_2$ non adjacents sont facultativement substitués par $R^5C=CR^5$, $C\equiv C$, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S ou $CONR^5$ ;
thioalcoxy en $C_1$ à $C_{40}$,
qui est facultativement substitué par un ou plusieurs substituants $R^5$ et
dans lequel un ou plusieurs groupes $CH_2$ non adjacents sont facultativement substitués par $R^5C=CR^5$, $C\equiv C$, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S ou $CONR^5$ ;
alcényle en $C_2$ à $C_{40}$,
qui est facultativement substitué par un ou plusieurs substituants $R^5$ et
dans lequel un ou plusieurs groupes $CH_2$ non adjacents sont facultativement substitués par $R^5C=CR^5$, $C\equiv C$, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S ou $CONR^5$ ;
alcynyle en $C_2$ à $C_{40}$,
qui est facultativement substitué par un ou plusieurs substituants $R^5$ et
dans lequel un ou plusieurs groupes $CH_2$ non adjacents sont facultativement substitués par $R^5C=CR^5$, $C\equiv C$, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S ou $CONR^5$ ;
aryle en $C_6$ à $C_{60}$,
qui est facultativement substitué par un ou plusieurs substituants $R^5$ ; et hétéroaryle en $C_2$ à $C_{57}$,
qui est facultativement substitué par un ou plusieurs substituants $R^5$.

**7.** Molécule organique selon l'une quelconque des revendications 1 à 6, dans laquelle $R^1$ est alkyle en $C_1$ à $C_6$.

**8.** Composition, comprenant :

(a) une molécule organique selon l'une quelconque des revendications 1 à 7, en particulier sous la forme d'un émetteur, et
(b) un matériau hôte, qui diffère de la molécule organique, et
(c) facultativement, une teinture et/ou un solvant.

**9.** Composition selon la revendication 8, contenant 0,1 à 30 % en poids, en particulier 0,8 à 15 % en poids, en particulier 1,5 à 5 % en poids, de la molécule organique.

**10.** Composition selon la revendication 8 ou 9, dans laquelle le matériau hôte comprend une structure représentée par la formule 4

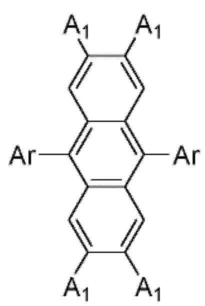

Formule 4

dans laquelle

chaque Ar est indépendamment d'un autre choisi dans le groupe consistant en aryle en $C_6$ à $C_{60}$, qui est

facultativement substitué par un ou plusieurs résidus choisis dans le groupe consistant en aryle en $C_6$ à $C_{60}$, hétéroaryle en $C_3$ à $C_{57}$, halogène, et (hétéro)alkyle en $C_1$ à $C_{40}$ ; et
hétéroaryle en $C_3$ à $C_{57}$, qui est facultativement substitué par un ou plusieurs résidus choisis dans le groupe consistant en aryle en $C_6$ à $C_{60}$, hétéroaryle en $C_3$ à $C_{57}$, halogène, et (hétéro)alkyle en $C_1$ à $C_{40}$ ; et
chaque $A_1$ est indépendamment d'un autre choisi dans le groupe consistant en hydrogène ; deutérium ;
aryle en $C_6$ à $C_{60}$, qui est facultativement substitué par un ou plusieurs résidus choisis dans le groupe consistant en aryle en $C_6$ à $C_{60}$, hétéroaryle en $C_3$ à $C_{57}$, halogène, et (hétéro)alkyle en $C_1$ à $C_{40}$ ;
hétéroaryle en $C_3$ à $C_{57}$, qui est facultativement substitué par un ou plusieurs résidus choisis dans le groupe consistant en aryle en $C_6$ à $C_{60}$, hétéroaryle en $C_3$ à $C_{57}$, halogène, et (hétéro)alkyle en $C_1$ à $C_{40}$ ; et
(hétéro)alkyle en $C_1$ à $C_{40}$, qui est facultativement substitué par un ou plusieurs résidus choisis dans le groupe consistant en aryle en $C_6$ à $C_{60}$, hétéroaryle en $C_3$ à $C_{57}$, halogène, et (hétéro)alkyle en $C_1$ à $C_{40}$.

**11.** Composition selon l'une quelconque des revendications 8 à 10, comprenant un matériau TADF et/ou un matériau de phosphorescence.

**12.** Dispositif optoélectronique, comprenant une molécule organique selon l'une quelconque des revendications 1 à 7, en particulier sous forme d'un émetteur luminescent, ou une composition selon l'une quelconque des revendications 8 à 11.

**13.** Dispositif optoélectronique selon la revendication 12, choisi dans le groupe consistant en :

• les diodes organiques,
• les diodes électroluminescentes organiques (OLED),
• les cellules électrochimiques électroluminescentes,
• les capteurs OLED,
• les cellules solaires organiques,
• les transistors organiques,
• les transistors à effet de champ organiques,
• les lasers organiques, et
• les éléments de conversion vers le bas.

**14.** Dispositif optoélectronique selon la revendication 12 ou 13, comprenant :

- un substrat,
- une anode, et
- une cathode, l'anode et la cathode étant disposées sur le substrat, et
- une couche électroluminescente, qui est disposée entre l'anode et la cathode et qui comprend la molécule organique ou la composition.

**15.** Procédé de génération de lumière ayant une longueur d'onde entre 440 nm et 560 nm, en particulier entre 440 nm et 470 nm, comprenant les étapes de :

(i) fourniture d'un dispositif optoélectronique selon l'une quelconque des revendications 12 à 14 ; et
(ii) application d'un courant électrique au dispositif optoélectronique.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2020135953 A1
- US 2019067577 A1


### Non-patent literature cited in the description


- **KONDAKOV**. *Philosophical Transactions of the Royal Society A: Mathematical, Physical and Engineering Sciences*, 2015, vol. 373, 20140321
- *CHEMICAL ABSTRACTS*, 128-08-5
- *CHEMICAL ABSTRACTS*, 73183-34-3
- *CHEMICAL ABSTRACTS*, 72287-26-4
- *CHEMICAL ABSTRACTS*, 127-08-2
- *CHEMICAL ABSTRACTS*, 14221-01-3
- *CHEMICAL ABSTRACTS*, 7778-53-2
- *CHEMICAL ABSTRACTS*, 51364-51-3
- *CHEMICAL ABSTRACTS*, 657408-07-6
- *CHEMICAL ABSTRACTS*, 128-09-6
- *CHEMICAL ABSTRACTS*, 564483-18-7
- *CHEMICAL ABSTRACTS*, 534-17-8
- *CHEMICAL ABSTRACTS*, 13716-12-6
- *CHEMICAL ABSTRACTS*, 865-48-5
- *CHEMICAL ABSTRACTS*, 7681-65-4
- *CHEMICAL ABSTRACTS*, 66-71-7
- *CHEMICAL ABSTRACTS*, 10294-33-4
- *CHEMICAL ABSTRACTS*, 131274-22-1
- *CHEMICAL ABSTRACTS*, 7646-69-7
- *CHEMICAL ABSTRACTS*, 74-88-4
- *CHEMICAL ABSTRACTS*, 594-19-4
- *CHEMICAL ABSTRACTS*, 10294-34-5
- *CHEMICAL ABSTRACTS*, 202865-57-4
- *CHEMICAL ABSTRACTS*, 584-08-7
- *CHEMICAL ABSTRACTS*, 1510810-80-6
- *CHEMICAL ABSTRACTS*, 6825-20-3
- *CHEMICAL ABSTRACTS*, 123324-71-0
- *CHEMICAL ABSTRACTS*, 56525-79-2
- *CHEMICAL ABSTRACTS*, 197223-39-5
- *CHEMICAL ABSTRACTS*, 100379-00-8
- *CHEMICAL ABSTRACTS*, 98-80-6
- *CHEMICAL ABSTRACTS*, 5599-70-2
- *CHEMICAL ABSTRACTS*, 2619632-07-2
- *CHEMICAL ABSTRACTS*, 16419-60-6
- *CHEMICAL ABSTRACTS*, 131409-18-2
- *CHEMICAL ABSTRACTS*, 13061-96-6
- *CHEMICAL ABSTRACTS*, 1780876-62-1
- *CHEMICAL ABSTRACTS*, 135-67-1
- *CHEMICAL ABSTRACTS*, 1219637-88-3
- *CHEMICAL ABSTRACTS*, 74924-94-0
- *CHEMICAL ABSTRACTS*, 22385-77-9
- *CHEMICAL ABSTRACTS*, 1153-85-1
- *CHEMICAL ABSTRACTS*, 109589-98-2
- *CHEMICAL ABSTRACTS*, 194-59-2
- *CHEMICAL ABSTRACTS*, 83846-48-4
- *CHEMICAL ABSTRACTS*, 19111-87-6
- *CHEMICAL ABSTRACTS*, 103068-20-8
- *CHEMICAL ABSTRACTS*, 204930-37-0
- *CHEMICAL ABSTRACTS*, 150255-96-2

- *CHEMICAL ABSTRACTS*, 850264-86-7
- *CHEMICAL ABSTRACTS*, 201849-15-2
- *CHEMICAL ABSTRACTS*, 13517-10-7
- *CHEMICAL ABSTRACTS*, 110407-59-5
- *CHEMICAL ABSTRACTS*, 128388-54-5
- *CHEMICAL ABSTRACTS*, 1246891-46-2
- *CHEMICAL ABSTRACTS*, 195062-59-0
- *CHEMICAL ABSTRACTS*, 3375-31-3